(19) Europäisches Patentamt / European Patent Office / Office européen des brevets

(11) EP 4 467 550 A1

(12) **EUROPEAN PATENT APPLICATION**
published in accordance with Art. 153(4) EPC

(43) Date of publication:
**27.11.2024 Bulletin 2024/48**

(21) Application number: **23743126.7**

(22) Date of filing: **06.01.2023**

(51) International Patent Classification (IPC):
***C07F 5/02** (2006.01)* ***C09K 11/06** (2006.01)*
***H10K 50/00** (2023.01)*

(52) Cooperative Patent Classification (CPC):
**C07F 5/02; C09K 11/06; H10K 50/00**

(86) International application number:
**PCT/JP2023/000230**

(87) International publication number:
**WO 2023/140130 (27.07.2023 Gazette 2023/30)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.01.2022 JP 2022006355**

(71) Applicant: **Kyulux, Inc.**
**Fukuoka-shi, Fukuoka 819-0388 (JP)**

(72) Inventors:
- **KASHIWAZAKI, Takahiro**
  **Fukuoka-shi, Fukuoka 819-0388 (JP)**
- **OHNO, Satoshi**
  **Fukuoka-shi, Fukuoka 819-0388 (JP)**
- **ISHIZU, Yuki**
  **Fukuoka-shi, Fukuoka 819-0388 (JP)**
- **OZAWA, Hiroaki**
  **Fukuoka-shi, Fukuoka 819-0388 (JP)**
- **KANAHARA, Kousei**
  **Fukuoka-shi, Fukuoka 819-0388 (JP)**
- **GAIHRE, Yuba Raj**
  **Fukuoka-shi, Fukuoka 819-0388 (JP)**

(74) Representative: **Zimmermann & Partner Patentanwälte mbB**
**Postfach 330 920**
**80069 München (DE)**

(54) **COMPOUND, LIGHT-EMITTING MATERIAL AND ORGANIC LIGHT-EMITTING DEVICE**

(57) The compound represented by the following general formula is useful as a material for an organic light emitting device. $X^1$ and $X^2$ represent O or S; $Y^1$ and $Y^2$ represent a single bond, O, S or $C(R^a)(R^b)$; $R^1$ to $R^{22}$, $R^a$, and $R^b$ represent H, a deuterium atom, or a substituent, but at least one of $R^1$ to $R^{22}$ is a substituent.

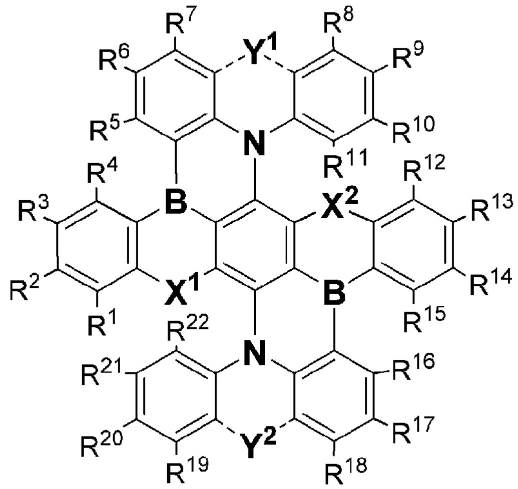

EP 4 467 550 A1

## Description

Technical Field

The present invention relates to a compound having good light emission characteristics. The present invention also relates to a light emitting material and an organic light emitting device using the compound.

Background Art

Studies for enhancing the light emission efficiency of organic light emitting devices such as organic light emitting diodes (OLEDs) are being made actively.

For example, NPL 1 describes that a compound that exhibits a multiple resonance effect such as 5,9-diphenyl-5H,9H-[1,4]benzazaborino[2,3,4-kl]phenazaborine (DABNA-1) is used to exhibit thermally activated delayed fluorescence due to reverse intersystem crossing, thereby realizing light emission with a narrow full-width at half-maximum and a high color purity. Such light emission attains a high light emission efficiency and is useful in display-oriented applications.

Also, NPLs 1 and 2 describe that, by modifying DABNA-1, the energy levels such as the highest occupied molecular orbital (HOMO) and the lowest unoccupied molecular orbital (LUMO) are adjusted to promote the fluorescence emission process and the reverse intersystem crossing process contributing to light emission, thereby improving the electroluminescence quantum efficiency.

Citation List

Non Patent Literature

NPL 1: Adv. Mater. 2016, 28, 2777-2781
NPL 2: Angew. Chem. Int. Ed. 2018, 57, 11316-11320

Summary of Invention

Technical Problem

As described above, various studies have been conducted on compounds that exhibit a multiple resonance effect, but there are many unknown points regarding the relationship between the structure and the light emission characteristics thereof. In order to produce practicable light emitting devices, it is said necessary to provide materials having as excellent light emission characteristics as possible.

Accordingly, the present inventors have promoted assiduous studies for the purpose of developing compounds having new ring skeletons.

Solution to Problem

As a result of assiduous studies, the present inventors have found that a compound expressing a multiple resonance effect and having a characteristic skeleton structure is useful as a material for organic light emitting devices. The present invention has been proposed based on these findings, and specifically has the following configuration.

[1] A compound represented by the following general formula (1).

General Formula (1)

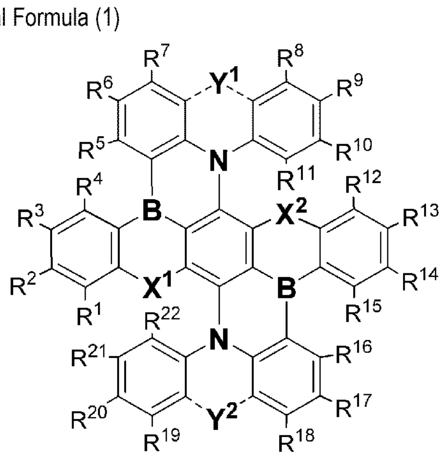

In the general formula (1), $X^1$ and $X^2$ each independently represent O or S;

$Y^1$ and $Y^2$ each independently represent a single bond, O, S or $C(R^a)(R^b)$;
$R^1$ to $R^{22}$, $R^a$, and $R^b$ each independently represent a hydrogen atom, a deuterium atom or a substituent, but at least one of $R^1$ to $R^{22}$ is a substituent;
$R^1$ and $R^2$, $R^2$ and $R^3$, $R^3$ and $R^4$, $R^5$ and $R^6$, $R^6$ and $R^7$, $R^7$ and $Y^1$, $Y^1$ and $R^8$, $R^8$ and $R^9$, $R^9$ and $R^{10}$, $R^{10}$ and $R^{11}$, $R^{12}$ and $R^{13}$, $R^{13}$ and $R^{14}$, $R^{14}$ and $R^{15}$, $R^{16}$ and $R^{17}$, $R^{17}$ and $R^{18}$, $R^{18}$ and $Y^2$, $Y^2$ and $R^{19}$, $R^{19}$ and $R^{20}$, $R^{20}$ and $R^{21}$, and $R^{21}$ and $R^{22}$ each can bond to each other to form a cyclic structure;
$R^{21}$ and $R^1$, $R^4$ and $R^5$, $R^{10}$ and $R^{12}$, and $R^{15}$ and $R^{16}$ each do not bond to each other to form a cyclic structure; and in the general formula (1), $C-R^1$, $C-R^2$, $C-R^3$, $C-R^4$, $C-R^5$, $C-R^6$, $C-R^7$, $C-R^8$, $C-R^9$, $C-R^{10}$, $C-R^{11}$, $C-R^{12}$, $C-R^{13}$, $C-R^{14}$, $C-R^{15}$, $C-R^{16}$, $C-R^{17}$, $C-R^{18}$, $C-R^{19}$, $C-R^{20}$, $C-R^{21}$, and $C-R^{22}$ can be substituted with N.

[2] The compound according to [1], wherein $R^1$ to $R^{22}$ each are a group selected from the group consisting of a hydrogen atom, a deuterium atom, an alkyl group and an aryl group or a group formed by combining at least two thereof, in which a part or all of the hydrogen atoms existing in the group can be substituted with deuterium atoms, or each are a substituted or unsubstituted diarylamino group, in which the two aryl groups constituting the diarylamino group can be linked to each other via a linking group.
[3] The compound according to [1] or [2], wherein at least one of $R^1$ to $R^{22}$ is an aryl group optionally substituted with at least one selected from the group consisting of a deuterium atom, an alkyl group and an aryl group.
[4] The compound according to any one of [1] to [3], wherein $R^6$, $R^9$, $R^{17}$, and $R^{20}$ are substituents.
[5] The compound according to any one of [1] to [4], wherein, among $R^1$ to $R^{22}$, only 1 to 6 selected from the group consisting of $R^2$, $R^3$, $R^6$, $R^9$, $R^{13}$, $R^{14}$, $R^{17}$, and $R^{20}$ are substituents.
[6] The compound according to any one of [1] to [5], wherein the total carbon number of $R^1$ to $R^{22}$ is 10 to 60.
[7] The compound according to any one of [1] to [6], wherein the total number of the benzene rings of $R^1$ to $R^{22}$ is 2 to 6.
[8] The compound according to any one of [1] to [7], wherein $Y^1$ and $Y^2$ are single bonds.
[9] The compound according to any one of [1] to [8], wherein $X^1$ and $X^2$ are O.
[10] The compound according to any one of [1] to [9], which has a point-symmetric structure.
[11] A light emitting material including the compound according to any one of [1] to [10].
[12] A film including the compound according to any one of [1] to [10].
[13] An organic semiconductor device including the compound according to any one of [1] to [10].
[14] An organic light emitting device including the compound according to any one of [1] to [10].
[15] The organic light emitting device according to [14], wherein the device has a layer containing the compound, and the layer also contains a host material.
[16] The organic light emitting device according to [15], wherein the layer containing the compound further contains a delayed fluorescent material in addition to the host material, and the delayed fluorescent material has a lowest excited singlet energy lower than that of the host material and higher than that of the compound.
[17] The organic light emitting device according to [14], wherein the device has a layer containing the compound, and the layer also contains a light emitting material having a structure different from that of the compound.
[18] The organic light emitting device according to any one of [14] to [16], wherein the amount of light emitted from the compound is the largest among the materials contained in the device.
[19] The organic light emitting device according to [17], wherein the amount of light emitted from the light emitting

material is larger than the amount of light emitted from the compound.
[20] The organic light emitting device according to any one of [14] to [19], which emits delayed fluorescence.

Advantageous Effects of Invention

The compound of the present invention shows excellent light emission characteristics and is easy to produce. The compound of the present invention includes one having a high orientation, one having a narrow full-width at half-maximum, and one having a high light emission efficiency. Also, the compound of the present invention includes one that emits red light.

Description of Embodiments

The contents of the present invention will be described in detail below. The constitutional elements may be described below with reference to representative embodiments and specific examples of the present invention, but the present invention is not limited to the embodiments and the specific examples. In the description herein, a numerical range expressed as "to" means a range that includes the numerical values described before and after "to" as the lower limit and the upper limit. A part or all of hydrogen atoms existing in the molecule of the compound for use in the present invention can be substituted with deuterium atoms ($^2H$, deuterium D). In the chemical structural formulae in the description herein, the hydrogen atom is expressed as H, or the expression thereof is omitted. For example, when expression of the atoms bonding to the ring skeleton-constituting carbon atoms of a benzene ring is omitted, H is considered to bond to the ring skeleton-constituting carbon atom at the site having the omitted expression. In this description, the term "substituent" means an atom or group of atoms other than a hydrogen atom and a deuterium atom. On the other hand, the term "substituted or unsubstituted" means that a hydrogen atom can be substituted by a deuterium atom or a substituent.

[Compound Represented by General Formula (1)]

The compound of the present invention is a compound represented by the following general formula (1).

General Formula (1)

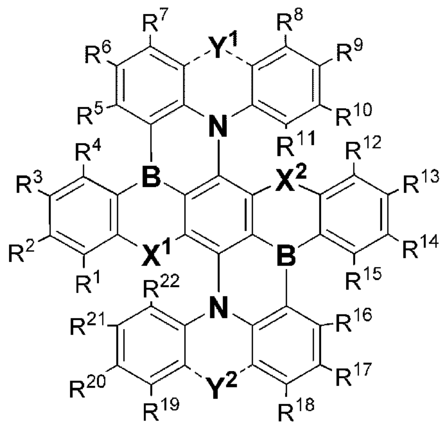

In the general formula (1), $X^1$ and $X^2$ each independently represent O or S. In one preferred aspect of the present invention, $X^1$ and $X^2$ are both O. In one aspect of the present invention, $X^1$ and $X^2$ are both S. In one aspect of the present invention, one of $X^1$ and $X^2$ is O, and the other is S.

In the general formula (1), $Y^1$ and $Y^2$ each independently represent a single bond, O, S or $C(R^a)(R^b)$. In one preferred aspect of the present invention, $Y^1$ and $Y^2$ are both single bonds. In one aspect of the present invention, $Y^1$ and $Y^2$ are both O. In one aspect of the present invention, $Y^1$ and $Y^2$ are both S. In one aspect of the present invention, $Y^1$ and $Y^2$ are both $C(R^a)(R^b)$. In one aspect of the present invention, one of $Y^1$ and $Y^2$ is a single bond, and the other is O or S. In one aspect of the present invention, one of $Y^1$ and $Y^2$ is O, and the other is S.

In one preferred aspect of the present invention, $X^1$ and $X^2$ are both O, and $Y^1$ and $Y^2$ are both single bonds, O or S, more preferably single bonds or O, even more preferably single bonds. In one preferred aspect of the present invention, $X^1$ and $X^2$ are both S, and $Y^1$ and $Y^2$ are both single bonds, O or S, more preferably single bonds. In one aspect of the present invention, $X^1$ and $X^2$ are both O, and $Y^1$ and $Y^2$ are both O, S or $C(R^a)(R^b)$, more preferably both O or S, even more preferably both O. In one aspect of the present invention, $X^1$ and $X^2$ are both S, and $Y^1$ and $Y^2$ are both O, S or $C(R^a)(R^b)$, more preferably both O or S.

In the general formula (1), $R^1$ to $R^{22}$, $R^a$, and $R^b$ each independently represent a hydrogen atom, a deuterium atom or a substituent, but at least one of $R^1$ to $R^{22}$ is a substituent. For example, the substituent as referred to herein can be selected from Substituent Group A, can be selected from Substituent Group B, can be selected from Substituent Group C, can be selected from Substituent Group D, or can be selected from Substituent Group E. In one preferred aspect of the present invention, $R^1$ to $R^{22}$ each are a group selected from the group consisting of a hydrogen atom, a deuterium atom, an alkyl group and an aryl group or a group formed by combining at least two thereof, in which a part or all of the hydrogen atoms existing in the group can be substituted with deuterium atoms, or each are a substituted or unsubstituted diarylamino group, in which the two aryl groups constituting the diarylamino group can be linked to each other via a linking group. In one preferred aspect of the present invention, $R^a$ and $R^b$ each are independently a group selected from the group consisting of a hydrogen atom, a deuterium atom, an alkyl group and an aryl group or a group formed by combining at least two thereof, in which a part or all of the hydrogen atoms existing in the group can be substituted with deuterium atoms.

The "aryl group" as referred to in the description herein can be a monocyclic ring or a fused ring in which two or more rings are fused. In the case of a fused ring, the number of fused rings is preferably 2 to 6, and can be selected from, for example, 2 to 4. Specific examples of the ring include a benzene ring, a naphthalene ring, an anthracene ring, a phenanthrene ring, and a triphenylene ring. Specific examples of the aryl group include a substituted or unsubstituted phenyl group, a substituted or unsubstituted naphthalen-1-yl group, and a substituted or unsubstituted naphthalen-2-yl group. Apart or all of the hydrogen atoms of the aryl group can be substituted with deuterium atoms. Apart or all of the hydrogen atoms of the aryl group can be substituted with substituents. For example, the substituent for the aryl group can be selected from Substituent Group A, can be selected from Substituent Group B, can be selected from Substituent Group C, can be selected from Substituent Group D, or can be selected from Substituent Group E.

The "alkyl group" as referred to in this description can be linear, branched or cyclic. Two or more of a linear moiety, a cyclic moiety and a branched moiety can be in the group as mixed. The carbon number of the alkyl group can be, for example, 1 or more, 2 or more, or 3 or more. The carbon number can also be 30 or less, 20 or less, 10 or less, 6 or less, or 4 or less. Specific examples of the alkyl group include a methyl group, an ethyl group, an n-propyl group, an isopropyl group, an n-butyl group, an isobutyl group, a tert-butyl group, an n-pentyl group, an isopentyl group, an n-hexyl group, an isohexyl group, a 2-ethylhexyl group, an n-heptyl group, an isoheptyl group, an n-octyl group, an isooctyl group, an n-nonyl group, an isononyl group, an n-decanyl group, an isodecanyl group, a cyclopentyl group, a cyclohexyl group, and a cycloheptyl group. A part or all of the hydrogen atoms of the alkyl group can be substituted with deuterium atoms. For example, the substituent for the alkyl group can be selected from Substituent Group A, can be selected from Substituent Group B, can be selected from Substituent Group C, can be selected from Substituent Group D, or can be selected from Substituent Group E.

In one preferred aspect of the present invention, the substituent that $R^1$ to $R^{22}$ can take is a group selected from the group consisting of an alkyl group and an aryl group, or a group formed by combining at least two thereof, in which a part or all of the hydrogen atoms existing in the group can be substituted with deuterium atoms. For example, the substituent is an alkyl group optionally substituted with one or more selected from the group consisting of a deuterium atom and an aryl group. Preferably, the substituent is an aryl group optionally substituted with one or more selected from the group consisting of a deuterium atom, an alkyl group and an aryl group, and more preferably, the substituent is a phenyl group optionally substituted with one or more selected from the group consisting of a deuterium atom, an alkyl group and an aryl group.

In one aspect of the present invention, the substituent that $R^1$ to $R^{22}$ can take can be an aryl group substituted with an electron-attractive group. The electron-attractive group as referred to herein means one having a Hammett's $\sigma p$ value of 0.3 or more, preferably 0.5 or more, more preferably 0.6 or more. The Hammett's $\sigma p$ value is proposed by L. P. Hammett and quantifies the influence of a substituent on the reaction rate or equilibrium of a para-substituted benzene derivative. Specifically, the value is a constant ($\sigma p$) peculiar to the substituent in the following equation that is established between a substituent and a reaction rate constant or an equilibrium constant in a para-substituted benzene derivative:

$$\log(k/k_0) = \rho\sigma p$$

or

$$\log(K/K_0) = \rho\sigma p$$

In the above equations, $k_0$ represents a rate constant of a benzene derivative not having a substituent; k represents a rate constant of a benzene derivative substituted with a substituent; $K_0$ represents an equilibrium constant of a benzene derivative not having a substituent; K represents an equilibrium constant of a benzene derivative substituted with a substituent; and $\rho$ represents a reaction constant to be determined by the kind and the condition of reaction. Regarding the description relating to the "Hammett's $\sigma p$ value" and the numerical value of each substituent in the present invention,

reference can be made to the description relating to σp value in Hansch, C. et. al., Chem. Rev., 91, 165-195 (1991). Specific examples of the electron-attractive group include a fluoroalkyl group and a cyano group. The fluoroalkyl group is preferably a perfluoroalkyl group, and examples thereof include a perfluoroalkyl group having 1 to 4 carbon atoms.

In one preferred aspect of the present invention, the substituent that $R^1$ to $R^{22}$ can take is a substituted or unsubstituted diarylamino group. The two aryl groups constituting the diarylamino group as referred to herein can be linked to each other via a linking group. For example, the groups can be linked via a single bond, -O-, -S-, - C($R^c$)($R^d$)-, or -N($R^e$)-. $R^c$, $R^d$, and $R^e$ each independently represent a hydrogen atom, a deuterium atom or a substituent, preferably a group selected from the group consisting of a hydrogen atom, a deuterium atom, an alkyl group and an aryl group, or a group formed by combining at least two thereof, in which a part or all of the hydrogens existing in the group can be substituted with deuterium atoms. The diarylamino group can be substituted with a substituent, and for example, the substituent can be selected from Substituent Group A, can be selected from Substituent Group B, can be selected from Substituent Group C, can be selected from Substituent Group D, or can be selected from Substituent Group E. In one preferred aspect of the present invention, the substituent for the diarylamino group is a group selected from the group consisting of a deuterium atom, an alkyl group and an aryl group, or a group formed by combining at least two thereof, in which a part or all of the hydrogen atoms existing in the group can be substituted with deuterium atoms.

The substituted or unsubstituted diarylamino group that $R^1$ to $R^{22}$ can take is preferably a substituted or unsubstituted carbazol-9-yl group. The two benzene rings constituting the carbazol-9-yl group can be each independently fused with any other ring. The ring to fuse can be any of an aromatic ring, a heteroaromatic ring, an aliphatic hydrocarbon ring or an aliphatic heterocyclic ring, or can be a ring formed by further fusing these. Preferably, the ring is an aromatic ring, a heteroaromatic ring or a fused ring thereof. The aromatic ring includes a benzene ring. The heteroaromatic ring means a ring exhibiting aromaticity including a heteroatom as a ring skeleton-constituting atom, and is preferably a 5- to 7-membered ring, and for example, a 5-membered ring or a 6-membered ring can be employed. In one aspect of the present invention, a furan ring, a thiophene ring, a pyrrole ring or a pyridine ring can be employed as the heteroaromatic ring. In one aspect of the present invention, the cyclic structure is an optionally-substituted benzene ring, which can be fused with at least one other cyclic structure such as a benzene ring and a furan ring. The benzene ring can be unsubstituted. In one aspect of the present invention, the cyclic structure is an optionally-substituted furan ring, which can be fused with at least one other cyclic structure such as a benzene ring and a furan ring. Preferred examples of the carbazol-9-yl group include an unsubstituted carbazol-9-yl group, a carbazol-9-yl group substituted at the position of at least one of the 3-position and the 6-position, and a carbazol-9-yl group substituted at both the 3-position and the 6-position.

Of $R^1$ to $R^{22}$, the number of the substituents is preferably 1 to 12, more preferably 1 to 8, even more preferably 1 to 6, and for example, can be selected from the range of 1 to 3, or can be selected from the range of 4 to 6. More preferably, the number of the substituents is 4 to 6. In one preferred aspect of the present invention, the number of the substituents selected from the group consisting of $R^2$, $R^3$, $R^6$, $R^9$, $R^{13}$, $R^{14}$, $R^{17}$, and $R^{20}$ is 1 to 6, and more preferably, only 1 to 6 selected from the group consisting of $R^2$, $R^3$, $R^6$, $R^9$, $R^{13}$, $R^{14}$, $R^{17}$, and $R^{20}$ are substituents. In one preferred aspect of the present invention, $R^6$, $R^9$, $R^{17}$, and $R^{20}$ are substituents. For example, only $R^6$, $R^9$, $R^{17}$, and $R^{20}$ are substituents. For example, only $R^2$, $R^6$, $R^9$, $R^{13}$, $R^{17}$, and $R^{20}$ are substituents. For example, only $R^3$, $R^6$, $R^9$, $R^{14}$, $R^{17}$, and $R^{20}$ are substituents. When the number of the substituents $R^1$ to $R^{22}$ that are substituted or unsubstituted aryl groups are 2 or more, the two or more aryl groups are preferably the same, but can differ. As compared with the compounds where the number of the substituents $R^1$ to $R^{22}$ is 0, the compounds represented by the general formula (1) are excellent.

The total carbon number of $R^1$ to $R^{22}$ can be 10 or more, can be 20 or more, or can be 30 or more, and can be 80 or less, can be 60 or less, or can be 40 or less. In one aspect of the present invention, the total carbon number of $R^1$ to $R^{22}$ is selected within a range of 10 to 80, preferably within a range of 10 to 60. In one preferred aspect of the present invention, the total carbon number of $R^1$ to $R^{22}$ is selected within a range of 20 to 40, and can be selected, for example, within a range of 20 to 30, or can be selected within a range of 31 to 40.

The total number of the benzene rings of $R^1$ to $R^{22}$ is selected within a range of 0 to 24. For example, the number can be 1 or more, can be 2 or more, can be 4 or more, or can be 6 or more, and can be 18 or less, can be 12 or less, can be 8 or less, or can be 6 or less. In one aspect of the present invention, the total number of the benzene rings of $R^1$ to $R^{22}$ is selected within a range of 2 to 8, preferably within a range of 2 to 6, and can be selected, for example, within a range of 4 to 6.

Of specific examples of the sub stituent that $R^1$ to $R^{22}$ can take, specific examples of a group selected from the group consisting of an alkyl group and an aryl group and a group formed by combining at least two thereof are shown below as N1 to N36. Also, of specific examples of the substituent that $R^1$ to $R^{22}$ can take, specific examples of a substituted or unsubstituted diarylamino group are shown below as D1 to D117. However, the substituent which can be employed in the present invention should not be limitatively interpreted by the following specific examples. In the following specific examples, * indicates a bonding site, and expression of a methyl group is omitted. For example, N1 is a methyl group, N2 is an ethyl group, N3 is an isopropyl group, and N4 is a tert-butyl group.

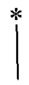 N1 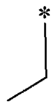 N2 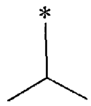 N3 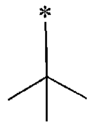 N4

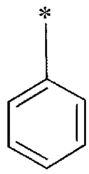 N5 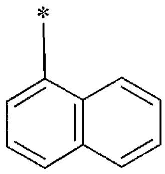 N6 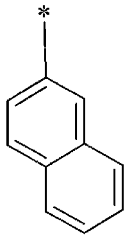 N7 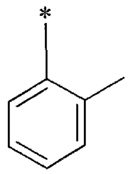 N8 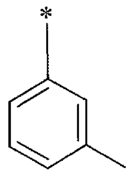 N9 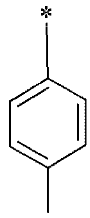 N10

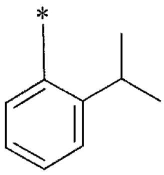 N11 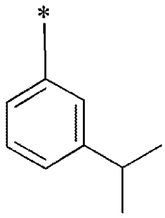 N12 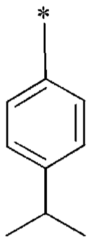 N13 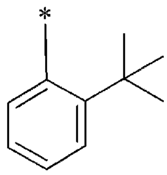 N14 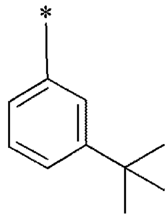 N15 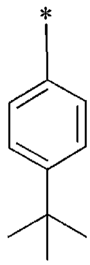 N16

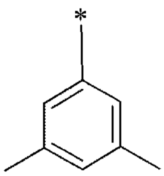 N17 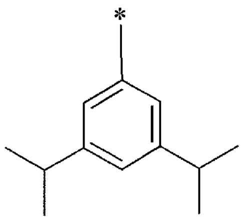 N18 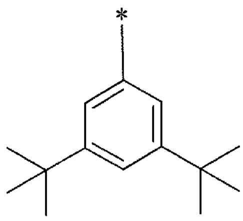 N19 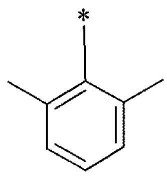 N20

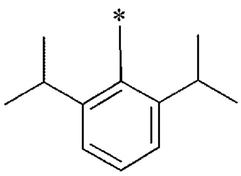 N21 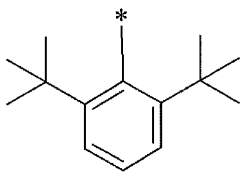 N22 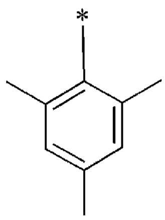 N23 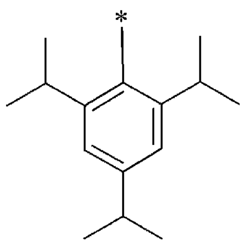 N24

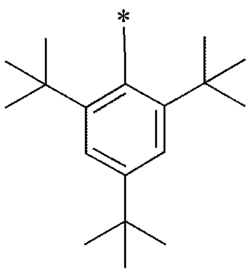 N25 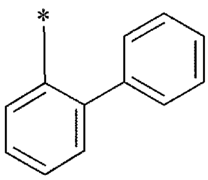 N26 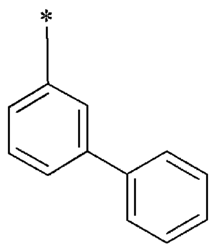 N27 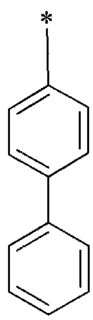 N28

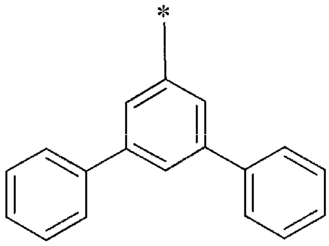
N29

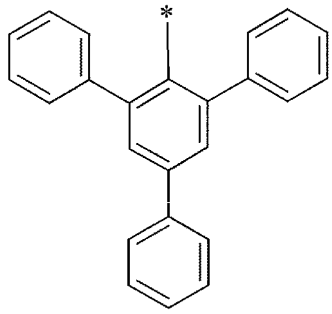
N30

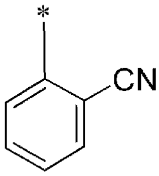
N31

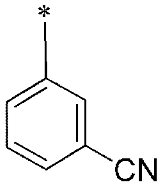
N32

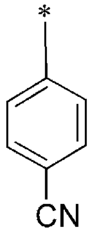
N33

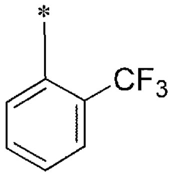
N34

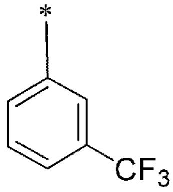
N35

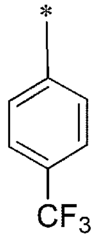
N36

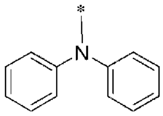
D1

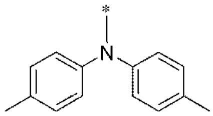
D2

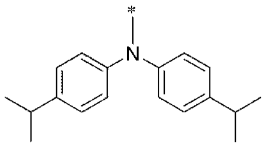
D3

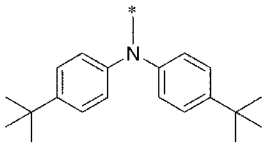
D4

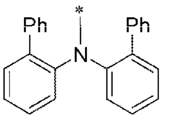
D5

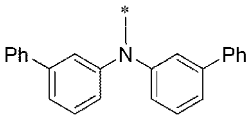
D6

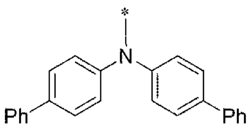
D7

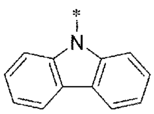
D8

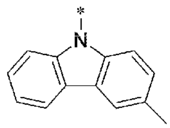
D9

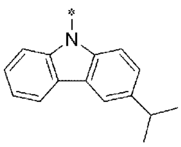
D10

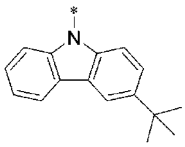
D11

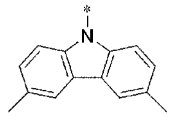
D12

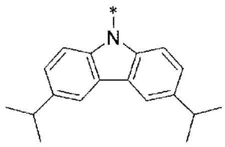
D13

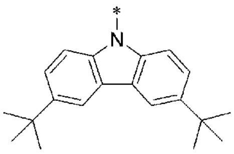
D14

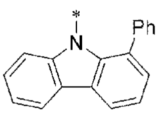
D15

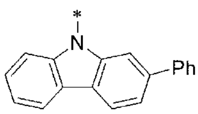
D16

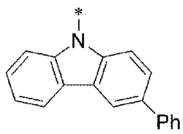
D17

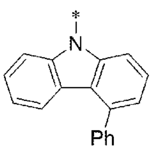
D18

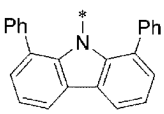
D19

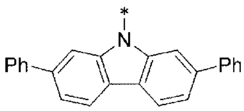
D20

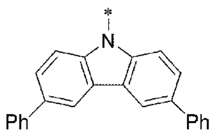
D21

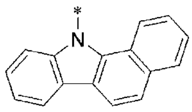
D22

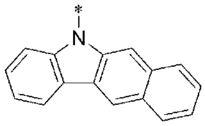
D23

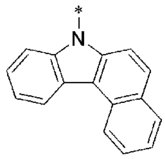
D24

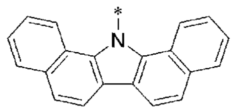
D25

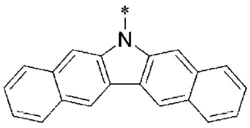
D26

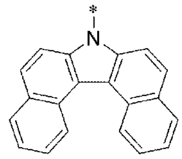
D27

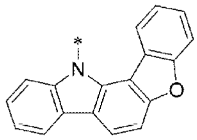
D28

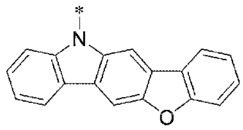
D29

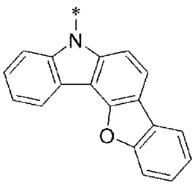
D30

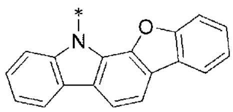
D31

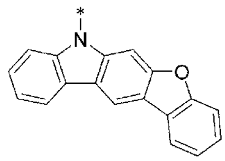
D32

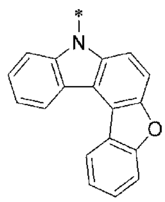
D33

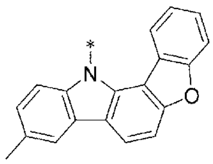
D34

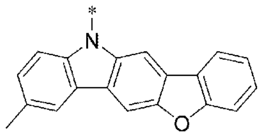
D35

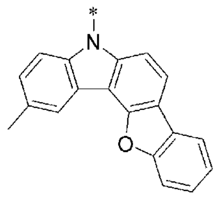
D36

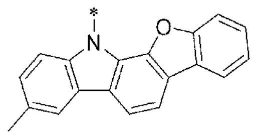
D37

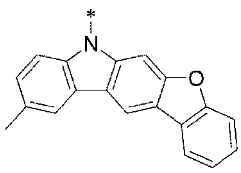
D38

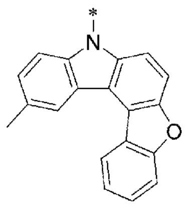
D39

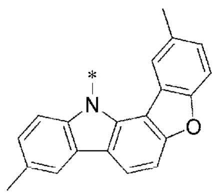
D40

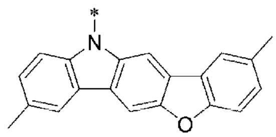
D41

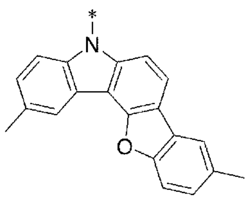
D42

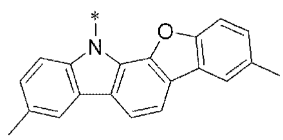
D43

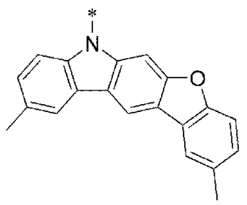
D44

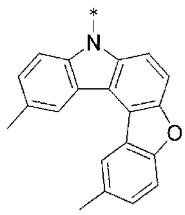
D45

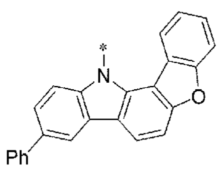
D46

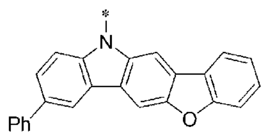
D47

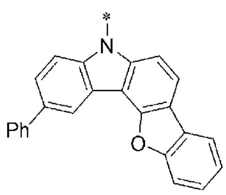
D48

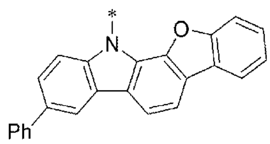
D49

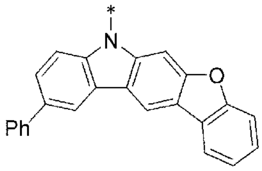
D50

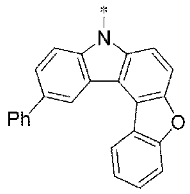
D51

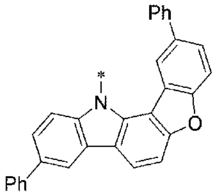
D52

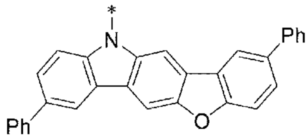
D53

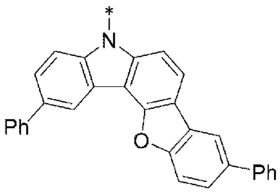
D54

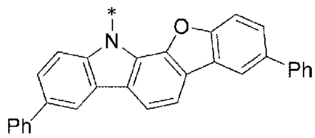
D55

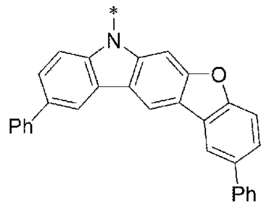
D56

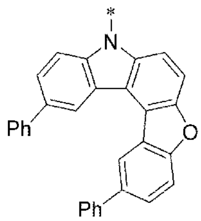
D57

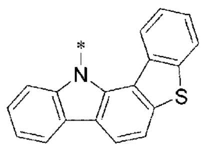
D58

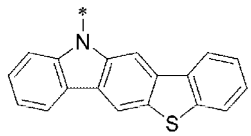
D59

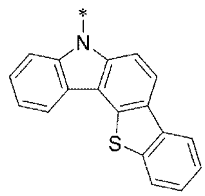
D60

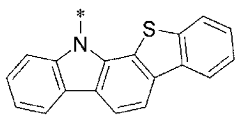
D61

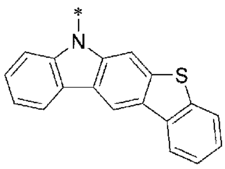
D62

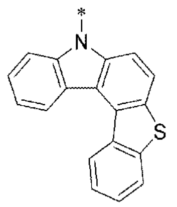
D63

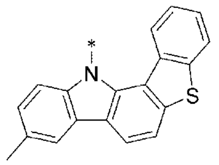
D64

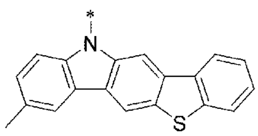
D65

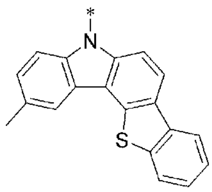
D66

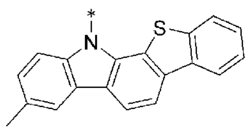
D67

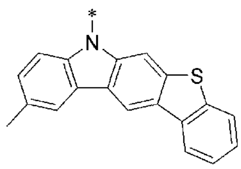
D68

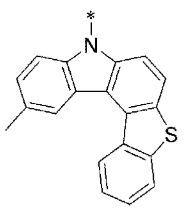
D69

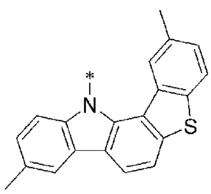
D70

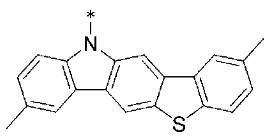
D71

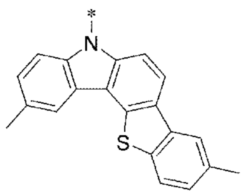
D72

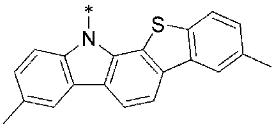
D73

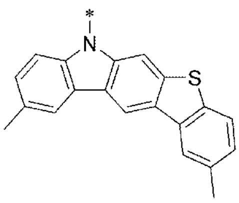
D74

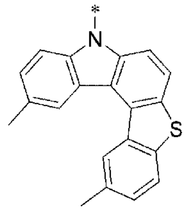
D75

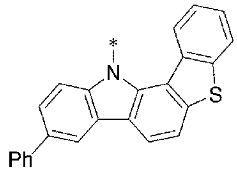
D76

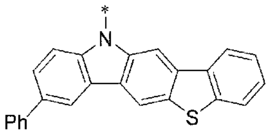
D77

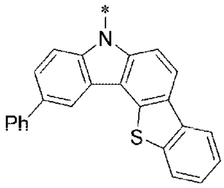
D78

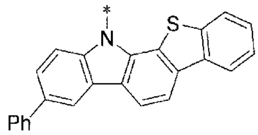
D79

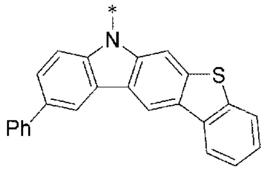
D80

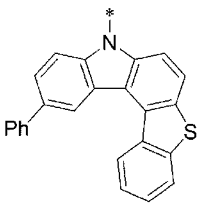
D81

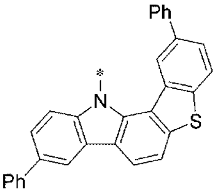
D82

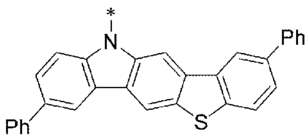
D83

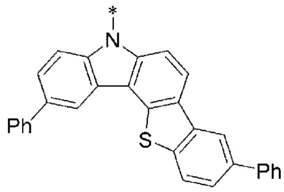
D84

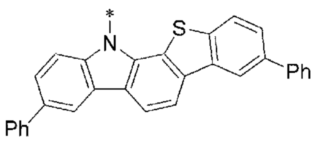
D85

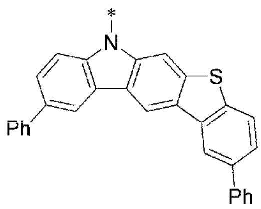
D86

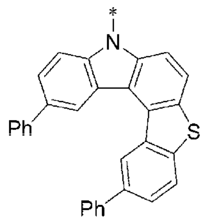
D87

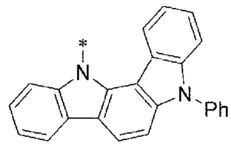
D88

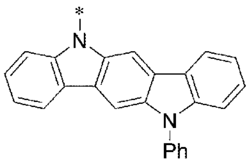
D89

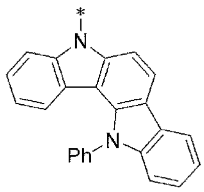
D90

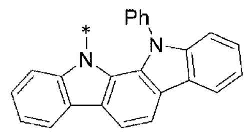
D91

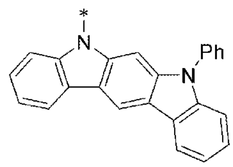
D92

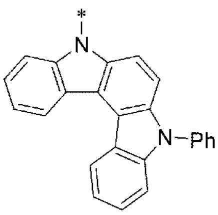
D93

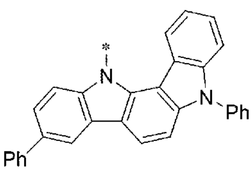
D94

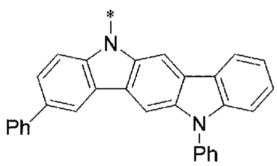
D95

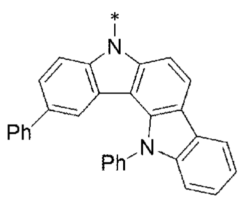
D96

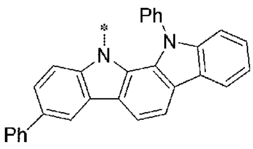
D97

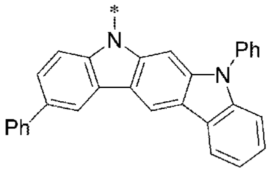
D98

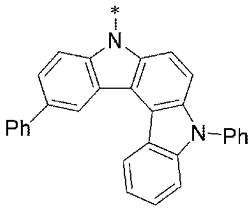
D99

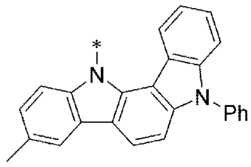
D100

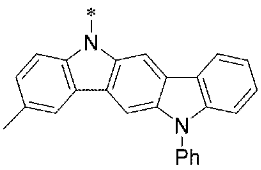
D101

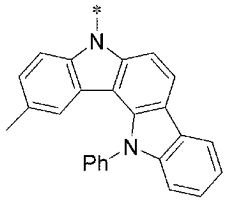
D102

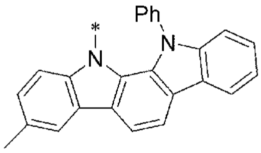
D103

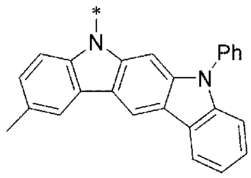
D104

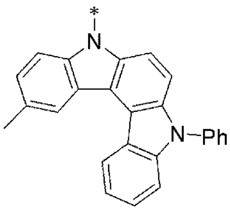
D105

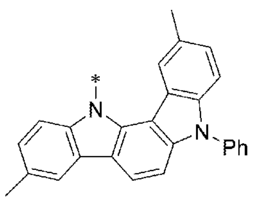
D106

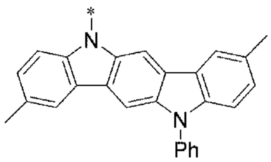
D107

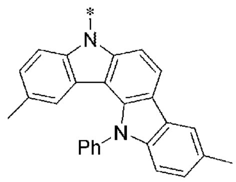
D108

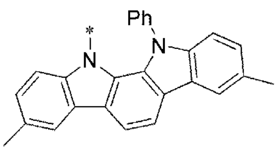
D109

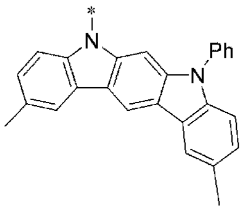
D110

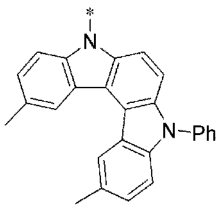
D111

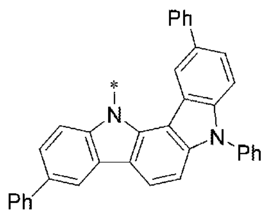
D112

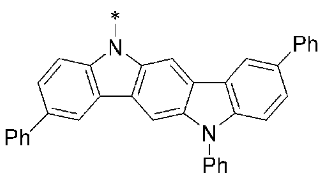
D113

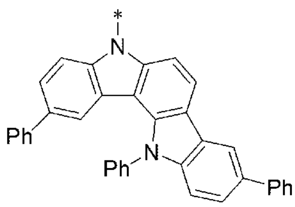
D114

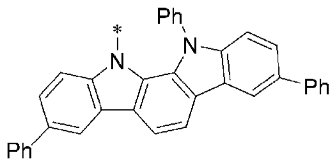
D115

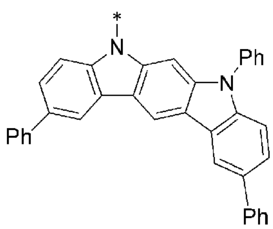
D116

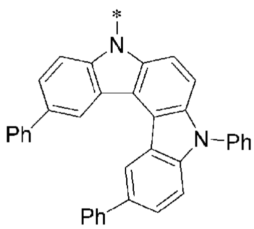
D117

Groups formed by substituting all hydrogen atoms of N1 to N36 and D1 to D117 with deuterium atoms are described herein as N1(D) to N36 (D) and D1(D) to D117(D), respectively. Groups formed by substituting all hydrogen atoms of the alkyl group of N8 to N25, D2 to D14, D34 to D45, D64 to D75, and D 100 to D111 with deuterium atoms are

described herein as N8(a) to N25(a), D2(a) to D14(a), D34(a) to D45(a), D64(a) to D75(a), and D100(a) to D111(a), respectively. Groups formed by substituting all hydrogen atoms of the phenyl group of N26 to N30, D15 to D21, D46 to D57, and D76 to D117 with deuterium atoms are described herein as N26(Ph) to N30(Ph), D15(Ph) to D21(Ph), D46(Ph) to D57(Ph), and D76(Ph) to D117(Ph), respectively.

$R^a$ and $R^b$ of $C(R^a)(R^b)$ that $Y^1$ and $Y^2$ can take is preferably a group selected from the group consisting of an alkyl group and an aryl group, or a group formed by combining at least two thereof, in which a part or all of the hydrogen atoms existing in the group can be substituted with deuterium atoms. $R^a$ and $R^b$ can be the same or can differ, but are preferably the same. Specific examples are N1 to N36, and N1(D) to N36(D) mentioned above. In one preferred aspect of the present invention, $R^a$ and $R^b$ are both unsubstituted aryl groups, more preferably unsubstituted phenyl groups. In one preferred aspect of the present invention, $R^a$ and $R^b$ are both unsubstituted alkyl groups, more preferably alkyl groups each having 1 to 4 carbon atoms, and are, for example, methyl groups.

In the general formula (1), $R^1$ and $R^2$, $R^2$ and $R^3$, $R^3$ and $R^4$, $R^5$ and $R^6$, $R^6$ and $R^7$, $R^7$ and $Y^1$, $Y^1$ and $R^8$, $R^8$ and $R^9$, $R^9$ and $R^{10}$, $R^{10}$ and $R^{11}$, $R^{12}$ and $R^{13}$, $R^{13}$ and $R^{14}$, $R^{14}$ and $R^{15}$, $R^{16}$ and $R^{17}$, $R^{17}$ and $R^{18}$, $R^{18}$ and $Y^2$, $Y^2$ and $R^{19}$, $R^{19}$ and $R^{20}$, $R^{20}$ and $R^{21}$, and $R^{21}$ and $R^{22}$ each can bond to each other to form a cyclic structure.

The cyclic structure can be any of an aromatic ring, an heteroaromatic ring, an aliphatic hydrocarbon ring, and an aliphatic heterocyclic ring, and can be a ring obtained by fusing these rings. The structure is preferably an aromatic ring or a heteroaromatic ring. Examples of the aromatic ring include a substituted or unsubstituted benzene ring. Another benzene ring can be further fused to the benzene ring, and a heterocyclic ring such as a pyridine ring can be fused to the benzene ring. The heteroaromatic ring means a ring exhibiting aromaticity including a heteroatom as a ring skeleton-constituting atom, and is preferably a 5- to 7-membered ring, and for example, a 5-membered ring or a 6-membered ring can be employed. In one aspect of the present invention, a furan ring, a thiophene ring, or a pyrrole ring can be employed as the heteroaromatic ring. In one aspect of the present invention, at least one pair of $R^1$ and $R^2$, $R^2$ and $R^3$, $R^3$ and $R^4$, $R^5$ and $R^6$, $R^6$ and $R^7$, $R^7$ and $Y^1$, $Y^1$ and $R^8$, $R^8$ and $R^9$, $R^9$ and $R^{10}$, $R^{10}$ and $R^{11}$, $R^{12}$ and $R^{13}$, $R^{13}$ and $R^{14}$, $R^{14}$ and $R^{15}$, $R^{16}$ and $R^{17}$, $R^{17}$ and $R^{18}$, $R^{18}$ and $Y^2$, $Y^2$ and $R^{19}$, $R^{19}$ and $R^{20}$, $R^{20}$ and $R^{21}$, and $R^{21}$ and $R^{22}$ each bond to each other to form a cyclic structure. In one aspect of the present invention, any of $R^1$ and $R^2$, $R^2$ and $R^3$, $R^3$ and $R^4$, $R^5$ and $R^6$, $R^6$ and $R^7$, $R^7$ and $Y^1$, $Y^1$ and $R^8$, $R^8$ and $R^9$, $R^9$ and $R^{10}$, $R^{10}$ and $R^{11}$, $R^{12}$ and $R^{13}$, $R^{13}$ and $R^{14}$, $R^{14}$ and $R^{15}$, $R^{16}$ and $R^{17}$ , $R^{17}$ and $R^{18}$, $R^{18}$ and $Y^2$, $Y^2$ and $R^{19}$, $R^{19}$ and $R^{20}$, $R^{20}$ and $R^{21}$, and $R^{21}$ and $R^{22}$ do not bond to each other to form a cyclic structure.

In the general formula (1), $R^{21}$ and $R^1$, $R^4$ and $R^5$, $R^{10}$ and $R^{12}$, and $R^{15}$ and $R^{16}$ each do not bond to each other to form a cyclic structure.

In the general formula (1), $C\text{-}R^1$, $C\text{-}R^2$, $C\text{-}R^3$, $C\text{-}R^4$, $C\text{-}R^5$, $C\text{-}R^6$, $C\text{-}R^7$, $C\text{-}R^8$, $C\text{-}R^9$, $C\text{-}R^{10}$, $C\text{-}R^{11}$, $C\text{-}R^{12}$, $C\text{-}R^{13}$, $C\text{-}R^{14}$, $C\text{-}R^{15}$, $C\text{-}R^{16}$, $C\text{-}R^{17}$, $C\text{-}R^{18}$, $C\text{-}R^{19}$, $C\text{-}R^{20}$, $C\text{-}R^{21}$, and $C\text{-}R^{22}$ can be substituted with N.

In the case where the groups are substituted with N, the number of the substituted groups is preferably 1 to 6, and for example, any of 4 to 6 groups can be substituted, or any of 1 to 3 groups can be substituted. For example, 0 to 4 of $C\text{-}R^1$, $C\text{-}R^2$, $C\text{-}R^3$, $C\text{-}R^4$, $C\text{-}R^{12}$, $C\text{-}R^{13}$, $C\text{-}R^{14}$, and $C\text{-}R^{15}$, and for example, 1 to 2 thereof can be substituted with N. For example, 0 to 4 of $C\text{-}R^5$, $C\text{-}R^6$, $C\text{-}R^7$, $C\text{-}R^8$, $C\text{-}R^9$, and $C\text{-}R^{10}$, and for example, 1 to 2 thereof can be substituted with N. For example, 0 to 4 of $C\text{-}R^{16}$, $C\text{-}R^{17}$, $C\text{-}R^{18}$, $C\text{-}R^{19}$, $C\text{-}R^{20}$, $C\text{-}R^{21}$, and $C\text{-}R^{22}$, and for example, 1 to 2 thereof can be substituted with N. In one aspect of the present invention, any of $C\text{-}R^1$, $C\text{-}R^2$, $C\text{-}R^3$, $C\text{-}R^4$, $C\text{-}R^5$, $C\text{-}R^6$, $C\text{-}R^7$, $C\text{-}R^8$, $C\text{-}R^9$, $C\text{-}R^{10}$, $C\text{-}R^{11}$, $C\text{-}R^{12}$, $C\text{-}R^{13}$, $C\text{-}R^{14}$, $C\text{-}R^{15}$, $C\text{-}R^{16}$, $C\text{-}R^{17}$, $C\text{-}R^{18}$, $C\text{-}R^{19}$, $C\text{-}R^{20}$, $C\text{-}R^{21}$, and $C\text{-}R^{22}$ are not substituted with N.

Preferably, the compound represented by the general formula (1) does not contain a metal atom. The metal atom as referred to herein does not include a boron atom. For example, as the compound represented by the general formula (1), a compound composed of atoms selected from the group consisting of a carbon atom, a hydrogen atom, a deuterium atom, a nitrogen atom, an oxygen atom, a sulfur atom and a boron atom can be selected. For example, as the compound represented by the general formula (1), a compound composed of atoms selected from the group consisting of a carbon atom, a hydrogen atom, a deuterium atom, a nitrogen atom, an oxygen atom and a boron atom can be selected. For example, as the compound represented by the general formula (1), a compound composed of atoms selected from the group consisting of a carbon atom, a hydrogen atom, a nitrogen atom, an oxygen atom and a boron atom can be selected. For example, as the compound represented by the general formula (1), a compound composed of atoms selected from the group consisting of a carbon atom, a hydrogen atom, a nitrogen atom, a sulfur atom and a boron atom can be selected. In one aspect of the present invention, the number of the oxygen atoms in the molecule is 2 to 4, and is, for example 2, or is, for example 4. In one aspect of the present invention, the number of the nitrogen atoms in the molecule is 2 to 8, preferably 2 to 4, and is, for example 2, or is, for example 4. The number of the boron atoms in the molecule is 2 to 8, preferably 2 to 4, and is, for example 2, or is, for example 4.

In the description herein, the term "Substituent Group A" means one group selected from the group consisting of a hydroxy group, a halogen atom (for example, a fluorine atom, a chlorine atom, a bromine atom, and an iodine atom), an alkyl group (for example, having 1 to 40 carbon atoms), an alkoxy group (for example, having 1 to 40 carbon atoms), an alkylthio group (for example, having 1 to 40 carbon atoms), an aryl group (for example, having 6 to 30 carbon atoms), an aryloxy group (for example, having 6 to 30 carbon atoms), an arylthio group (for example, having 6 to 30 carbon atoms), a heteroaryl group (for example, having 5 to 30 ring skeleton-constituting atoms), a heteroaryloxy group (for example,

having 5 to 30 ring skeleton-constituting atoms), a heteroarylthio group (for example, having 5 to 30 ring skeleton-constituting atoms), an acyl group (for example, having 1 to 40 carbon atoms), an alkenyl group (for example, having 1 to 40 carbon atoms), an alkynyl group (for example, having 1 to 40 carbon atoms), an alkoxycarbonyl group (for example, having 1 to 40 carbon atoms), an aryloxycarbonyl group (for example, having 1 to 40 carbon atoms), a heteroaryloxycarbonyl group (for example, having 1 to 40 carbon atoms), a silyl group (for example, a trialkylsilyl group having 1 to 40 carbon atoms), and a nitro group, or a group formed by combining at least two thereof.

In the description herein, the term "Substituent Group B" means one group selected from the group consisting of an alkyl group (for example, having 1 to 40 carbon atoms), an alkoxy group (for example, having 1 to 40 carbon atoms), an aryl group (for example, having 6 to 30 carbon atoms), an aryloxy group (for example, having 6 to 30 carbon atoms), a heteroaryl group (for example, having 5 to 30 ring skeleton-constituting atoms), a heteroaryloxy group (for example, having 5 to 30 ring skeleton-constituting atoms), and a diarylaminoamino group (for example, having 0 to 20 carbon atoms), or a group formed by combining at least two thereof.

In the description herein, the term "Substituent Group C" means one group selected from the group consisting of an alkyl group (for example, having 1 to 20 carbon atoms), an aryl group (for example, having 6 to 22 carbon atoms), a heteroaryl group (for example, having 5 to 20 ring skeleton-constituting atoms), and a diarylamino group (for example, having 12 to 20 carbon atoms), or a group formed by combining at least two thereof.

In the description herein, the term "Substituent Group D" means one group selected from the group consisting of an alkyl group (for example, having 1 to 20 carbon atoms), an aryl group (for example, having 6 to 22 carbon atoms), and a heteroaryl group (for example, having 5 to 20 ring skeleton-constituting atoms), or a group formed by combining at least two thereof.

In the description herein, the term "Substituent Group E" means one group selected from the group consisting of an alkyl group (for example, having 1 to 20 carbon atoms), and an aryl group (for example, having 6 to 22 carbon atoms), or a group formed by combining at least two thereof.

A part or all of the hydrogen atoms existing in the group described in these Substituent Groups A to E can be substituted with deuterium atoms.

In the description herein, the "substituent" or the substituent meant by an expression of "substituted or unsubstituted" can be selected, for example, from Substituent Group A, can be selected from Substituent Group B, can be selected from Substituent Group C, can be selected from Substituent Group D, or can be selected from Substituent Group E.

In one aspect of the present invention, as the compound represented by the general formula (1), a compound having a rotationally symmetric structure is selected. In that case, $R^1$ to $R^{11}$ are the same as $R^{12}$ to $R^{22}$, respectively, $X^1$ and $X^2$ are the same, and $Y^1$ and $Y^2$ are the same. In one aspect of the present invention, as the compound represented by the general formula (1), a compound having an asymmetric structure is selected.

The compound represented by the general formula (1) preferably has, for example, any of the following skeleton structures. In the skeleton structures, X represents O or S, Y represents O, S or C($R^a$)($R^b$), and $R^a$ and $R^b$ are as defined in the general formula (1). At least one hydrogen atom in the following skeleton can be substituted with a deuterium atom or a substituent. Further, rings can be fused. Regarding the details of the substituent and the fused ring, reference can be made to the corresponding description of the general formula (1).

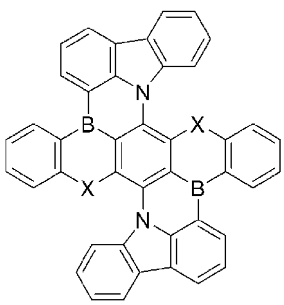
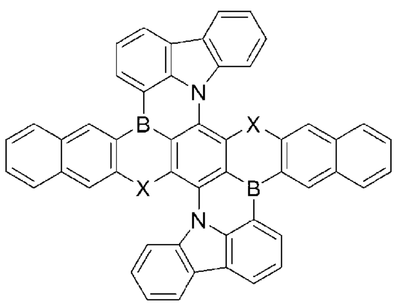
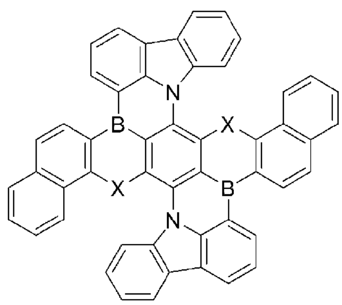

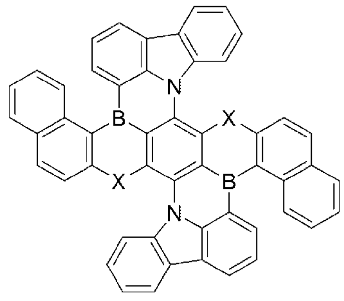
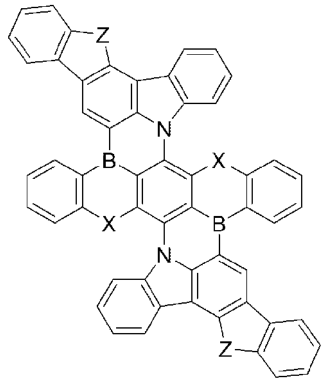
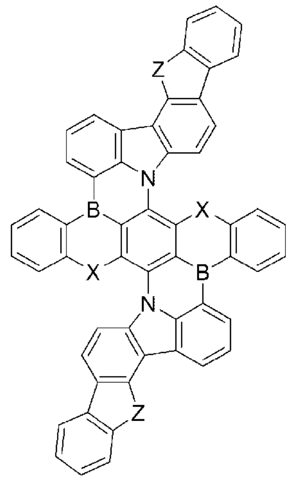

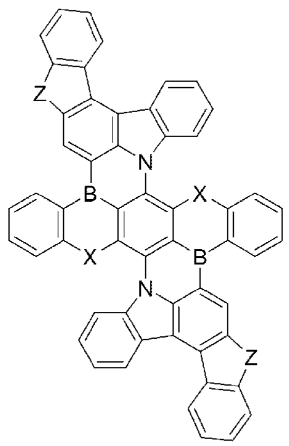
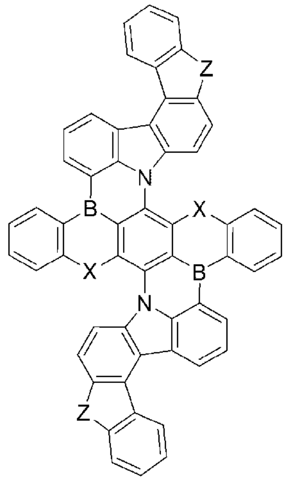
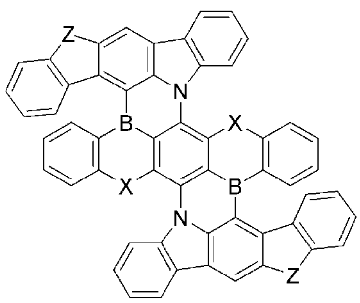

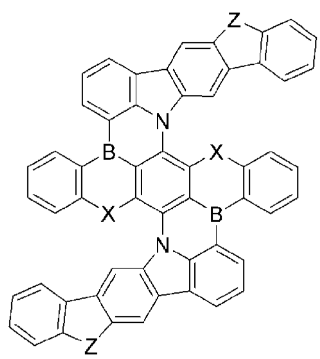
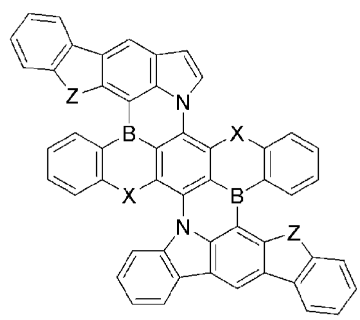
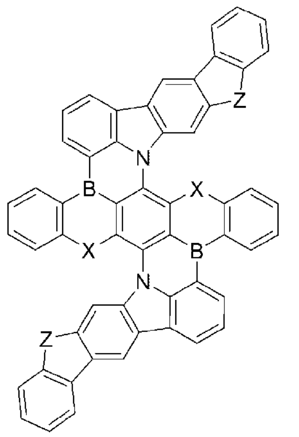

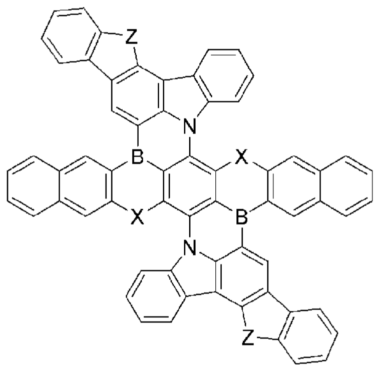
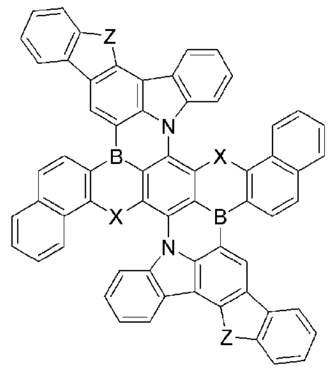
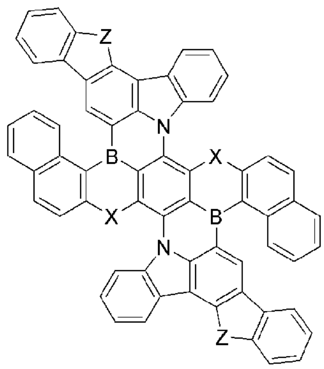

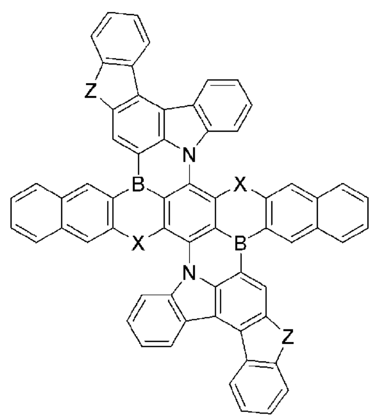
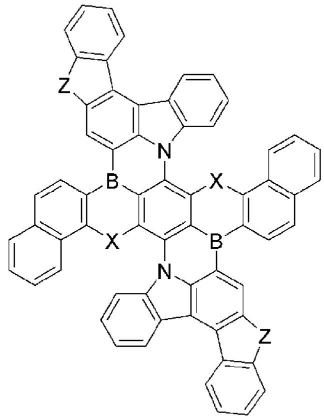
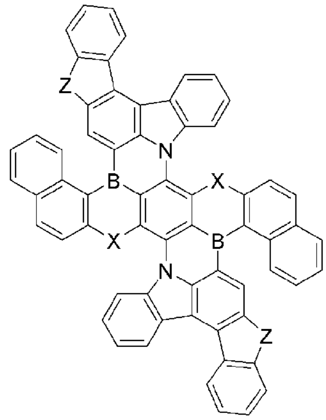

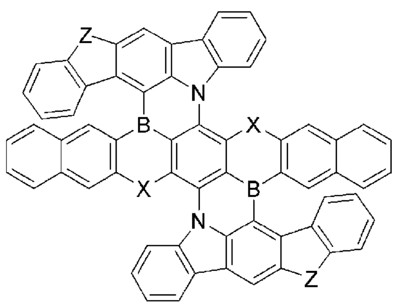
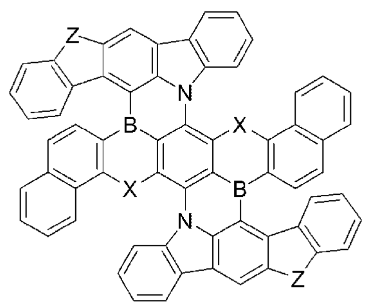

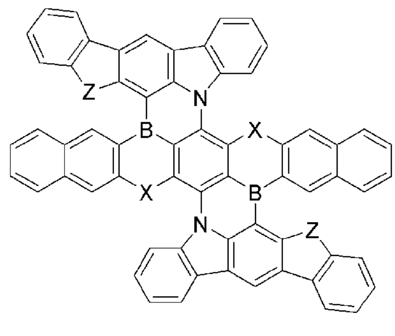
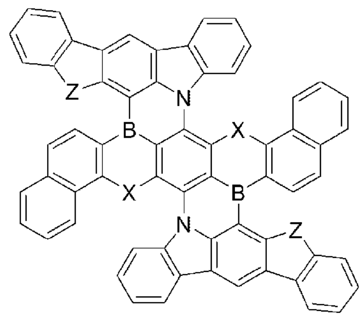

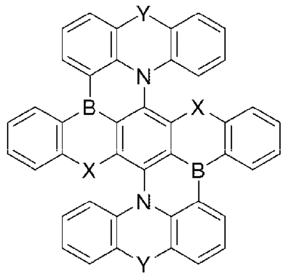
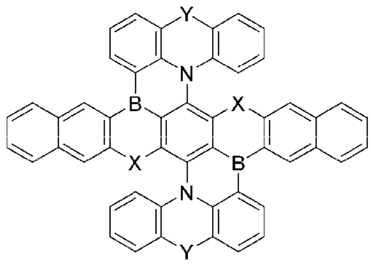
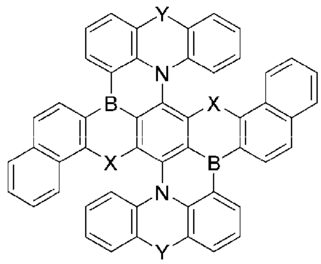
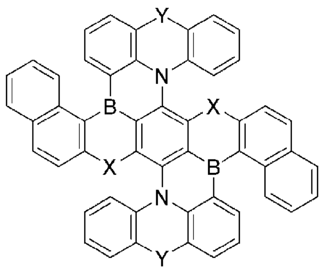
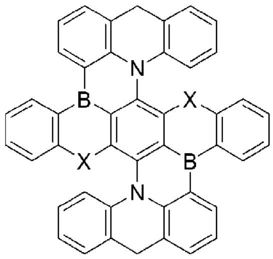
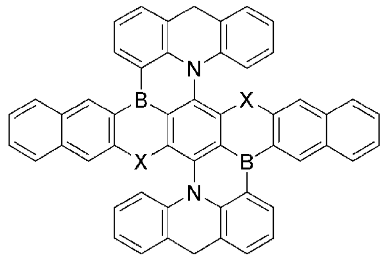
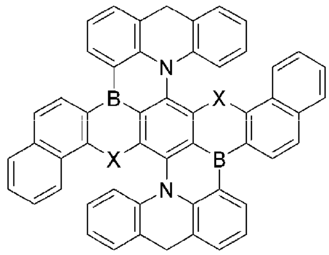
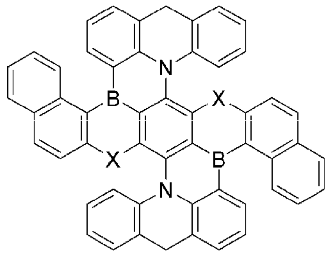

Specific examples of the compound represented by the general formula (1) are shown below. However, the compound represented by the general formula (1) that can be used in the present invention should not be construed as being limited by these specific examples.

In Table 1, $R^2$, $R^3$, $R^6$, $R^9$, $R^{13}$, $R^{14}$, $R^{17}$, and $R^{20}$ in the general formula (1) are specified for each compound to individually show the structures of Compounds 1 to 480.

In Table 2, structures of Compounds 1 to 67200 are shown by collectively displaying $R^2$, $R^3$, $R^6$, $R^9$, $R^{13}$, $R^{14}$, $R^{17}$, and $R^{20}$ of a plurality of compounds in each row. For example, regarding the row of Compounds 1 to 160 in Table 2, those of the general formula (1) where $R^3$ and $R^{14}$ are fixed to a hydrogen atom (H), and $R^2$, $R^6$, $R^9$, $R^{13}$, $R^{17}$, and $R^{20}$ are all any of X1 to X160 are shown as Compounds 1 to 160, respectively. That is, the row of Compounds 1 to 160 in Table 2 collectively represents Compounds 1 to 160 specified in Table 1. Similarly, regarding the row of Compounds 161 to 320 in Table 2, those of the general formula (1) where $R^2$ and $R^{13}$ are fixed to a hydrogen atom (H), and $R^3$, $R^6$, $R^9$, $R^{14}$, $R^{17}$, and $R^{20}$ are all any of X1 to X160 are shown as Compounds 161 to 320, respectively. In the same manner, the structures of Compounds 321 to 67200 in Table 2 are also specified. In Table 2, the expression "-" in the column of Y means that Y is a single bond. NPh in the column of Z represents a nitrogen atom to which a phenyl group bonds.

The structures of X1 to X160 are shown after Table 2.

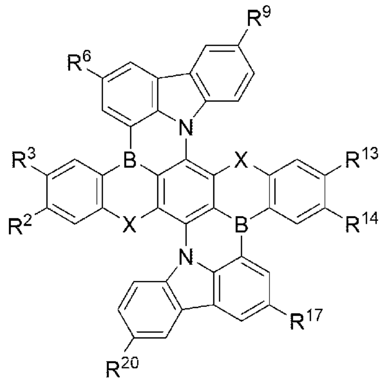

( I )

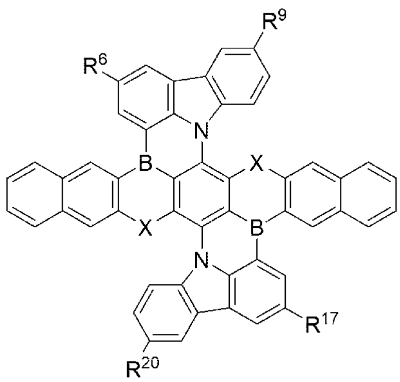

( I I )

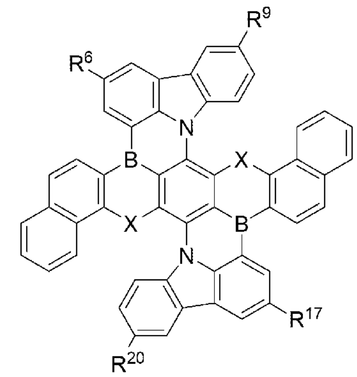

( I I I )

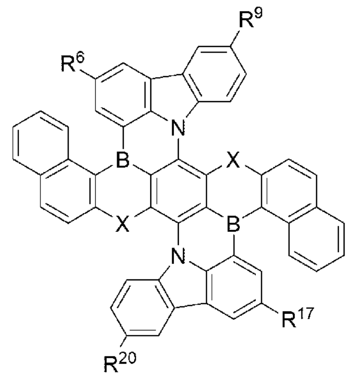

( I V )

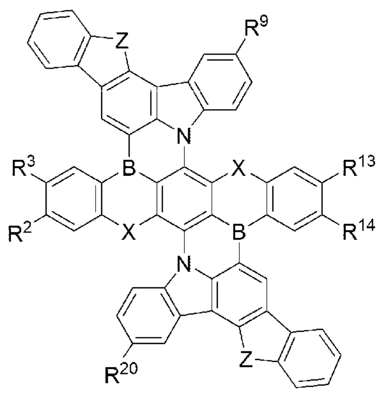

( V )

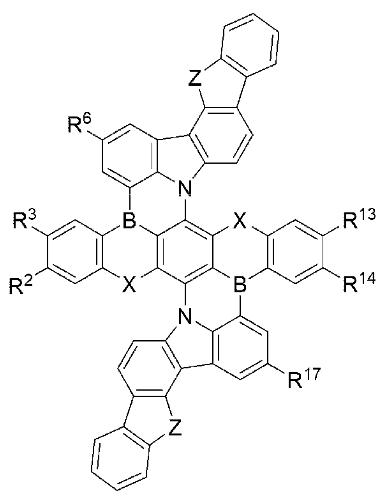

( V I )

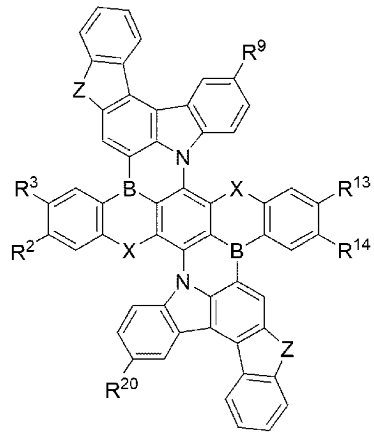

(VII)

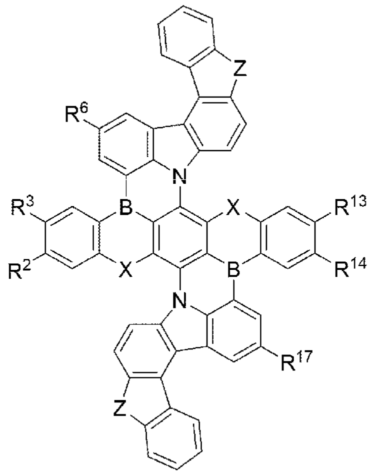

(VIII)

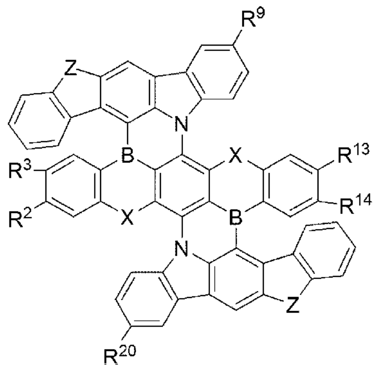

(IX)

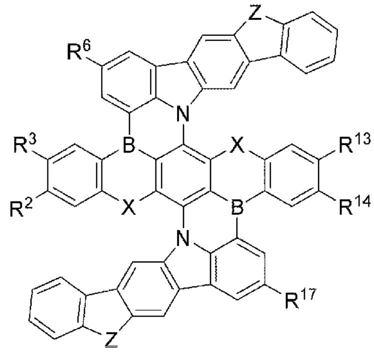

(X)

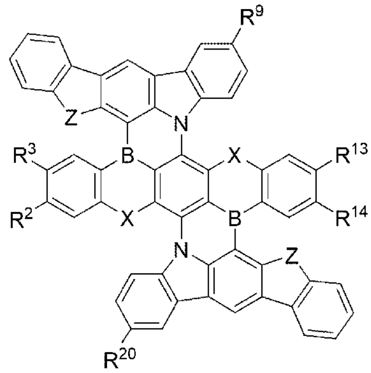

(XI)

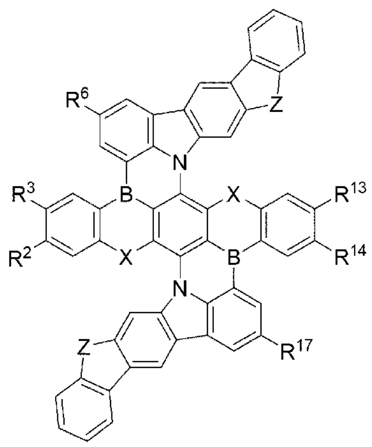

(XII)

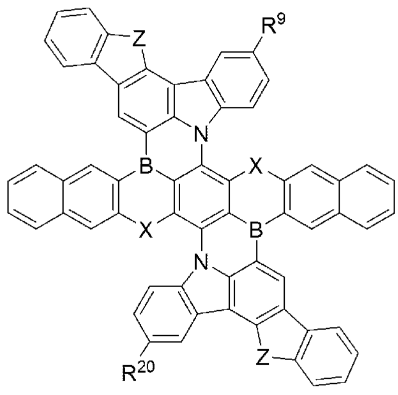

(XIII)

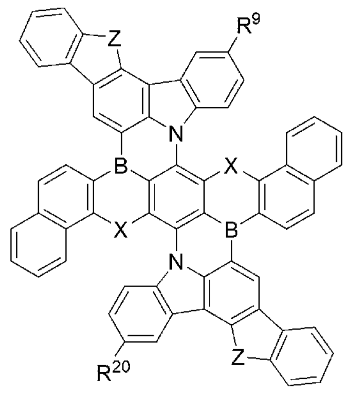

(XIV)

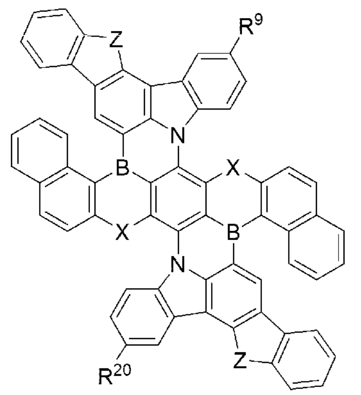

(XV)

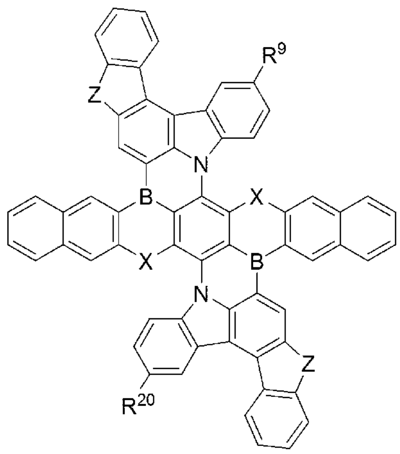

(XVI)

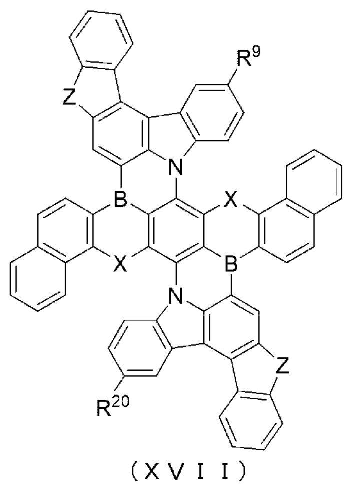

(XVII)

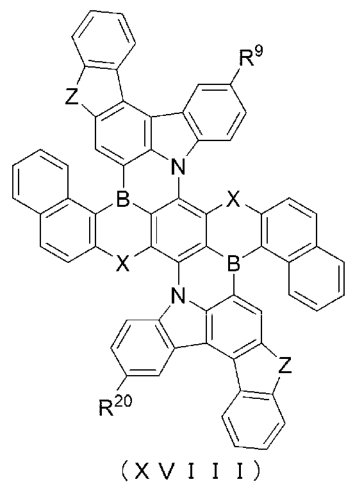

(XVIII)

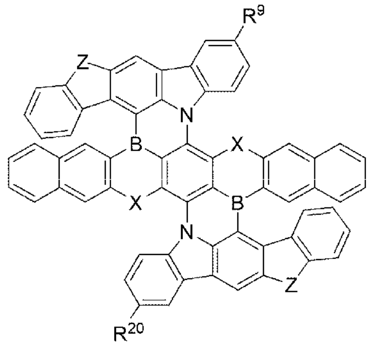

(XIX)

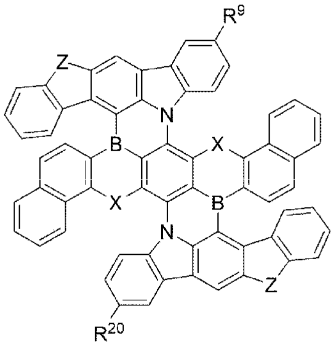

(XX)

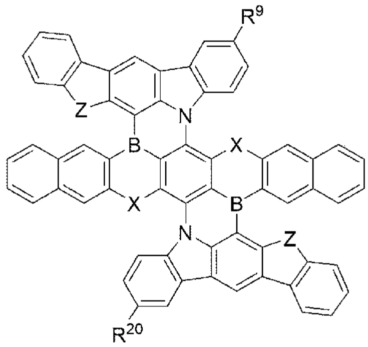

(XXI)

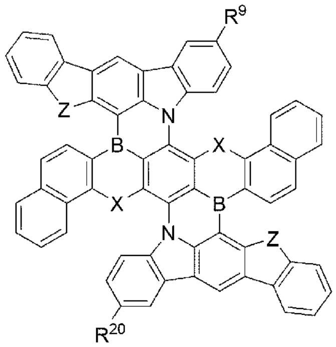

(XXII)

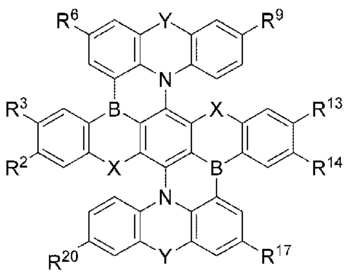

(XXIII)

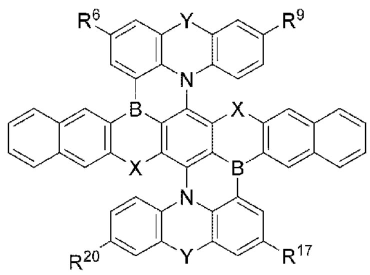

(XXIV)

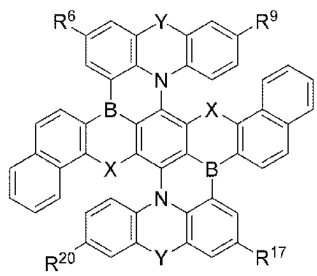

(XXV)

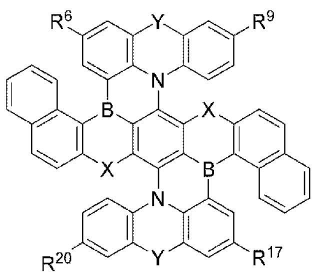

(XXVI)

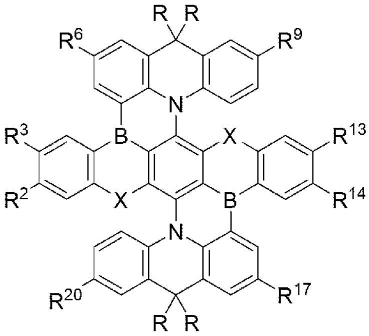

(XXVII)

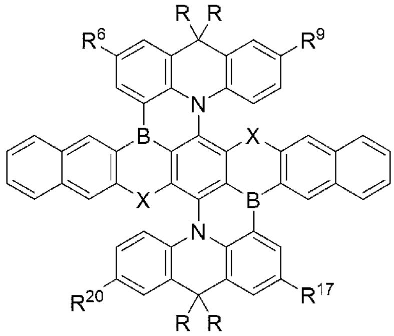

(XXVIII)

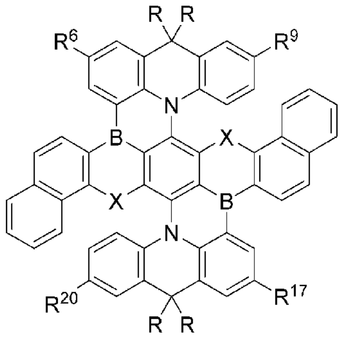

(XXIX)

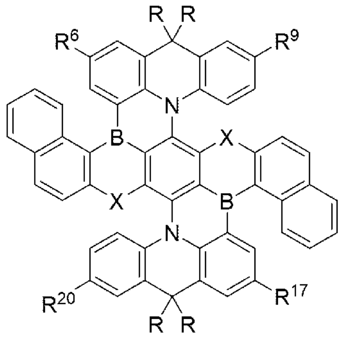

(XXX)

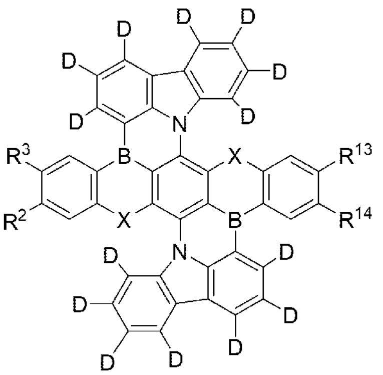

(XXXI)

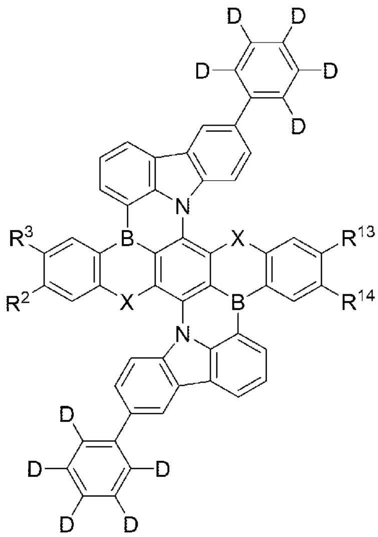

(XXXII)

[Table 1-1]

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 1 | I | X1 | H | X1 | X1 | X1 | H | X1 | X1 |
| 2 | I | X2 | H | X2 | X2 | X2 | H | X2 | X2 |
| 3 | I | X3 | H | X3 | X3 | X3 | H | X3 | X3 |
| 4 | I | X4 | H | X4 | X4 | X4 | H | X4 | X4 |
| 5 | I | X5 | H | X5 | X5 | X5 | H | X5 | X5 |
| 6 | I | X6 | H | X6 | X6 | X6 | H | X6 | X6 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 7 | I | X7 | H | X7 | X7 | X7 | H | X7 | X7 |
| 8 | I | X8 | H | X8 | X8 | X8 | H | X8 | X8 |
| 9 | I | X9 | H | X9 | X9 | X9 | H | X9 | X9 |
| 10 | I | X10 | H | X10 | X10 | X10 | H | X10 | X10 |
| 11 | I | X11 | H | X11 | X11 | X11 | H | X11 | X11 |
| 12 | I | X12 | H | X12 | X12 | X12 | H | X12 | X12 |
| 13 | I | X13 | H | X13 | X13 | X13 | H | X13 | X13 |
| 14 | I | X14 | H | X14 | X14 | X14 | H | X14 | X14 |
| 15 | I | X15 | H | X15 | X15 | X15 | H | X15 | X15 |
| 16 | I | X16 | H | X16 | X16 | X16 | H | X16 | X16 |
| 17 | I | X17 | H | X17 | X17 | X17 | H | X17 | X17 |
| 18 | I | X18 | H | X18 | X18 | X18 | H | X18 | X18 |
| 19 | I | X19 | H | X19 | X19 | X19 | H | X19 | X19 |
| 20 | I | X20 | H | X20 | X20 | X20 | H | X20 | X20 |
| 21 | I | X21 | H | X21 | X21 | X21 | H | X21 | X21 |
| 22 | I | X22 | H | X22 | X22 | X22 | H | X22 | X22 |
| 23 | I | X23 | H | X23 | X23 | X23 | H | X23 | X23 |
| 24 | I | X24 | H | X24 | X24 | X24 | H | X24 | X24 |
| 25 | I | X25 | H | X25 | X25 | X25 | H | X25 | X25 |
| 26 | I | X26 | H | X26 | X26 | X26 | H | X26 | X26 |
| 27 | I | X27 | H | X27 | X27 | X27 | H | X27 | X27 |
| 28 | I | X28 | H | X28 | X28 | X28 | H | X28 | X28 |
| 29 | I | X29 | H | X29 | X29 | X29 | H | X29 | X29 |
| 30 | I | X30 | H | X30 | X30 | X30 | H | X30 | X30 |
| 31 | I | X31 | H | X31 | X31 | X31 | H | X31 | X31 |
| 32 | I | X32 | H | X32 | X32 | X32 | H | X32 | X32 |
| 33 | I | X33 | H | X33 | X33 | X33 | H | X33 | X33 |
| 34 | I | X34 | H | X34 | X34 | X34 | H | X34 | X34 |
| 35 | I | X35 | H | X35 | X35 | X35 | H | X35 | X35 |
| 36 | I | X36 | H | X36 | X36 | X36 | H | X36 | X36 |
| 37 | I | X37 | H | X37 | X37 | X37 | H | X37 | X37 |
| 38 | I | X38 | H | X38 | X38 | X38 | H | X38 | X38 |
| 39 | I | X39 | H | X39 | X39 | X39 | H | X39 | X39 |
| 40 | I | X40 | H | X40 | X40 | X40 | H | X40 | X40 |
| 41 | I | X41 | H | X41 | X41 | X41 | H | X41 | X41 |
| 42 | I | X42 | H | X42 | X42 | X42 | H | X42 | X42 |
| 43 | I | X43 | H | X43 | X43 | X43 | H | X43 | X43 |
| 44 | I | X44 | H | X44 | X44 | X44 | H | X44 | X44 |
| 45 | I | X45 | H | X45 | X45 | X45 | H | X45 | X45 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 46 | I | X46 | H | X46 | X46 | X46 | H | X46 | X46 |
| 47 | I | X47 | H | X47 | X47 | X47 | H | X47 | X47 |
| 48 | I | X48 | H | X48 | X48 | X48 | H | X48 | X48 |
| 49 | I | X49 | H | X49 | X49 | X49 | H | X49 | X49 |
| 50 | I | X50 | H | X50 | X50 | X50 | H | X50 | X50 |
| 51 | I | X51 | H | X51 | X51 | X51 | H | X51 | X51 |
| 52 | I | X52 | H | X52 | X52 | X52 | H | X52 | X52 |
| 53 | I | X53 | H | X53 | X53 | X53 | H | X53 | X53 |
| 54 | I | X54 | H | X54 | X54 | X54 | H | X54 | X54 |
| 55 | I | X55 | H | X55 | X55 | X55 | H | X55 | X55 |
| 56 | I | X56 | H | X56 | X56 | X56 | H | X56 | X56 |
| 57 | I | X57 | H | X57 | X57 | X57 | H | X57 | X57 |
| 58 | I | X58 | H | X58 | X58 | X58 | H | X58 | X58 |
| 59 | I | X59 | H | X59 | X59 | X59 | H | X59 | X59 |
| 60 | I | X60 | H | X60 | X60 | X60 | H | X60 | X60 |
| 61 | I | X61 | H | X61 | X61 | X61 | H | X61 | X61 |
| 62 | I | X62 | H | X62 | X62 | X62 | H | X62 | X62 |
| 63 | I | X63 | H | X63 | X63 | X63 | H | X63 | X63 |
| 64 | I | X64 | H | X64 | X64 | X64 | H | X64 | X64 |
| 65 | I | X65 | H | X65 | X65 | X65 | H | X65 | X65 |
| 66 | I | X66 | H | X66 | X66 | X66 | H | X66 | X66 |
| 67 | I | X67 | H | X67 | X67 | X67 | H | X67 | X67 |
| 68 | I | X68 | H | X68 | X68 | X68 | H | X68 | X68 |
| 69 | I | X69 | H | X69 | X69 | X69 | H | X69 | X69 |
| 70 | I | X70 | H | X70 | X70 | X70 | H | X70 | X70 |
| 71 | I | X71 | H | X71 | X71 | X71 | H | X71 | X71 |
| 72 | I | X72 | H | X72 | X72 | X72 | H | X72 | X72 |
| 73 | I | X73 | H | X73 | X73 | X73 | H | X73 | X73 |
| 74 | I | X74 | H | X74 | X74 | X74 | H | X74 | X74 |
| 75 | I | X75 | H | X75 | X75 | X75 | H | X75 | X75 |
| 76 | I | X76 | H | X76 | X76 | X76 | H | X76 | X76 |
| 77 | I | X77 | H | X77 | X77 | X77 | H | X77 | X77 |
| 78 | I | X78 | H | X78 | X78 | X78 | H | X78 | X78 |
| 79 | I | X79 | H | X79 | X79 | X79 | H | X79 | X79 |
| 80 | I | X80 | H | X80 | X80 | X80 | H | X80 | X80 |
| 81 | I | X81 | H | X81 | X81 | X81 | H | X81 | X81 |
| 82 | I | X82 | H | X82 | X82 | X82 | H | X82 | X82 |
| 83 | I | X83 | H | X83 | X83 | X83 | H | X83 | X83 |
| 84 | I | X84 | H | X84 | X84 | X84 | H | X84 | X84 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 85 | I | X85 | H | X85 | X85 | X85 | H | X85 | X85 |
| 86 | I | X86 | H | X86 | X86 | X86 | H | X86 | X86 |
| 87 | I | X87 | H | X87 | X87 | X87 | H | X87 | X87 |
| 88 | I | X88 | H | X88 | X88 | X88 | H | X88 | X88 |
| 89 | I | X89 | H | X89 | X89 | X89 | H | X89 | X89 |
| 90 | I | X90 | H | X90 | X90 | X90 | H | X90 | X90 |
| 91 | I | X91 | H | X91 | X91 | X91 | H | X91 | X91 |
| 92 | I | X92 | H | X92 | X92 | X92 | H | X92 | X92 |
| 93 | I | X93 | H | X93 | X93 | X93 | H | X93 | X93 |
| 94 | I | X94 | H | X94 | X94 | X94 | H | X94 | X94 |
| 95 | I | X95 | H | X95 | X95 | X95 | H | X95 | X95 |
| 96 | I | X96 | H | X96 | X96 | X96 | H | X96 | X96 |
| 97 | I | X97 | H | X97 | X97 | X97 | H | X97 | X97 |
| 98 | I | X98 | H | X98 | X98 | X98 | H | X98 | X98 |
| 99 | I | X99 | H | X99 | X99 | X99 | H | X99 | X99 |
| 100 | I | X100 | H | X100 | X100 | X100 | H | X100 | X100 |

[Table 1-2]

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 101 | I | X101 | H | X101 | X101 | X101 | H | X101 | X101 |
| 102 | I | X102 | H | X102 | X102 | X102 | H | X102 | X102 |
| 103 | I | X103 | H | X103 | X103 | X103 | H | X103 | X103 |
| 104 | I | X104 | H | X104 | X104 | X104 | H | X104 | X104 |
| 105 | I | X105 | H | X105 | X105 | X105 | H | X105 | X105 |
| 106 | I | X106 | H | X106 | X106 | X106 | H | X106 | X106 |
| 107 | I | X107 | H | X107 | X107 | X107 | H | X107 | X107 |
| 108 | I | X108 | H | X108 | X108 | X108 | H | X108 | X108 |
| 109 | I | X109 | H | X109 | X109 | X109 | H | X109 | X109 |
| 110 | I | X110 | H | X110 | X110 | X110 | H | X110 | X110 |
| 111 | I | X111 | H | X111 | X111 | X111 | H | X111 | X111 |
| 112 | I | X112 | H | X112 | X112 | X112 | H | X112 | X112 |
| 113 | I | X113 | H | X113 | X113 | X113 | H | X113 | X113 |
| 114 | I | X114 | H | X114 | X114 | X114 | H | X114 | X114 |
| 115 | I | X115 | H | X115 | X115 | X115 | H | X115 | X115 |
| 116 | I | X116 | H | X116 | X116 | X116 | H | X116 | X116 |
| 117 | I | X117 | H | X117 | X117 | X117 | H | X117 | X117 |
| 118 | I | X118 | H | X118 | X118 | X118 | H | X118 | X118 |
| 119 | I | X119 | H | X119 | X119 | X119 | H | X119 | X119 |
| 120 | I | X120 | H | X120 | X120 | X120 | H | X120 | X120 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 121 | I | X121 | H | X121 | X121 | X121 | H | X121 | X121 |
| 122 | I | X122 | H | X122 | X122 | X122 | H | X122 | X122 |
| 123 | I | X123 | H | X123 | X123 | X123 | H | X123 | X123 |
| 124 | I | X124 | H | X124 | X124 | X124 | H | X124 | X124 |
| 125 | I | X125 | H | X125 | X125 | X125 | H | X125 | X125 |
| 126 | I | X126 | H | X126 | X126 | X126 | H | X126 | X126 |
| 127 | I | X127 | H | X127 | X127 | X127 | H | X127 | X127 |
| 128 | I | X128 | H | X128 | X128 | X128 | H | X128 | X128 |
| 129 | I | X129 | H | X129 | X129 | X129 | H | X129 | X129 |
| 130 | I | X130 | H | X130 | X130 | X130 | H | X130 | X130 |
| 131 | I | X131 | H | X131 | X131 | X131 | H | X131 | X131 |
| 132 | I | X132 | H | X132 | X132 | X132 | H | X132 | X132 |
| 133 | I | X133 | H | X133 | X133 | X133 | H | X133 | X133 |
| 134 | I | X134 | H | X134 | X134 | X134 | H | X134 | X134 |
| 135 | I | X135 | H | X135 | X135 | X135 | H | X135 | X135 |
| 136 | I | X136 | H | X136 | X136 | X136 | H | X136 | X136 |
| 137 | I | X137 | H | X137 | X137 | X137 | H | X137 | X137 |
| 138 | I | X138 | H | X138 | X138 | X133 | H | X138 | X138 |
| 139 | I | X139 | H | X139 | X139 | X139 | H | X139 | X139 |
| 140 | I | X140 | H | X140 | X140 | X140 | H | X140 | X140 |
| 141 | I | X141 | H | X141 | X141 | X141 | H | X141 | X141 |
| 142 | I | X142 | H | X142 | X142 | X142 | H | X142 | X142 |
| 143 | I | X143 | H | X143 | X143 | X143 | H | X143 | X143 |
| 144 | I | X144 | H | X144 | X144 | X144 | H | X144 | X144 |
| 145 | I | X145 | H | X145 | X145 | X145 | H | X145 | X145 |
| 146 | I | X146 | H | X146 | X146 | X146 | H | X146 | X146 |
| 147 | I | X147 | H | X147 | X147 | X147 | H | X147 | X147 |
| 148 | I | X148 | H | X148 | X148 | X148 | H | X148 | X148 |
| 149 | I | X149 | H | X149 | X149 | X149 | H | X149 | X149 |
| 150 | I | X150 | H | X150 | X150 | X150 | H | X150 | X150 |
| 151 | I | X151 | H | X151 | X151 | X151 | H | X151 | X151 |
| 152 | I | X152 | H | X152 | X152 | X152 | H | X152 | X152 |
| 153 | I | X153 | H | X153 | X153 | X153 | H | X153 | X153 |
| 154 | I | X154 | H | X154 | X154 | X154 | H | X154 | X154 |
| 155 | I | X155 | H | X155 | X155 | X155 | H | X155 | X155 |
| 156 | I | X156 | H | X156 | X156 | X156 | H | X156 | X156 |
| 157 | I | X157 | H | X157 | X157 | X157 | H | X157 | X157 |
| 158 | I | X158 | H | X158 | X158 | X158 | H | X158 | X158 |
| 159 | I | X159 | H | X159 | X159 | X159 | H | X159 | X159 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 160 | I | X160 | H | X160 | X160 | X160 | H | X160 | X160 |
| 161 | I | H | X1 | X1 | X1 | H | X1 | X1 | X1 |
| 162 | I | H | X2 | X2 | X2 | H | X2 | X2 | X2 |
| 163 | I | H | X3 | X3 | X3 | H | X3 | X3 | X3 |
| 164 | I | H | X4 | X4 | X4 | H | X4 | X4 | X4 |
| 165 | I | H | X5 | X5 | X5 | H | X5 | X5 | X5 |
| 166 | I | H | X6 | X6 | X6 | H | X6 | X6 | X6 |
| 167 | I | H | X7 | X7 | X7 | H | X7 | X7 | X7 |
| 168 | I | H | X8 | X8 | X8 | H | X8 | X8 | X8 |
| 169 | I | H | X9 | X9 | X9 | H | X9 | X9 | X9 |
| 170 | I | H | X10 | X10 | X10 | H | X10 | X10 | X10 |
| 171 | I | H | X11 | X11 | X11 | H | X11 | X11 | X11 |
| 172 | I | H | X12 | X12 | X12 | H | X12 | X12 | X12 |
| 173 | I | H | X13 | X13 | X13 | H | X13 | X13 | X13 |
| 174 | I | H | X14 | X14 | X14 | H | X14 | X14 | X14 |
| 175 | I | H | X15 | X15 | X15 | H | X15 | X15 | X15 |
| 176 | I | H | X16 | X16 | X16 | H | X16 | X16 | X16 |
| 177 | I | H | X17 | X17 | X17 | H | X17 | X17 | X17 |
| 178 | I | H | X18 | X18 | X18 | H | X18 | X18 | X18 |
| 179 | I | H | X19 | X19 | X19 | H | X19 | X19 | X19 |
| 180 | I | H | X20 | X20 | X20 | H | X20 | X20 | X20 |
| 181 | I | H | X21 | X21 | X21 | H | X21 | X21 | X21 |
| 182 | I | H | X22 | X22 | X22 | H | X22 | X22 | X22 |
| 183 | I | H | X23 | X23 | X23 | H | X23 | X23 | X23 |
| 184 | I | H | X24 | X24 | X24 | H | X24 | X24 | X24 |
| 185 | I | H | X25 | X25 | X25 | H | X25 | X25 | X25 |
| 186 | I | H | X26 | X26 | X26 | H | X26 | X26 | X26 |
| 187 | I | H | X27 | X27 | X27 | H | X27 | X27 | X27 |
| 188 | I | H | X28 | X28 | X28 | H | X28 | X28 | X28 |
| 189 | I | H | X29 | X29 | X29 | H | X29 | X29 | X29 |
| 190 | I | H | X30 | X30 | X30 | H | X30 | X30 | X30 |
| 191 | I | H | X31 | X31 | X31 | H | X31 | X31 | X31 |
| 192 | I | H | X32 | X32 | X32 | H | X32 | X32 | X32 |
| 193 | I | H | X33 | X33 | X33 | H | X33 | X33 | X33 |
| 194 | I | H | X34 | X34 | X34 | H | X34 | X34 | X34 |
| 195 | I | H | X35 | X35 | X35 | H | X35 | X35 | X35 |
| 196 | I | H | X36 | X36 | X36 | H | X36 | X36 | X36 |
| 197 | I | H | X37 | X37 | X37 | H | X37 | X37 | X37 |
| 198 | I | H | X38 | X38 | X38 | H | X38 | X38 | X38 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 199 | I | H | X39 | X39 | X39 | H | X39 | X39 | X39 |
| 200 | I | H | X40 | X40 | X40 | H | X40 | X40 | X40 |

[Table 1-3]

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 201 | I | H | X41 | X41 | X41 | H | X41 | X41 | X41 |
| 202 | I | H | X42 | X42 | X42 | H | X42 | X42 | X42 |
| 203 | I | H | X43 | X43 | X43 | H | X43 | X43 | X43 |
| 204 | I | H | X44 | X44 | X44 | H | X44 | X44 | X44 |
| 205 | I | H | X45 | X45 | X45 | H | X45 | X45 | X45 |
| 206 | I | H | X46 | X46 | X46 | H | X46 | X46 | X46 |
| 207 | I | H | X47 | X47 | X47 | H | X47 | X47 | X47 |
| 208 | I | H | X48 | X48 | X48 | H | X48 | X48 | X48 |
| 209 | I | H | X49 | X49 | X49 | H | X49 | X49 | X49 |
| 210 | I | H | X50 | X50 | X50 | H | X50 | X50 | X50 |
| 211 | I | H | X51 | X51 | X51 | H | X51 | X51 | X51 |
| 212 | I | H | X52 | X52 | X52 | H | X52 | X52 | X52 |
| 213 | I | H | X53 | X53 | X53 | H | X53 | X53 | X53 |
| 214 | I | H | X54 | X54 | X54 | H | X54 | X54 | X54 |
| 215 | I | H | X55 | X55 | X55 | H | X55 | X55 | X55 |
| 216 | I | H | X56 | X56 | X56 | H | X56 | X56 | X56 |
| 217 | I | H | X57 | X57 | X57 | H | X57 | X57 | X57 |
| 218 | I | H | X58 | X58 | X58 | H | X58 | X58 | X58 |
| 219 | I | H | X59 | X59 | X59 | H | X59 | X59 | X59 |
| 220 | I | H | X60 | X60 | X60 | H | X60 | X60 | X60 |
| 221 | I | H | X61 | X61 | X61 | H | X61 | X61 | X61 |
| 222 | I | H | X62 | X62 | X62 | H | X62 | X62 | X62 |
| 223 | I | H | X63 | X63 | X63 | H | X63 | X63 | X63 |
| 224 | I | H | X64 | X64 | X64 | H | X64 | X64 | X64 |
| 225 | I | H | X65 | X65 | X65 | H | X65 | X65 | X65 |
| 226 | I | H | X66 | X66 | X66 | H | X66 | X66 | X66 |
| 227 | I | H | X67 | X67 | X67 | H | X67 | X67 | X67 |
| 228 | I | H | X68 | X68 | X68 | H | X68 | X68 | X68 |
| 229 | I | H | X69 | X69 | X69 | H | X69 | X69 | X69 |
| 230 | I | H | X70 | X70 | X70 | H | X70 | X70 | X70 |
| 231 | I | H | X71 | X71 | X71 | H | X71 | X71 | X71 |
| 232 | I | H | X72 | X72 | X72 | H | X72 | X72 | X72 |
| 233 | I | H | X73 | X73 | X73 | H | X73 | X73 | X73 |
| 234 | I | H | X74 | X74 | X74 | H | X74 | X74 | X74 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 235 | I | H | X75 | X75 | X75 | H | X75 | X75 | X75 |
| 236 | I | H | X76 | X76 | X76 | H | X76 | X76 | X76 |
| 237 | I | H | X77 | X77 | X77 | H | X77 | X77 | X77 |
| 238 | I | H | X78 | X78 | X78 | H | X78 | X78 | X78 |
| 239 | I | H | X79 | X79 | X79 | H | X79 | X79 | X79 |
| 240 | I | H | X80 | X80 | X80 | H | X80 | X80 | X80 |
| 241 | I | H | X81 | X81 | X81 | H | X81 | X81 | X81 |
| 242 | I | H | X82 | X82 | X82 | H | X82 | X82 | X82 |
| 243 | I | H | X83 | X83 | X83 | H | X83 | X83 | X83 |
| 244 | I | H | X84 | X84 | X84 | H | X84 | X84 | X84 |
| 245 | I | H | X85 | X85 | X85 | H | X85 | X85 | X85 |
| 246 | I | H | X86 | X86 | X86 | H | X86 | X86 | X86 |
| 247 | I | H | X87 | X87 | X87 | H | X87 | X87 | X87 |
| 248 | I | H | X88 | X88 | X88 | H | X88 | X88 | X88 |
| 249 | I | H | X89 | X89 | X89 | H | X89 | X89 | X89 |
| 250 | I | H | X90 | X90 | X90 | H | X90 | X90 | X90 |
| 251 | I | H | X91 | X91 | X91 | H | X91 | X91 | X91 |
| 252 | I | H | X92 | X92 | X92 | H | X92 | X92 | X92 |
| 253 | I | H | X93 | X93 | X93 | H | X93 | X93 | X93 |
| 254 | I | H | X94 | X94 | X94 | H | X94 | X94 | X94 |
| 255 | I | H | X95 | X95 | X95 | H | X95 | X95 | X95 |
| 256 | I | H | X96 | X96 | X96 | H | X96 | X96 | X96 |
| 257 | I | H | X97 | X97 | X97 | H | X97 | X97 | X97 |
| 258 | I | H | X98 | X98 | X98 | H | X98 | X98 | X98 |
| 259 | I | H | X99 | X99 | X99 | H | X99 | X99 | X99 |
| 260 | I | H | X100 | X100 | X100 | H | X100 | X100 | X100 |
| 261 | I | H | X101 | X101 | X101 | H | X101 | X101 | X101 |
| 262 | I | H | X102 | X102 | X102 | H | X102 | X102 | X102 |
| 263 | I | H | X103 | X103 | X103 | H | X103 | X103 | X103 |
| 264 | I | H | X104 | X104 | X104 | H | X104 | X104 | X104 |
| 265 | I | H | X105 | X105 | X105 | H | X105 | X105 | X105 |
| 266 | I | H | X106 | X106 | X106 | H | X106 | X106 | X106 |
| 267 | I | H | X107 | X107 | X107 | H | X107 | X107 | X107 |
| 268 | I | H | X108 | X108 | X108 | H | X108 | X108 | X108 |
| 269 | I | H | X109 | X109 | X109 | H | X109 | X109 | X109 |
| 270 | I | H | X110 | X110 | X110 | H | X110 | X110 | X110 |
| 271 | I | H | X111 | X111 | X111 | H | X111 | X111 | X111 |
| 272 | I | H | X112 | X112 | X112 | H | X112 | X112 | X112 |
| 273 | I | H | X113 | X113 | X113 | H | X113 | X113 | X113 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 274 | I | H | X114 | X114 | X114 | H | X114 | X114 | X114 |
| 275 | I | H | X115 | X115 | X115 | H | X115 | X115 | X115 |
| 276 | I | H | X116 | X116 | X116 | H | X116 | X116 | X116 |
| 277 | I | H | X117 | X117 | X117 | H | X117 | X117 | X117 |
| 278 | I | H | X118 | X118 | X118 | H | X118 | X118 | X118 |
| 279 | I | H | X119 | X119 | X119 | H | X119 | X119 | X119 |
| 280 | I | H | X120 | X120 | X120 | H | X120 | X120 | X120 |
| 281 | I | H | X121 | X121 | X121 | H | X121 | X121 | X121 |
| 282 | I | H | X122 | X122 | X122 | H | X 122 | X122 | X122 |
| 283 | I | H | X123 | X123 | X123 | H | X123 | X123 | X123 |
| 284 | I | H | X124 | X124 | X124 | H | X124 | X124 | X124 |
| 285 | I | H | X125 | X125 | X125 | H | X125 | X125 | X125 |
| 286 | I | H | X126 | X126 | X126 | H | X126 | X126 | X126 |
| 287 | I | H | X127 | X127 | X127 | H | X127 | X127 | X127 |
| 288 | I | H | X128 | X128 | X128 | H | X128 | X128 | X128 |
| 289 | I | H | X129 | X129 | X129 | H | X129 | X129 | X129 |
| 290 | I | H | X130 | X130 | X130 | H | X130 | X130 | X130 |
| 291 | I | H | X131 | X131 | X131 | H | X131 | X131 | X131 |
| 292 | I | H | X132 | X132 | X132 | H | X132 | X132 | X132 |
| 293 | I | H | X133 | X133 | X133 | H | X133 | X133 | X133 |
| 294 | I | H | X134 | X134 | X134 | H | X134 | X134 | X134 |
| 295 | I | H | X135 | X135 | X135 | H | X135 | X135 | X135 |
| 296 | I | H | X136 | X136 | X136 | H | X136 | X136 | X136 |
| 297 | I | H | X137 | X137 | X137 | H | X137 | X137 | X137 |
| 298 | I | H | X138 | X138 | X138 | H | X138 | X138 | X138 |
| 299 | I | H | X139 | X139 | X139 | H | X139 | X139 | X139 |
| 300 | I | H | X140 | X140 | X140 | H | X140 | X140 | X140 |

[Table 1-4]

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 301 | I | H | X141 | X141 | X141 | H | X141 | X141 | X141 |
| 302 | I | H | X142 | X142 | X142 | H | X142 | X142 | X142 |
| 303 | I | H | X143 | X143 | X143 | H | X143 | X143 | X143 |
| 304 | I | H | X144 | X144 | X144 | H | X144 | X144 | X144 |
| 305 | I | H | X145 | X145 | X145 | H | X145 | X145 | X145 |
| 306 | I | H | X146 | X146 | X146 | H | X146 | X146 | X146 |
| 307 | I | H | X147 | X147 | X147 | H | X147 | X147 | X147 |
| 308 | I | H | X148 | X148 | X148 | H | X148 | X148 | X148 |
| 309 | I | H | X149 | X149 | X149 | H | X149 | X149 | X149 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 310 | I | H | X150 | X150 | X150 | H | X150 | X150 | X150 |
| 311 | I | H | X151 | X151 | X151 | H | X151 | X151 | X151 |
| 312 | I | H | X152 | X152 | X152 | H | X152 | X152 | X152 |
| 313 | I | H | X153 | X153 | X153 | H | X153 | X153 | X153 |
| 314 | I | H | X154 | X154 | X154 | H | X154 | X154 | X154 |
| 315 | I | H | X155 | X155 | X155 | H | X155 | X155 | X155 |
| 316 | I | H | X156 | X156 | X156 | H | X156 | X156 | X156 |
| 317 | I | H | X157 | X157 | X157 | H | X157 | X157 | X157 |
| 318 | I | H | X158 | X158 | X158 | H | X158 | X158 | X158 |
| 319 | I | H | X159 | X159 | X159 | H | X159 | X159 | X159 |
| 320 | I | H | X160 | X160 | X160 | H | X160 | X160 | X160 |
| 321 | I | H | H | X1 | X1 | H | H | X1 | X1 |
| 322 | I | H | H | X2 | X2 | H | H | X2 | X2 |
| 323 | I | H | H | X3 | X3 | H | H | X3 | X3 |
| 324 | I | H | H | X4 | X4 | H | H | X4 | X4 |
| 325 | I | H | H | X5 | X5 | H | H | X5 | X5 |
| 326 | I | H | H | X6 | X6 | H | H | X6 | X6 |
| 327 | I | H | H | X7 | X7 | H | H | X7 | X7 |
| 328 | I | H | H | X8 | X8 | H | H | X8 | X8 |
| 329 | I | H | H | X9 | X9 | H | H | X9 | X9 |
| 330 | I | H | H | X10 | X10 | H | H | X10 | X10 |
| 331 | I | H | H | X11 | X11 | H | H | X11 | X11 |
| 332 | I | H | H | X12 | X12 | H | H | X12 | X12 |
| 333 | I | H | H | X13 | X13 | H | H | X13 | X13 |
| 334 | I | H | H | X14 | X14 | H | H | X14 | X14 |
| 335 | I | H | H | X15 | X15 | H | H | X15 | X15 |
| 336 | I | H | H | X16 | X16 | H | H | X16 | X16 |
| 337 | I | H | H | X17 | X17 | H | H | X17 | X17 |
| 338 | I | H | H | X18 | X18 | H | H | X18 | X18 |
| 339 | I | H | H | X19 | X19 | H | H | X19 | X19 |
| 340 | I | H | H | X20 | X20 | H | H | X20 | X20 |
| 341 | I | H | H | X21 | X21 | H | H | X21 | X21 |
| 342 | I | H | H | X22 | X22 | H | H | X22 | X22 |
| 343 | I | H | H | X23 | X23 | H | H | X23 | X23 |
| 344 | I | H | H | X24 | X24 | H | H | X24 | X24 |
| 345 | I | H | H | X25 | X25 | H | H | X25 | X25 |
| 346 | I | H | H | X26 | X26 | H | H | X26 | X26 |
| 347 | I | H | H | X27 | X27 | H | H | X27 | X27 |
| 348 | I | H | H | X28 | X28 | H | H | X28 | X28 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 349 | I | H | H | X29 | X29 | H | H | X29 | X29 |
| 350 | I | H | H | X30 | X30 | H | H | X30 | X30 |
| 351 | I | H | H | X31 | X31 | H | H | X31 | X31 |
| 352 | I | H | H | X32 | X32 | H | H | X32 | X32 |
| 353 | I | H | H | X33 | X33 | H | H | X33 | X33 |
| 354 | I | H | H | X34 | X34 | H | H | X34 | X34 |
| 355 | I | H | H | X35 | X35 | H | H | X35 | X35 |
| 356 | I | H | H | X36 | X36 | H | H | X36 | X36 |
| 357 | I | H | H | X37 | X37 | H | H | X37 | X37 |
| 358 | I | H | H | X38 | X38 | H | H | X38 | X38 |
| 359 | I | H | H | X39 | X39 | H | H | X39 | X39 |
| 360 | I | H | H | X40 | X40 | H | H | X40 | X40 |
| 361 | I | H | H | X41 | X41 | H | H | X41 | X41 |
| 362 | I | H | H | X42 | X42 | H | H | X42 | X42 |
| 363 | I | H | H | X43 | X43 | H | H | X43 | X43 |
| 364 | I | H | H | X44 | X44 | H | H | X44 | X44 |
| 365 | I | H | H | X45 | X45 | H | H | X45 | X45 |
| 366 | I | H | H | X46 | X46 | H | H | X46 | X46 |
| 367 | I | H | H | X47 | X47 | H | H | X47 | X47 |
| 368 | I | H | H | X48 | X48 | H | H | X48 | X48 |
| 369 | I | H | H | X49 | X49 | H | H | X49 | X49 |
| 370 | I | H | H | X50 | X50 | H | H | X50 | X50 |
| 371 | I | H | H | X51 | X51 | H | H | X51 | X51 |
| 372 | I | H | H | X52 | X52 | H | H | X52 | X52 |
| 373 | I | H | H | X53 | X53 | H | H | X53 | X53 |
| 374 | I | H | H | X54 | X54 | H | H | X54 | X54 |
| 375 | I | H | H | X55 | X55 | H | H | X55 | X55 |
| 376 | I | H | H | X56 | X56 | H | H | X56 | X56 |
| 377 | I | H | H | X57 | X57 | H | H | X57 | X57 |
| 378 | I | H | H | X58 | X58 | H | H | X58 | X58 |
| 379 | I | H | H | X59 | X59 | H | H | X59 | X59 |
| 380 | I | H | H | X60 | X60 | H | H | X60 | X60 |
| 381 | I | H | H | X61 | X61 | H | H | X61 | X61 |
| 382 | I | H | H | X62 | X62 | H | H | X62 | X62 |
| 383 | I | H | H | X63 | X63 | H | H | X63 | X63 |
| 384 | I | H | H | X64 | X64 | H | H | X64 | X64 |
| 385 | I | H | H | X65 | X65 | H | H | X65 | X65 |
| 386 | I | H | H | X66 | X66 | H | H | X66 | X66 |
| 387 | I | H | H | X67 | X67 | H | H | X67 | X67 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 388 | I | H | H | X68 | X68 | H | H | X68 | X68 |
| 389 | I | H | H | X69 | X69 | H | H | X69 | X69 |
| 390 | I | H | H | X70 | X70 | H | H | X70 | X70 |
| 391 | I | H | H | X71 | X71 | H | H | X71 | X71 |
| 392 | I | H | H | X72 | X72 | H | H | X72 | X72 |
| 393 | I | H | H | X73 | X73 | H | H | X73 | X73 |
| 394 | I | H | H | X74 | X74 | H | H | X74 | X74 |
| 395 | I | H | H | X75 | X75 | H | H | X75 | X75 |
| 396 | I | H | H | X76 | X76 | H | H | X76 | X76 |
| 397 | I | H | H | X77 | X77 | H | H | X77 | X77 |
| 398 | I | H | H | X78 | X78 | H | H | X78 | X78 |
| 399 | I | H | H | X79 | X79 | H | H | X79 | X79 |
| 400 | I | H | H | X80 | X80 | H | H | X80 | X80 |

[Table 1-5]

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 401 | I | H | H | X81 | X81 | H | H | X81 | X81 |
| 402 | I | H | H | X82 | X82 | H | H | X82 | X82 |
| 403 | I | H | H | X83 | X83 | H | H | X83 | X83 |
| 404 | I | H | H | X84 | X84 | H | H | X84 | X84 |
| 405 | I | H | H | X85 | X85 | H | H | X85 | X85 |
| 406 | I | H | H | X86 | X86 | H | H | X86 | X86 |
| 407 | I | H | H | X87 | X87 | H | H | X87 | X87 |
| 408 | I | H | H | X88 | X88 | H | H | X88 | X88 |
| 409 | I | H | H | X89 | X89 | H | H | X89 | X89 |
| 410 | I | H | H | X90 | X90 | H | H | X90 | X90 |
| 411 | I | H | H | X91 | X91 | H | H | X91 | X91 |
| 412 | I | H | H | X92 | X92 | H | H | X92 | X92 |
| 413 | I | H | H | X93 | X93 | H | H | X93 | X93 |
| 414 | I | H | H | X94 | X94 | H | H | X94 | X94 |
| 415 | I | H | H | X95 | X95 | H | H | X95 | X95 |
| 416 | I | H | H | X96 | X96 | H | H | X96 | X96 |
| 417 | I | H | H | X97 | X97 | H | H | X97 | X97 |
| 418 | I | H | H | X98 | X98 | H | H | X98 | X98 |
| 419 | I | H | H | X99 | X99 | H | H | X99 | X99 |
| 420 | I | H | H | X100 | X100 | H | H | X100 | X100 |
| 421 | I | H | H | X101 | X101 | H | H | X101 | X101 |
| 422 | I | H | H | X102 | X102 | H | H | X102 | X102 |
| 423 | I | H | H | X103 | X103 | H | H | X103 | X103 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 424 | I | H | H | X104 | X104 | H | H | X104 | X104 |
| 425 | I | H | H | X105 | X105 | H | H | X105 | X105 |
| 426 | I | H | H | X106 | X106 | H | H | X106 | X106 |
| 427 | I | H | H | X107 | X107 | H | H | X107 | X107 |
| 428 | I | H | H | X108 | X108 | H | H | X108 | X108 |
| 429 | I | H | H | X109 | X109 | H | H | X109 | X109 |
| 430 | I | H | H | X110 | X110 | H | H | X110 | X110 |
| 431 | I | H | H | X111 | X111 | H | H | X111 | X111 |
| 432 | I | H | H | X112 | X112 | H | H | X112 | X112 |
| 433 | I | H | H | X113 | X113 | H | H | X113 | X113 |
| 434 | I | H | H | X114 | X114 | H | H | X114 | X114 |
| 435 | I | H | H | X115 | X115 | H | H | X115 | X115 |
| 436 | I | H | H | X116 | X116 | H | H | X116 | X116 |
| 437 | I | H | H | X117 | X117 | H | H | X117 | X117 |
| 438 | I | H | H | X118 | X118 | H | H | X118 | X118 |
| 439 | I | H | H | X119 | X119 | H | H | X119 | X119 |
| 440 | I | H | H | X120 | X120 | H | H | X120 | X120 |
| 441 | I | H | H | X121 | X121 | H | H | X121 | X121 |
| 442 | I | H | H | X122 | X122 | H | H | X122 | X122 |
| 443 | I | H | H | X123 | X123 | H | H | X123 | X123 |
| 444 | I | H | H | X124 | X124 | H | H | X124 | X124 |
| 445 | I | H | H | X125 | X125 | H | H | X125 | X125 |
| 446 | I | H | H | X126 | X126 | H | H | X126 | X126 |
| 447 | I | H | H | X127 | X127 | H | H | X127 | X127 |
| 448 | I | H | H | X128 | X128 | H | H | X128 | X128 |
| 449 | I | H | H | X129 | X129 | H | H | X129 | X129 |
| 450 | I | H | H | X130 | X130 | H | H | X130 | X130 |
| 451 | I | H | H | X131 | X131 | H | H | X131 | X131 |
| 452 | I | H | H | X132 | X132 | H | H | X132 | X132 |
| 453 | I | H | H | X133 | X133 | H | H | X133 | X133 |
| 454 | I | H | H | X134 | X134 | H | H | X134 | X134 |
| 455 | I | H | H | X135 | X135 | H | H | X135 | X135 |
| 456 | I | H | H | X136 | X136 | H | H | X136 | X136 |
| 457 | I | H | H | X137 | X137 | H | H | X137 | X137 |
| 458 | I | H | H | X138 | X138 | H | H | X138 | X138 |
| 459 | I | H | H | X139 | X139 | H | H | X139 | X139 |
| 460 | I | H | H | X140 | X140 | H | H | X140 | X140 |
| 461 | I | H | H | X141 | X141 | H | H | X141 | X141 |
| 462 | I | H | H | X142 | X142 | H | H | X142 | X142 |

(continued)

| No. | ( ) | $R^2$ | $R^3$ | $R^6$ | $R^9$ | $R^{13}$ | $R^{14}$ | $R^{17}$ | $R^{20}$ |
|---|---|---|---|---|---|---|---|---|---|
| 463 | I | H | H | X143 | X143 | H | H | X143 | X143 |
| 464 | I | H | H | X144 | X144 | H | H | X144 | X144 |
| 465 | I | H | H | X145 | X145 | H | H | X145 | X145 |
| 466 | I | H | H | X146 | X146 | H | H | X146 | X146 |
| 467 | I | H | H | X147 | X147 | H | H | X147 | X147 |
| 468 | I | H | H | X148 | X148 | H | H | X148 | X148 |
| 469 | I | H | H | X149 | X149 | H | H | X149 | X149 |
| 470 | I | H | H | X150 | X150 | H | H | X150 | X150 |
| 471 | I | H | H | X151 | X151 | H | H | X151 | X151 |
| 472 | I | H | H | X152 | X152 | H | H | X152 | X152 |
| 473 | I | H | H | X153 | X153 | H | H | X153 | X153 |
| 474 | I | H | H | X154 | X154 | H | H | X154 | X154 |
| 475 | I | H | H | X155 | X155 | H | H | X155 | X155 |
| 476 | I | H | H | X156 | X156 | H | H | X156 | X156 |
| 477 | I | H | H | X157 | X157 | H | H | X157 | X157 |
| 478 | I | H | H | X158 | X158 | H | H | X158 | X158 |
| 479 | I | H | H | X159 | X159 | H | H | X159 | X159 |
| 480 | I | H | H | X160 | X160 | H | H | X160 | X160 |

[Table 2-1]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 1 ~ 160 | (I) | X1~X160 | H | X1~X160 | X1~X160 | X1~X160 | H | X1~X160 | X1~X160 | O | | | |
| 161 ~ 320 | (I) | H | X1~X160 | X1~X160 | X1~X160 | H | X1~X160 | X1~X160 | X1~X160 | O | | | |
| 321 ~ 480 | (I) | H | H | X1~X160 | X1~X160 | H | H | X1~X160 | X1~X160 | O | | | |
| 481 ~ 640 | (I) | X1~X160 | H | X1~X160 | H | X1~X160 | H | X1~X160 | H | O | | | |
| 641 ~ 800 | (I) | X1~X160 | H | X1~X160 | H | X1~X160 | H | H | X1~X160 | O | | | |
| 801 ~ 960 | (I) | X1~X160 | H | H | X1~X160 | X1~X160 | H | X1~X160 | H | O | | | |
| 961 ~ 1120 | (I) | X1~X160 | H | H | X1~X160 | X1~X160 | H | H | X1~X160 | O | | | |
| 1121 ~ 1280 | (I) | H | X1~X160 | X1~X160 | H | H | X1~X160 | X1~X160 | H | O | | | |
| 1281 ~ 1440 | (I) | H | X1~X160 | X1~X160 | H | H | X1~X160 | H | X1~X160 | O | | | |
| 1441 ~ 1600 | (I) | H | X1~X160 | H | X1~X160 | H | X1~X160 | X1~X160 | H | O | | | |
| 1601 ~ 1760 | (I) | H | X1~X160 | H | X1~X160 | H | X1~X160 | H | X1~X160 | O | | | |
| 1761 ~ 1920 | (I) | X1~X160 | H | H | H | X1~X160 | H | H | H | O | | | |
| 1921 ~ 2080 | (I) | H | X1~X160 | H | H | H | X1~X160 | H | H | O | | | |
| 2081 ~ 2240 | (II) | | | X1~X160 | X1~X160 | | | X1~X160 | X1~X160 | O | | | |
| 2241 ~ 2400 | (III) | | | X1~X160 | X1~X160 | | | X1~X160 | X1~X160 | O | | | |
| 2401 ~ 2560 | (IV) | | | X1~X160 | X1~X160 | | | X1~X160 | X1~X160 | O | | | |
| 2561 ~ 2720 | (V) | X1~X160 | H | | X1~X160 | X1~X160 | H | | X1~X160 | O | | O | |
| 2721 ~ 2880 | (V) | H | X1~X160 | | X1~X160 | H | X1~X160 | | X1~X160 | O | | O | |
| 2881 ~ 3040 | (V) | H | H | | X1~X160 | H | H | | X1~X160 | O | | O | |
| 3041 ~ 3200 | (V) | X1~X160 | H | | H | H | X1~X160 | | H | O | | O | |
| 3201 ~ 3360 | (V) | H | X1~X160 | | H | X1~X160 | H | | H | O | | O | |
| 3361 ~ 3520 | (V) | X1~X160 | H | | X1~X160 | X1~X160 | H | | X1~X160 | O | | S | |
| 3521 ~ 3680 | (V) | H | X1~X160 | - | X1~X160 | H | X1~X160 | | X1~X160 | O | | S | |
| 3681 ~ 3840 | (V) | H | H | - | X1~X160 | H | H | | X1~X160 | O | | S | |
| 3841 ~ 4000 | (V) | X1~X160 | H | - | H | H | X1~X160 | | H | O | | S | |
| 4001 ~ 4160 | (V) | H | X1~X160 | | H | X1~X160 | H | | H | O | | S | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 4161 ~ 4320 | (V) | X1~X160 | H | | X1~X160 | X1~X160 | H | | X1~X160 | O | | N-Ph | |
| 4321 ~ 4480 | (V) | H | X1~X160 | | X1~X160 | H | X1~X160 | | X1~X160 | O | | N-Ph | |
| 4481 ~ 4640 | (V) | H | H | | X1~X160 | H | H | | X1~X160 | O | | N-Ph | |
| 4641 ~ 4800 | (V) | X1~X160 | H | | H | H | X1~X160 | | H | O | | N-Ph | |

[Table 2-2]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 4801 ~ 4960 | (V) | H | X1~X160 | | H | X1~X160 | H | | H | O | | N-Ph | |
| 4961 ~ 5120 | (VI) | X1~X160 | H | X1~X160 | | X1~X160 | H | X1~X160 | | O | | O | |
| 5121 ~ 5280 | (VI) | H | X1~X160 | X1~X160 | | H | X1~X160 | X1~X160 | | O | | O | |
| 5281 ~ 5440 | (VI) | H | H | X1~X160 | | H | H | X1~X160 | | O | | O | |
| 5441 ~ 5600 | (VI) | X1~X160 | H | H | | H | X1~X160 | H | | O | | O | |
| 5601 ~ 5760 | (VI) | H | X1~X160 | H | | X1~X160 | H | H | | O | | O | |
| 5761 ~ 5920 | (VI) | X1~X160 | H | X1~X160 | | X1~X160 | H | X1~X160 | | O | | S | |
| 5921 ~ 6080 | (VI) | H | X1~X160 | X1~X160 | | H | X1~X160 | X1~X160 | | O | | S | |
| 6081 ~ 6240 | (VI) | H | H | X1~X160 | | H | H | X1~X160 | | O | | S | |
| 6241 ~ 6400 | (VI) | X1~X160 | H | H | | H | X1~X160 | H | | O | | S | |
| 6401 ~ 6560 | (VI) | H | X1~X160 | H | | X1~X160 | H | H | | O | | S | |
| 6561 ~ 6720 | (VI) | X1~X160 | H | X1~X160 | | X1~X160 | H | X1~X160 | | O | | N-Ph | |
| 6721 ~ 6880 | (VI) | H | X1~X160 | X1~X160 | | H | X1~X160 | X1~X160 | | O | | N-Ph | |
| 6881 ~ 7040 | (VI) | H | H | X1~X160 | | H | H | X1~X160 | | O | | N-Ph | |
| 7041 ~ 7200 | (VI) | X1~X160 | H | H | | H | X1~X160 | H | | O | | N-Ph | |
| 7201 ~ 7360 | (VI) | H | X1~X160 | H | | X1~X160 | H | H | | O | | N-Ph | |
| 7361 ~ 7520 | (VII) | X1~X160 | H | | X1~X160 | X1~X160 | H | | X1~X160 | O | | O | |
| 7521 ~ 7680 | (VII) | H | X1~X160 | | X1~X160 | H | X1~X160 | | X1~X160 | O | | O | |
| 7681 ~ 7840 | (VII) | H | H | | X1~X160 | H | H | | X1~X160 | O | | O | |
| 7841 ~ 8000 | (VII) | X1~X160 | H | | H | H | X1~X160 | | H | O | | O | |
| 8001 ~ 8160 | (VII) | H | X1~X160 | | H | X1~X160 | H | | H | O | | O | |
| 8161 ~ 8320 | (VII) | X1~X160 | H | | X1~X160 | X1~X160 | H | | X1~X160 | O | | S | |
| 8321 ~ 8480 | (VII) | H | X1~X160 | | X1~X160 | H | X1~X160 | | X1~X160 | O | | S | |
| 8481 ~ 8640 | (VII) | H | H | | X1~X160 | H | H | | X1~X160 | O | | S | |
| 8641 ~ 8800 | (VII) | X1~X160 | H | | H | H | X1~X160 | | H | O | | S | |
| 8801 ~ 8960 | (VII) | H | X1~X160 | | H | X1~X160 | H | | H | O | | S | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 8961 ~ 9120 | (VII) | X1~X160 | H | | X1~X160 | X1~X160 | H | | X1~X160 | O | | N-Ph | |
| 9121 ~ 9280 | (VII) | H | X1~X160 | | X1~X160 | H | X1~X160 | | X1~X160 | O | | N-Ph | |
| 9281 ~ 9440 | (VII) | H | H | | X1~X160 | H | H | | X1~X160 | O | | N-Ph | |
| 9441 ~ 9600 | (VII) | X1~X160 | H | | H | H | X1~X160 | | H | O | | N-Ph | |
| 9601 ~ 9760 | (VII) | H | X1~X160 | | H | X1~X160 | H | | H | O | | N-Ph | |

[Table 2-3]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 9761 ~ 9920 | (VIII) | X1~X160 | H | X1~X160 | | X1~X160 | H | X1~X160 | | O | | O | |
| 9921 ~ 10080 | (VIII) | H | X1~X160 | X1~X160 | | H | X1~X160 | X1~X160 | | O | | O | |
| 10081 ~ 10240 | (VIII) | H | H | X1~X160 | | H | H | X1-X160 | | O | | O | |
| 10241 ~ 10400 | (VIII) | X1~X160 | H | H | | H | X1~X160 | H | | O | | O | |
| 10401 ~ 10560 | (VIII) | H | X1~X160 | H | | X1~X160 | H | H | | O | | O | |
| 10561 ~ 10720 | (VIII) | X1~X160 | H | X1~X160 | | X1~X160 | H | X1~X160 | | O | | S | |
| 10721 ~ 10880 | (VIII) | H | X1~X160 | X1~X160 | | H | X1~X160 | X1~X160 | | O | | S | |
| 10881 ~ 11040 | (VIII) | H | H | X1~X160 | | H | H | X1~X160 | | O | | S | |
| 11041 ~ 11200 | (VIII) | X1~X160 | H | H | | H | X1~X160 | H | | O | | S | |
| 11201 ~ 11360 | (VIII) | H | X1~X160 | H | | X1~X160 | H | H | | O | | S | |
| 11361 ~ 11520 | (VIII) | X1~X160 | H | X1~X160 | | X1~X160 | H | X1~X160 | | O | | N-Ph | |
| 11521 ~ 11680 | (VIII) | H | X1~X160 | X1~X160 | | H | X1~X160 | X1~X160 | | O | | N-Ph | |
| 11681 ~ 11840 | (VIII) | H | H | X1~X160 | | H | H | X1~X160 | | O | | N-Ph | |
| 11841 ~ 12000 | (VIII) | X1~X160 | H | H | | H | X1~X180 | H | | O | | N-Ph | |
| 12001 ~ 12160 | (VIII) | H | X1~X160 | H | | X1~X160 | H | H | | O | | N-Ph | |
| 12161 ~ 12320 | (IX) | X1~X160 | H | | X1~X160 | X1~X160 | H | | X1~X160 | O | | O | |
| 12321 ~ 12480 | (IX) | H | X1~X160 | | X1~X160 | H | X1~X160 | | X1~X160 | O | | O | |
| 12481 ~ 12640 | (IX) | H | H | | X1~X160 | H | H | | X1~X160 | O | | O | |
| 12641 ~ 12800 | (IX) | X1~X160 | H | | H | H | X1~X160 | | H | O | | O | |
| 12801 ~ 12960 | (IX) | H | X1~X160 | | H | X1~X160 | H | | H | O | | O | |
| 12961 ~ 13120 | (IX) | X1~X160 | H | | X1~X160 | X1~X160 | H | | X1~X160 | O | | S | |
| 13121 ~ 13280 | (IX) | H | X1~X160 | | X1~X160 | H | X1~X160 | | X1~X160 | O | | S | |
| 13281 ~ 13440 | (IX) | H | H | | X1~X160 | H | H | | X1~X160 | O | | S | |
| 13441 ~ 13600 | (IX) | X1~X160 | H | | H | H | X1~X160 | | H | O | | S | |
| 13601 ~ 13760 | (IX) | H | X1~X160 | | H | X1~X160 | H | | H | O | | S | |
| 13761 ~ 13920 | (IX) | X1~X160 | H | | X1~X160 | X1~X160 | H | | X1~X160 | O | | N-Ph | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 13921 ~ 14080 | (IX) | H | X1~X160 | | X1~X160 | H | X1~X160 | | X1~X160 | O | | N-Ph | |
| 14081 ~ 14240 | (IX) | H | H | | X1~X160 | H | H | | X1~X160 | O | | N-Ph | |
| 14241 ~ 14400 | (IX) | X1~X160 | H | | H | H | X1~X160 | | H | O | | N-Ph | |
| 14401 ~ 14560 | (IX) | H | X1~X160 | | H | X1~X160 | H | | H | O | | N-Ph | |

[Table 2-4]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 14561 ~ 14720 | (X) | X1~X160 | H | X1~X160 | | X1~X160 | H | X1~X160 | | O | | O | |
| 14721 ~ 14880 | (X) | H | X1~X160 | X1~X160 | | H | X1~X160 | X1~X160 | | O | | O | |
| 14881 ~ 15040 | (X) | H | H | X1~X160 | | H | H | X1~X160 | | O | | O | |
| 15041 ~ 15200 | (X) | X1~X160 | H | H | | H | X1~X160 | H | | O | | O | |
| 15201 ~ 15360 | (X) | H | X1~X160 | H | | X1~X160 | H | H | | O | | O | |
| 15361 ~ 15520 | (X) | X1~X160 | H | X1~X160 | | X1~X160 | H | X1~X160 | | O | | S | |
| 15521 ~ 15680 | (X) | H | X1~X160 | X1~X160 | | H | X1~X160 | X1~X160 | | O | | S | |
| 15681 ~ 15840 | (X) | H | H | X1~X160 | | H | H | X1~X160 | | O | | S | |
| 15841 ~ 16000 | (X) | X1~X160 | H | H | | H | X1~X160 | H | | O | | S | |
| 16001 ~ 16160 | (X) | H | X1~X160 | H | | X1~X160 | H | H | | O | | S | |
| 16161 ~ 16320 | (X) | X1~X160 | H | X1~X160 | | X1~X160 | H | X1~X160 | | O | | N-Ph | |
| 16321 ~ 16480 | (X) | H | X1~X160 | X1~X160 | | H | X1~X160 | X1~X160 | | O | | N-Ph | |
| 16481 ~ 16640 | (X) | H | H | X1~X160 | | H | H | X1~X160 | | O | | N-Ph | |
| 16641 ~ 16800 | (X) | X1~X160 | H | H | | H | X1~X160 | H | | O | | N-Ph | |
| 16801 ~ 16960 | (X) | H | X1~X160 | H | | X1~X160 | H | H | | O | | N-Ph | |
| 16961 ~ 17120 | (XI) | X1~X160 | H | | X1~X160 | X1~X160 | H | | X1~X160 | O | | O | |
| 17121 ~ 17280 | (XI) | H | X1~X160 | | X1~X160 | H | X1~X160 | | X1~X160 | O | | O | |
| 17281 ~ 17440 | (XI) | H | H | | X1~X160 | H | H | | X1~X160 | O | | O | |
| 17441 ~ 17600 | (XI) | X1~X160 | H | | H | H | X1~X160 | | H | O | | O | |
| 17601 ~ 17760 | (XI) | H | X1~X160 | | H | X1~X160 | H | | H | O | | O | |
| 17761 ~ 17920 | (XI) | X1~X160 | H | | X1~X160 | X1~X160 | H | | X1~X160 | O | | S | |
| 17921 ~ 18080 | (XI) | H | X1~X160 | | X1~X160 | H | X1~X160 | | X1~X160 | O | | S | |
| 18081 ~ 18240 | (XI) | H | H | | X1~X160 | H | H | | X1~X160 | O | | S | |
| 18241 ~ 18400 | (XI) | X1~X160 | H | | H | H | X1~X160 | | H | O | | S | |
| 18401 ~ 18560 | (XI) | H | X1~X160 | | H | X1~X160 | H | | H | O | | S | |
| 18561 ~ 18720 | (XI) | X1~X160 | H | | X1~X160 | X1~X160 | H | | X1~X160 | O | | N-Ph | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 18721 ~ 18880 | (XI) | H | X1~X160 | | X1~X160 | H | X1~X160 | | X1~X160 | O | | N-Ph | |
| 18881 ~ 19040 | (XI) | H | H | | X1~X160 | H | H | | X1~X160 | O | | N-Ph | |
| 19041 ~ 19200 | (XI) | X1~X160 | H | | H | H | X1~X160 | | H | O | | N-Ph | |
| 19201 ~ 19360 | (XI) | H | X1~X160 | | H | X1~X160 | H | | H | O | | N-Ph | |
| 19361 ~ 19520 | (XII) | X1~X160 | H | X1~X160 | | X1~X160 | H | X1~X160 | | O | | O | |
| 19521 ~ 19680 | (XII) | H | X1~X160 | X1~X160 | | H | X1~X160 | X1~X160 | | O | | O | |

[Table 2-5]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 19681 ~ 19840 | (XII) | H | H | X1~X160 | | H | H | X1~X160 | | O | | O | |
| 19841 ~ 20000 | (XII) | X1~X160 | H | H | | H | X1~X160 | H | | O | | O | |
| 20001 ~ 20160 | (XII) | H | X1~X160 | H | | X1~X160 | H | H | | O | | O | |
| 20161 ~ 20320 | (XII) | X1~X160 | H | X1~X160 | | X1~X160 | H | X1~X160 | | O | | S | |
| 20321 ~ 20480 | (XII) | H | X1~X160 | X1~X160 | | H | X1~X160 | X1~X160 | | O | | S | |
| 20481 ~ 20640 | (XII) | H | H | X1~X160 | | H | H | X1~X160 | | O | | S | |
| 20641 ~ 20800 | (XII) | X1~X160 | H | H | | H | X1~X160 | H | | O | | S | |
| 20801 ~ 20960 | (XII) | H | X1~X160 | H | | X1~X160 | H | H | | O | | S | |
| 20961 ~ 21120 | (XII) | X1~X160 | H | X1~X160 | | X1~X160 | H | X1~X160 | | O | | N-Ph | |
| 21121 ~ 21280 | (XII) | H | X1~X160 | X1~X160 | | H | X1~X160 | X1~X160 | | O | | N-Ph | |
| 21281 ~ 21440 | (XII) | H | H | X1~X160 | | H | H | X1~X160 | | O | | N-Ph | |
| 21441 ~ 21600 | (XII) | X1~X160 | H | H | | H | X1~X160 | H | | O | | N-Ph | |
| 21601 ~ 21760 | (XII) | H | X1~X160 | H | | X1~X160 | H | H | | O | | N-Ph | |
| 21761 ~ 21920 | (XIII) | | | | X1~X160 | | | | X1~X160 | O | | O | |
| 21921 ~ 22080 | (XIII) | | | | X1~X160 | | | | X1~X160 | O | | S | |
| 22081 ~ 22240 | (XIII) | | | | X1~X160 | | | | X1~X160 | O | | N-Ph | |
| 22241 ~ 22400 | (XIV) | | | | X1~X160 | | | | X1~X160 | O | | O | |
| 22401 ~ 22560 | (XIV) | | | | X1~X160 | | | | X1~X160 | O | | S | |
| 22561 ~ 22720 | (XIV) | | | | X1~X160 | | | | X1~X160 | O | | N-Ph | |
| 22721 ~ 22880 | (XV) | | | | X1~X160 | | | | X1~X160 | O | | O | |
| 22881 ~ 23040 | (XV) | | | | X1~X160 | | | | X1~X160 | O | | S | |
| 23041 ~ 23200 | (XV) | | | | X1~X160 | | | | X1~X160 | O | | N-Ph | |
| 23201 ~ 23360 | (XVI) | | | | X1~X160 | | | | X1~X160 | O | | O | |
| 23361 ~ 23520 | (XVI) | | | | X1~X160 | | | | X1~X160 | O | | S | |
| 23521 ~ 23680 | (XVI) | | | | X1~X160 | | | | X1~X160 | O | | N-Ph | |
| 23681 ~ 23840 | (XVII) | | | | X1~X160 | | | | X1~X160 | O | | O | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 23841 ~ 24000 | (XVII) | | | | X1~X160 | | | | X1~X160 | O | | S | |
| 24001 ~ 24160 | (XVII) | | | | X1~X160 | | | | X1~X160 | O | | N-Ph | |
| 24161 ~ 24320 | (XVIII) | | | | X1~X160 | | | | X1~X160 | O | | O | |
| 24321 ~ 24480 | (XVIII) | | | | X1~X160 | | | | X1~X160 | O | | S | |
| 24481 ~ 24640 | (XVIII) | | | | X1~X160 | | | | X1~X160 | O | | N-Ph | |

[Table 2-6]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 24641 ~ 24800 | (XIX) | | | | X1~X160 | | | | X1~X160 | O | | O | |
| 24801 ~ 24960 | (XIX) | | | | X1~X160 | | | | X1~X160 | O | | S | |
| 24961 ~ 25120 | (XIX) | | | | X1~X160 | | | | X1~X160 | O | | N-Ph | |
| 25121 ~ 25280 | (XX) | | | | X1~X160 | | | | X1~X160 | O | | O | |
| 25281 ~ 25440 | (XX) | | | | X1~X160 | | | | X1~X160 | O | | S | |
| 25441 ~ 25600 | (XX) | | | | X1~X160 | | | | X1~X160 | O | | N-Ph | |
| 25601 ~ 25760 | (XXI) | | | | X1~X160 | | | | X1~X160 | O | | O | |
| 25761 ~ 25920 | (XXI) | | | | X1~X160 | | | | X1~X160 | O | | S | |
| 25921 ~ 26080 | (XXI) | | | | X1~X160 | | | | X1~X160 | O | | N-Ph | |
| 26081 ~ 26240 | (XXII) | | | | X1~X160 | | | | X1~X160 | O | | O | |
| 26241 ~ 26400 | (XXII) | | | | X1~X160 | | | | X1~X160 | O | | S | |
| 26401 ~ 26560 | (XXII) | | | | X1~X160 | | | | X1~X160 | O | | N-Ph | |
| 26561 ~ 26720 | (XXIII) | X1~X160 | H | X1~X160 | X1~X160 | X1~X160 | H | X1~X160 | X1~X160 | O | - | | |
| 26721 ~ 26880 | (XXIII) | H | X1~X160 | X1~X160 | X1~X160 | H | X1~X160 | X1~X160 | X1~X160 | O | - | | |
| 26881 ~ 27040 | (XXIII) | H | H | X1~X160 | X1~X160 | H | H | X1~X160 | X1~X160 | O | - | | |
| 27041 ~ 27200 | (XXIII) | X1~X160 | H | H | H | H | X1~X160 | H | H | O | - | | |
| 27201 ~ 27360 | (XXIII) | H | X1~X160 | H | H | X1~X160 | H | H | H | O | - | | |
| 27361 ~ 27520 | (XXIII) | X1~X160 | H | X1~X160 | X1~X160 | X1~X160 | H | X1~X160 | X1~X160 | O | O | | |
| 27521 ~ 27680 | (XXIII) | H | X1~X160 | X1~X160 | X1~X160 | H | X1~X160 | X1~X160 | X1~X160 | O | O | | |
| 27681 ~ 27840 | (XXIII) | H | H | X1~X160 | X1~X160 | H | H | X1~X160 | X1~X160 | O | O | | |
| 27841 ~ 28000 | (XXIII) | X1~X160 | H | H | H | H | X1~X160 | H | H | O | O | | |
| 28001 ~ 28160 | (XXIII) | H | X1~X160 | H | H | X1~X160 | H | H | H | O | O | | |
| 28161 ~ 28320 | (XXIII) | X1~X160 | H | X1~X160 | X1~X160 | X1~X160 | H | X1~X160 | X1~X160 | O | S | | |
| 28321 ~ 28480 | (XXIII) | H | X1~X160 | X1~X160 | X1~X160 | H | X1~X160 | X1~X160 | X1~X160 | O | S | | |
| 28481 ~ 28640 | (XXIII) | H | H | X1~X160 | X1~X160 | H | H | X1~X160 | X1~X160 | O | S | | |
| 28641 ~ 28800 | (XXIII) | X1~X160 | H | H | H | H | X1~X160 | H | H | O | S | | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 28801 ~ 28960 | (XXIII) | H | X1~X160 | H | H | X1~X160 | H | H | H | O | S | | |
| 28961 ~ 29120 | (XXIV) | | | X1~X160 | X1~X160 | | | X1~X160 | X1~X160 | O | - | | |
| 29121 ~ 29280 | (XXIV) | | | X1~X160 | X1~X160 | | | X1~X160 | X1~X160 | O | O | | |
| 29281 ~ 29440 | (XXIV) | | | X1~X160 | X1~X160 | | | X1~X160 | X1~X160 | O | S | | |
| 29441 ~ 29600 | (XXV) | | | X1~X160 | X1~X160 | | | X1~X160 | X1~X160 | O | - | | |

[Table 2-7]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 29601 ~ 29760 | (XXV) | | | X1~X160 | X1~X160 | | | X1~X160 | X1~X160 | O | O | | |
| 29761 ~ 29920 | (XXV) | | | X1~X160 | X1~X160 | | | X1~X160 | X1~X160 | O | S | | |
| 29921 ~ 30080 | (XXVI) | | | X1~X160 | X1~X160 | | | X1~X160 | X1~X160 | O | - | | |
| 30081 ~ 30240 | (XXVI) | | | X1~X160 | X1~X160 | | | X1~X160 | X1~X160 | O | O | | |
| 30241 ~ 30400 | (XXVI) | | | X1~X160 | X1~X160 | | | X1~X160 | X1~X160 | O | S | | |
| 30401 ~ 30560 | (XXVII) | X1~X160 | H | X1~X160 | X1~X160 | X1~X160 | H | X1~X160 | X1~X160 | O | | | X1 |
| 30561 ~ 30720 | (XXVII) | H | X1~X160 | X1~X160 | X1~X160 | H | X1~X160 | X1~X160 | X1~X160 | O | | | X1 |
| 30721 ~ 30880 | (XXVII) | H | H | X1~X160 | X1~X160 | H | H | X1~X160 | X1~X160 | O | | | X1 |
| 30881 ~ 31040 | (XXVII) | X1~X160 | H | H | H | H | X1~X160 | H | H | O | | | X1 |
| 31041 ~ 31200 | (XXVII) | H | X1~X160 | H | H | X1~X160 | H | H | H | O | | | X1 |
| 31201 ~ 31360 | (XXVII) | X1~X160 | H | X1~X160 | X1~X160 | X1~X160 | H | X1~X160 | X1~X160 | O | | | X4 |
| 31361 ~ 31520 | (XXVII) | H | X1~X160 | X1~X160 | X1~X160 | H | X1~X160 | X1~X160 | X1~X160 | O | | | X4 |
| 31521 ~ 31680 | (XXVII) | H | H | X1~X160 | X1~X160 | H | H | X1~X160 | X1~X160 | O | | | X4 |
| 31681 ~ 31840 | (XXVII) | X1~X160 | H | H | H | H | X1~X160 | H | H | O | | | X4 |
| 31841 ~ 32000 | (XXVII) | H | X1~X160 | H | H | X1~X160 | H | H | H | O | | | X4 |
| 32001 ~ 32160 | (XXVIII) | | | X1~X160 | X1~X160 | | | X1~X160 | X1~X160 | O | | | X1 |
| 32161 ~ 32320 | (XXVIII) | | | X1~X160 | X1~X160 | | | X1~X160 | X1~X160 | O | | | X4 |
| 32321 ~ 32480 | (XXIX) | | | X1~X160 | X1~X160 | | | X1~X160 | X1~X160 | O | | | X1 |
| 32481 ~ 32640 | (XXIX) | | | X1~X160 | X1~X160 | | | X1~X160 | X1~X160 | O | | | X4 |
| 32641 ~ 32800 | (XXX) | | | X1~X160 | X1~X160 | | | X1~X160 | X1~X160 | O | | | X1 |
| 32801 ~ 32960 | (XXX) | | | X1~X160 | X1~X160 | | | X1~X160 | X1~X160 | O | | | X4 |
| 32961 ~ 33120 | (XXXI) | X1~X160 | H | | | X1~X160 | H | | | O | | | |
| 33121 ~ 33280 | (XXXI) | H | X1~X160 | | | H | X1~X160 | | | O | | | |
| 33281 ~ 33440 | (XXXII) | X1~X160 | H | | | X1~X160 | H | | | O | | | |
| 33441 ~ 33600 | (XXXII) | H | X1~X160 | | | H | X1~X160 | | | O | | | |
| 33601 ~ 33760 | (I) | X1~X160 | H | X1~X160 | X1~X160 | X1~X160 | H | X1~X160 | X1~X160 | S | | | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 33761 ~ 33920 | (I) | H | X1~X160 | X1~X160 | X1~X160 | H | X1~X160 | X1~X160 | X1~X160 | S | | | |
| 33921 ~ 34080 | (I) | H | H | X1~X160 | X1~X160 | H | H | X1~X160 | X1~X160 | S | | | |
| 34081 ~ 34240 | (I) | X1~X160 | H | X1~X160 | H | X1~X160 | H | X1~X160 | H | S | | | |
| 34241 ~ 34400 | (I) | X1~X160 | H | X1~X160 | H | X1~X160 | H | H | X1~X160 | S | | | |
| 34401 ~ 34560 | (I) | X1~X160 | H | H | X1~X160 | X1~X160 | H | X1~X160 | H | S | | | |

[Table 2-8]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 34561 ~ 34720 | (I) | X1~X160 | H | H | X1~X160 | X1~X160 | H | H | X1~X160 | S | | | |
| 34721 ~ 34880 | (I) | H | X1~X160 | X1~X160 | H | H | X1~X160 | X1~X160 | H | S | | | |
| 34881 ~ 35040 | (I) | H | X1~X160 | X1~X160 | H | H | X1~X160 | H | X1~X160 | S | | | |
| 35041 ~ 35200 | (I) | H | X1~X160 | H | X1~X160 | H | X1~X160 | X1~X160 | H | S | | | |
| 35201 ~ 35360 | (I) | H | X1~X160 | H | X1~X160 | H | X1~X160 | H | X1~X160 | S | | | |
| 35361 ~ 35520 | (I) | X1~X160 | H | H | H | X1~X160 | H | H | H | S | | | |
| 35521 ~ 35680 | (I) | H | X1~X160 | H | H | H | X1~X160 | H | H | S | | | |
| 35681 ~ 35840 | (II) | | | X1~X160 | X1~X160 | | | X1~X160 | X1~X160 | S | | | |
| 35841 ~ 36000 | (III) | | | X1~X160 | X1~X160 | | | X1~X160 | X1~X160 | S | | | |
| 36001 ~ 36160 | (IV) | | | X1~X160 | X1~X160 | | | X1~X160 | X1~X160 | S | | | |
| 36161 ~ 36320 | (V) | X1~X160 | H | | X1~X160 | X1~X160 | H | | X1~X160 | S | | O | |
| 36321 ~ 36480 | (V) | H | X1~X160 | | X1~X160 | H | X1~X160 | | X1~X160 | S | | O | |
| 36481 ~ 36640 | (V) | H | H | | X1~X160 | H | H | | X1~X160 | S | | O | |
| 36641 ~ 36800 | (V) | X1~X160 | H | | H | H | X1~X160 | | H | S | | O | |
| 36801 ~ 36960 | (V) | H | X1~X160 | | H | X1~X160 | H | | H | S | | O | |
| 36961 ~ 37120 | (V) | X1~X160 | H | | X1~X160 | X1~X160 | H | | X1~X160 | S | | S | |
| 37121 ~ 37280 | (V) | H | X1~X160 | | X1~X160 | H | X1~X160 | | X1~X160 | S | | S | |
| 37281 ~ 37440 | (V) | H | H | | X1~X160 | H | H | | X1~X160 | S | | S | |
| 37441 ~ 37600 | (V) | X1~X160 | H | | H | H | X1~X160 | | H | S | | S | |
| 37601 ~ 37760 | (V) | H | X1~X160 | | H | X1~X160 | H | | H | S | | S | |
| 37761 ~ 37920 | (V) | X1~X160 | H | | X1~X160 | X1~X160 | H | | X1~X160 | S | | N-Ph | |
| 37921 ~ 38080 | (V) | H | X1~X160 | | X1~X160 | H | X1~X160 | | X1~X160 | S | | N-Ph | |
| 38081 ~ 38240 | (V) | H | H | | X1~X160 | H | H | | X1~X160 | S | | N-Ph | |
| 38241 ~ 38400 | (V) | X1~X160 | H | | H | H | X1~X160 | | H | S | | N-Ph | |
| 38401 ~ 38560 | (V) | H | X1~X160 | | H | X1~X160 | H | | H | S | | N-Ph | |
| 38561 ~ 38720 | (VI) | X1~X160 | H | X1~X160 | | X1~X160 | H | X1~X160 | | S | | O | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 38721 ~ 38880 | (VI) | H | X1~X160 | X1~X160 | | H | X1~X160 | X1~X160 | | S | | O | |
| 38881 ~ 39040 | (VI) | H | H | X1~X160 | | H | H | X1~X160 | | S | | O | |
| 39041 ~ 39200 | (VI) | X1~X160 | H | H | | H | X1~X160 | H | | S | | O | |
| 39201 ~ 39360 | (VI) | H | X1~X160 | H | | X1~X160 | H | H | | S | | O | |
| 39361 ~ 39520 | (VI) | X1~X160 | H | X1~X160 | | X1~X160 | H | X1~X160 | | S | | S | |

[Table 2-9]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 39521 ~ 39680 | (VI) | H | X1~X160 | X1~X160 | | H | X1~X160 | X1~X160 | | S | | S | |
| 39681 ~ 39840 | (VI) | H | H | X1~X160 | | H | H | X1~X160 | | S | | S | |
| 39841 ~ 40000 | (VI) | X1~X160 | H | H | | H | X1~X160 | H | | S | | S | |
| 40001 ~ 40160 | (VI) | H | X1~X160 | H | | X1~X160 | H | H | | S | | S | |
| 40161 ~ 40320 | (VI) | X1~X160 | H | X1~X160 | | X1~X160 | H | X1~X160 | | S | | N-Ph | |
| 40321 ~ 40480 | (VI) | H | X1~X160 | X1~X160 | | H | X1~X160 | X1~X160 | | S | | N-Ph | |
| 40481 ~ 40640 | (VI) | H | H | X1~X160 | | H | H | X1~X160 | | S | | N-Ph | |
| 40641 ~ 40800 | (VI) | X1~X160 | H | H | | H | X1~X160 | H | | S | | N-Ph | |
| 40801 ~ 40960 | (VI) | H | X1~X160 | H | | X1~X160 | H | H | | S | | N-Ph | |
| 40961 ~ 41120 | (VII) | X1~X160 | H | | X1~X160 | X1~X160 | H | | X1~X160 | S | | O | |
| 41121 ~ 41280 | (VII) | H | X1~X160 | | X1~X160 | H | X1~X160 | | X1~X160 | S | | O | |
| 41281 ~ 41440 | (VII) | H | H | | X1~X160 | H | H | | X1~X160 | S | | O | |
| 41441 ~ 41600 | (VII) | X1~X160 | H | | H | H | X1~X160 | | H | S | | O | |
| 41601 ~ 41760 | (VII) | H | X1~X160 | | H | X1~X160 | H | | H | S | | O | |
| 41761 ~ 41920 | (VII) | X1~X160 | H | | X1~X160 | X1~X160 | H | | X1~X160 | S | | S | |
| 41921 ~ 42080 | (VII) | H | X1~X160 | | X1~X160 | H | X1~X160 | | X1~X160 | S | | S | |
| 42081 ~ 42240 | (VII) | H | H | | X1~X160 | H | H | | X1~X160 | S | | S | |
| 42241 ~ 42400 | (VII) | X1~X160 | H | | H | H | X1~X160 | | H | S | | S | |
| 42401 ~ 42560 | (VII) | H | X1~X160 | | H | X1~X160 | H | | H | S | | S | |
| 42561 ~ 42720 | (VII) | X1~X160 | H | | X1~X160 | X1~X160 | H | | X1~X160 | S | | N-Ph | |
| 42721 ~ 42880 | (VII) | H | X1~X160 | | X1~X160 | H | X1~X160 | | X1~X160 | S | | N-Ph | |
| 42881 ~ 43040 | (VII) | H | H | | X1~X160 | H | H | | X1~X160 | S | | N-Ph | |
| 43041 ~ 43200 | (VII) | X1~X160 | H | | H | H | X1~X160 | | H | S | | N-Ph | |
| 43201 ~ 43360 | (VII) | H | X1~X160 | | H | X1~X160 | H | | H | S | | N-Ph | |
| 43361 ~ 43520 | (VIII) | X1~X160 | H | X1~X160 | | X1~X160 | H | X1~X160 | | S | | O | |
| 43521 ~ 43680 | (VIII) | H | X1~X160 | X1~X160 | | H | X1~X160 | X1~X160 | | S | | O | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 43681 ~ 43840 | (VIII) | H | H | X1~X160 | | H | H | X1~X160 | | S | | O | |
| 43841 ~ 44000 | (VIII) | X1~X160 | H | H | | H | X1~X160 | H | | S | | O | |
| 44001 ~ 44160 | (VIII) | H | X1~X160 | H | | X1~X160 | H | H | | S | | O | |
| 44161 ~ 44320 | (VIII) | X1~X160 | H | X1~X160 | | X1~X160 | H | X1~X160 | | S | | S | |
| 44321 ~ 44480 | (VIII) | H | X1~X160 | X1~X160 | | H | X1~X160 | X1~X160 | | S | | S | |

[Table 2-10]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 44481 ~ 44640 | (VIII) | H | H | X1~X160 | | H | H | X1~X160 | | S | | S | |
| 44641 ~ 44800 | (VIII) | X1~X160 | H | H | | H | X1~X160 | H | | S | | S | |
| 44801 ~ 44960 | (VIII) | H | X1~X160 | H | | X1~X160 | H | H | | S | | S | |
| 44961 ~ 45120 | (VIII) | X1~X160 | H | X1 -X160 | | X1~X160 | H | X1~X160 | | S | | N-Ph | |
| 45121 ~ 45280 | (VIII) | H | X1~X160 | X1~X160 | | H | X1~X160 | X1~X160 | | S | | N-Ph | |
| 45281 ~ 45440 | (VIII) | H | H | X1~X160 | | H | H | X1~X160 | | S | | N-Ph | |
| 45441 ~ 45600 | (VIII) | X1~X160 | H | H | | H | X1~X160 | H | | S | | N-Ph | |
| 45601 ~ 45760 | (VIII) | H | X1~X160 | H | | X1~X160 | H | H | | S | | N-Ph | |
| 45761 ~ 45920 | (IX) | X1~X160 | H | | X1~X160 | X1~X160 | H | | X1~X160 | S | | O | |
| 45921 ~ 46080 | (IX) | H | X1~X160 | | X1~X160 | H | X1~X160 | | X1~X160 | S | | O | |
| 46081 ~ 46240 | (IX) | H | H | | X1~X160 | H | H | | X1~X160 | S | | O | |
| 46241 ~ 46400 | (IX) | X1~X160 | H | | H | H | X1~X160 | | H | S | | O | |
| 46401 ~ 46560 | (IX) | H | X1~X160 | | H | X1~X160 | H | | H | S | | O | |
| 46561 ~ 46720 | (IX) | X1~X160 | H | | X1~X160 | X1~X160 | H | | X1~X160 | S | | S | |
| 46721 ~ 46880 | (IX) | H | X1~X160 | | X1~X160 | H | X1~X160 | | X1~X160 | S | | S | |
| 46881 ~ 47040 | (IX) | H | H | | X1~X160 | H | H | | X1~X160 | S | | S | |
| 47041 ~ 47200 | (IX) | X1~X160 | H | | H | H | X1~X160 | | H | S | | S | |
| 47201 ~ 47360 | (IX) | H | X1~X160 | | H | X1~X160 | H | | H | S | | S | |
| 47361 ~ 47520 | (IX) | X1~X160 | H | | X1~X160 | X1~X160 | H | | X1~X160 | S | | N-Ph | |
| 47521 ~ 47680 | (IX) | H | X1~X160 | | X1~X160 | H | X1~X160 | | X1~X160 | S | | N-Ph | |
| 47681 ~ 47840 | (IX) | H | H | | X1~X160 | H | H | | X1~X160 | S | | N-Ph | |
| 47841 ~ 48000 | (IX) | X1~X160 | H | | H | H | X1~X160 | | H | S | | N-Ph | |
| 48001 ~ 48160 | (IX) | H | X1~X160 | | H | X1~X160 | H | | H | S | | N-Ph | |
| 48161 ~ 48320 | (X) | X1~X160 | H | X1~X160 | | X1~X160 | H | X1~X160 | | S | | O | |
| 48321 ~ 48480 | (X) | H | X1~X160 | X1~X160 | | H | X1~X160 | X1~X160 | | S | | O | |
| 48481 ~ 48640 | (X) | H | H | X1~X160 | | H | H | X1~X160 | | S | | O | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 48641 ~ 48800 | (X) | X1~X160 | H | H | | H | X1~X160 | H | | S | | O | |
| 48801 ~ 48960 | (X) | H | X1~X160 | H | | X1~X160 | H | H | | S | | O | |
| 48961 ~ 49120 | (X) | X1~X160 | H | X1~X160 | | X1~X160 | H | X1~X160 | | S | | S | |
| 49121 ~ 49280 | (X) | H | X1~X160 | X1~X160 | | H | X1~X160 | X1~X160 | | S | | 5 | |
| 49281 ~ 49440 | (X) | H | H | X1~X160 | | H | H | X1~X160 | | S | | S | |

[Table 2-11]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 49441 ~ 49600 | (X) | X1~X160 | H | H | | H | X1~X160 | H | | S | | S | |
| 49601 ~ 49760 | (X) | H | X1~X160 | H | | X1~X160 | H | H | | S | | S | |
| 49761 ~ 49920 | (X) | X1~X160 | H | X1~X160 | | X1~X160 | H | X1~X160 | | S | | N-Ph | |
| 49921 ~ 50080 | (X) | H | X1~X160 | X1~X160 | | H | X1~X160 | X1~X160 | | S | | N-Ph | |
| 50081 ~ 50240 | (X) | H | H | X1~X160 | | H | H | X1~X160 | | S | | N-Ph | |
| 50241 ~ 50400 | (X) | X1~X160 | H | H | | H | X1~X160 | H | | S | | N-Ph | |
| 50401 ~ 50560 | (X) | H | X1~X160 | H | | X1~X160 | H | H | | S | | N-Ph | |
| 50561 ~ 50720 | (XI) | X1~X160 | H | - | X1~X160 | X1~X160 | H | | X1~X160 | S | | O | |
| 50721 ~ 50880 | (XI) | H | X1~X160 | | X1~X160 | H | X1~X160 | | X1~X160 | S | | O | |
| 50881 ~ 51040 | (XI) | H | H | | X1~X160 | H | H | | X1~X160 | S | | O | |
| 51041 ~ 51200 | (XI) | X1~X160 | H | | H | H | X1~X160 | | H | S | | O | |
| 51201 ~ 51360 | (XI) | H | X1~X160 | | H | X1~X160 | H | | H | S | | O | |
| 51361 ~ 51520 | (XI) | X1~X160 | H | | X1~X160 | X1~X160 | H | | X1-X160 | S | | S | |
| 51521 ~ 51680 | (XI) | H | X1~X160 | | X1~X160 | H | X1~X160 | | X1~X160 | S | | S | |
| 51681 ~ 51840 | (XI) | H | H | | X1~X160 | H | H | | X1~X160 | S | | S | |
| 51841 ~ 52000 | (XI) | X1~X160 | H | | H | H | X1~X160 | | H | S | | S | |
| 52001 ~ 52160 | (XI) | H | X1~X160 | | H | X1~X160 | H | | H | S | | S | |
| 52161 ~ 52320 | (XI) | X1~X160 | H | | X1~X160 | X1~X160 | H | | X1~X160 | S | | N-Ph | |
| 52321 ~ 52480 | (XI) | H | X1~X160 | | X1~X160 | H | X1~X160 | | X1~X160 | S | | N-Ph | |
| 52481 ~ 52640 | (XI) | H | H | | X1~X160 | H | H | | X1~X160 | S | | N-Ph | |
| 52641 ~ 52800 | (XI) | X1~X160 | H | | H | H | X1~X160 | | H | S | | N-Ph | |
| 52801 ~ 52960 | (XI) | H | X1~X160 | | H | X1~X160 | H | | H | S | | N-Ph | |
| 52961 ~ 53120 | (XII) | X1~X160 | H | X1~X160 | | X1~X160 | H | X1~X160 | | S | | O | |
| 53121 ~ 53280 | (XII) | H | X1~X160 | X1~X160 | | H | X1~X160 | X1~X160 | | S | | O | |
| 53281 ~ 53440 | (XII) | H | H | X1~X160 | | H | H | X1~X160 | | S | | O | |
| 53441 ~ 53600 | (XII) | X1~X160 | H | H | | H | X1~X160 | H | | S | | O | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 53601 ~ 53760 | (XII) | H | X1~X160 | H | | X1~X160 | H | H | | S | | O | |
| 53761 ~ 53920 | (XII) | X1~X160 | H | X1~X160 | | X1~X160 | H | X1~X160 | | S | | S | |
| 53921 ~ 54080 | (XII) | H | X1~X160 | X1~X160 | | H | X1~X160 | X1~X160 | | S | | S | |
| 54081 ~ 54240 | (XII) | H | H | X1~X160 | | H | H | X1~X160 | | S | | S | |
| 54241 ~ 54400 | (XII) | X1~X160 | H | H | | H | X1~X160 | H | | S | | S | |

[Table 2-12]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 54401 ~ 54560 | (XII) | H | X1~X160 | H | | X1~X160 | H | H | | S | | S | |
| 54561 ~ 54720 | (XII) | X1~X160 | H | X1~X160 | | X1~X160 | H | X1~X160 | | S | | N-Ph | |
| 54721 ~ 54880 | (XII) | H | X1~X160 | X1~X160 | | H | X1~X160 | X1~X160 | | S | | N-Ph | |
| 54881 ~ 55040 | (XII) | H | H | X1~X160 | | H | H | X1~X160 | | s | | N-Ph | |
| 55041 ~ 55200 | (XII) | X1~X160 | H | H | | H | X1~X160 | H | | S | | N-Ph | |
| 55201 ~ 55360 | (XII) | H | X1~X160 | H | | X1~X160 | H | H | | S | | N-Ph | |
| 55361 ~ 55520 | (XIII) | | | | X1~X160 | | | | X1~X160 | S | | O | |
| 55521 ~ 55680 | (XIII) | | | | X1~X160 | | | | X1~X160 | s | | S | |
| 55681 ~ 55840 | (XIII) | | | | X1~X160 | | | | X1~X160 | S | | N-Ph | |
| 55841 ~ 56000 | (XIV) | | | | X1~X160 | | | | X1~X160 | S | | O | |
| 56001 ~ 56160 | (XIV) | | | | X1~X160 | | | | X1~X160 | S | | S | |
| 56161 ~ 56320 | (XIV) | | | | X1~X160 | | | | X1~X160 | S | | N-Ph | |
| 56321 ~ 56480 | (XV) | | | | X1~X160 | | | | X1~X160 | S | | O | |
| 56481 ~ 56640 | (XV) | | | | X1~X160 | | | | X1~X160 | s | | S | |
| 56641 ~ 56800 | (XV) | | | | X1~X160 | | | | X1~X160 | S | | N-Ph | |
| 56801 ~ 56960 | (XVI) | | | | X1~X160 | | | | X1~X160 | S | | O | |
| 56961 ~ 57120 | (XVI) | | | | X1~X160 | | | | X1~X160 | S | | S | |
| 57121 ~ 57280 | (XVI) | | | | X1~X160 | | | | X1~X160 | S | | N-Ph | |
| 57281 ~ 57440 | (XVII) | | | | X1~X160 | | | | X1~X160 | S | | O | |
| 57441 ~ 57600 | (XVII) | | | | X1~X160 | | | | X1~X160 | S | | S | |
| 57601 ~ 57760 | (XVII) | | | | X1~X160 | | | | X1~X160 | S | | N-Ph | |
| 57761 ~ 57920 | (XVIII) | | | | X1~X160 | | | | X1~X160 | S | | O | |
| 57921 ~ 58080 | (XVIII) | | | | X1~X160 | | | | X1~X160 | s | | S | |
| 58081 ~ 58240 | (XVIII) | | | | X1~X160 | | | | X1~X160 | S | | N-Ph | |
| 58241 ~ 58400 | (XIX) | | | | X1~X160 | | | | X1~X160 | S | | O | |
| 58401 ~ 58560 | (XIX) | | | | X1~X160 | | | | X1~X160 | S | | S | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 58561 ~ 58720 | (XIX) | | | | X1~X160 | | | | X1~X160 | S | | N-Ph | |
| 58721 ~ 58880 | (XX) | | | | X1~X160 | | | | X1~X160 | S | | O | |
| 58881 ~ 59040 | (XX) | | | | X1~X160 | | | | X1~X160 | S | | S | |
| 59041 ~ 59200 | (XX) | | | | X1~X160 | | | | X1~X160 | S | | N-Ph | |
| 59201 ~ 59360 | (XXI) | | | | X1~X160 | | | | X1~X160 | S | | O | |

[Table 2-13]

| No. | ( ) | R2 | R3 | R6 | R9 | R13 | R14 | R17 | R20 | X | Y | Z | R |
|---|---|---|---|---|---|---|---|---|---|---|---|---|---|
| 59361 ~ 59520 | (XXI) | | | | X1~X160 | | | | X1~X160 | S | | S | |
| 59521 ~ 59680 | (XXI) | | | | X1~X160 | | | | X1~X160 | S | | N-Ph | |
| 59681 ~ 59840 | (XXII) | | | | X1~X160 | | | | X1~X160 | S | | O | |
| 59841 ~ 60000 | (XXII) | | | | X1~X160 | | | | X1~X160 | S | | S | |
| 60001 ~ 60160 | (XXII) | | | | X1~X160 | | | | X1~X160 | S | | N-Ph | |
| 60161 ~ 60320 | (XXIII) | X1~X160 | H | X1~X160 | X1~X160 | X1~X160 | H | X1~X160 | X1~X160 | S | - | | |
| 60321 ~ 60480 | (XXIII) | H | X1~X160 | X1~X160 | X1~X160 | H | X1~X160 | X1~X160 | X1~X160 | S | - | | |
| 60481 ~ 60640 | (XXIII) | H | H | X1~X160 | X1~X160 | H | H | X1~X160 | X1~X160 | S | - | | |
| 60641 ~ 60800 | (XXIII) | X1~X160 | H | H | H | H | X1~X160 | H | H | S | - | | |
| 60801 ~ 60960 | (XXIII) | H | X1~X160 | H | H | X1~X160 | H | H | H | S | - | | |
| 60961 ~ 61120 | (XXIII) | X1~X160 | H | X1~X160 | X1~X160 | X1~X160 | H | X1~X160 | X1~X160 | S | O | | |
| 61121 ~ 61280 | (XXIII) | H | X1~X160 | X1~X160 | X1~X160 | H | X1~X160 | X1~X160 | X1~X160 | S | O | | |
| 61281 ~ 61440 | (XXIII) | H | H | X1~X160 | X1~X160 | H | H | X1~X160 | X1~X160 | S | O | | |
| 61441 ~ 61600 | (XXIII) | X1~X160 | H | H | H | H | X1~X160 | H | H | S | O | | |
| 61601 ~ 61760 | (XXIII) | H | X1~X160 | H | H | X1~X160 | H | H | H | S | O | | |
| 61761 ~ 61920 | (XXIII) | X1~X160 | H | X1~X160 | X1~X160 | X1~X160 | H | X1~X160 | X1~X160 | S | S | | |
| 61921 ~ 62080 | (XXIII) | H | X1~X160 | X1~X160 | X1~X160 | H | X1~X160 | X1~X160 | X1~X160 | S | S | | |
| 62081 ~ 62240 | (XXIII) | H | H | X1~X160 | X1~X160 | H | H | X1~X160 | X1~X160 | S | S | | |
| 62241 ~ 62400 | (XXIII) | X1~X160 | H | H | H | H | X1~X160 | H | H | S | S | | |
| 62401 ~ 62560 | (XXIII) | H | X1~X160 | H | H | X1~X160 | H | H | H | S | S | | |
| 62561 ~ 62720 | (XXIV) | | | X1~X160 | X1~X160 | | | X1~X160 | X1~X160 | S | - | | |
| 62721 ~ 62880 | (XXIV) | | | X1~X160 | X1~X160 | | | X1~X160 | X1~X160 | S | O | | |
| 62881 ~ 63040 | (XXIV) | | | X1~X160 | X1~X160 | | | X1~X160 | X1~X160 | S | S | | |
| 63041 ~ 63200 | (XXV) | | | X1~X160 | X1~X160 | | | X1~X160 | X1~X160 | S | - | | |
| 63201 ~ 63360 | (XXV) | | | X1~X160 | X1~X160 | | | X1~X160 | X1~X160 | S | O | | |
| 63361 ~ 63520 | (XXV) | | | X1~X160 | X1~X160 | | | X1~X160 | X1~X160 | S | S | | |

(continued)

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 63521 ~ 63680 | (XXVI) | | | X1~X160 | X1~X160 | | | X1~X160 | X1~X160 | s | - | | |
| 63681 ~ 63840 | (XXVI) | | | X1~X160 | X1~X160 | | | X1~X160 | X1~X160 | S | O | | |
| 63841 ~ 64000 | (XXVI) | | | X1~X160 | X1~X160 | | | X1~X160 | X1~X160 | S | S | | |
| 64001 ~ 64160 | (XXVII) | X1~X160 | H | X1~X160 | X1~X160 | X1~X160 | H | X1~X160 | X1~X160 | S | | | X1 |
| 64161 ~ 64320 | (XXVII) | H | X1~X160 | X1~X160 | X1~X160 | H | X1~X160 | X1~X160 | X1~X160 | S | | | X1 |

[Table 2-14]

| No. | ( ) | $R^2$ | $R^3$ | $R^6$ | $R^9$ | $R^{13}$ | $R^{14}$ | $R^{17}$ | $R^{20}$ | X | Y | Z | R |
|---|---|---|---|---|---|---|---|---|---|---|---|---|---|
| 64321 ~ 64480 | (XXVII) | H | H | X1~X160 | X1~X160 | H | H | X1~X160 | X1~X160 | S | | | X1 |
| 64481 ~ 64640 | (XXVII) | X1-X160 | H | H | H | H | X1~X160 | H | H | S | | | X1 |
| 64641 ~ 64800 | (XXVII) | H | X1~X160 | H | H | X1~X160 | H | H | H | s | | | X1 |
| 64801 ~ 64960 | (XXVII) | X1~X160 | H | X1~X160 | X1 ~X160 | X1~X160 | H | X1~X160 | X1~X160 | s | | | X4 |
| 64961 ~ 65120 | (XXVII) | H | X1~X160 | X1-X160 | X1~X160 | H | X1~X160 | X1~X160 | X1~X160 | S | | | X4 |
| 65121 ~ 65280 | (XXVII) | H | H | X1~X160 | X1~X160 | H | H | X1~X160 | X1~X160 | S | | | X4 |
| 65281 ~ 65440 | (XXVII) | X1~X160 | H | H | H | H | X1~X160 | H | H | S | | | X4 |
| 65441 ~ 65600 | (XXVII) | H | X1~X160 | H | H | X1~X160 | H | H | H | S | | | X4 |
| 65601 ~ 65760 | (XXVIII) | | | X1~X160 | X1~X160 | | | X1~X160 | X1~X160 | S | | | X1 |
| 65761 ~ 65920 | (XXVIII) | | | X1~X160 | X1~X160 | | | X1~X160 | X1~X160 | S | | | X4 |
| 65921 ~ 66080 | (XXIX) | | | X1~X160 | X1~X160 | | | X1~X160 | X1~X160 | S | | | X1 |
| 66081 ~ 66240 | (XXIX) | | | X1~X160 | X1~X160 | | | X1~X160 | X1~X160 | S | | | X4 |
| 66241 ~ 66400 | (XXX) | | | X1~X160 | X1~X160 | | | X1~X160 | X1~X160 | S | | | X1 |
| 66401 ~ 66560 | (XXX) | | | X1~X160 | X1~X160 | | | X1~X160 | X1~X160 | S | | | X4 |
| 66561 ~ 66720 | (XXXI) | X1~X160 | H | | | X1~X160 | H | | | S | | | |
| 66721 ~ 66880 | (XXXI) | H | X1~X160 | | | H | X1~X160 | | | S | | | |
| 66881 ~ 67040 | (XXXII) | X1~X160 | H | | | X1~X160 | H | | | S | | | |
| 67041 ~ 67200 | (XXXII) | H | X1~X160 | | | H | X1~X160 | | | S | | | |

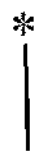
X1
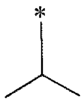
X2
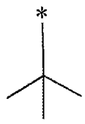
X3
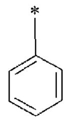
X4
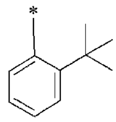
X5
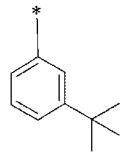
X6
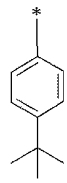
X7

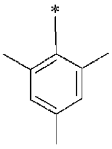
X8
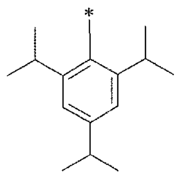
X9
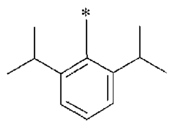
X10
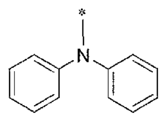
X11
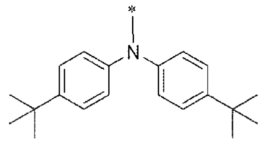
X12

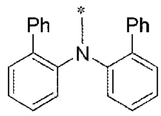
X13
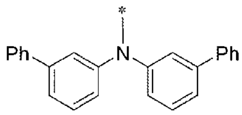
X14
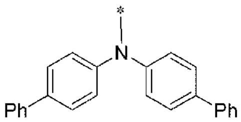
X15
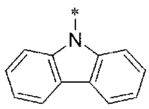
X16
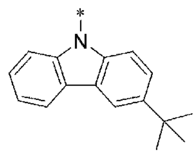
X17

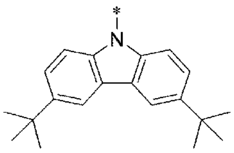
X18
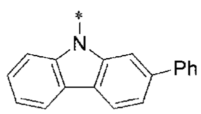
X19
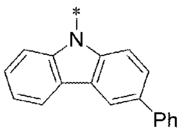
X20
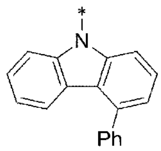
X21
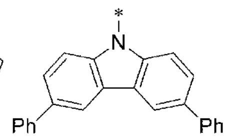
X22

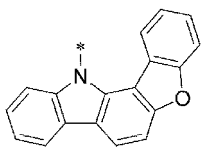
X23
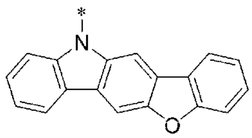
X24
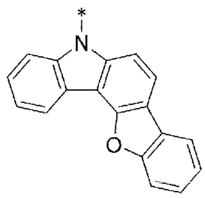
X25
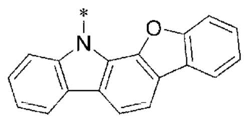
X26

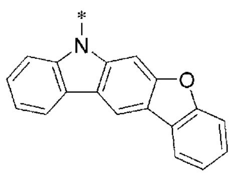
X27
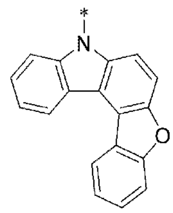
X28
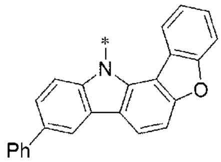
X29
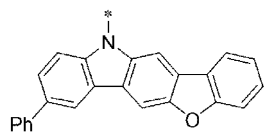
X30

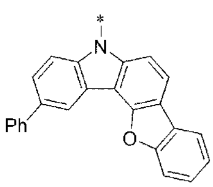
X31
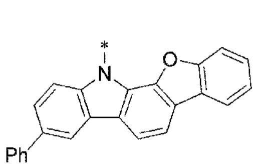
X32
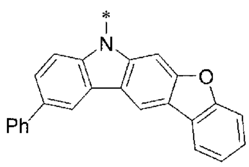
X33
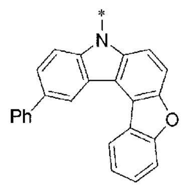
X34

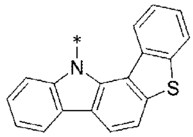
X35

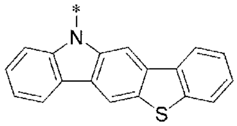
X36

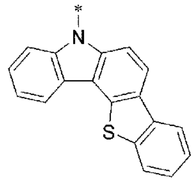
X37

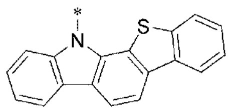
X38

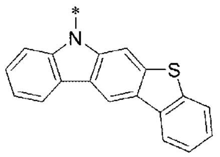
X39

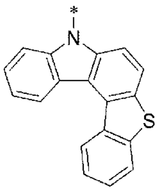
X40

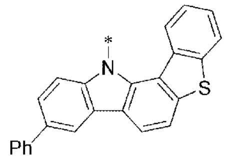
X41

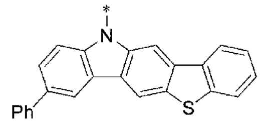
X42

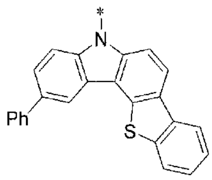
X43

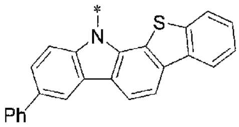
X44

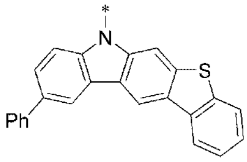
X45

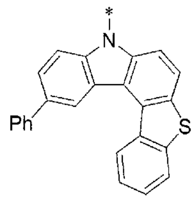
X46

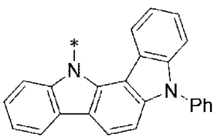
X47

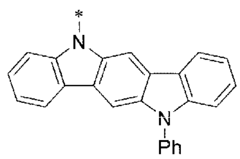
X48

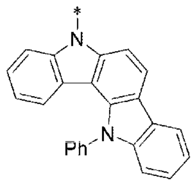
X49

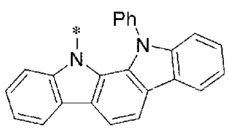
X50

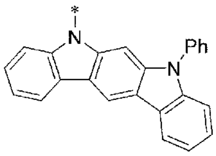
X51

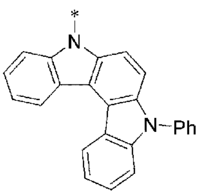
X52

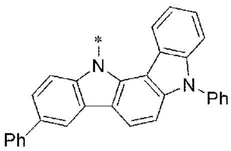
X53

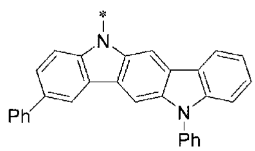
X54

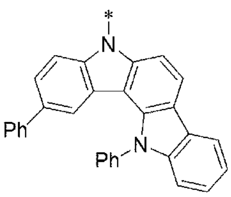
X55

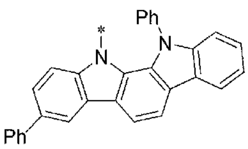
X56

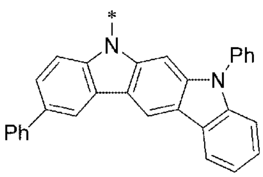
X57

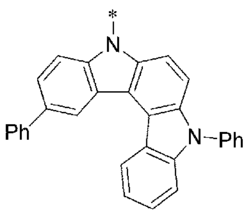
X58

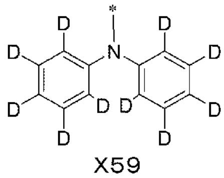
X59

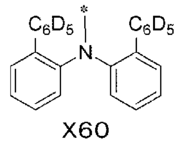
X60

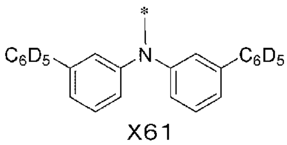
X61

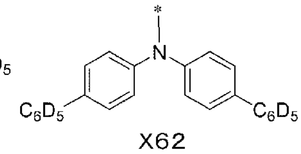
X62

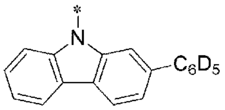
X63

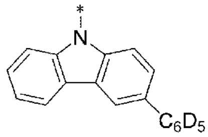
X64

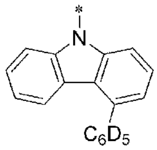
X65

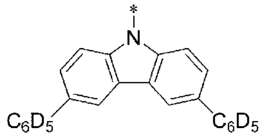
X66

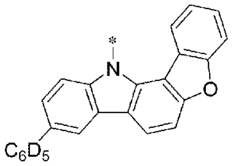
X67

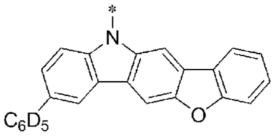
X68

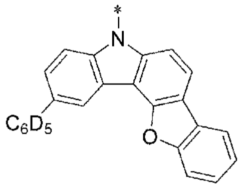
X69

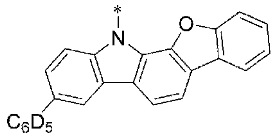
X70

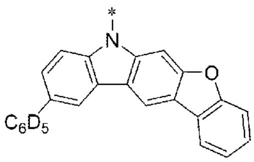
X71

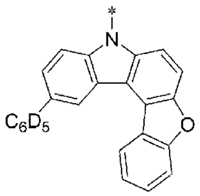
X72

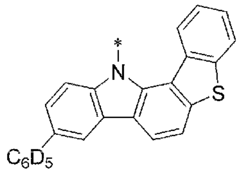
X73

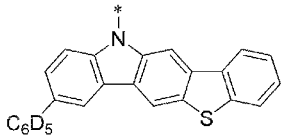
X74

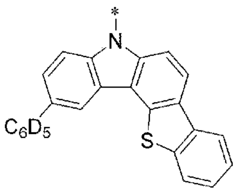
X75

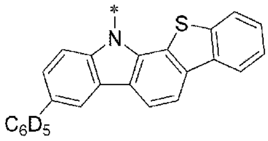
X76

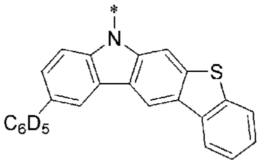
X77

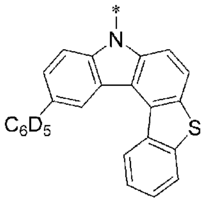
X78

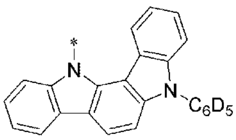
X79

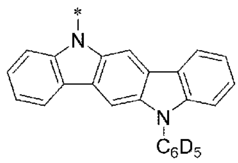
X80

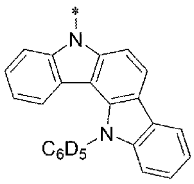
X81

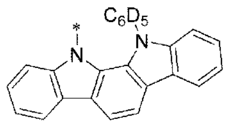
X82

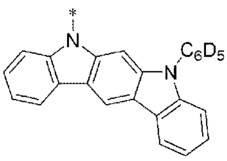
X83

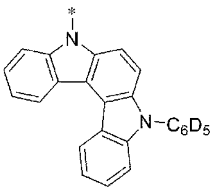
X84

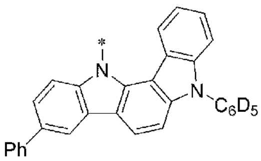
X85

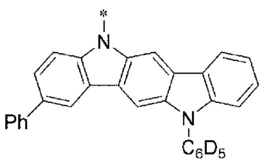
X86

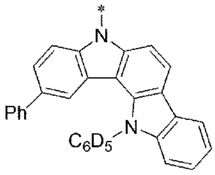
X87

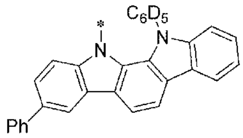
X88

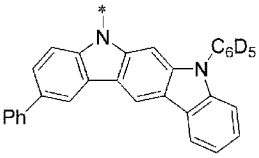
X89

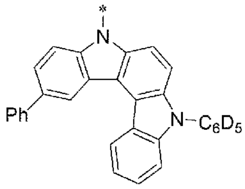
X90

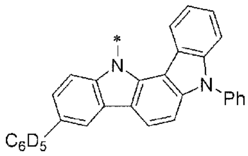
X91

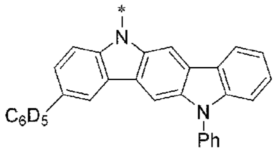
X92

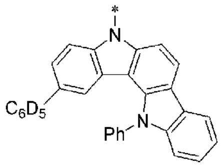
X93

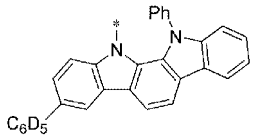
X94

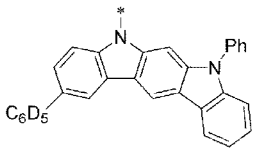
X95

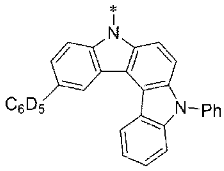
X96

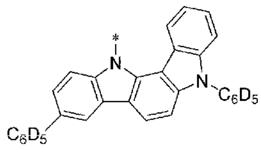
X97

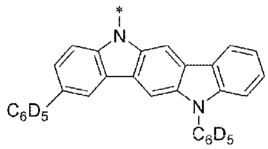
X98

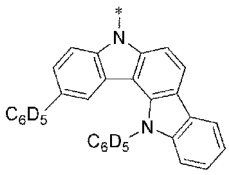
X99

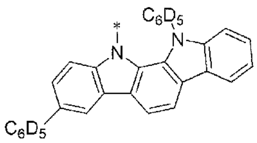
X100

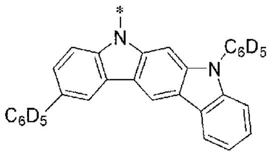
X101

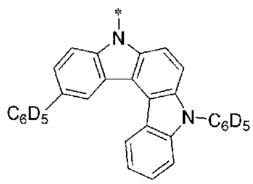
X102

Those produced by substituting all hydrogen atoms existing in X1 to X58 with deuterium atoms are described here as X103 to X160, respectively.

Compounds obtained by substituting all hydrogen atoms existing in the molecules of the above Compounds 1 to 67200 with deuterium atoms are disclosed as Compounds 1(D) to 67200(D).

The compounds specified by the above numbers are all individually disclosed. In addition, among the specific examples of the compounds, in the case where a rotamer is present, a mixture of rotamers and each separated rotamer are also disclosed in the description herein.

In one aspect of the present invention, compounds are selected from Compounds 1 to 67200. In one aspect of the present invention, compounds are selected from Compounds 1(D) to 67200(D).

In one aspect of the present invention, compounds are selected from Compounds 1 to 32641. In one aspect of the present invention, compounds are selected from Compounds 32642 to 67200.

In one aspect of the present invention, compounds are selected from Compounds 1 to 2560. In one aspect of the present invention, compounds are selected from Compounds 2561 to 26560. In one aspect of the present invention, compounds are selected from Compounds 26561 to 30400. In one aspect of the present invention, compounds are selected from Compounds 30401 to 32641. In one aspect of the present invention, compounds are selected from Compounds 32642 to 36160. In one aspect of the present invention, compounds are selected from Compounds 36161 to 60160. In one aspect of the present invention, compounds are selected from Compounds 60161 to 64000. In one aspect of the present invention, compounds are selected from Compounds 64001 to 67200.

In one aspect of the present invention, compounds are selected from Compounds 1 to 2080. In one aspect of the present invention, compounds are selected from Compounds 2081 to 2240. In one aspect of the present invention, compounds are selected from Compounds 2241 to 2400. In one aspect of the present invention, compounds are selected from Compounds 2401 to 2560. In one aspect of the present invention, compounds are selected from Compounds 2561 to 4960. In one aspect of the present invention, compounds are selected from Compounds 4961 to 7360. In one aspect of the present invention, compounds are selected from Compounds 7361 to 9760. In one aspect of the present invention, compounds are selected from Compounds 9761 to 12160. In one aspect of the present invention, compounds are selected from Compounds 12161 to 14560. In one aspect of the present invention, compounds are selected from Compounds 14561 to 16960. In one aspect of the present invention, compounds are selected from Compounds 19961 to 19360. In one aspect of the present invention, compounds are selected from Compounds 19361 to 21760. In one aspect of the present invention, compounds are selected from Compounds 21761 to 22240. In one aspect of the present invention, compounds are selected from Compounds 22241 to 22720. In one aspect of the present invention, compounds are selected from Compounds 22721 to 23200. In one aspect of the present invention, compounds are selected from Compounds 23201 to 23680. In one aspect of the present invention, compounds are selected from Compounds 23681 to 24160. In one aspect of the present invention, compounds are selected from Compounds 24161 to 24640. In one aspect of the present invention, compounds are selected from Compounds 24641 to 25120. In one aspect of the present invention, compounds are

selected from Compounds 25121 to 25600. In one aspect of the present invention, compounds are selected from Compounds 25601 to 26080. In one aspect of the present invention, compounds are selected from Compounds 26081 to 26560. In one aspect of the present invention, compounds are selected from Compounds 26561 to 28960. In one aspect of the present invention, compounds are selected from Compounds 28961 to 29440. In one aspect of the present invention, compounds are selected from Compounds 29441 to 29920. In one aspect of the present invention, compounds are selected from Compounds 29921 to 30400. In one aspect of the present invention, compounds are selected from Compounds 30401 to 32000. In one aspect of the present invention, compounds are selected from Compounds 32001 to 32320. In one aspect of the present invention, compounds are selected from Compounds 32321 to 32640. In one aspect of the present invention, compounds are selected from Compounds 32641 to 32960. In one aspect of the present invention, compounds are selected from Compounds 32961 to 33280. In one aspect of the present invention, compounds are selected from Compounds 33281 to 33600.

In one aspect of the present invention, compounds are selected from Compounds 33601 to 35680. In one aspect of the present invention, compounds are selected from Compounds 35681 to 35840. In one aspect of the present invention, compounds are selected from Compounds 35841 to 36000. In one aspect of the present invention, compounds are selected from Compounds 36001 to 36160. In one aspect of the present invention, compounds are selected from Compounds 36161 to 38560. In one aspect of the present invention, compounds are selected from Compounds 38561 to 40960. In one aspect of the present invention, compounds are selected from Compounds 40961 to 43360. In one aspect of the present invention, compounds are selected from Compounds 43361 to 45760. In one aspect of the present invention, compounds are selected from Compounds 45761 to 48160. In one aspect of the present invention, compounds are selected from Compounds 48161 to 50560. In one aspect of the present invention, compounds are selected from Compounds 50561 to 52960. In one aspect of the present invention, compounds are selected from Compounds 52961 to 55360. In one aspect of the present invention, compounds are selected from Compounds 55361 to 55840. In one aspect of the present invention, compounds are selected from Compounds 55841 to 56320. In one aspect of the present invention, compounds are selected from Compounds 56321 to 56800. In one aspect of the present invention, compounds are selected from Compounds 56801 to 57280. In one aspect of the present invention, compounds are selected from Compounds 57281 to 57760. In one aspect of the present invention, compounds are selected from Compounds 57761 to 58240. In one aspect of the present invention, compounds are selected from Compounds 58241 to 58720. In one aspect of the present invention, compounds are selected from Compounds 58721 to 59200. In one aspect of the present invention, compounds are selected from Compounds 59201 to 59680. In one aspect of the present invention, compounds are selected from Compounds 59681 to 60160. In one aspect of the present invention, compounds are selected from Compounds 60161 to 62560. In one aspect of the present invention, compounds are selected from Compounds 62561 to 63040. In one aspect of the present invention, compounds are selected from Compounds 63041 to 63520. In one aspect of the present invention, compounds are selected from Compounds 63521 to 64000. In one aspect of the present invention, compounds are selected from Compounds 64001 to 65600. In one aspect of the present invention, compounds are selected from Compounds 65601 to 65920. In one aspect of the present invention, compounds are selected from Compounds 65921 to 66240. In one aspect of the present invention, compounds are selected from Compounds 66241 to 66560. In one aspect of the present invention, compounds are selected from Compounds 66561 to 66880. In one aspect of the present invention, compounds are selected from Compounds 66881 to 67200.

In one preferred aspect of the present invention, the compound represented by the general formula (1) is selected from the following group of compounds.

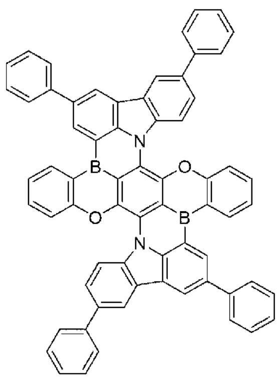
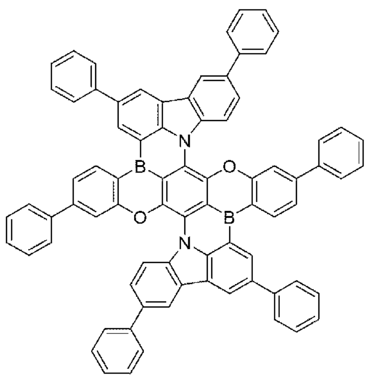
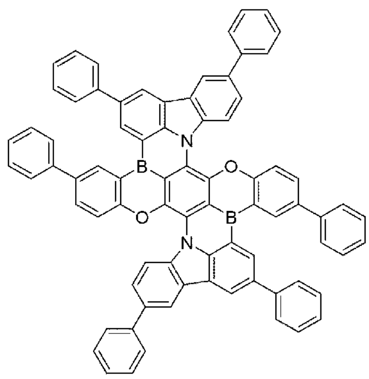

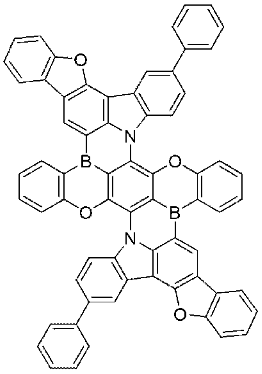
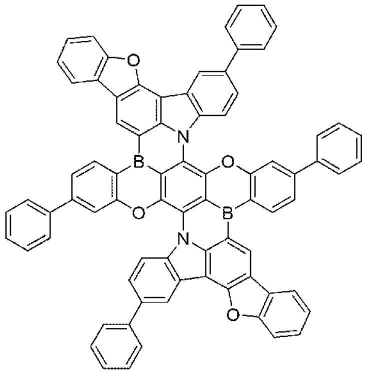
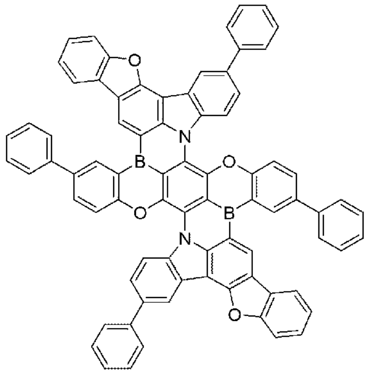

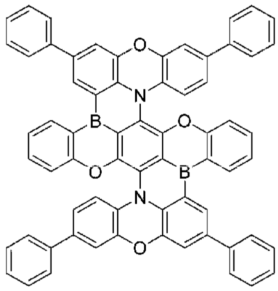
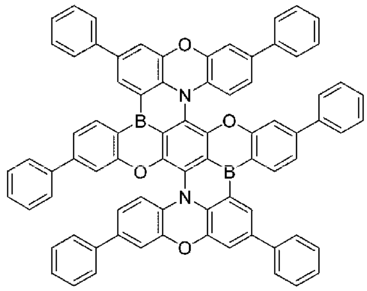
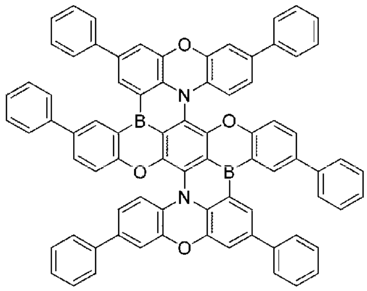

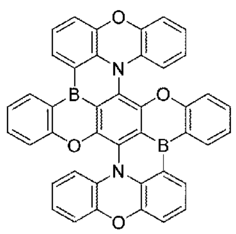
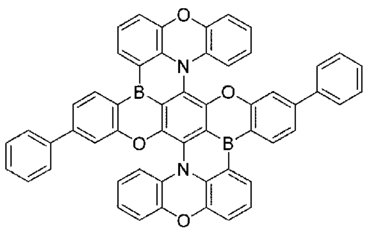
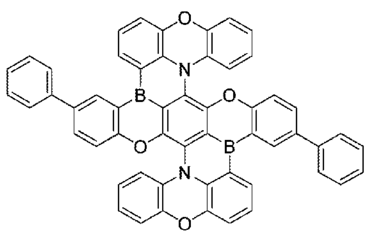

The molecular weight of the compound represented by the general formula (1) is preferably 1500 or less, more preferably 1200 or less, even more preferably 1000 or less, and further more preferably 900 or less, for example, in the case where an organic layer containing the compound represented by the general formula (1) is intended to be film-formed by a vapor deposition method and used. The lower limit of the molecular weight is the molecular weight of the minimum compound represented by the general formula (1).

The compound represented by the general formula (1) can be formed into a film by a coating method regardless of the molecular weight. When the coating method is used, even a compound having a relatively large molecular weight can be formed into a film. The compound represented by the general formula (1) has an advantage of being easily dissolved in an organic solvent. For this reason, the compound represented by the general formula (1) is easily applicable to a coating method and is easily purified to increase its purity.

The compound represented by the general formula (1) includes one having a high orientation. For example, the compound represented by the general formula (1) includes one that when a composition containing the compound is formed into a film, the film exhibits a high orientation. The orientation is evaluated by an orientation value (S value). An orientation value having a larger negative value (having a smaller numerical value) means a higher orientation. The orientation value (S value) can be determined by the method described in Scientific Reports 2017, 7, 8405.

It is also conceivable to use a compound containing a plurality of structures represented by the general formula (1) in a molecule as a light emitting material by applying the present invention.

For example, it is conceivable that a polymer obtained by allowing a polymerizable group to be present in the structure represented by the general formula (1) in advance and polymerizing the polymerizable group is used as the light emitting material. For example, it is conceivable that a polymer having a repeating unit is obtained by preparing a monomer containing a polymerizable functional group at any site of the general formula (1) and polymerizing the monomer alone or copolymerizing the monomer with another monomer, and the polymer is used as the light emitting material. Alternatively, it is also conceivable to obtain a dimer or a trimer by coupling compounds having a structure represented by the general formula (1) to each other and to use the dimer or the trimer as a light emitting material.

Examples of the polymer having a repeating unit containing a structure represented by the general formula (1) include polymers containing a structure represented by any one of the following two general formulae.

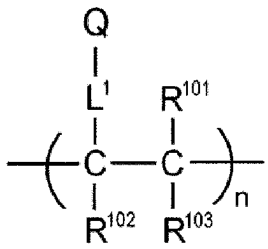

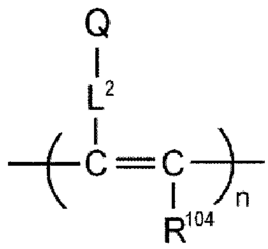

In the above general formulae, Q represents a group containing the structure represented by the general formula (1), and $L^1$ and $L^2$ represent a linking group. The linking group preferably has 0 to 20 carbon atoms, more preferably 1 to 15 carbon atoms, and even more preferably 2 to 10 carbon atoms. The linking group preferably has a structure represented by $-X^{11}-L^{11}-$. Here, $X^{11}$ represents an oxygen atom or a sulfur atom, and is preferably an oxygen atom. $L^{11}$ represents a linking group, and is preferably a substituted or unsubstituted alkylene group or a substituted or unsubstituted arylene group, and more preferably a substituted or unsubstituted alkylene group having 1 to 10 carbon atoms or a substituted or unsubstituted phenylene group.

In the above general formulae, $R^{101}$, $R^{102}$, $R^{103}$ and $R^{104}$ each independently represent a substituent. It is preferably a substituted or unsubstituted alkyl group having 1 to 6 carbon atoms, a substituted or unsubstituted alkoxy group having 1 to 6 carbon atoms, or a halogen atom, more preferably an unsubstituted alkyl group having 1 to 3 carbon atoms, an unsubstituted alkoxy group having 1 to 3 carbon atoms, a fluorine atom, or a chlorine atom, and even more preferably an unsubstituted alkyl group having 1 to 3 carbon atoms or an unsubstituted alkoxy group having 1 to 3 carbon atoms.

The linking group represented by $L^1$ and $L^2$ can bond to any site of the general formula (1) constituting Q. Two or more linking groups can be linked to one Q to form a cross-linked structure or a network structure.

Specific structural examples of the repeating unit include structures represented by the following formulae.

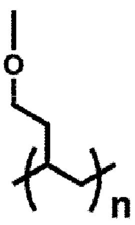

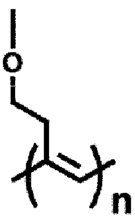

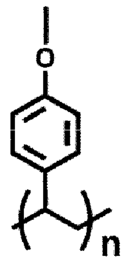

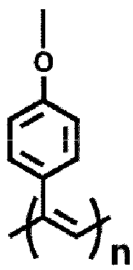

The polymer having a repeating unit including these formulae can be synthesized by introducing a hydroxy group into any site of the general formula (1), reacting the following compound using the hydroxy group as a linker to introduce a polymerizable group, and polymerizing the polymerizable group.

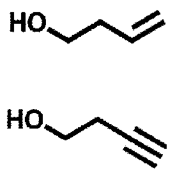

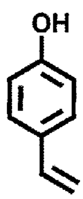

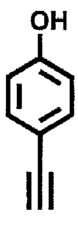

The polymer having a structure represented by the general formula (1) in the molecule can be a polymer having only a repeating unit that has the structure represented by the general formula (1), or can be a polymer containing a repeating unit that has any other structure. The repeating unit having the structure represented by the general formula (1) to be contained in the polymer can be a single kind or two or more kinds. The repeating unit not having the structure represented by the general formula (1) includes those derived from monomers used in general copolymerization. For example, it includes repeating units derived from monomers having an ethylenically unsaturated bond, such as ethylene or styrene.

In some embodiments, the compound represented by the general formula (1) is a light emitting material.

In some embodiments, the compound represented by the general formula (1) is a compound capable of emitting delayed fluorescence. In some embodiments, the compound represented by the general formula (1) is a compound having a narrow full-width at half-maximum.

In some embodiments of the present disclosure, the compound represented by the general formula (1) is, when excited thermally or by an electronic means, able to emit light in a UV region, emit light of blue, green, yellow, orange, or red in a visible spectral region (e.g., about 420 nm to about 500 nm, about 500 nm to about 600 nm, or about 600 nm to about 700 nm) or emit light in a near IR region.

In some embodiments of the present disclosure, the compound represented by the general formula (1) is, when excited thermally or by an electronic means, able to emit light of a red or orange region in a visible spectrum (e.g., about 610 nm to about 780 nm, or about 650 nm).

In some embodiments of the present disclosure, the compound represented by the general formula (1) is, when excited thermally or by an electronic means, able to emit light in an IR spectral region (e.g., 780 nm to 2 μm).

In some embodiments of the present disclosure, an organic semiconductor device using the compound represented by the general formula (1) can be produced. For example, a CMOS (complementary metal-oxide semiconductor) or the like using the compound represented by the general formula (1) can be produced. In some embodiments of the present disclosure, an organic optical device such as an organic electroluminescent device or a solid-state imaging device (for example, a CMOS image sensor) can be produced using the compound represented by the general formula (1).

Electronic characteristics of small-molecule chemical substance libraries can be calculated by known *ab initio* quantum chemistry calculation. For example, according to time-dependent density functional theory calculation using 6-31G* as a basis, and a functional group known as Becke's three parameters, Lee-Yang-Parr hybrid functionals, the Hartree-Fock equation (TD-DFTB3LYP/6-31G*) is analyzed and molecular fractions (parts) having HOMO not lower than a specific threshold value and LUMO not higher than a specific threshold value can be screened.

With that, for example, in the presence of a HOMO energy (for example, ionizing potential) of -6.5 eV or more, a donor part ("D") can be selected. On the other hand, for example, in the presence of a LUMO energy (for example, electron affinity) of -0.5 eV or less, an acceptor part ("A") can be selected. A bridge part ("B") is a strong conjugated system, for example, capable of strictly limiting the acceptor part and the donor part in a specific three-dimensional configuration, and therefore prevents the donor part and the acceptor part from overlapping in the π-conjugated system.

In some embodiments, a compound library is screened using at least one of the following characteristics.

1. Light emission around a specific wavelength
2. A triplet state over a calculated specific energy level
3. $\Delta E_{ST}$ value lower than a specific value
4. Quantum yield more than a specific value
5. HOMO level
6. LUMO level

In some embodiments, the difference ($\Delta E_{ST}$) between the lowest singlet excited state and the lowest triplet excited state at 77 K is less than about 0.5 eV, less than about 0.4 eV, less than about 0.3 eV, less than about 0.2 eV, or less than about 0.1 eV In some embodiments, $\Delta E_{ST}$ value is less than about 0.09 eV, less than about 0.08 eV, less than about 0.07 eV, less than about 0.06 eV, less than about 0.05 eV, less than about 0.04 eV, less than about 0.03 eV, less than about 0.02 eV, or less than about 0.01 eV

In some embodiments, the compound represented by the general formula (1) shows a quantum yield of more than 25%, for example, about 30%, about 35%, about 40%, about 45%, about 50%, about 55%, about 60%, about 65%, about 70%, about 75%, about 80%, about 85%, about 90%, about 95% or more.

[Method for Synthesizing Compound Represented by General Formula (1)]

The compound represented by the general formula (1) includes a novel compound.

The compound represented by the general formula (1) can be synthesized by combining known reactions. For example, the compound can be synthesized by utilizing ring closure reaction or by utilizing substitution reaction. In the case of utilizing ring closure reaction, for example, as in the following reaction formula, a chloride is prepared, then reacted with t-butyl lithium, and thereafter boron tribromide is added and an amine is added for cyclization to synthesize the compound. For details of the reaction conditions, Synthesis Examples described later can be referred to. The compound represented by the general formula (1) is easier to synthesize than any other compound having a similar skeleton and expressing a multiple resonance effect.

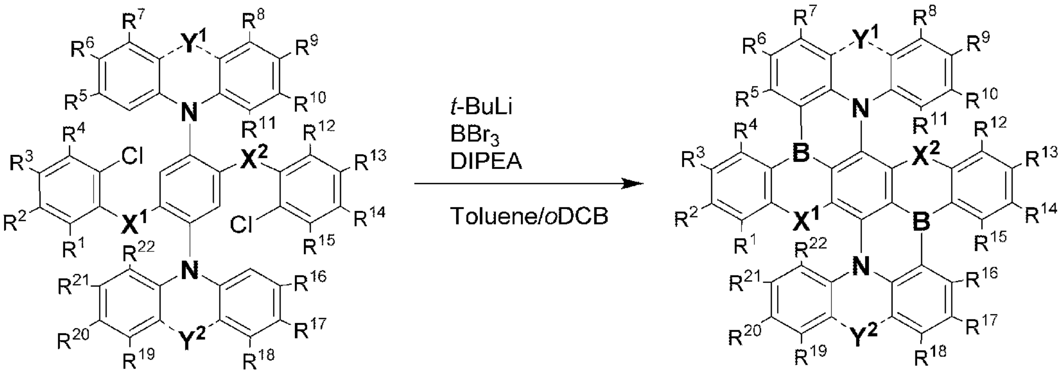


[Structure Using Compound Represented by General Formula (1)]

In some embodiments, the compound represented by the general formula (1) is used along with one or more materials (e.g., small molecules, polymers, metals, metal complexes), by combining them, or by dispersing the compound, or by covalent-bonding with the compound, or by coating with the compound, or by carrying the compound, or by associating with the compound, and solid films or layers are formed. For example, by combining the compound represented by the general formula (1) with an electroactive material, a film can be formed. In some cases, the compound represented by the general formula (1) can be combined with a hole transporting polymer. In some cases, the compound represented by the general formula (1) can be combined with an electron transporting polymer. In some cases, the compound represented by the general formula (1) can be combined with a hole transporting polymer and an electron transporting polymer. In some cases, the compound represented by the general formula (1) can be combined with a copolymer having both a hole transporting moiety and an electron transporting moiety. In the embodiments mentioned above, the electrons and/or the holes formed in a solid film or layer can be interacted with the compound represented by the general formula (1).

[Film Formation]

In some embodiments, a film containing the compound represented by the general formula (1) can be formed in a wet process. In a wet process, a solution prepared by dissolving a composition containing the compound of the present invention is applied onto a surface, and then the solvent is removed to form a film. The wet process includes a spin coating method, a slit coating method, an inkjet method (a spraying method), a gravure printing method, an offset printing method and flexographic printing method, which, however are not limitative. In the wet process, an appropriate organic solvent capable of dissolving a composition containing the compound of the present invention is selected and used. In some embodiments, a substituent (e.g., an alkyl group) capable of increasing the solubility in an organic solvent can be introduced into the compound contained in the composition.

In some embodiments, a film containing the compound of the present invention can be formed in a dry process. In some embodiments, a vacuum deposition method is employable as a dry process, which, however, is not limitative. In the case where a vacuum deposition method is employed, compounds to constitute a film can be vapor co-deposited from individual vapor deposition sources, or can be vapor co-deposited from a single vapor deposition source formed by mixing the compounds. In the case where a single vapor deposition source is used, a mixed powder prepared by mixing compound powders can be used, or a compression molded body prepared by compression-molding the mixed powder can be used, or a mixture prepared by heating and melting the compounds and cooling the resulting melt can be used. In some embodiments, by vapor co-deposition under the condition where the vapor deposition rate (weight reduction rate) of the plural compounds contained in a single vapor deposition source is the same or is nearly the same, a film having a compositional ratio corresponding to the compositional ratio of the plural compounds contained in the vapor deposition source can be formed. When plural compounds are mixed in the same compositional ratio as the compositional ratio of the film to be formed to prepare a vapor deposition source, a film having a desired compositional ratio can be formed in a simplified manner. In some embodiments, the temperature at which the compounds to be vapor co-deposited have the same weight reduction ratio is specifically defined, and the temperature can be employed as the temperature of vapor co-deposition.

[Use Examples of Compound Represented by General Formula (1)]

The compound represented by the general formula (1) is useful as a material for an organic light emitting device. In particular, the compound is preferably used for an organic light emitting diode or the like.

Organic Light Emitting Diode:

One aspect of the present invention relates to use of the compound represented by the general formula (1) of the present invention as a light emitting material for organic light emitting devices. In some embodiments, the compound represented by the general formula (1) of the present invention can be effectively used as a light emitting material in a light emitting layer in an organic light emitting device. In some embodiments, the compound represented by the general formula (1) includes a delayed fluorescent material that emits delayed fluorescence. In some embodiments, the present invention provides a delayed fluorescent material having a structure represented by the general formula (1). In some embodiments, the present invention relates to use of the compound represented by the general formula (1) as a delayed fluorescent material. In some embodiments, the compound represented by the general formula (1) of the present invention can be used as a host material, and can be used along with one or more light emitting materials, and the light emitting material can be a fluorescent material, a phosphorescent material or a delayed fluorescent material (TADF). In some embodiments, the compound represented by the general formula (1) can be used as a hole transporting material. In some embodiments, the compound represented by the general formula (1) can be used as an electron transporting material. In some embodiments, the present invention relates to a method of generating delayed fluorescence from the compound represented by the general formula (1). In some embodiments, the organic light emitting device containing the compound as a light emitting material emits delayed fluorescence and shows a high light emission efficiency.
In some embodiments, the light emitting layer contains the compound represented by the general formula (1), and the compound represented by the general formula (1) is aligned in parallel to the substrate. In some embodiments, the substrate is a film-forming surface. In some embodiment, the alignment of the compound represented by the general formula (1) relative to the film-forming surface has some influence on the propagation direction of light emitted by the aligned compounds, or determines the direction. In some embodiments, by aligning the propagation direction of light emitted by the compound represented by the general formula (1), the light extraction efficiency from the light emitting layer can be improved.
One aspect of the present invention relates to an organic light emitting device. In some embodiments, the organic light emitting device includes a light emitting layer. In some embodiments, the organic light emitting device is an organic photoluminescent device (organic PL device). In some embodiments, the organic light emitting device is an organic electroluminescent device (organic EL device). In some embodiments, the compound represented by the general formula (1) is a light emitting material having the largest emission intensity among the components contained in the light emitting layer. In some embodiments, the lowest excited singlet energy level of the compound represented by the general formula (1) is the lowest among the lowest excited singlet energy level of the components contained in the light emitting layer. In some embodiments, the device contains at least two components having a higher lowest excited singlet energy level than the lowest excited singlet energy level of the compound represented by the general formula (1). For example, the device contains at least 3 such components.
In some embodiments, the compound represented by the general formula (1) assists light irradiation from the other light emitting materials contained in the light emitting layer (as a so-called assist dopant). In some embodiments, the lowest excited singlet energy level of the compound represented by the general formula (1) contained in the light emitting layer is between the lowest excited singlet energy level of the host material contained in the light emitting layer and the lowest excited singlet energy level of the other light emitting material contained in the light emitting layer.
In some embodiments, the organic photoluminescent device comprises at least one light emitting layer. In some embodiments, the organic electroluminescent device includes at least an anode, a cathode, and an organic layer between the anode and the cathode. In some embodiments, the organic layer includes at least a light emitting layer. In some embodiments, the organic layer includes only a light emitting layer. In some embodiments, the organic layer includes one or more organic layers in addition to the light emitting layer. Examples of the organic layer include a hole transporting layer, a hole injection layer, an electron barrier layer, a hole barrier layer, an electron injection layer, an electron transporting layer and an exciton barrier layer. In some embodiments, the hole transporting layer can be a hole injection and transporting layer having a hole injection function, and the electron transporting layer can be an electron injection and transporting layer having an electron injection function.

Light Emitting Layer:

In some embodiments, the light emitting layer is a layer where holes and electrons injected from the anode and the cathode, respectively, are recombined to form excitons. In some embodiments, the layer emits light.
In some embodiments, only a light emitting material is used as the light emitting layer. In some embodiments, the light emitting layer contains a light emitting material and a host material. In some embodiments, the light emitting material is one or more compounds represented by the general formula (1). In some embodiments, for improving luminous radiation efficiency of an organic electroluminescent device and an organic photoluminescent device, the singlet exciton and the triplet exciton generated in a light emitting material are confined inside the light emitting material. In some embodiments, a

host material is used in the light emitting layer in addition to a light emitting material. In some embodiments, the host material is an organic compound. In some embodiments, the organic compound has an excited singlet energy and an excited triplet energy, and at least one of them is higher than those in the light emitting material of the present invention. In some embodiments, the singlet exciton and the triplet exciton generated in the light emitting material of the present invention are confined in the molecules of the light emitting material of the present invention. In some embodiments, the singlet and triplet excitons are fully confined for improving luminous radiation efficiency. In some embodiments, although high luminous radiation efficiency is still attained, singlet excitons and triplet excitons are not fully confined, that is, a host material capable of attaining high luminous radiation efficiency can be used in the present invention with no specific limitation. In some embodiments, in the light emitting material in the light emitting layer of the device of the present invention, luminous radiation occurs. In some embodiments, radiated light includes both fluorescence and delayed fluorescence. In some embodiments, radiated light includes radiated light from a host material. In some embodiments, radiated light is composed of radiated light from a host material. In some embodiments, radiated light includes radiated light from the compound represented by the general formula (1) and radiated light from a host material. In some embodiment, a TADF molecule and a host material are used. In some embodiments, TADF is an assist dopant and has a lower excited singlet energy than that of the host material in the light emitting layer and a higher excited singlet energy than that of the light emitting material in the light emitting layer.

In the case where the compound represented by the general formula (1) is used as an assist dopant, various compounds can be employed as a light emitting material (preferably a fluorescent material). As such light emitting materials, employable are an anthracene derivative, a tetracene derivative, a naphthacene derivative, a pyrene derivative, a perylene derivative, a chrysene derivative, a rubrene derivative, a coumarin derivative, a pyran derivative, a stilbene derivative, a fluorene derivative, an anthryl derivative, a pyrromethene derivative, a terphenyl derivative, a terphenylene derivative, a fluoranthene derivative, an amine derivative, a quinacridone derivative, an oxadiazole derivative, a malononitrile derivative, a pyran derivative, a carbazole derivative, a julolidine derivative, a thiazole derivative, and a derivative having a metal (Al, Zn). These exemplified skeletons can have a substituent, or may not have a substituent. These exemplified skeletons can be combined.

Light emitting materials that can be used in combination with the assist dopant having a structure represented by the general formula (1) are shown below.

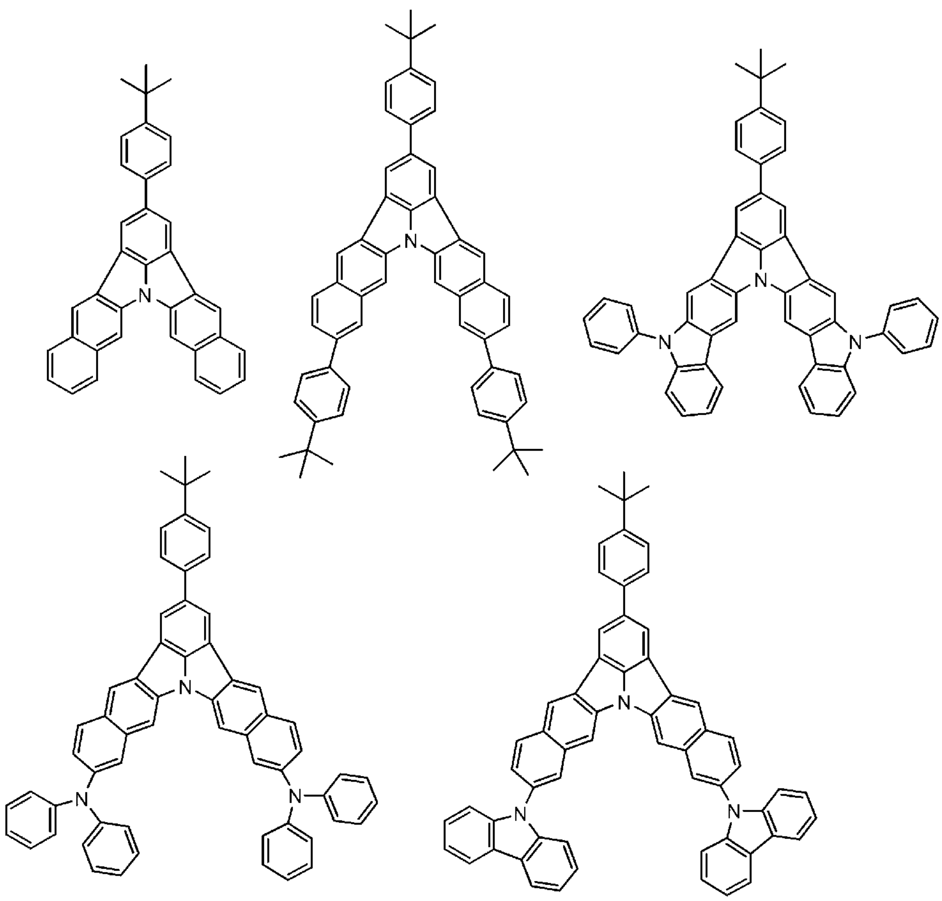

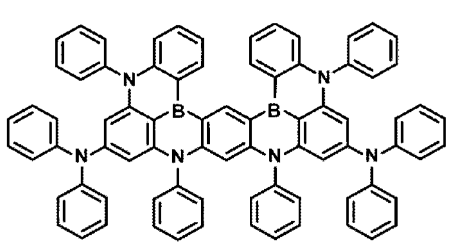

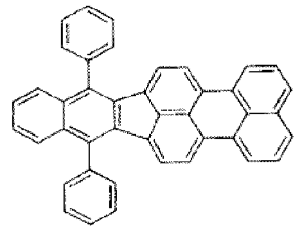

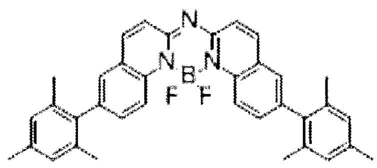

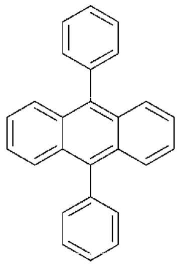

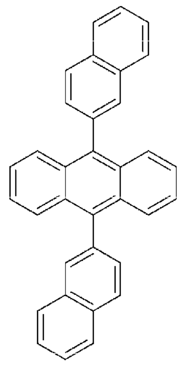

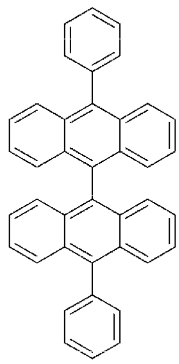

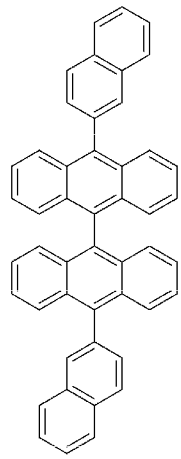

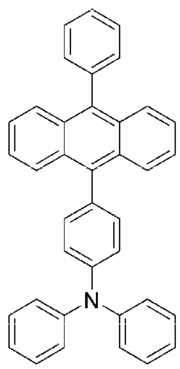

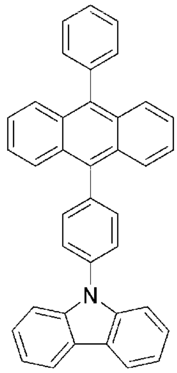

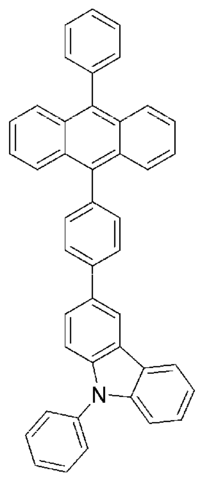

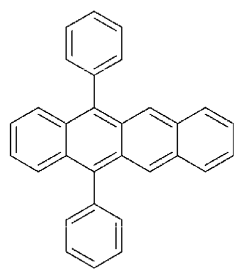

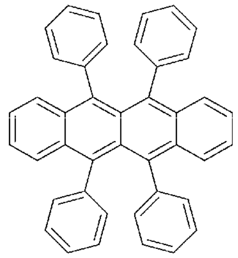
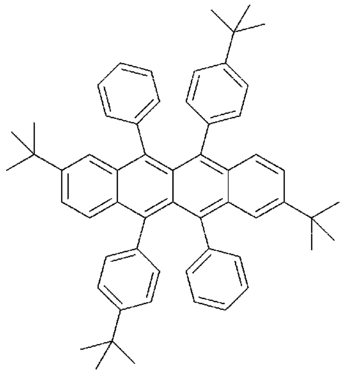
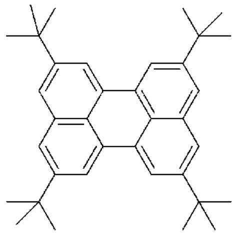

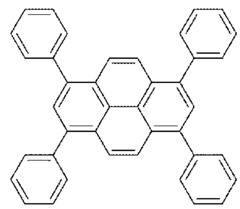
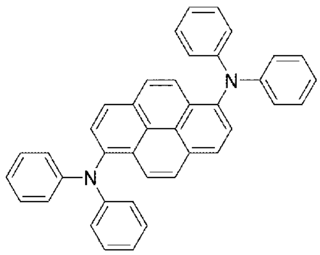
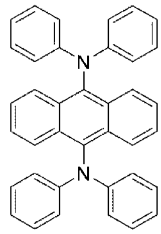

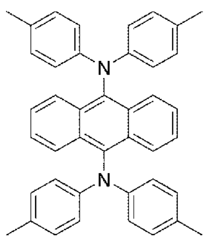
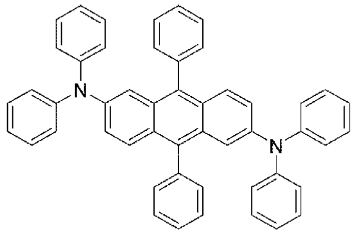
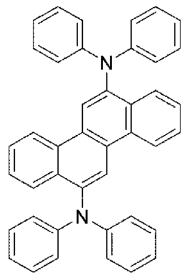

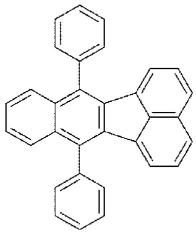
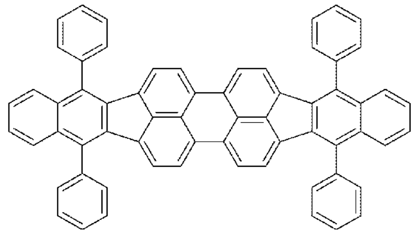
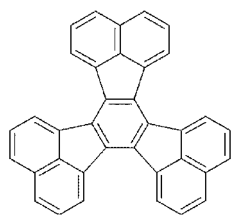

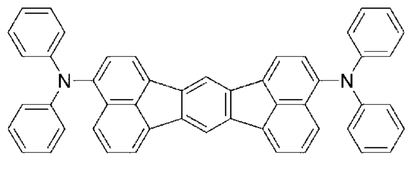
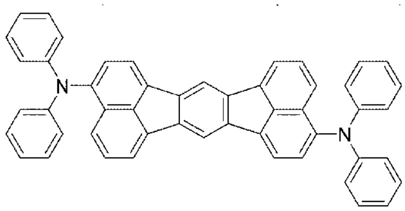

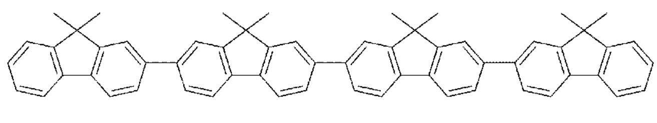

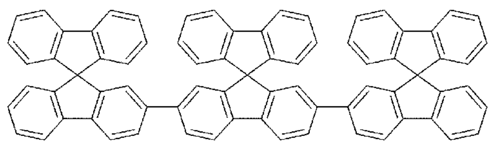

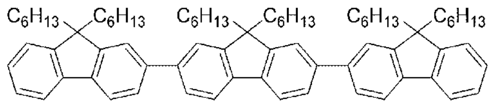

In addition, the compounds described in WO2015/022974A, paragraphs 0220 to 0239 are also especially favorably employable as a light emitting material for use along with the assist dopant having a structure represented by the general formula (1).

In some embodiments where a host material is used, the amount of the compound of the present invention contained in a light emitting layer as a light emitting material is 0.1% by weight or more. In some embodiments where a host material is used, the amount of the compound of the present invention contained in a light emitting layer as a light emitting material is 1% by weight or more. In some embodiments where a host material is used, the amount of the compound of the present invention contained in a light emitting layer as a light emitting material is 50% by weight or less. In some embodiments where a host material is used, the amount of the compound of the present invention contained in a light emitting layer as a light emitting material is 20% by weight or less. In some embodiments where a host material is used, the amount of the compound of the present invention contained in a light emitting layer as a light emitting material is 10% by weight or less.

In some embodiments, the host material in a light emitting layer is an organic compound having a hole transporting capability and an electron transporting capability. In some embodiments, the host material in a light emitting layer is an organic compound that prevents increase in the wavelength of emitted light. In some embodiments, the host material in a light emitting layer is an organic compound having a high glass transition temperature.

Compounds preferably usable as the host material are shown below, but the host material that can be adopted in the present invention is not construed as limiting to the following specific examples.

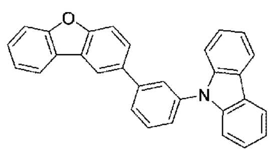

H 1

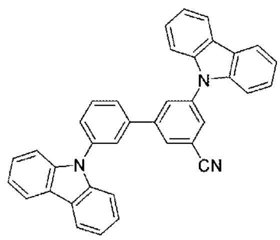

H 2

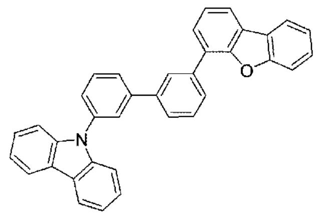

H 3

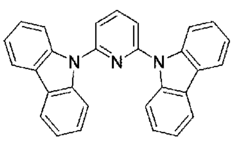

H 4

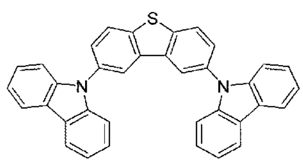

H 5

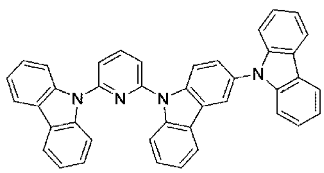

H 6

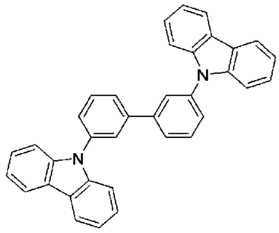

H7

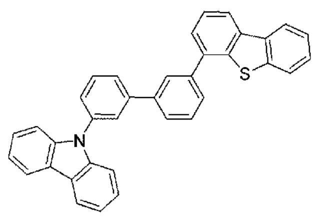

H8

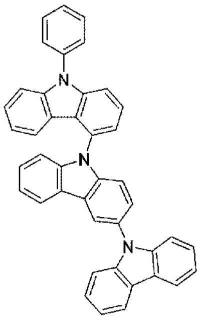

H9

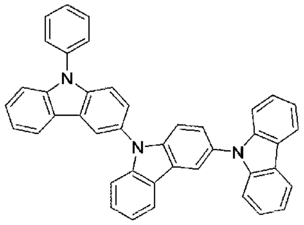

H10

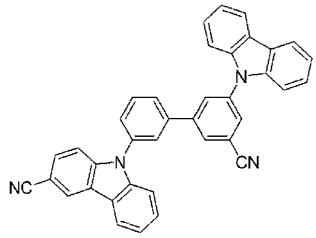

H11

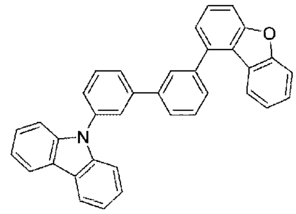

H12

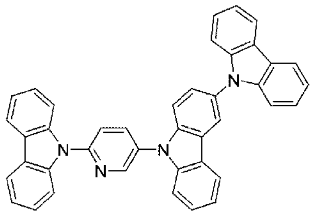

H13

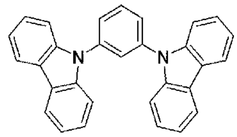

H14

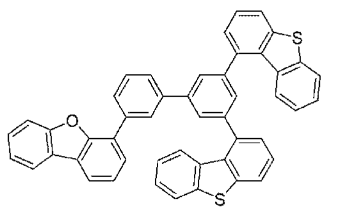

H15

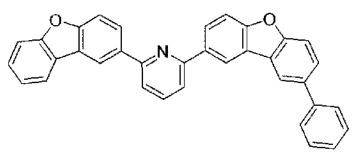

H16

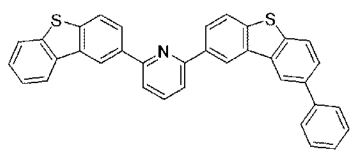

H17

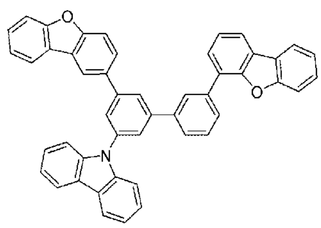

H18

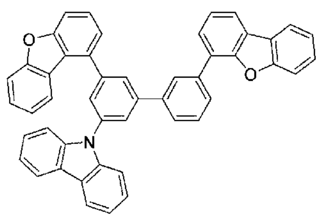

H19

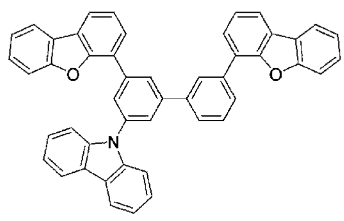

H20

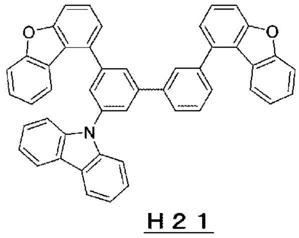

H21

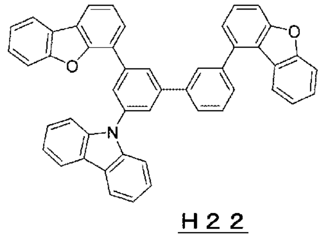

H22

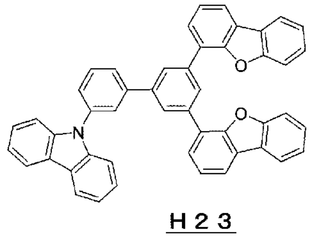

H23

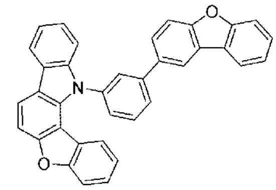

Ｈ２４

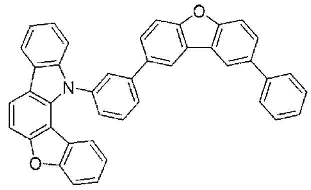

Ｈ２５

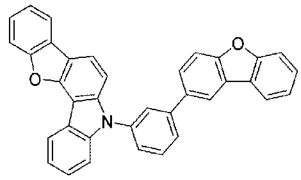

Ｈ２６

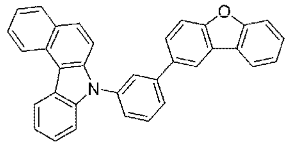

Ｈ２７

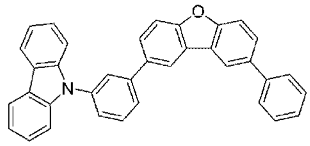

Ｈ２８

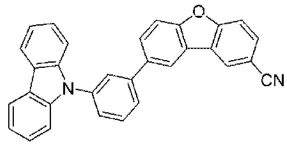

Ｈ２９

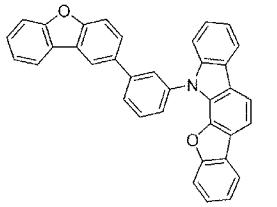

Ｈ３０

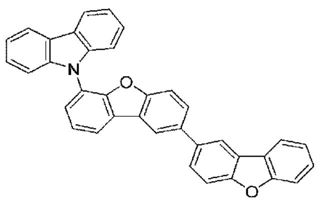

Ｈ３１

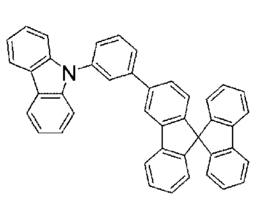

Ｈ３２

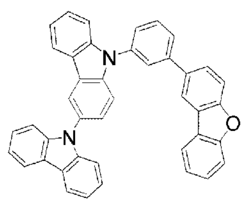

Ｈ３３

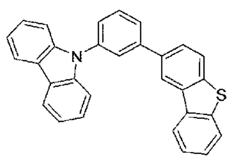

Ｈ３４

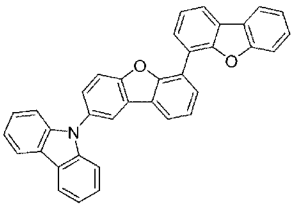

Ｈ３５

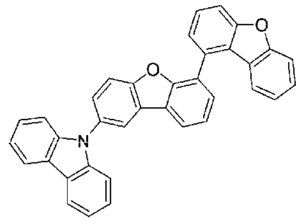

Ｈ３６

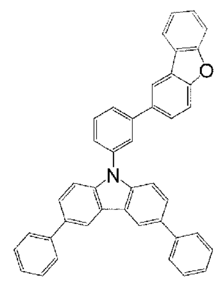

Ｈ３７

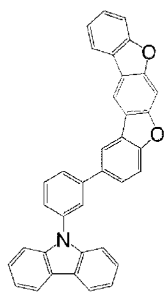

Ｈ３８

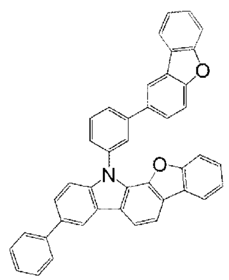

Ｈ３９

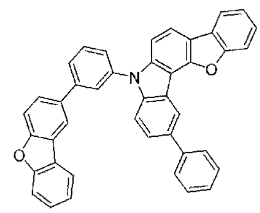

Ｈ４０

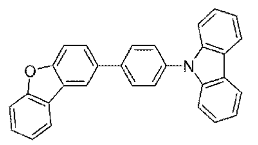

Ｈ４１

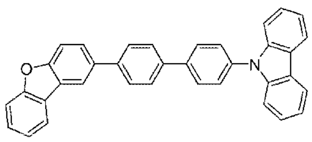

H42

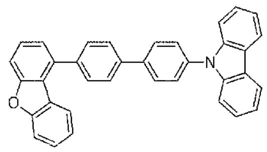

H43

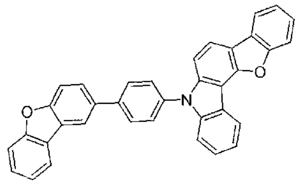

H44

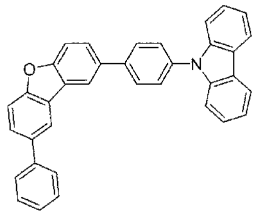

H45

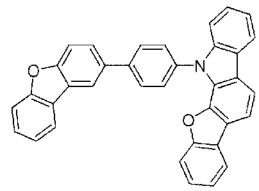

H46

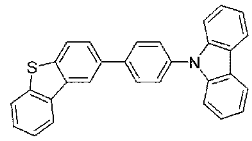

H47

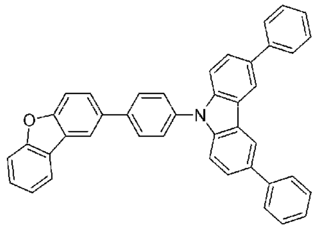

H48

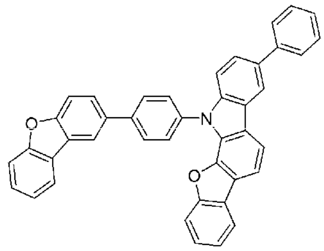

H49

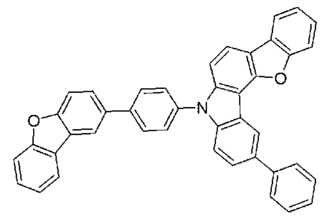

H50

In the light emitting layer, a delayed fluorescent material can be used as a light emitting material or an assist dopant. For the light emitting material and the assist dopant, different delayed fluorescent materials can be used. The delayed fluorescent material generally gives fluorescence that has an emission lifetime of 100 ns (nanoseconds) or longer, when the emission lifetime thereof is measured with a fluorescence lifetime measuring system (for example, a streak camera system by Hamamatsu Photonics K.K.). The delayed fluorescent material is preferably such that the difference $\Delta E_{ST}$ between the lowest excited singlet energy and the lowest excited triplet energy at 77 K is 0.3 eV or less, more preferably 0.25 eV or less, even more preferably 0.2 eV or less, further more preferably 0.15 eV or less, further more preferably 0.1 eV or less, further more preferably 0.07 eV or less, further more preferably 0.05 eV or less, further more preferably 0.03 eV or less, and particularly preferably 0.01 eV or less. When $\Delta E_{ST}$ is small, reverse intersystem crossing from an excited triplet state to an excited singlet state can readily occur through thermal energy absorption, and therefore the compound of the type can function as a thermal activation type delayed fluorescent material. A thermal activation type delayed fluorescent material can absorb heat generated by a device to relatively readily undergo reverse intersystem crossing from an excited triplet state to an excited singlet state, and can make the excited triplet energy efficiently contribute toward light emission.

In the present invention, the lowest excited singlet energy ($E_{S1}$) and the lowest excited triplet energy ($E_{T1}$) of a compound are determined according to the following process. $\Delta E_{ST}$ is a value determined by calculating $E_{S1}$ - $E_{T1}$.

(1) Lowest Excited Singlet Energy ($E_{S1}$)

A thin film or a toluene solution (concentration: $10^{-5}$ mol/L) of the targeted compound is prepared as a measurement sample. The fluorescent spectrum of the sample is measured at room temperature (300 K). For the fluorescent spectrum, the light emission intensity is on the vertical axis and the wavelength is on the horizontal axis. A tangent line is drawn to the rising of the emission spectrum on the short wavelength side, and the wavelength value λedge [nm] at the intersection between the tangent line and the horizontal axis is read. The wavelength value is converted into an energy value according to the following conversion expression to calculate $E_{S1}$.

$$\text{Conversion Expression: } E_{S1}\ [\text{eV}] = 1239.85/\lambda\text{edge}$$

For the measurement of the emission spectrum in Examples given below, an LED light source (by Thorlabs

Corporation, M300L4) was used as an excitation light source along with a detector (by Hamamatsu Photonics K.K., PMA-12 Multichannel Spectroscope C10027-01).

(2) Lowest Excited Triplet Energy ($E_{T1}$)

The same sample as that for measurement of the lowest excited singlet energy ($E_{S1}$) is cooled to 77 [K] with liquid nitrogen, and the sample for phosphorescence measurement is irradiated with excitation light (300 nm), and using the detector, the phosphorescence thereof is measured. The light emission after 100 milliseconds from irradiation with the excitation light is drawn as a phosphorescent spectrum. A tangent line is drawn to the rising of the phosphorescent spectrum on the short wavelength side, and the wavelength value λedge [nm] at the intersection between the tangent line and the horizontal axis is read. The wavelength value is converted into an energy value according to the following conversion expression to calculate $E_{T1}$.

$$\text{Conversion Expression: } E_{T1}\ [\text{eV}] = 1239.85/\lambda\text{edge}$$

The tangent line to the rising of the phosphorescent spectrum on the short wavelength side is drawn as follows. While moving on the spectral curve from the short wavelength side of the phosphorescent spectrum toward the local maximum value on the shortest wavelength side among the local maximum values of the spectrum, a tangent line at each point on the curve toward the long wavelength side is taken into consideration. With rising thereof (that is, with increase in the vertical axis), the inclination of the tangent line increases. The tangent line drawn at the point at which the inclination value has a local maximum value is referred to as the tangent line to the rising on the short wavelength side of the phosphorescent spectrum.

The local maximum point having a peak intensity of 10% or less of the maximum peak intensity of the spectrum is not included in the local maximum value on the above-mentioned shortest wavelength side, and the tangent line drawn at the point which is closest to the local maximum value on the shortest wavelength side and at which the inclination value has a local maximum value is referred to as the tangent line to the rising on the short wavelength side of the phosphorescent spectrum.

Preferably, the delayed fluorescent material does not contain a metal atom. For example, as the delayed fluorescent material, a compound including an atom selected from the group consisting of a carbon atom, a hydrogen atom, a deuterium atom, a nitrogen atom, an oxygen atom, and a sulfur atom can be selected. For example, as the delayed fluorescent material, a compound composed of a carbon atom, a hydrogen atom and a nitrogen atom can be selected.

A typical delayed fluorescent material includes a compound having a structure in which 1 or 2 acceptor groups and at least one donor group bond to a benzene ring. Preferred examples of the acceptor group include a cyano group, and a group that contains a heteroaryl ring containing a nitrogen atom as a ring skeleton-constituting atom such as a triazinyl ring. Preferred examples of the donor group include a substituted or unsubstituted carbazol-9-yl group. Examples thereof include a compound in which at least three substituted or unsubstituted carbazol-9-yl groups bond to a benzene ring, and a compound in which a 5-membered ring moiety of a substituted or unsubstituted benzofuran ring, a substituted or unsubstituted benzothiophene ring, a substituted or unsubstituted indole ring, a substituted or unsubstituted indene ring, or a substituted or unsubstituted silaindene ring is fused to at least one of the two benzene rings constituting a carbazol-9-yl group.

In one preferred aspect of the present invention, a compound represented by the following general formula (T1) is used as the delayed fluorescent material.

General Formula (T1)

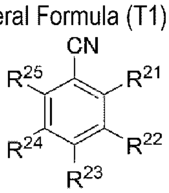

In the general formula (T1), one of $R^{21}$ to $R^{23}$ represents a cyano group or a group represented by the following general formula (T2), the remaining two of $R^{21}$ to $R^{23}$ and at least one of $R^{24}$ and $R^{25}$ each represent a group represented by the following general formula (T3), the remaining $R^{21}$ to $R^{25}$ each represent a hydrogen atom or a substituent, provided that the substituent referred to here is not a cyano group, the group represented by the following general formula (T2) and the group represented by the following general formula (T3).

General Formula (T2)

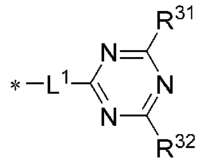

In the general formula (T2), $L^1$ represents a single bond or a divalent linking group, $R^{31}$ and $R^{32}$ each independently represent a hydrogen atom or a substituent, * indicates a bonding site.

General Formula (T3)

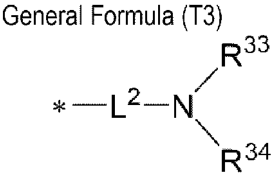

In the general formula (T3), $L^2$ represents a single bond or a divalent linking group, $R^{33}$ and $R^{34}$ each independently represent a hydrogen atom or a substituent, * indicates a bonding site.

In one preferred aspect of the present invention, $R^{22}$ is a cyano group. In one preferred aspect of the present invention, $R^{22}$ is a group represented by the general formula (T2). In one aspect of the present invention, $R^{21}$ is a cyano group, or a group represented by the general formula (T2). In one aspect of the present invention, $R^{23}$ is a cyano group, or a group represented by the general formula (T2). In one aspect of the present invention, one of $R^{21}$ to $R^{23}$ is a cyano group. In one aspect of the present invention, one of $R^{21}$ to $R^{23}$ is a group represented by the general formula (T2).

In one preferred aspect of the present invention, $L^1$ in the general formula (T2) is a single bond. In one aspect of the present invention, $L^1$ is a divalent linking group, and is preferably a substituted or unsubstituted arylene group or a substituted or unsubstituted heteroarylene group, more preferably a substituted or unsubstituted arylene group, even more preferably a substituted or unsubstituted 1,4-phenylene group (in which the substituent is, for example, an alkyl group having 1 to 3 carbon atoms).

In one aspect of the present invention, $R^{31}$ and $R^{32}$ in the general formula (T2) are each independently one group selected from the group consisting of an alkyl group (for example, having 1 to 40 carbon atoms), an aryl group (for example, having 6 to 30 carbon atoms), a heteroaryl group (for example, having 5 to 30 ring skeleton-constituting atoms), an alkenyl group (for example, having 2 to 40 carbon atoms) and an alkynyl group (for example, having 2 to 40 carbon atoms), or a group formed by combining at least two thereof (hereinunder these groups are referred to as "groups of Substituent Group A"). In one preferred aspect of the present invention, $R^{31}$ and $R^{32}$ are each independently a substituted or unsubstituted aryl group (for example, having 6 to 30 carbon atoms), and examples of the substituent for the aryl group include the groups of Substituent Group A. In one preferred aspect of the present invention, $R^{31}$ and $R^{32}$ are the same.

In one preferred aspect of the present invention, $L^2$ in the general formula (T3) is a single bond. In one aspect of the present invention, $L^2$ is a divalent linking group, and is preferably a substituted or unsubstituted arylene group or a substituted or unsubstituted heteroarylene group, more preferably a substituted or unsubstituted arylene group, even more preferably a substituted or unsubstituted 1,4-phenylene group (in which the substituent is, for example, an alkyl group having 1 to 3 carbon atoms).

In one aspect of the present invention, $R^{33}$ and $R^{34}$ in the general formula (T3) are each independently a substituted or unsubstituted alkyl group (for example, having 1 to 40 carbon atoms), a substituted or unsubstituted alkenyl group (for example, having 2 to 40 carbon atoms), a substituted or unsubstituted aryl group (for example, having 6 to 30 carbon atoms), or a substituted or unsubstituted heteroaryl group (for example, having 5 to 30 carbon atoms). The substituent for the alkyl group, the alkenyl group, the aryl group and the heteroaryl group as referred to herein includes one group selected from the group consisting of a hydroxyl group, a halogen atom (for example, a fluorine atom, a chlorine atom, a bromine atom, and an iodine atom), an alkyl group (for example, having 1 to 40 carbon atoms), an alkoxy group (for example, having 2 to 40 carbon atoms), an alkylthio group (for example, having 1 to 40 carbon atoms), an aryl group (for example, having 6 to 30 carbon atoms), an aryloxy group (for example, having 6 to 30 carbon atoms), an arylthio group (for example, having 6 to 30 carbon atoms), a heteroaryl group (for example, having 5 to 30 ring skeleton-constituting atoms), a heteroaryloxy group (for example, having 5 to 30 ring skeleton-constituting atoms), a heteroarylthio group (for example, having 5 to 30 ring skeleton-constituting atoms), an acyl group (for example, having 2 to 40 carbon atoms), an alkenyl group (for example, having 2 to 40 carbon atoms), an alkynyl group (for example, having 2 to 40 carbon atoms), an alkoxycarbonyl group (for example, having 3 to 40 carbon atoms), an aryloxycarbonyl group (for example, having 7 to 40 carbon atoms), a heteroaryloxycarbonyl group (for example, having 6 to 40 carbon atoms), a silyl group (for example, a trialkylsilyl group having 3 to 40 carbon atoms), a nitro group, and a cyano group, or a group formed by combining at least

two thereof (hereinunder these groups are referred to as "groups of Substituent Group B").

$R^{33}$ and $R^{34}$ can bond to each other via a single bond or a linking group to form a cyclic structure. In particular, in the case were $R^{33}$ and $R^{34}$ are aryl groups, preferably, they bond to each other via a single bond or a linking group to form a cyclic structure. The linking group as referred to herein includes -O-, -S-, -N($R^{35}$)-, -C($R^{36}$)($R^{37}$)-, and - C(=O)-, preferably -O-, -S-, -N($R^{35}$)-, and -C($R^{36}$)($R^{37}$)-, more preferably -O-, -S-, and - N($R^{35}$)-. $R^{35}$ to $R^{37}$ each independently represent a hydrogen atom, or a substituent. For the substituent, the groups of the above Substituent Group A can be selected, or the groups of the above Substituent Group B can be selected, and preferably, the substituent is one group selected from the group consisting of an alkyl group having 1 to 10 carbon atoms and an aryl group having 6 to 14 carbon atoms, or a group formed by combining at least two thereof.

The group represented by the general formula (T3) is preferably a group represented by the following general formula (T4).

General Formula (T4)

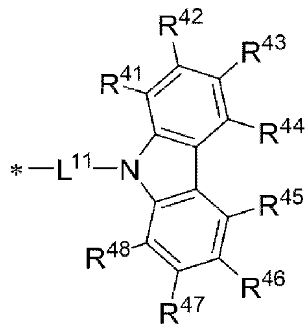

In the general formula (T4), $L^{11}$ represents a single bond or a divalent linking group. Regarding the description and the preferred range of $L^{11}$, reference can be made to the description and the preferred range of $L^2$ described hereinabove.

$R^{41}$ to $R^{48}$ in the general formula (T4) each independently represent a hydrogen atom, or a substituent. $R^{41}$ and $R^{42}$, $R^{42}$ and $R^{43}$, $R^{43}$ and $R^{44}$, $R^{44}$ and $R^{45}$, $R^{45}$ and $R^{46}$, $R^{46}$ and $R^{47}$, and $R^{47}$ and $R^{48}$ each can bond to each other to form a cyclic structure. The cyclic structure to be formed by bonding to each other can be an aromatic ring or an aliphatic ring, or can contain a heteroatom, and further, the cyclic structure can also be a fused ring of two or more rings. The heteroatom as referred to herein is preferably selected from the group consisting of a nitrogen atom, an oxygen atom and a sulfur atom. Examples of the cyclic structure to be formed include a benzene ring, a naphthalene ring, a pyridine ring, a pyridazine ring, a pyrimidine ring, a pyrazine ring, a pyrrole ring, an imidazole ring, a pyrazole ring, an imidazoline ring, an oxazole ring, an isoxazole ring, a thiazole ring, an isothiazole ring, a cyclohexadiene ring, a cyclohexene ring, a cyclopentaene ring, a cycloheptatriene ring, a cycloheptadiene ring, a cycloheptaene ring, a furan ring, a thiophene ring, a naphthyridine ring, a quinoxaline ring, and a quinoline ring. Many rings can be fused to form a ring such as a phenanthrene ring or a triphenylene ring. The number of the rings contained in the group represented by the general formula (T4) can be selected from the range of 3 to 5, or can be selected from the range of 5 to 7.

The substituent which $R^{41}$ to $R^{48}$ can take includes the groups of the above-mentioned Substituent Group B, and is preferably an unsubstituted alkyl group having 1 to 10 carbon atoms, or an aryl group having 6 to 10 carbon atoms optionally substituted with an unsubstituted alkyl group having 1 to 10 carbon atoms. In one preferred aspect of the present invention, $R^{41}$ to $R^{48}$ each are a hydrogen atom or an unsubstituted alkyl group having 1 to 10 carbon atoms. In one preferred aspect of the present invention, $R^{41}$ to $R^{48}$ each are a hydrogen atom or an unsubstituted aryl group having 6 to 10 carbon atoms. In one preferred aspect of the present invention, $R^{41}$ to $R^{48}$ are all hydrogen atoms.

In the general formula (T4), * indicates a bonding site.

In one preferred aspect of the present invention, an azabenzene derivative is used as the delayed fluorescent material. In one preferred aspect of the present invention, the azabenzene derivative has an azabenzene structure in which three ring skeleton-constituting carbon atoms of the benzene ring are substituted with nitrogen atoms. For example, an azabenzene derivative having a 1,3,5-triazine structure can be preferably selected. In one preferred aspect of the present invention, the azabenzene derivative has an azabenzene structure in which two ring skeleton-constituting carbon atoms of the benzene ring are substituted with nitrogen atoms. For example, it includes an azabenzene derivative having a pyridazine structure, a pyrimidine structure, or a pyrazine structure, and an azabenzene derivative having a pyrimidine structure can be preferably selected. In one aspect of the present invention, the azabenzene derivative has a pyridine structure in which one ring skeleton-constituting carbon atom of the benzene ring is substituted with a nitrogen atom.

In one preferred aspect of the present invention, a compound represented by the following general formula (T5) is used as the delayed fluorescent material.

General Formula (T5)

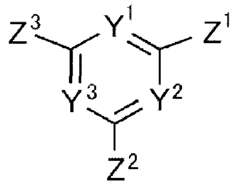

In the general formula (T5), at least one of $Y^1$, $Y^2$ and $Y^3$ is a nitrogen atom and the remainder represents a methine group. In one aspect of the present invention, $Y^1$ is a nitrogen atom, and $Y^2$ and $Y^3$ are methine groups. Preferably, $Y^1$ and $Y^2$ are nitrogen atoms, and $Y^3$ is a methine group. More preferably, $Y^1$ to $Y^3$ are all nitrogen atoms.

In the general formula (T5), $Z^1$ to $Z^3$ each independently represent a hydrogen atom or a substituent, but at least one is a donor substituent. The donor substituent means a group having a negative Hammett's $\sigma p$ value. Preferably, at least one of $Z^1$ to $Z^3$ is a group containing a diarylamino structure, in which the two aryl groups bonding to the nitrogen atom can bond to each other, and is more preferably a group represented by the above general formula (T3), for example, a group represented by the above general formula (T4). In one aspect of the present invention, only one of $Z^1$ to $Z^3$ is a group represented by the general formula (T3) or (T4). In one aspect of the present invention, only two of $Z^1$ to $Z^3$ are each independently a group represented by the general formula (T3) or (T4). In one aspect of the present invention, all of $Z^1$ to $Z^3$ are each independently a group represented by the general formula (T3) or (T4). For details and preferable ranges of the general formula (T3) and the general formula (T4), the corresponding descriptions given above can be referred to. The remaining $Z^1$ to $Z^3$ that are not the groups represented by the general formula (T3) and the general formula (T4) each are preferably a substituted or unsubstituted aryl group (for example, having 6 to 40 carbon atoms, preferably 6 to 20 carbon atoms), and examples of the substituent for the aryl group as referred to herein include one group selected from the group consisting of an aryl group (for example, having 6 to 20 carbon atoms, preferably 6 to 14 carbon atoms) and an alkyl group (for example, having 1 to 20 carbon atoms, preferably 1 to 6 carbon atoms), and a group formed by combining at least two thereof. In one aspect of the present invention, the general formula (T5) does not include a cyano group.

In one preferred aspect of the present invention, a compound represented by the following general formula (T6) is used as the delayed fluorescent material.

General Formula (T6)

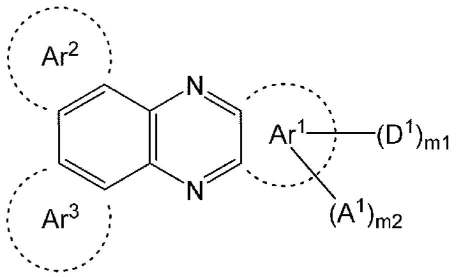

In one aspect of the present invention, in the general formula (T6), $Ar^1$ forms a cyclic structure optionally substituted with the following $A^1$ and $D^1$, and represents a benzene ring, a naphthalene ring, an anthracene ring or a phenanthrene ring. $Ar^2$ and $Ar^3$ each can form a cyclic structure, and in the case of forming a cyclic structure, they represent a benzene ring, a naphthalene ring, a pyridine ring, or a benzene ring substituted with a cyano group. m1 represents an integer of any of 0 to 2, and m2 represents an integer of any of 0 to 1. $A^1$ represents a cyano group, a phenyl group, a pyrimidyl group, a triazyl group, or a benzonitrile group. $D^1$ represents a substituted or unsubstituted 5H-indolo[3,2,1-de]phenazin-5-yl group, or a substituted or unsubstituted hetero ring-fused carbazolyl group not containing a naphthalene structure, and in the case where the general formula (T6) has plural $D^1$'s, they can be the same or different. The substituents for $D^1$ can bond to each other to form a cyclic structure.

In another aspect of the present invention, in the general formula (T6), $Ar^1$ represents a cyclic structure, and represents a benzene ring, a naphthalene ring, an anthracene ring or a phenanthrene ring. $D^1$ represents a group represented by the following general formula (T7). $A^1$ represents a group selected from the group consisting of a cyano group, a phenyl group, a pyrimidyl group, a triazyl group and an alkyl group, or a group formed by combining at least two thereof (but excepting a substituted alkyl group). m is 1 or 2, and n is 0, 1 or 2. When m is 2, two $D^1$'s can be the same or different. When n is 2, two $A^1$'s can be the same or different. $Ar^2$ and $Ar^3$ each independently can form a cyclic structure selected from the group consisting of a benzene ring, a naphthalene ring and a pyridine ring, and the formed cyclic structure can be substituted with one group selected from the group consisting of an alkyl group, an aryl group, a heteroaryl group, and a cyano group, or a group formed by combining at least two thereof.

General Formula (T7)

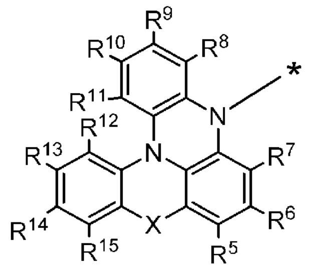

In the general formula (T7), $R^5$ to $R^{15}$ each independently represent a hydrogen atom, a deuterium atom, or a substituent. $R^5$ and $R^6$, $R^6$ and $R^7$, $R^8$ and $R^9$, $R^9$ and $R^{10}$, $R^{10}$ and $R^{11}$, $R^{11}$ and $R^{12}$, $R^{12}$ and $R^{13}$, $R^{13}$ and $R^{14}$, and $R^{14}$ and $R^{15}$ each can bond to each other to form a cyclic structure. X represents a single bond, an oxygen atom or a sulfur atom. * indicates a bonding site.

Compounds represented by the following general formula (E1) are further preferred delayed fluorescent materials.

General Formula (E1)

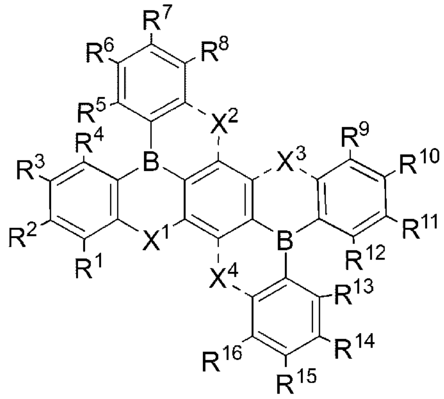

In the general formula (E1), $R^1$ and $R^3$ to $R^{16}$ each independently represent a hydrogen atom, a deuterium atom, or a substituent. $R^2$ represents an acceptor group, or $R^1$ and $R^2$ bond to each other to form an acceptor group, or $R^2$ and $R^3$ bond to each other to form an acceptor group. $R^3$ and $R^4$, $R^4$ and $R^5$, $R^5$ and $R^6$, $R^6$ and $R^7$, $R^7$ and $R^8$, $R^9$ and $R^{10}$, $R^{10}$ and $R^{11}$, $R^{11}$ and $R^{12}$, $R^{12}$ and $R^{13}$, $R^{13}$ and $R^{14}$, $R^{14}$ and $R^{15}$, and $R^{15}$ and $R^{16}$ each can bond to each other to form a cyclic structure. $X^1$ represents O or NR, and R represents a substituent. Of $X^2$ to $X^4$, at least one of $X^3$ and $X^4$ is O or NR, and the remainder may be O or R, or unlinked. When not linked, both ends each independently represent a hydrogen atom, a deuterium atom or a substituent. In the general formula (E1), C-$R^1$, C-$R^3$, C-$R^4$, C-$R^5$, C-$R^6$, C-$R^7$, C-$R^8$, C-$R^9$ , C-$R^{10}$, C-$R^{11}$, C-$R^{12}$, C-$R^{13}$, C-$R^{14}$, C-$R^{15}$, and C-$R^{16}$ can be substituted with N.

Compounds represented by the following general formula (E2) are further preferred delayed fluorescent materials.

General Formula (E2)

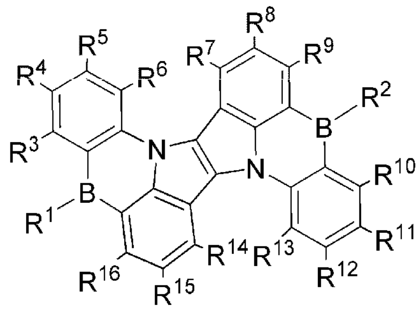

In the general formula (E2), $R^1$ and $R^2$ each independently represent a substituted or unsubstituted alkyl group, a substituted or unsubstituted aryl group, or a substituted or unsubstituted heteroaryl group, and $R^3$ to $R^{16}$ each

independently represent a hydrogen atom, a deuterium atom or a substituent. $R^1$ and $R^3$, $R^3$ and $R^4$, $R^4$ and $R^5$, $R^5$ and $R^6$, $R^6$ and $R^7$, $R^7$ and $R^8$, $R^8$ and $R^9$, $R^9$ and $R^2$, $R^2$ and $R^{10}$, $R^{10}$ and $R^{11}$, $R^{11}$ and $R^{12}$, $R^{12}$ and $R^{13}$, $R^{13}$ and $R^{14}$, $R^{14}$ and $R^{15}$, $R^{15}$ and $R^{16}$, and $R^{16}$ and $R^1$ each can bond to each other to form a cyclic structure. In the general formula (E2), C-$R^3$, C-$R^4$, C-$R^5$, C-$R^6$, C-$R^7$, C-$R^8$, C-$R^9$, C-$R^{10}$, C-$R^{11}$, C-$R^{12}$, C-$R^{13}$, C-$R^{14}$, C-$R^{15}$, and C-$R^{16}$ can be substituted with N.

Compounds represented by the following general formula (E3) are further preferred delayed fluorescent materials.

General Formula (E3)

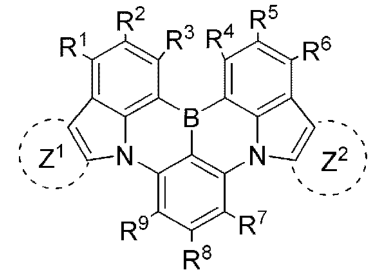

In the general formula (E3), $Z^1$ and $Z^2$ each independently represent a substituted or unsubstituted aromatic ring, or a substituted or unsubstituted heteroaromatic ring, $R^1$ to $R^9$ each independently represent a hydrogen atom, a deuterium atom or a substituent. $R^1$ and $R^2$, $R^2$ and $R^3$, $R^3$ and $R^4$, $R^4$ and $R^5$, $R^5$ and $R^6$, $R^7$ and $R^8$, and $R^8$ and $R^9$ each can bond to each other to form a cyclic structure. However, at least one of the ring formed by $Z^1$, $Z^2$, $R^1$ and $R^2$ bonding to each other, the ring formed by $R^2$ and $R^3$ bonding to each other, the ring formed by $R^4$ and $R^5$ bonding to each other, and the ring formed by $R^5$ and $R^6$ bonding to each other is a furan ring of a substituted or unsubstituted benzofuran, a thiophene ring of a substituted or unsubstituted benzothiophene, or a pyrrole ring of a substituted or unsubstituted indole, and at least one of $R^1$ to $R^9$ is a substituted or unsubstituted aryl group or an acceptor group, or at least one of $Z^1$ and $Z^2$ is a ring having an aryl group or an acceptor group as a substituent. Of the benzene ring skeleton-constituting carbon atoms to constitute the benzofuran ring, the benzothiophene ring, and the indole ring, a substitutable carbon atom can be substituted with a nitrogen atom. In the general formula (E3), C-$R^1$, C-$R^2$, C-$R^3$, C-$R^4$, C-$R^5$, C-$R^6$, C-$R^7$, C-$R^8$, and C-$R^9$ can be substituted with N.

Compounds represented by the following general formula (E4) are further preferred delayed fluorescent materials.

General Formula (E4)

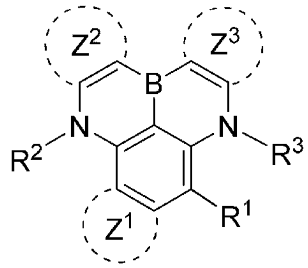

In the general formula (E4), $Z^1$ represents a furan ring fused with a substituted or unsubstituted benzene ring, a thiophene ring fused with a substituted or unsubstituted benzene ring, or an N-substituted pyrrole ring fused with a substituted or unsubstituted benzene ring, $Z^2$ and $Z^3$ each independently represent a substituted or unsubstituted aromatic ring, or a substituted or unsubstituted heteroaromatic ring, $R^1$ represents a hydrogen atom, a deuterium atom, or a substituent, and $R^2$ and $R^3$ each independently represent a substituted or unsubstituted aryl group, or a substituted or unsubstituted heteroaryl group. $Z^1$ and $R^1$, $R^2$ and $Z^2$, $Z^2$ and $Z^3$, and $Z^3$ and $R^3$ each can bond to each other to form a cyclic structure. However, at least one pair of $R^2$ and $Z^2$, $Z^2$ and $Z^3$, and $Z^3$ and $R^3$ bonds to each other to form a cyclic structure.

Compounds represented by the following general formula (E5) are further preferred delayed fluorescent materials.

General Formula (E5)

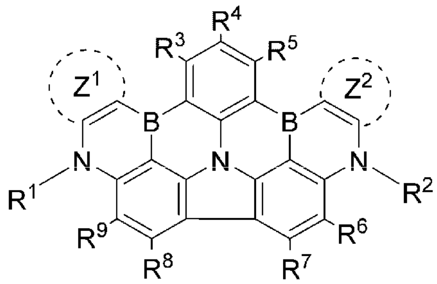

In the general formula (E5), $R^1$ and $R^2$ each independently represent a substituted or unsubstituted alkyl group, a substituted or unsubstituted aryl group, or a substituted or unsubstituted heteroaryl group, $Z^1$ and $Z^2$ each independently represent a substituted or unsubstituted aromatic ring, or a substituted or unsubstituted heteroaromatic ring, and $R^3$ to $R^9$ each independently represent a hydrogen atom, a deuterium atom or a substituent. However, at least one of $R^1$, $R^2$, $Z^1$ and $Z^2$ includes a substituted or unsubstituted benzofuran ring, a substituted or unsubstituted benzothiophene ring, or a substituted or unsubstituted indole ring. $R^1$ and $Z^1$, $Z^1$ and $R^3$, $R^3$ and $R^4$, $R^4$ and $R^5$, $R^5$ and $Z^2$, $Z^2$ and $R^2$, $R^2$ and $R^6$, $R^6$ and $R^7$, $R^7$ and $R^8$, $R^8$ and $R^9$, and $R^9$ and $R^1$ each can bond to each other to form a cyclic structure. Of the benzene ring skeleton-constituting carbon atoms to constitute the benzofuran ring, the benzothiophene ring, and the indole ring, a substitutable carbon atom can be substituted with a nitrogen atom. In the general formula (E5), C-$R^3$, C-$R^4$, C-$R^5$, C-$R^6$, C-$R^7$, C-$R^8$, and C-$R^9$ can be substituted with N.

Compounds represented by the following general formula (E6) are further preferred delayed fluorescent materials.

General Formula (E6)

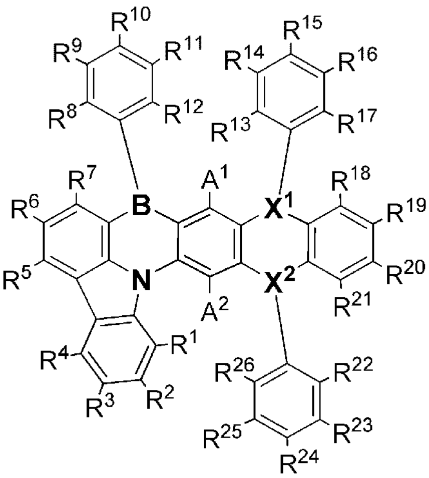

In the general formula (E6), one of $X^1$ and $X^2$ is a nitrogen atom, and the other is a boron atom. $R^1$ to $R^{26}$, $A^1$ and $A^2$ each independently represent a hydrogen atom, a deuterium atom, or a substituent. $R^1$ and $R^2$, $R^2$ and $R^3$, $R^3$ and $R^4$, $R^4$ and $R^5$, $R^5$ and $R^6$, $R^6$ and $R^7$, $R^7$ and $R^8$, $R^8$ and $R^9$, $R^9$ and $R^{10}$, $R^{10}$ and $R^{11}$, $R^{11}$ and $R^{12}$, $R^{13}$ and $R^{14}$, $R^{14}$ and $R^{15}$, $R^{15}$ and $R^{16}$, $R^{16}$ and $R^{17}$, $R^{17}$ and $R^{18}$, $R^{18}$ and $R^{19}$, $R^{19}$ and $R^{20}$, $R^{20}$ and $R^{21}$, $R^{21}$ and $R^{22}$, $R^{22}$ and $R^{23}$, $R^{23}$ and $R^{24}$, $R^{24}$ and $R^{25}$, and $R^{25}$ and $R^{26}$ each can bond to each other to form a cyclic structure. However, when $X^1$ is a nitrogen atom, $R^{17}$ and $R^{18}$ bond to each other to be a single bond to form a pyrrole ring, and when $X^2$ is a nitrogen atom, $R^{21}$ and $R^{22}$ bond to each other to be a single bond to form a pyrrole ring. However, in the case where $X^1$ is a nitrogen atom, and where $R^7$ and $R^8$, and $R^{21}$ and $R^{22}$ each bond to each other via a nitrogen atom to form a 6-membered ring, and $R^{17}$ and $R^{18}$ bond to each other to form a single bond, at least one of $R^1$ to $R^6$ is a substituted or unsubstituted aryl group, or any of $R^1$ and $R^2$, $R^2$ and $R^3$, $R^3$ and $R^4$, $R^4$ and $R^5$, and $R^5$ and $R^6$ bond to each other to form an aromatic ring or a heteroaromatic ring.

Compounds represented by the following general formula (E7) are further preferred delayed fluorescent materials.

General Formula (E7)

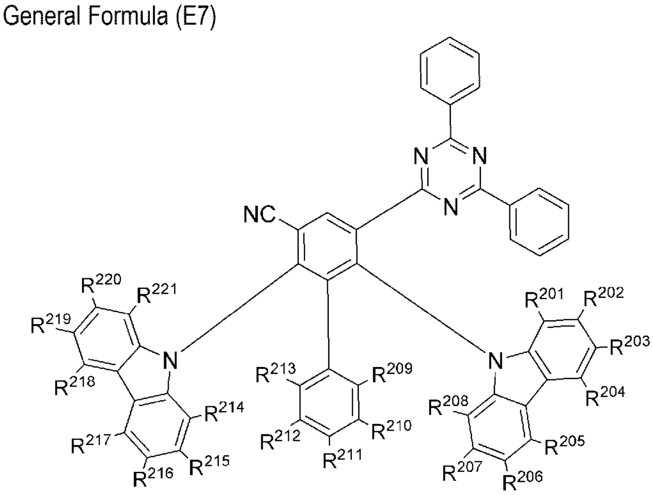

In the general formula (E7), $R^{201}$ to $R^{221}$ each independently represent a hydrogen atom, a deuterium atom or a substituent, preferably a hydrogen atom, a deuterium atom, an alkyl group, an aryl group, or a group formed by combining an alkyl group and an aryl group. At least one pair of $R^{201}$ and $R^{202}$, $R^{202}$ and $R^{203}$, $R^{203}$ and $R^{204}$, $R^{205}$ and $R^{206}$, $R^{206}$ and $R^{207}$, $R^{207}$ and $R^{208}$, $R^{214}$ and $R^{215}$, $R^{215}$ and $R^{216}$, $R^{216}$ and $R^{217}$, $R^{218}$ and $R^{219}$, $R^{219}$ and $R^{220}$, and $R^{220}$ and $R^{221}$ each bond to each other to form a benzofuro structure or a benzothieno structure. Preferably, one or two pairs of $R^{201}$ and $R^{202}$, $R^{202}$ and $R^{203}$ , $R^{203}$ and $R^{204}$, $R^{205}$ and $R^{206}$, $R^{206}$ and $R^{207}$ and $R^{207}$ and $R^{208}$, and one or two pairs of $R^{214}$ and $R^{215}$, $R^{215}$ and $R^{216}$, $R^{216}$ and $R^{217}$, $R^{218}$ and $R^{219}$, $R^{219}$ and $R^{220}$ and $R^{220}$ and $R^{221}$ bond to each other to form a benzofuro structure or a benzothieno structure. Further preferably, $R^{203}$ and $R^{204}$ bond to each other to form a benzofuro structure or a benzothieno structure, even more preferably, $R^{203}$ and $R^{204}$, and $R^{216}$ and $R^{217}$ each bond to each other to form a benzofuro structure or a benzothieno structure. Especially preferably, $R^{203}$ and $R^{204}$, and $R^{216}$ and $R^{217}$ each bond to each other to form a benzofuro structure or a benzothieno structure, and $R^{206}$ and $R^{219}$ each represent a substituted or unsubstituted aryl group (preferably, a substituted or unsubstituted phenyl group, more preferably an unsubstituted phenyl group).

Further, compounds represented by the general formula (1) described in each specification of Japanese Patent Application Nos. 2021-103698, 2021-103699, 2021-103700, 2021-081332, 2021-103701, 2021-151805, and 2021-188860 can be used as a delayed fluorescent material. Descriptions of these general formulae (1) and specific compounds are hereby incorporated by reference as a part of this description.

Preferred compound examples for use as a delayed fluorescent material are shown below. In the structural formulae of the following exemplary compounds, t-Bu represents a tertiary butyl group (tert-butyl group).

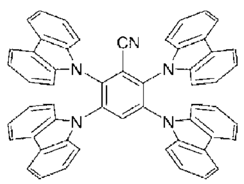

T1

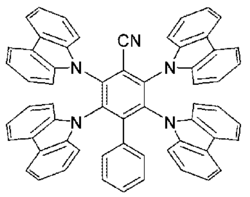

T2

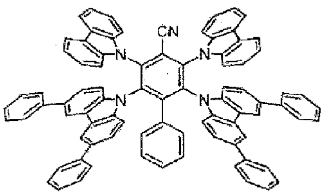

T3

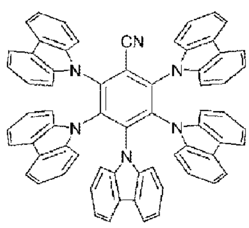

T4

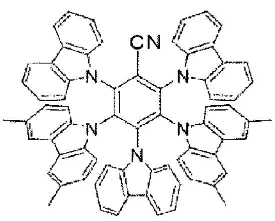

T5

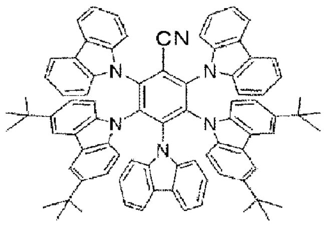

T6

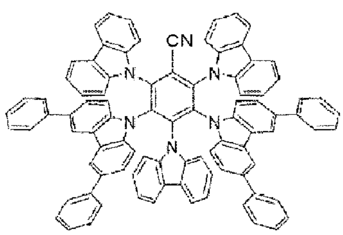

T7

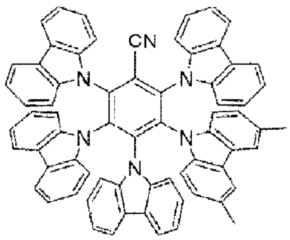

T8

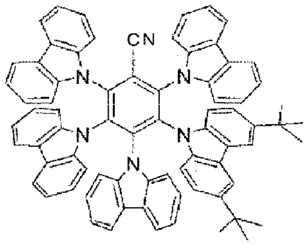

T9

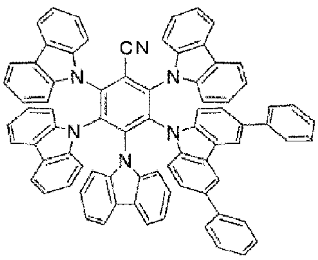

T10

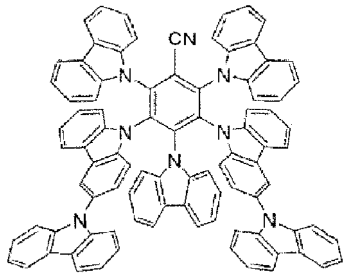

T11

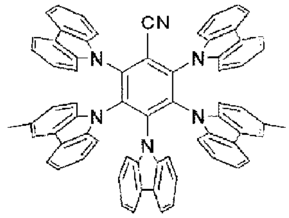

T12

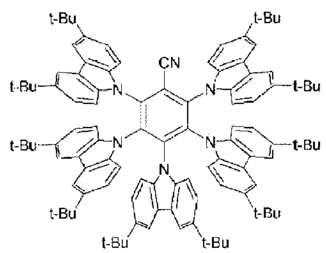

T13

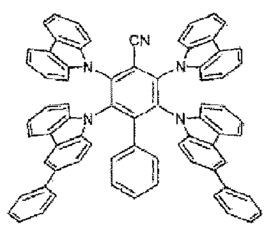

T14

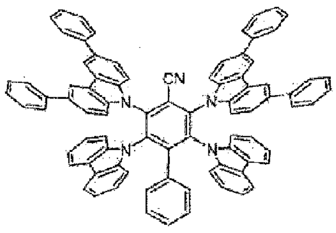

T15

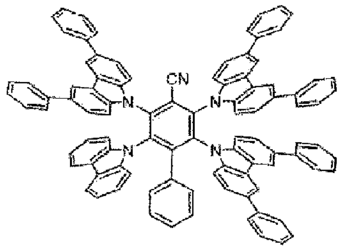

T16

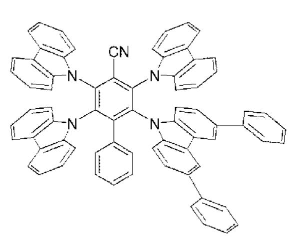

T17

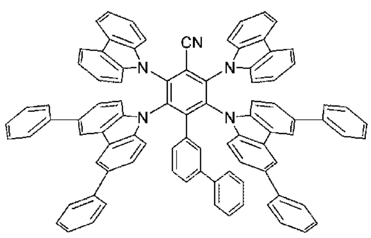

T18

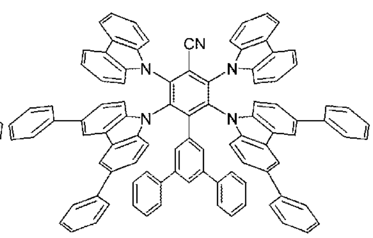

T19

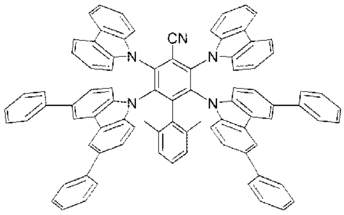
T20

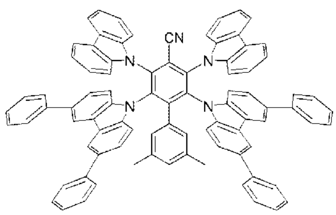
T21

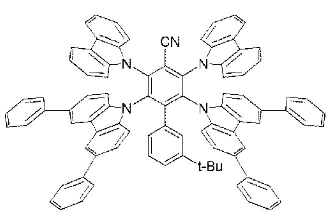
T22

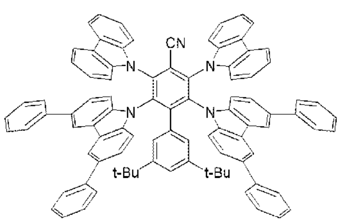
T23

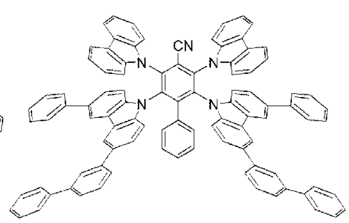
T24

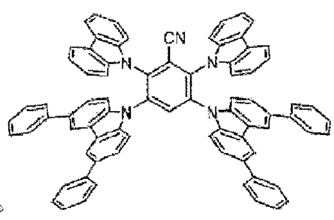
T25

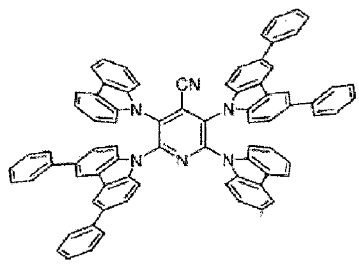
T26

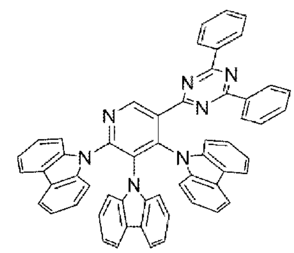
T27

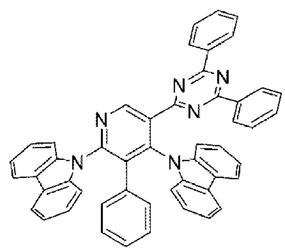
T28

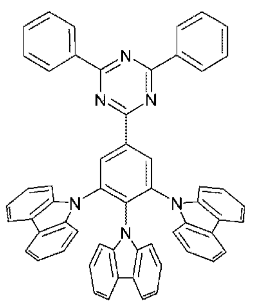
T29

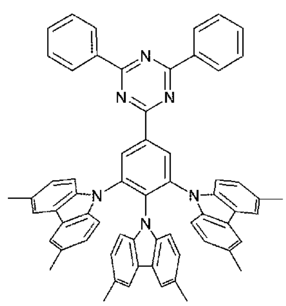
T30

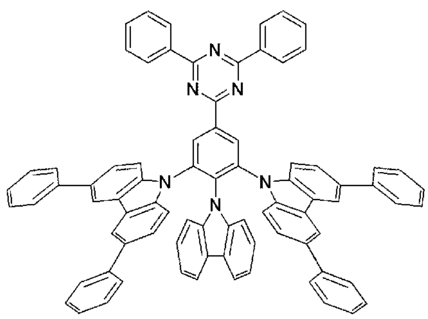
T31

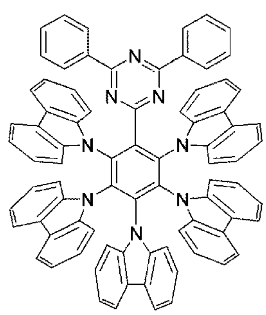
T32

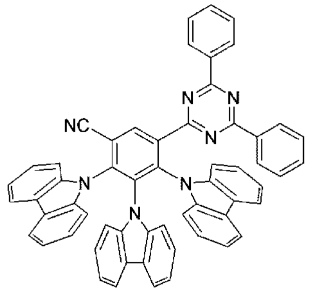
T33

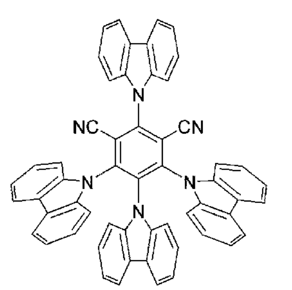
T34

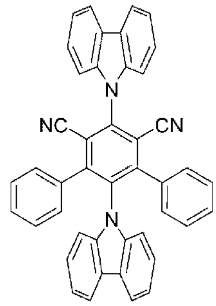
T35

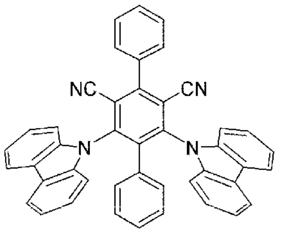
T36

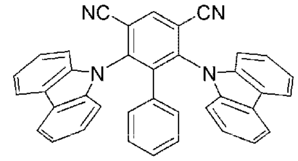
T37

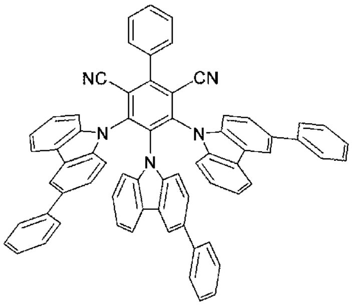
T38

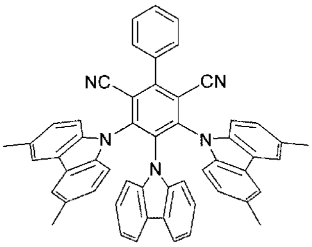
T39

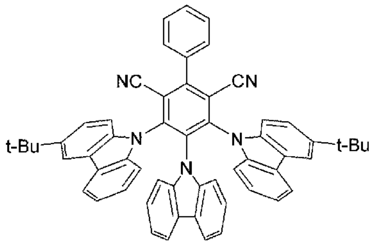
T40

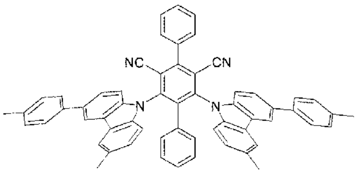
T41

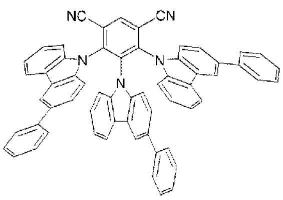
T42

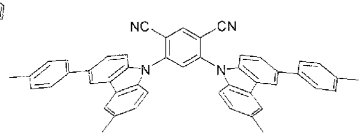
T43

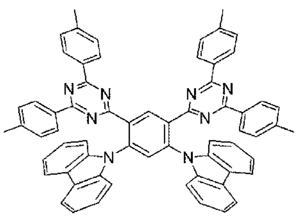
T44

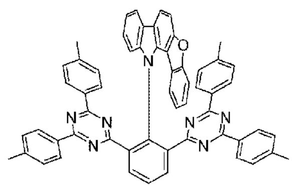
T45

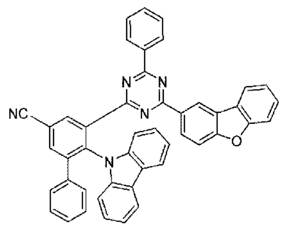
T46

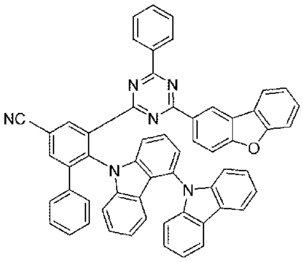
T47

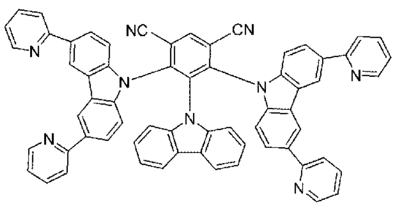
T48

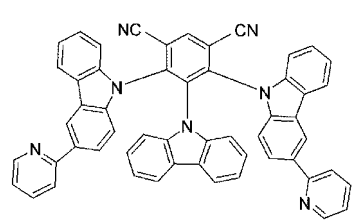

T49

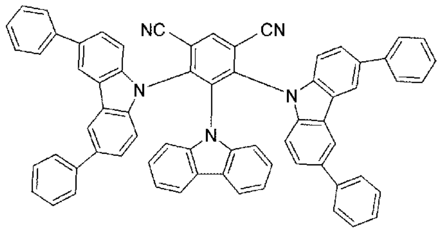

T50

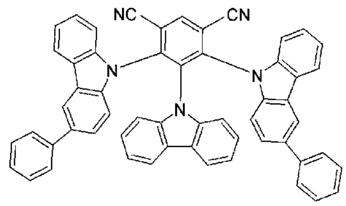

T51

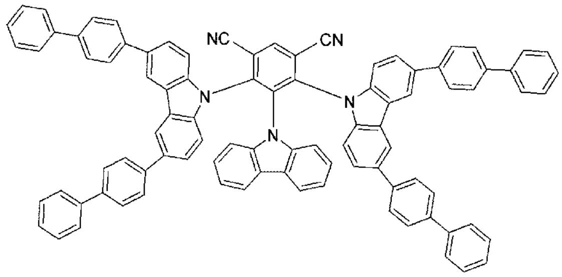

T52

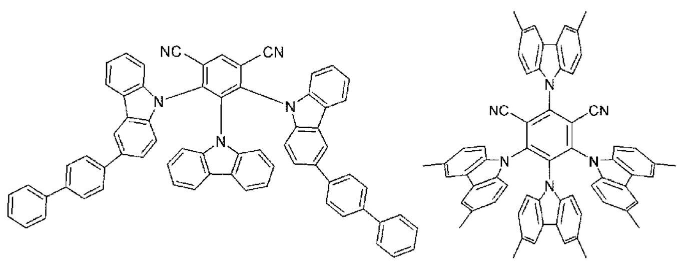

T53

T54

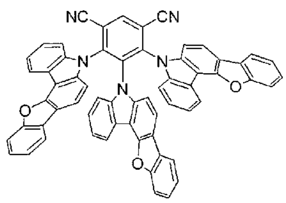

T55

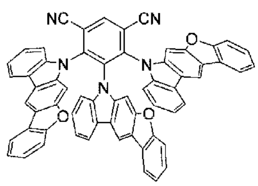

T56

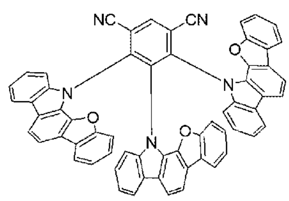

T57

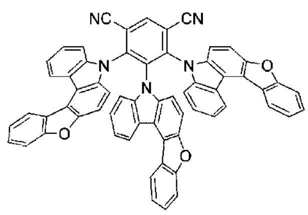

T58

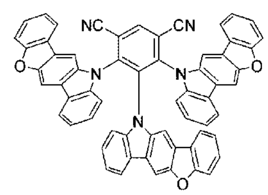

T59

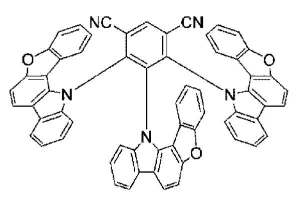

T60

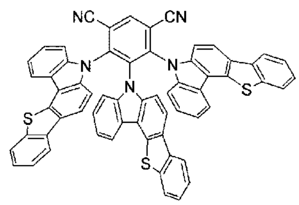

T61

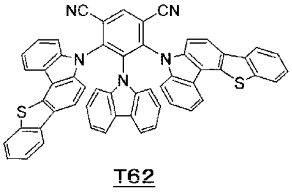

T62

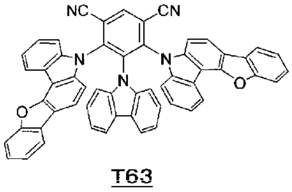

T63

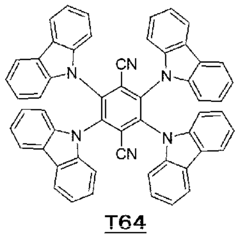

T64

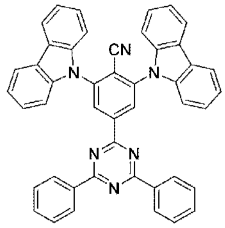

T65

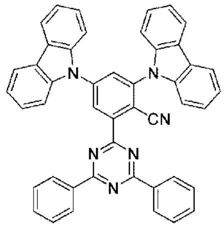

T66

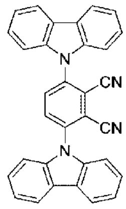

T67

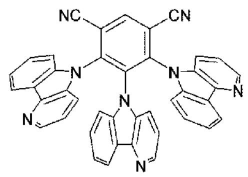

T68

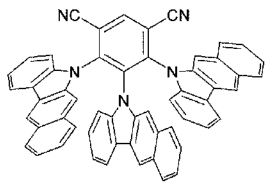

T69

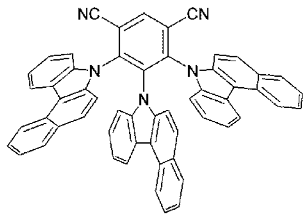

T70

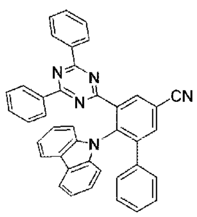

T71

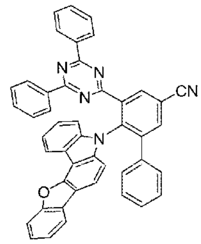

T72

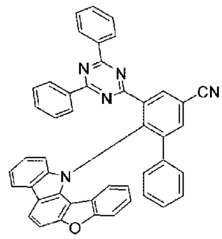

T73

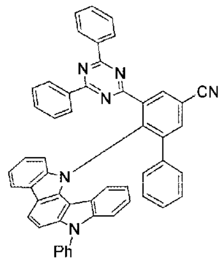

T74

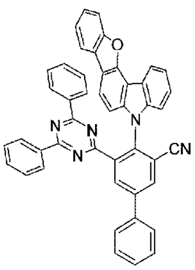

T75

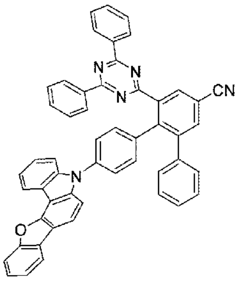

T76

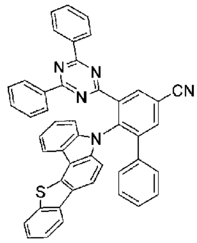

T77

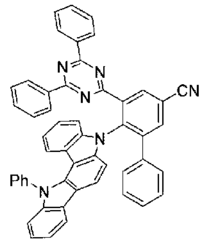

T78

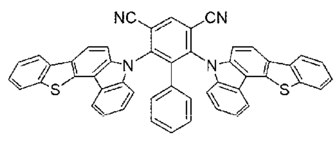

T79

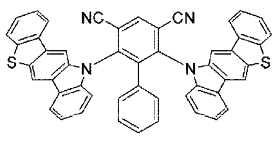

T80

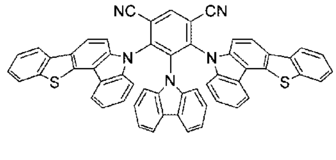

T81

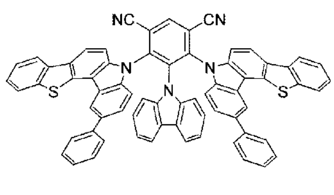

T82

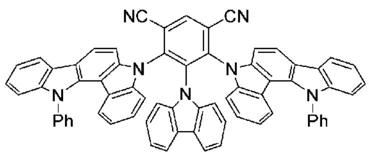

T83

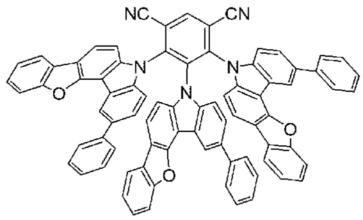

T84

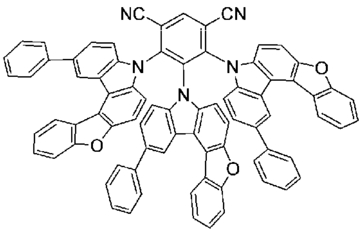

T85

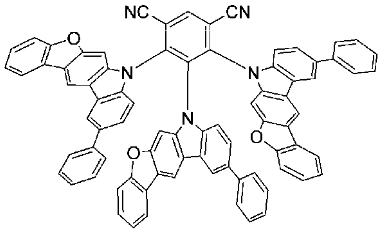

T86

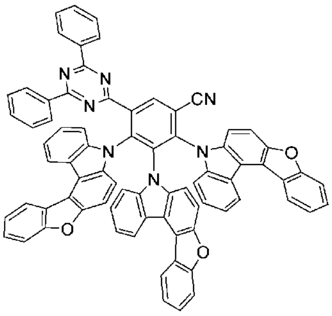

T87

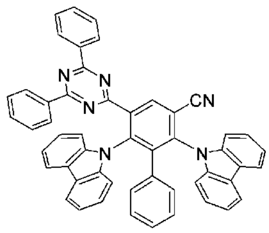

T88

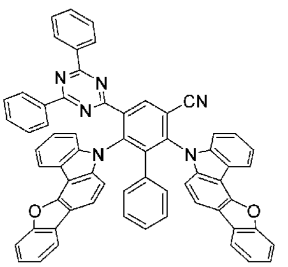

T89

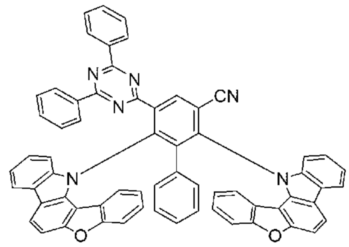

T90

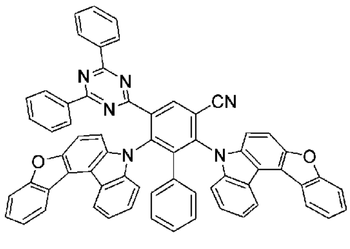

T91

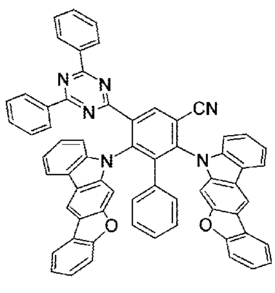

T92

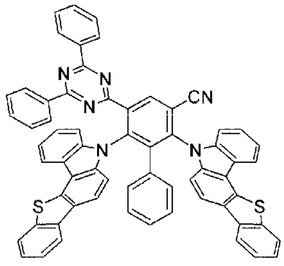

T93

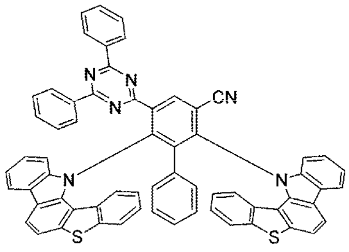

T94

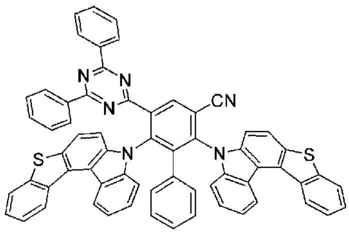

T95

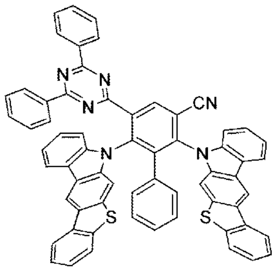

T96

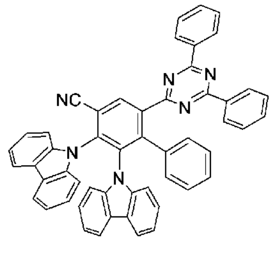

T97

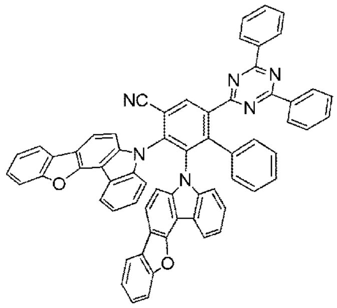

T98

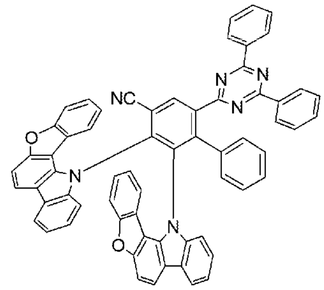

T99

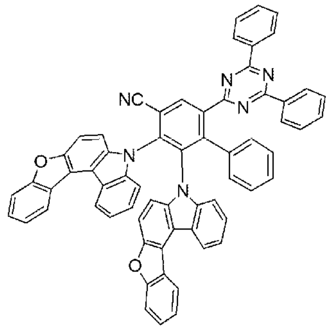

T100

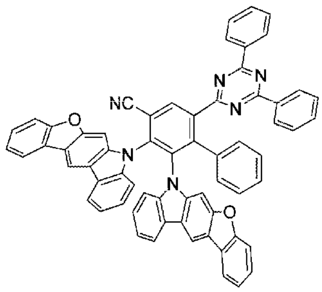

T101

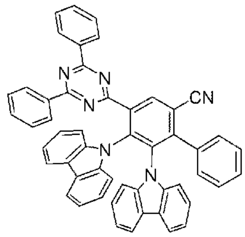

T102

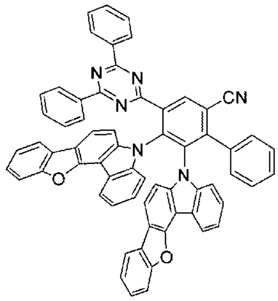

T103

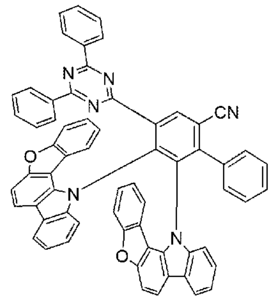

T104

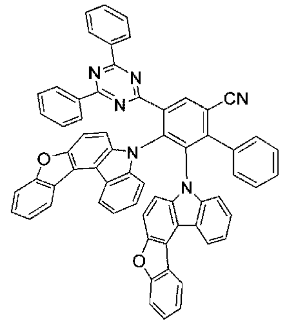

T105

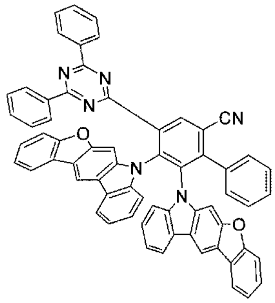

T106

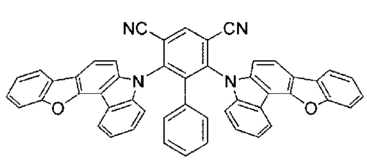

T107

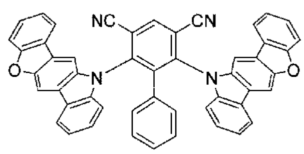

T108

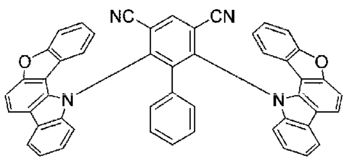

T109

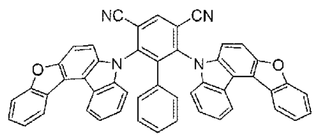

T110

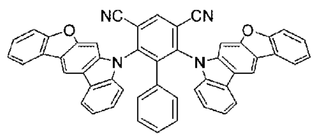

T111

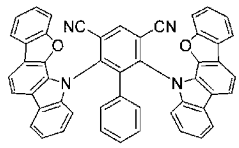

T112

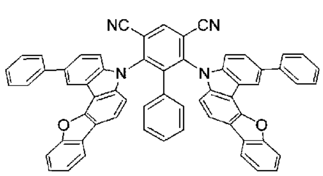

T113

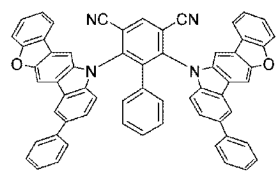

T114

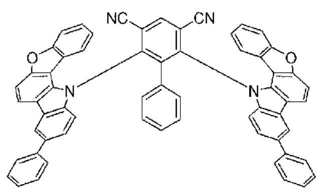

T115

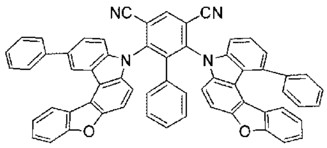

T116

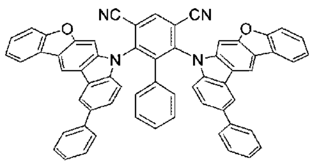

T117

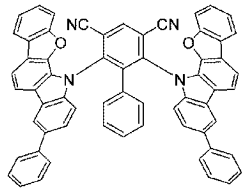

T118

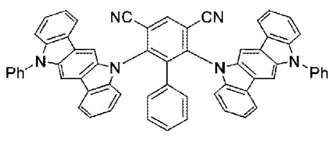

T119

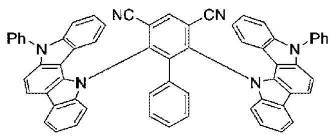

T120

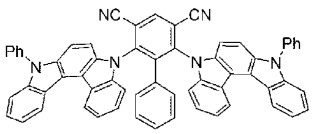

T121

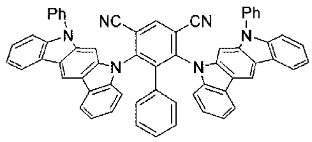

T122

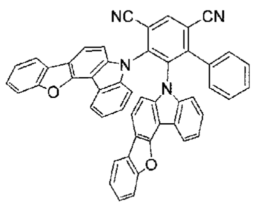

T123

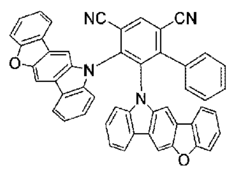

T124

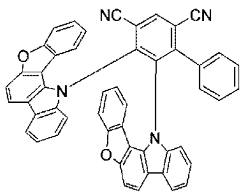

T125

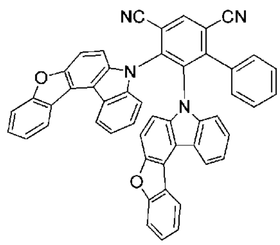

T126

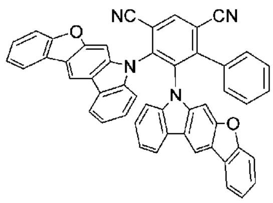

T127

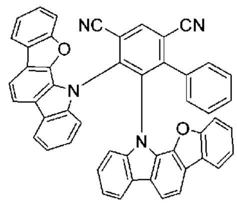

T128

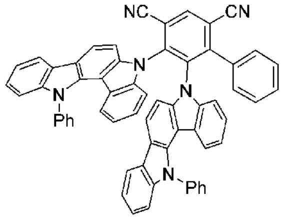

T129

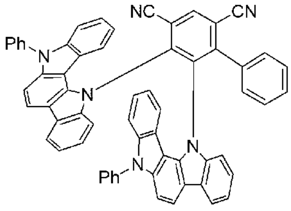

T130

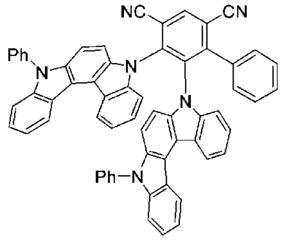

T131

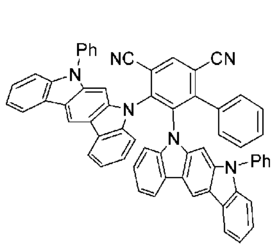

T132

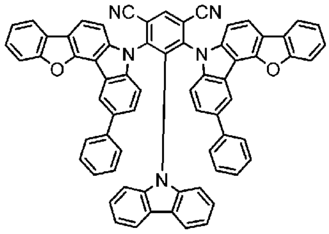

T133

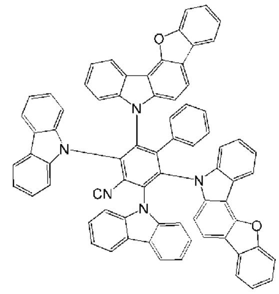

T134

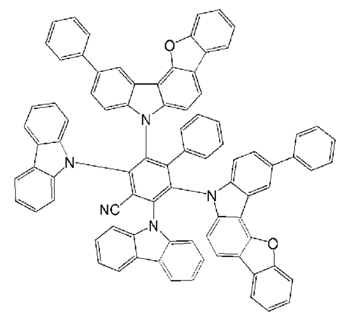

T135

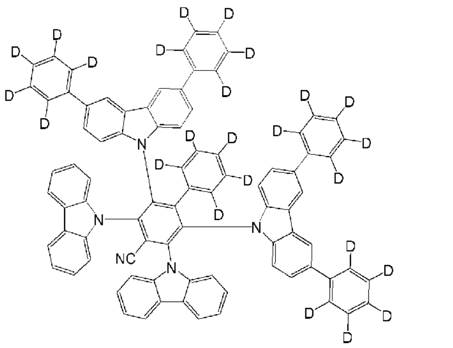

T136

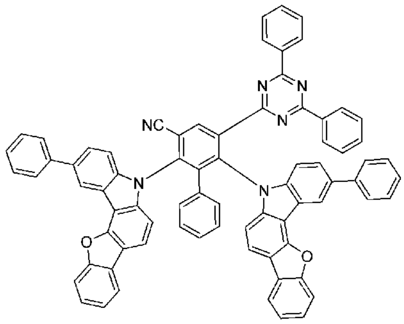

T137

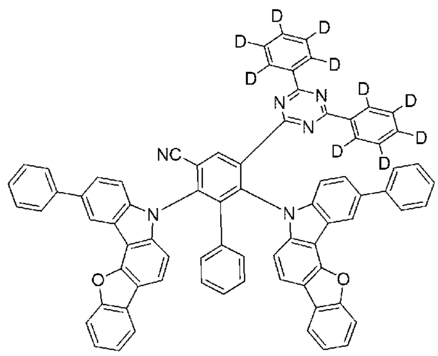

T138

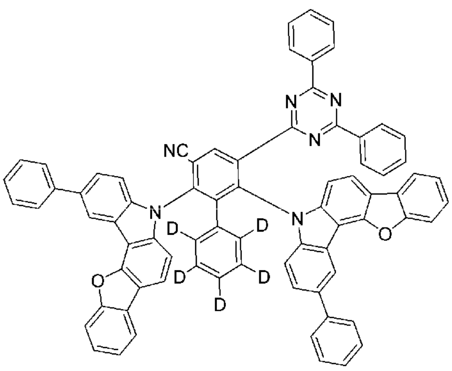

T139

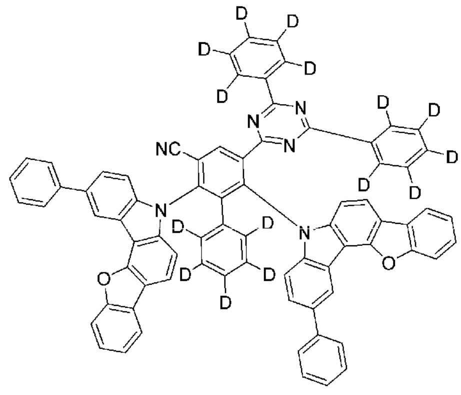

T140

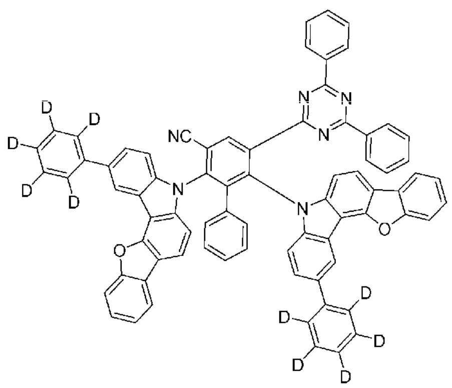

T141

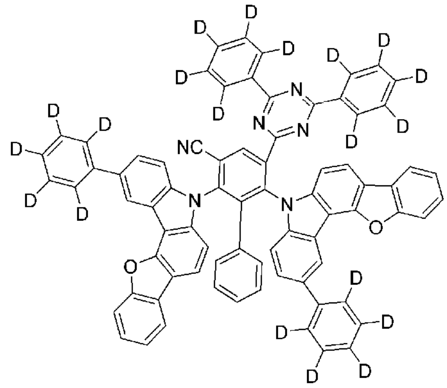

T142

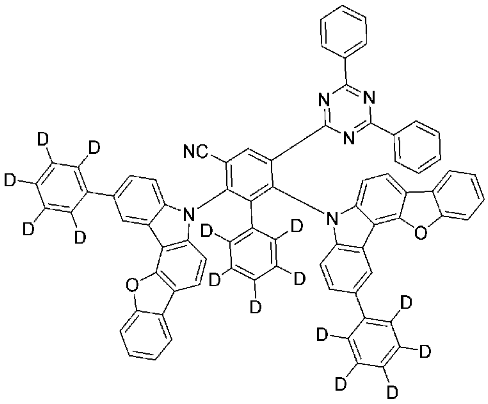

T143

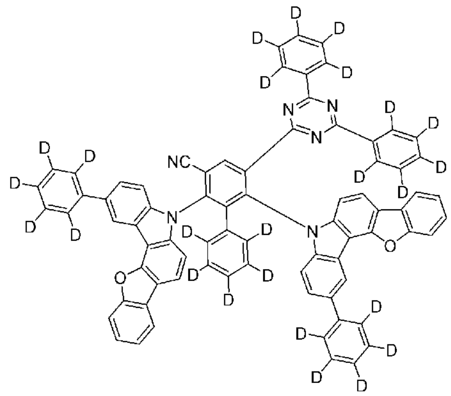

T144

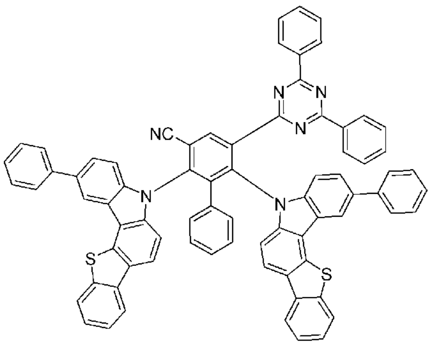

T145

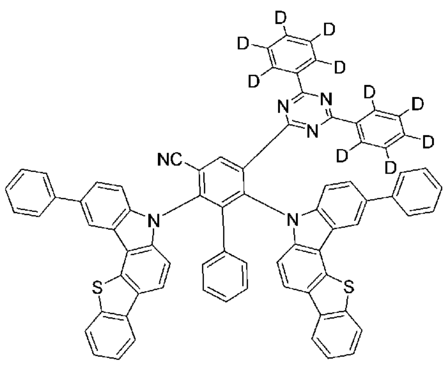

T146

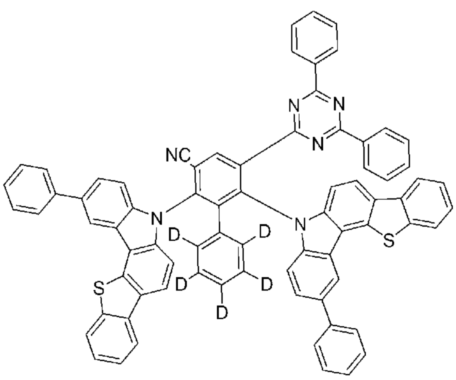

T147

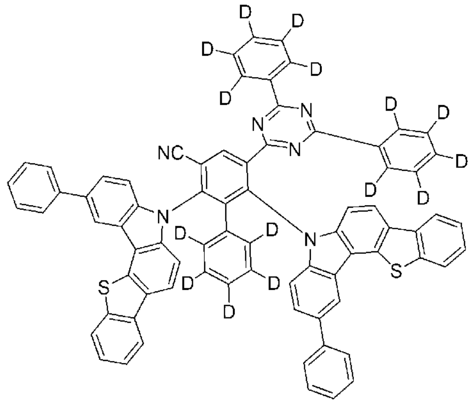

T148

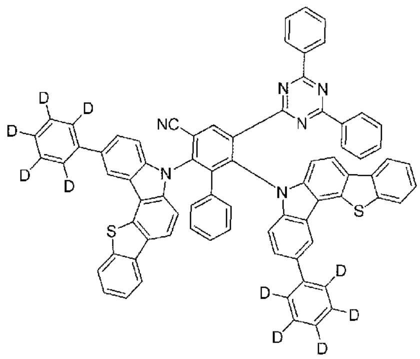

T149

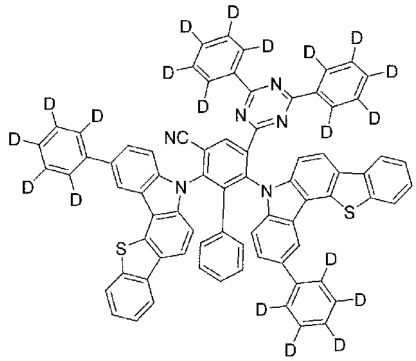

T150

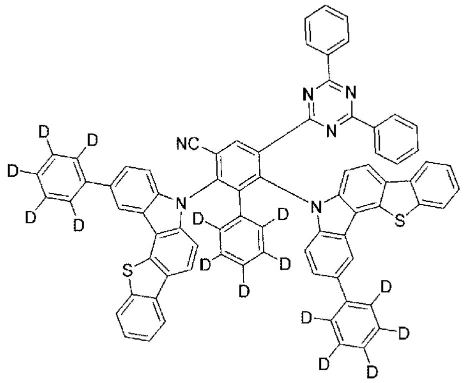

T151

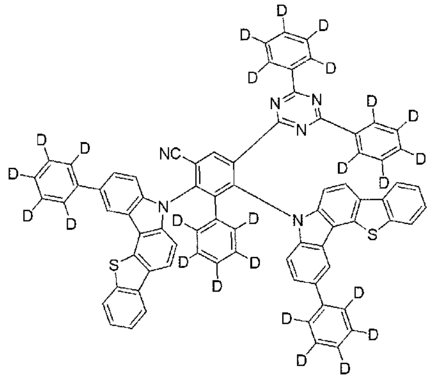

T152

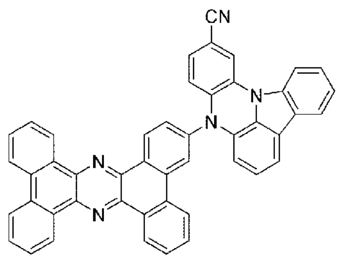

T153

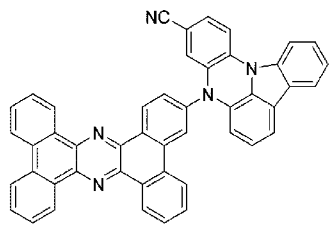

T154

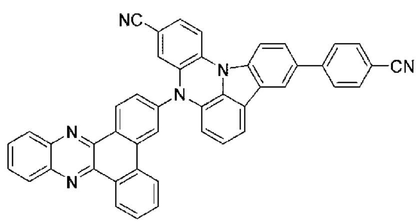

T155

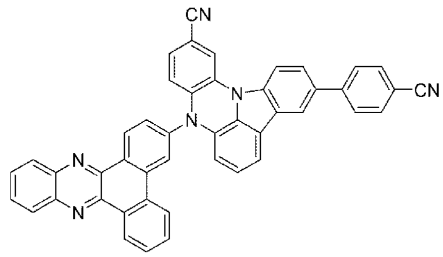

T156

Any other known delayed fluorescent materials than the above can be appropriately combined and used. In addition, unknown delayed fluorescent materials can also be used.

As delayed fluorescent materials, there can be mentioned compounds included in the general formulae described in WO2013/154064A, paragraphs 0008 to 0048 and 0095 to 0133; WO2013/011954A, paragraphs 0007 to 0047 and 0073 to 0085; WO2013/011955A, paragraphs 0007 to 0033 and 0059 to 0066; WO2013/081088A, paragraphs 0008 to 0071 and 0118 to 0133; JP2013-256490A, paragraphs 0009 to 0046 and 0093 to 0134; JP2013-116975A, paragraphs 0008 to 0020 and 0038 to 0040; WO2013/133359A, paragraphs 0007 to 0032 and 0079 to 0084; WO2013/161437A, paragraphs 0008 to 0054 and 0101 to 0121; JP2014-9352A, paragraphs 0007 to 0041 and 0060 to 0069; and JP2014-9224A, paragraphs 0008 to 0048 and 0067 to 0076; JP2017-119663A, paragraphs 0013 to 0025;

JP2017-119664A, paragraphs 0013 to 0026; JP2017-222623A, paragraphs 0012 to 0025; JP2017-226838A, paragraphs 0010 to 0050; JP2018-100411A, paragraphs 0012 to 0043; WO2018/047853A, paragraphs 0016 to 0044; and especially, exemplary compounds therein capable of emitting delayed fluorescence. In addition, also employable here are light emitting materials capable of emitting delayed fluorescence, as described in JP2013-253121A, WO2013/133359A, WO2014/034535A, WO2014/115743A, WO2014/122895A, WO2014/126200A, WO2014/136758A, WO2014/133121A, WO2014/136860A, WO2014/196585A, WO2014/189122A, WO2014/168101A, WO2015/008580A, WO2014/203840A, WO2015/002213A, WO2015/016200A, WO2015/019725A, WO2015/072470A, WO2015/108049A, WO2015/080182A, WO2015/072537A, WO2015/080183A, JP2015-129240A, WO2015/129714A, WO2015/129715A, WO2015/133501A, WO2015/136880A, WO2015/137244A, WO2015/137202A, WO2015/137136A, WO2015/146541A and WO2015/159541A. These patent publications described in this paragraph are hereby incorporated as a part of this description by reference.

In some embodiments, the light emitting layer contains two or more kinds of TADF molecules differing in the structure. For example, the light emitting layer can contain three kinds of materials of a host material, a first TADF molecule and a second TADF molecule whose excited singlet energy level is higher in that order. In that case, both the first TADF molecule and the second TADF molecule are preferably such that the difference $\Delta E_{ST}$ between the lowest excited singlet energy level and the lowest excited triplet energy level at 77 K is 0.3 eV or less, more preferably 0.25 eV or less, even more preferably 0.2 eV or less, further more preferably 0.15 eV or less, further more preferably 0.1 eV or less, further more preferably 0.07 eV or less, further more preferably 0.05 eV or less, further more preferably 0.03 eV or less, and particularly preferably 0.01 eV or less. The content of the first TADF molecule in the light emitting layer is preferably larger than the content of the second TADF molecule therein. The content of the host material in the light emitting layer is preferably larger than the content of the second TADF molecule therein. The content of the first TADF molecule in the light emitting layer can be larger than or can be smaller than or can be the same as the content of the host material therein. In some embodiments, the composition in the light emitting layer can be 10 to 70% by weight of a host material, 10 to 80% by weight of a first TADF molecule, and 0.1 to 30% by weight of a second TADF molecule. In some embodiments, the composition in the light emitting layer can be 20 to 45% by weight of a host material, 50 to 75% by weight of a first TADF molecule, and 5 to 20% by weight of a second TADF molecule. In some embodiments, the emission quantum yield $\phi$PL1(A) by photo-excitation of a vapor co-deposited film of a first TADF molecule and a host material (the content of the first TADF molecule in the vapor co-deposited film = A% by weight) and the emission quantum yield $\phi$PL2(A) by photo-excitation of a vapor co-deposited film of a second TADF molecule and a host material (the content of the second TADF molecule in the vapor co-deposited film = A% by weight) satisfy a relational formula $\phi$PL1(A) > $\phi$PL2(A). In some embodiments, the emission quantum yield $\phi$PL2(B) by photo-excitation of a vapor co-deposited film of a second TADF molecule and a host material (the content of the second TADF molecule in the vapor co-deposited film = B% by weight) and the emission quantum yield $\phi$PL2(100) by photo-excitation of a single film of a second TADF molecule satisfy a relational formula $\phi$PL2(B) > $\phi$PL2(100). In some embodiments, the light emitting layer can contain three kinds of TADF molecules differing in the structure. The compound of the present invention can be any of the plural TADF compounds contained in the light emitting layer.

In the following, the constituent members and the other layers than the light emitting layer of the organic electroluminescent device are described.

Substrate:

In some embodiments, the organic electroluminescent device of the present invention is supported by a substrate, wherein the substrate is not particularly limited and can be any materials that have been commonly used in an organic electroluminescent device, for example those formed of glass, transparent plastics, quartz and silicon.

Anode:

In some embodiments, the anode of the organic electroluminescent device is made of a metal, an alloy, an electroconductive compound, or a combination thereof. In some embodiments, the metal, alloy, or electroconductive compound has a large work function (4 eV or more). In some embodiments, the metal is Au. In some embodiments, the electroconductive transparent material is selected from CuI, indium tin oxide (ITO), $SnO_2$, and ZnO. In some embodiments, an amorphous material capable of forming a transparent electroconductive film, such as IDIXO ($In_2O_3$-ZnO), is be used. In some embodiments, the anode is a thin film. In some embodiments, the thin film is made by vapor deposition or sputtering. In some embodiments, the film is patterned by a photolithography method. In some embodiments, where the pattern may not require high accuracy (for example, approximately 100 $\mu$m or more), the pattern can be formed with a mask having a desired shape on vapor deposition or sputtering of the electrode material. In some embodiments, when a material can be applied as a coating, such as an organic electroconductive compound, a wet film forming method, such as a printing method or a coating method is used. In some embodiments, when the emitted light goes through the anode, the anode has a transmittance of more than 10%, and the anode has a sheet resistance of several hundred Ohm per unit area

or less. In some embodiments, the thickness of the anode is from 10 to 1,000 nm. In some embodiments, the thickness of the anode is from 10 to 200 nm. In some embodiments, the thickness of the anode varies depending on the material used.

Cathode:

In some embodiments, the cathode is made of an electrode material such as a metal having a small work function (4 eV or less) (referred to as an electron injection metal), an alloy, an electroconductive compound, or a combination thereof. In some embodiments, the electrode material is selected from sodium, a sodium-potassium alloy, magnesium, lithium, a magnesium-copper mixture, a magnesium-silver mixture, a magnesium-aluminum mixture, a magnesium-indium mixture, an aluminum-aluminum oxide ($Al_2O_3$) mixture, indium, a lithium-aluminum mixture, and a rare earth element. In some embodiments, a mixture of an electron injection metal and a second metal that is a stable metal having a larger work function than that of the electron injection metal is used. In some embodiments, the mixture is selected from a magnesium-silver mixture, a magnesium-aluminum mixture, a magnesium-indium mixture, an aluminum-aluminum oxide ($Al_2O_3$) mixture, a lithium-aluminum mixture, and aluminum. In some embodiments, the mixture increases the electron injection property and the durability against oxidation. In some embodiments, the cathode is produced by forming the electrode material into a thin film by vapor deposition or sputtering. In some embodiments, the cathode has a sheet resistance of several hundred Ohm per unit area or less. In some embodiments, the thickness of the cathode is from 10 nm to 5 $\mu$m. In some embodiments, the thickness of the cathode is from 50 to 200 nm. In some embodiments, for transmitting the emitted light, any one of the anode and the cathode of the organic electroluminescent device is transparent or translucent. In some embodiments, the transparent or translucent electroluminescent devices enhances the light emission luminance.

In some embodiments, the cathode is formed with an electroconductive transparent material, as described for the anode, to form a transparent or translucent cathode. In some embodiments, a device comprises an anode and a cathode, both being transparent or translucent.

Injection Layer:

An injection layer is a layer between the electrode and the organic layer. In some embodiments, the injection layer decreases the drive voltage and enhances the light emission luminance. In some embodiments, the injection layer includes a hole injection layer and an electron injection layer. The injection layer can be positioned between the anode and the light emitting layer or the hole transporting layer, and between the cathode and the light emitting layer or the electron transporting layer. In some embodiments, an injection layer is present. In some embodiments, no injection layer is present.

Preferred compound examples for use as a hole injection material are shown below.

$MoO_3$,

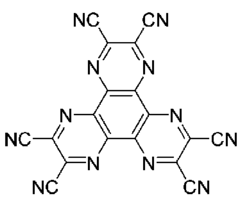

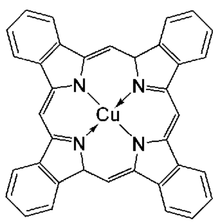

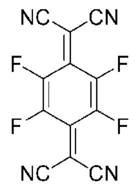

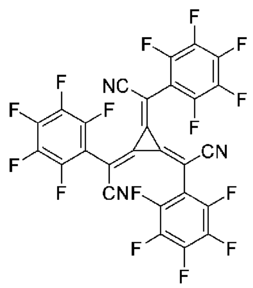

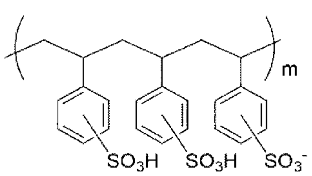

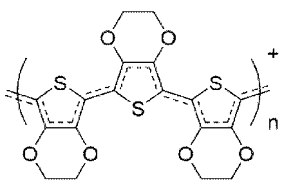

Next, preferred compound examples for use as an electron injection material are shown below.

LiF, CsF,

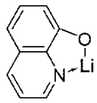

Barrier Layer:

A barrier layer is a layer capable of inhibiting charges (electrons or holes) and/or excitons present in the light emitting layer from being diffused outside the light emitting layer. In some embodiments, the electron barrier layer is between the light emitting layer and the hole transporting layer, and inhibits electrons from passing through the light emitting layer toward the hole transporting layer. In some embodiments, the hole barrier layer is between the light emitting layer and the electron transporting layer, and inhibits holes from passing through the light emitting layer toward the electron transporting layer. In some embodiments, the barrier layer inhibits excitons from being diffused outside the light emitting layer. In some embodiments, the electron barrier layer and the hole barrier layer are exciton barrier layers. As used herein, the term "electron barrier layer" or "exciton barrier layer" includes a layer that has both the function of an electron barrier layer and the function of an exciton barrier layer.

Hole Barrier Layer:

A hole barrier layer acts as an electron transporting layer. In some embodiments, the hole barrier layer inhibits holes from reaching the electron transporting layer while transporting electrons. In some embodiments, the hole barrier layer enhances the recombination probability of electrons and holes in the light emitting layer. The material used for the hole barrier layer can be the same materials as the ones described for the electron transporting layer.

Preferred compound examples for use for the hole barrier layer are shown below.

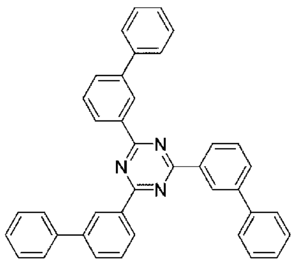
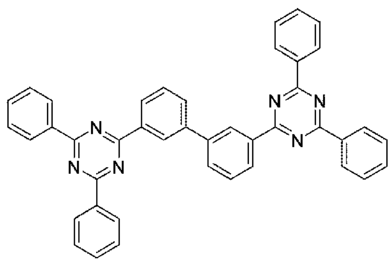
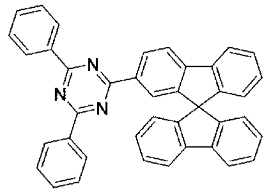
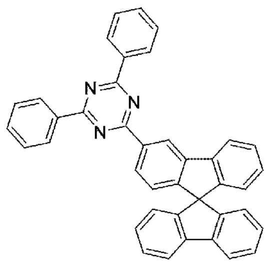
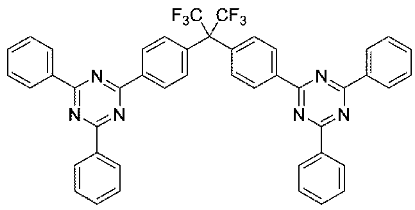
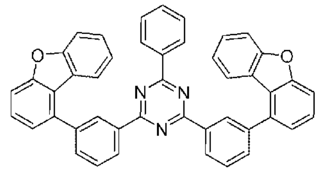
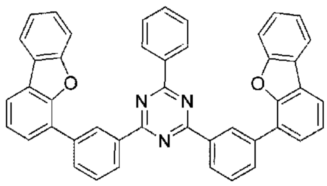
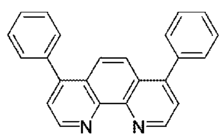
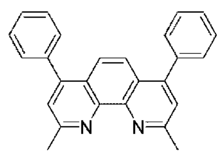

Electron Barrier Layer:

An electron barrier layer transports holes. In some embodiments, the electron barrier layer inhibits electrons from reaching the hole transporting layer while transporting holes. In some embodiments, the electron barrier layer enhances the recombination probability of electrons and holes in the light emitting layer. The material used for the electron barrier layer can be the same material as the ones described above for the hole transporting layer.

Specific examples of a preferred compound for use as the electron barrier material are shown below.

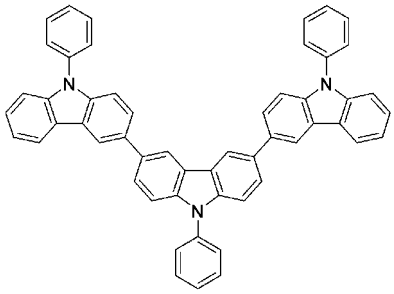
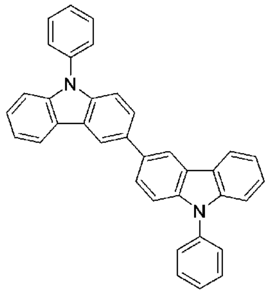
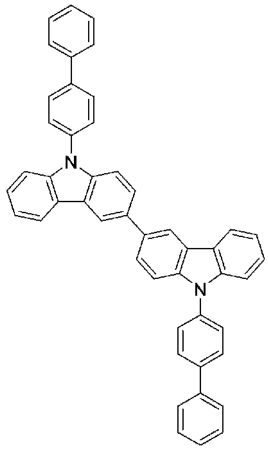

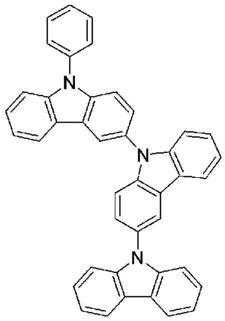
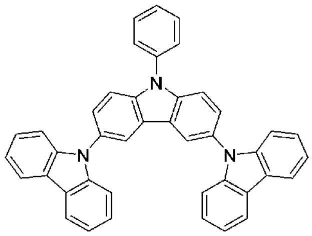
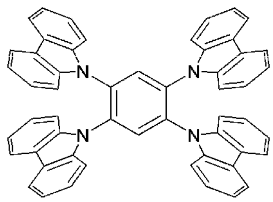

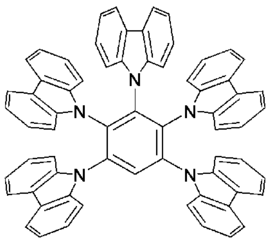
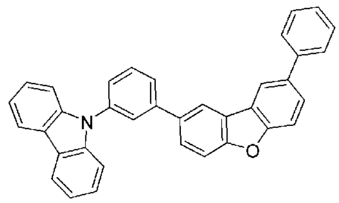
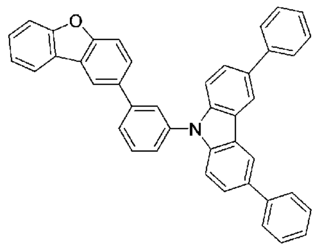

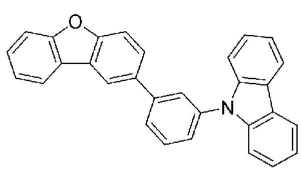

Exciton Barrier Layer:

An exciton barrier layer inhibits excitons generated through recombination of holes and electrons in the light emitting layer from being diffused to the charge transporting layer. In some embodiments, the exciton barrier layer enables effective confinement of excitons in the light emitting layer. In some embodiments, the light emission efficiency of the device is enhanced. In some embodiments, the exciton barrier layer is adjacent to the light emitting layer on any of the side of the anode and the side of the cathode, and on both the sides. In some embodiments, where the exciton barrier layer is on the side of the anode, the layer can be between the hole transporting layer and the light emitting layer and adjacent to the light emitting layer. In some embodiments, where the exciton barrier layer is on the side of the cathode, the layer can be between the light emitting layer and the cathode and adjacent to the light emitting layer. In some embodiments, a hole injection layer, an electron barrier layer, or a similar layer is between the anode and the exciton barrier layer that is adjacent to the light emitting layer on the side of the anode. In some embodiments, a hole injection layer, an electron barrier layer, a hole barrier layer, or a similar layer is between the cathode and the exciton barrier layer that is adjacent to the light emitting layer on the side of the cathode. In some embodiments, the exciton barrier layer comprises excited singlet energy and excited triplet energy, at least one of which is higher than the excited singlet energy and the excited triplet energy of the light

emitting material, respectively.

Hole Transporting Layer:

The hole transporting layer comprises a hole transporting material. In some embodiments, the hole transporting layer is a single layer. In some embodiments, the hole transporting layer comprises a plurality of layers.

In some embodiments, the hole transporting material has one of injection or transporting property of holes and barrier property of electrons. In some embodiments, the hole transporting material is an organic material. In some embodiments, the hole transporting material is an inorganic material. Examples of known hole transporting materials that can be used in the present invention include but are not limited to a triazole derivative, an oxadiazole derivative, an imidazole derivative, a carbazole derivative, an indolocarbazole derivative, a polyarylalkane derivative, a pyrazoline derivative, a pyrazolone derivative, a phenylenediamine derivative, an allylamine derivative, an amino-substituted chalcone derivative, an oxazole derivative, a styrylanthracene derivative, a fluorenone derivative, a hydrazone derivative, a stilbene derivative, a silazane derivative, an aniline copolymer and an electroconductive polymer oligomer (particularly, a thiophene oligomer), or a combination thereof. In some embodiments, the hole transporting material is selected from a porphyrin compound, an aromatic tertiary amine compound, and a styrylamine compound. In some embodiments, the hole transporting material is an aromatic tertiary amine compound. Specific examples of a preferred compound for use as the hole transporting material are shown below.

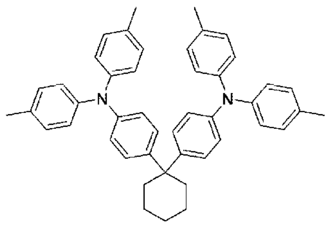
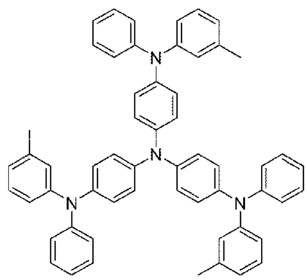
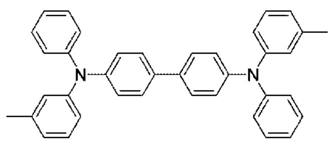

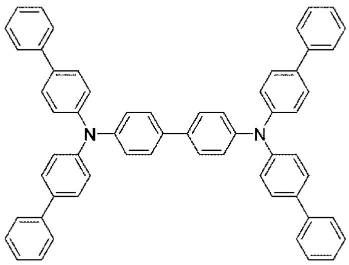
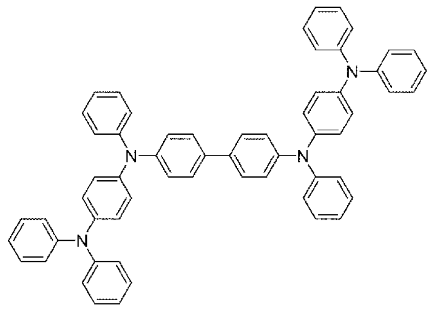

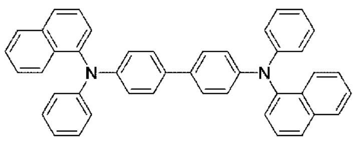
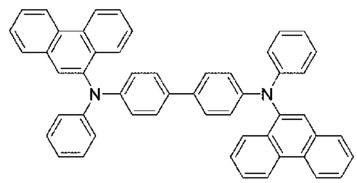

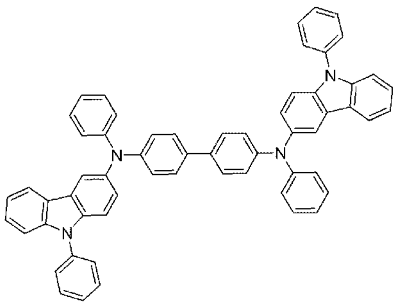
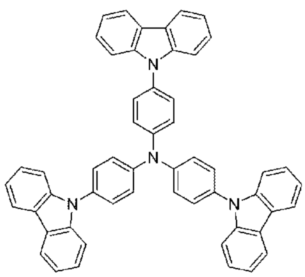
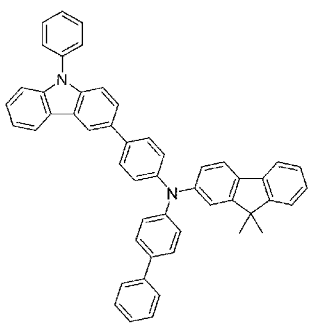

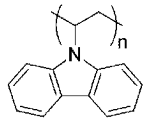
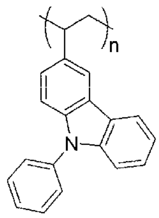
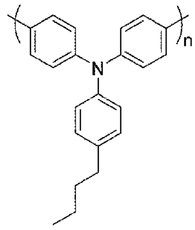

Electron Transporting Layer:

The electron transporting layer comprises an electron transporting material. In some embodiments, the electron transporting layer is a single layer. In some embodiments, the electron transporting layer comprises a plurality of layers.

In some embodiments, the electron transporting material needs only to have a function of transporting electrons, which are injected from the cathode, to the light emitting layer. In some embodiments, the electron transporting material also function as a hole barrier material. Examples of the electron transporting layer that can be used in the present invention include but are not limited to a nitro-substituted fluorene derivative, a diphenylquinone derivative, a thiopyran dioxide derivative, carbodiimide, a fluorenylidene methane derivative, anthraquinodimethane, an anthrone derivatives, an oxadiazole derivative, an azole derivative, an azine derivative, or a combination thereof, or a polymer thereof. In some embodiments, the electron transporting material is a thiadiazole derivative, or a quinoxaline derivative. In some embodiments, the electron transporting material is a polymer material. Specific examples of a preferred compound for use as the electron transporting material are shown below.

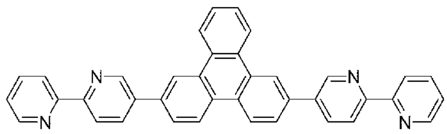
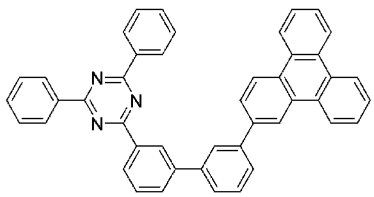
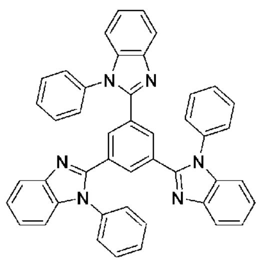
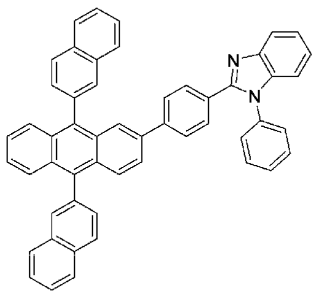
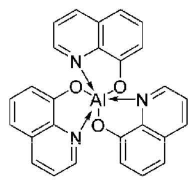
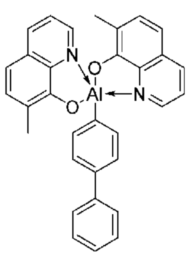
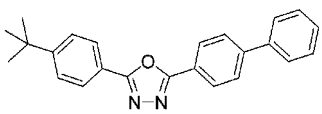
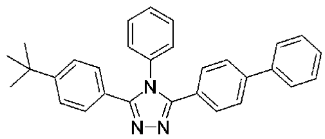

Further, compound examples preferred as a material that can be added to the organic layers are shown. For example, it is conceivable to add these as a stabilization material.

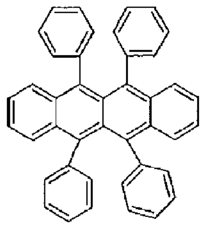 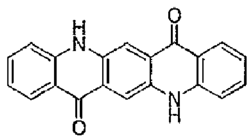 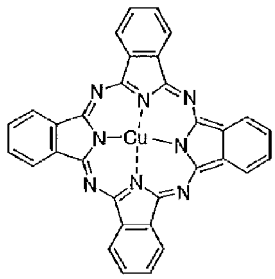

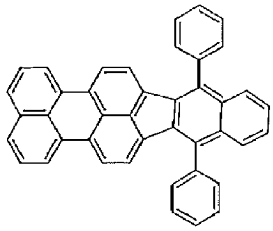 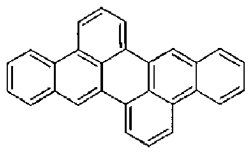

Preferred materials for use in the organic electroluminescent device are specifically shown. However, the materials usable in the present invention should not be limitatively interpreted by the above exemplary compounds. Compounds that are exemplified as materials having a specific function can also be used as materials having any other function.

Devices:

In some embodiments, a light emitting layer is incorporated into a device. For example, the device includes, but is not limited to an OLED bulb, an OLED lamp, a television screen, a computer monitor, a mobile phone, and a tablet.

In some embodiments, an electronic device includes an OLED comprising an anode, a cathode, and at least one organic layer comprising a light emitting layer between the anode and the cathode.

In some embodiments, compositions described herein can be incorporated into various light-sensitive or light-activated devices, such as OLEDs or opto-electronic devices. In some embodiments, the composition can be useful in facilitating charge transfer or energy transfer within a device and/or as a hole-transport material. The device can be, for example, an organic light emitting diode (OLED), an organic integrated circuit (O-IC), an organic field-effect transistor (O-FET), an organic thin-film transistor (O-TFT), an organic light emitting transistor (O-LET), an organic solar cell (O-SC), an organic optical detector, an organic photoreceptor, an organic field-quench device (O-FQD), a light emitting electrochemical cell (LEC) or an organic laser diode (O-laser).

Bulbs or Lamps:

In some embodiments, an electronic device includes an OLED comprising an anode, a cathode, and at least one organic layer comprising a light emitting layer between the anode and the cathode.

In some embodiments, a device comprises OLEDs that differ in color. In some embodiments, a device comprises an array comprising a combination of OLEDs. In some embodiments, the combination of OLEDs is a combination of three colors (e.g., RGB). In some embodiments, the combination of OLEDs is a combination of colors that are not red, green, or blue (for example, orange and yellow green). In some embodiments, the combination of OLEDs is a combination of two, four, or more colors.

In some embodiments, a device is an OLED light comprising:

a circuit board having a first surface with a mounting surface and an opposing second surface, and defining at least one opening;

at least one OLED on the mounting surface, the at least one OLED configured to emanate light, the OLED comprising: an anode, a cathode, and at least one organic layer comprising a light emitting layer between the anode and the cathode;

a housing for the circuit board; and

at least one connector arranged at an end of the housing, the housing and the connector defining a package adapted for installation in a light fixture.

In some embodiments, the OLED light comprises a plurality of OLEDs mounted on a circuit board such that light emanates in a plurality of directions. In some embodiments, a portion of the light emanated in a first direction is deflected to emanate in a second direction. In some embodiments, a reflector is used to deflect the light emanated in a first direction.

Displays or Screens:

In some embodiments, the light emitting layer of the present invention can be used in a screen or a display. In some embodiments, the compounds of the present invention are deposited onto a substrate using a process including, but not limited to, vacuum evaporation, deposition, vapor deposition, or chemical vapor deposition (CVD). In some embodiments, the substrate is a photoplate structure useful in a two-sided etching that provides a unique aspect ratio pixel. The screen (which can also be referred to as a mask) is used in a process in the manufacturing of OLED displays. The corresponding artwork pattern design facilitates a very steep and narrow tie-bar between the pixels in the vertical direction and a large, sweeping bevel opening in the horizontal direction. This allows the fine patterning of pixels needed for high resolution displays while optimizing the chemical vapor deposition onto a TFT backplane.

The internal patterning of the pixel allows the construction of a three-dimensional pixel opening with varying aspect ratios in the horizontal and vertical directions. Additionally, the use of imaged "stripes" or halftone circles within the pixel area inhibits etching in specific areas until these specific patterns are undercut and fall off the substrate. At that point the entire pixel area is subjected to a similar etching rate but the depths are varying depending on the halftone pattern. Varying the size and spacing of the halftone pattern allow etching to be inhibited at different rates within the pixel and allow a localized deeper etch needed to create steep vertical bevels.

A preferred material for the deposition mask is invar. Invar is a metal alloy that is cold rolled into a long thin sheet in a steel mill. Invar cannot be electrodeposited onto a rotating mandrel as the nickel mask. A preferred and more cost feasible method for forming the opening areas in the mask used for deposition is through a wet chemical etching.

In some embodiments, a screen or display pattern is a pixel matrix on a substrate. In some embodiments, a screen or display pattern is fabricated using lithography (e.g., photolithography and e-beam lithography). In some embodiments, a screen or display pattern is fabricated using a wet chemical etching. In further embodiments, a screen or display pattern is fabricated using plasma etching.

Methods of Manufacturing Devices:

An OLED display is generally manufactured by forming a large mother panel and then cutting the mother panel in units of cell panels. In general, each of the cell panels on the mother panel is formed by forming a thin film transistor (TFT) including an active layer and a source/drain electrode on a base substrate, applying a planarization film to the TFT, and sequentially forming a pixel electrode, a light emitting layer, a counter electrode, and an encapsulation layer, and then is cut from the mother panel.

In another aspect, provided herein is a method of manufacturing an organic light emitting diode (OLED) display, the method comprising:

forming a barrier layer on a base substrate of a mother panel;
forming a plurality of display units in units of cell panels on the barrier layer;
forming an encapsulation layer on each of the display units of the cell panels;
applying an organic film to an interface portion between the cell panels.

In some embodiments, the barrier layer is an inorganic film formed of, for example, SiNx, and an edge portion of the barrier layer is covered with an organic film formed of polyimide or acryl. In some embodiments, the organic film helps the mother panel to be softly cut in units of the cell panel.

In some embodiments, the thin film transistor (TFT) layer includes a light emitting layer, a gate electrode, and a source/drain electrode. Each of the plurality of display units may include a thin film transistor (TFT) layer, a planarization film formed on the TFT layer, and a light emitting unit formed on the planarization film, wherein the organic film applied to the interface portion is formed of a same material as a material of the planarization film and is formed at a same time as the planarization film is formed. In some embodiments, a light emitting unit is connected to the TFT layer with a passivation layer and a planarization film therebetween and an encapsulation layer that covers and protects the light emitting unit. In some embodiments of the method of manufacturing, the organic film is connected to neither the display units nor the encapsulation layer.

Each of the organic film and the planarization film can include any one of polyimide and acryl. In some embodiments, the barrier layer can be an inorganic film. In some embodiments, the base substrate can be formed of polyimide. The method can further include, before the forming of the barrier layer on one surface of the base substrate formed of polyimide, attaching a carrier substrate formed of a glass material to another surface of the base substrate, and

before the cutting along the interface portion, separating the carrier substrate from the base substrate. In some embodiments, the OLED display is a flexible display.

In some embodiments, the passivation layer is an organic film disposed on the TFT layer to cover the TFT layer. In some embodiments, the planarization film is an organic film formed on the passivation layer. In some embodiments, the planarization film is formed of polyimide or acryl, like the organic film formed on the edge portion of the barrier layer. In some embodiments, the planarization film and the organic film are simultaneously formed when the OLED display is manufactured. In some embodiments, the organic film can be formed on the edge portion of the barrier layer such that a portion of the organic film directly contacts the base substrate and a remaining portion of the organic film contacts the barrier layer while surrounding the edge portion of the barrier layer.

In some embodiments, the light emitting layer includes a pixel electrode, a counter electrode, and an organic light emitting layer disposed between the pixel electrode and the counter electrode. In some embodiments, the pixel electrode is connected to the source/drain electrode of the TFT layer.

In some embodiments, when a voltage is applied to the pixel electrode through the TFT layer, an appropriate voltage is formed between the pixel electrode and the counter electrode, and thus the organic light emitting layer emits light, thereby forming an image. Hereinafter, an image forming unit including the TFT layer and the light emitting unit is referred to as a display unit.

In some embodiments, the encapsulation layer that covers the display unit and prevents penetration of external moisture can be formed to have a thin film encapsulation structure in which an organic film and an inorganic film are alternately stacked. In some embodiments, the encapsulation layer has a thin film encapsulation structure in which a plurality of thin films are stacked. In some embodiments, the organic film applied to the interface portion is spaced apart from each of the plurality of display units. In some embodiments, the organic film is formed such that a portion of the organic film directly contacts the base substrate and a remaining portion of the organic film contacts the barrier layer while surrounding an edge portion of the barrier layer.

In one embodiment, the OLED display is flexible and uses the soft base substrate formed of polyimide. In some embodiments, the base substrate is formed on a carrier substrate formed of a glass material, and then the carrier substrate is separated.

In some embodiments, the barrier layer is formed on a surface of the base substrate opposite to the carrier substrate. In one embodiment, the barrier layer is patterned according to a size of each of the cell panels. For example, while the base substrate is formed over the entire surface of a mother panel, the barrier layer is formed according to a size of each of the cell panels, and thus a groove is formed at an interface portion between the barrier layers of the cell panels. Each of the cell panels can be cut along the groove.

In some embodiments, the method of manufacture further comprises cutting along the interface portion, wherein a groove is formed in the barrier layer, wherein at least a portion of the organic film is formed in the groove, and wherein the groove does not penetrate into the base substrate. In some embodiments, the TFT layer of each of the cell panels is formed, and the passivation layer which is an inorganic film and the planarization film which is an organic film are disposed on the TFT layer to cover the TFT layer. At the same time as the planarization film formed of, for example, polyimide or acryl is formed, the groove at the interface portion is covered with the organic film formed of, for example, polyimide or acryl. This is to prevent cracks from occurring by allowing the organic film to absorb an impact generated when each of the cell panels is cut along the groove at the interface portion. That is, if the entire barrier layer is entirely exposed without the organic film, an impact generated when each of the cell panels is cut along the groove at the interface portion is transferred to the barrier layer, thereby increasing the risk of cracks. However, in one embodiment, since the groove at the interface portion between the barrier layers is covered with the organic film and the organic film absorbs an impact that would otherwise be transferred to the barrier layer, each of the cell panels can be softly cut and cracks can be prevented from occurring in the barrier layer. In one embodiment, the organic film covering the groove at the interface portion and the planarization film are spaced apart from each other. For example, if the organic film and the planarization film are connected to each other as one layer, since external moisture may penetrate into the display unit through the planarization film and a portion where the organic film remains, the organic film and the planarization film are spaced apart from each other such that the organic film is spaced apart from the display unit.

In some embodiments, the display unit is formed by forming the light emitting unit, and the encapsulation layer is disposed on the display unit to cover the display unit. As such, once the mother panel is completely manufactured, the carrier substrate that supports the base substrate is separated from the base substrate. In some embodiments, when a laser beam is emitted toward the carrier substrate, the carrier substrate is separated from the base substrate due to a difference in a thermal expansion coefficient between the carrier substrate and the base substrate.

In some embodiments, the mother panel is cut in units of the cell panels. In some embodiments, the mother panel is cut along an interface portion between the cell panels by using a cutter. In some embodiments, since the groove at the interface portion along which the mother panel is cut is covered with the organic film, the organic film absorbs an impact during the cutting. In some embodiments, cracks can be prevented from occurring in the barrier layer during the cutting.

In some embodiments, the methods reduce a defect rate of a product and stabilize its quality.

Another aspect is an OLED display including: a barrier layer that is formed on a base substrate; a display unit that is formed on the barrier layer; an encapsulation layer that is formed on the display unit; and an organic film that is applied to an edge portion of the barrier layer.

Examples

The features of the present invention will be described more specifically with reference to Synthesis Examples and Examples given below. The materials, processes, procedures and the like shown below can be appropriately modified unless they deviate from the substance of the present invention. Accordingly, the scope of the present invention is not construed as being limited to the specific examples shown below. Hereunder, the light emission characteristics were evaluated using a source meter (by Keithley Instruments, Inc., 2400 series), a semiconductor parameter analyzer (by Agilent Technologies, Inc., E5273A), an optical power meter device (by Newport Corporation, 1930C), an optical spectroscope (by Ocean Optics Corporation, USB2000), a spectroradiometer (by Topcon Corporation, SR-3), an absolute PL quantum yield measuring device (by Hamamatsu Photonics K.K., Model C11347), and a streak camera (by Hamamatsu Photonics K.K., Model C4334); and the orientation value was measured using a molecular orientation characteristics measuring device (by Hamamatsu Photonics K.K., C14234-01).

(Synthesis Example 1) Synthesis of Compound 120

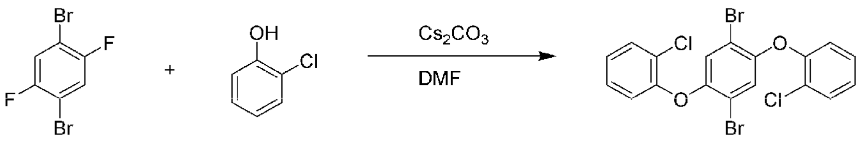


A

Intermediate A

Under a nitrogen stream, an N,N-dimethylformamide solution (60 mL) of 1,4-dibromo-2,5-difluorobenzene (5.00 g, 18.4 mmol), 2-chlorophenol (4.96 g, 38.6 mmol) and cesium carbonate (18.0 g, 55.2 mmol) was stirred at 120°C for 17 hours. The mixture was restored to room temperature, water was added thereto to take a solid by filtration. The solid was purified by silica gel column chromatography (toluene/hexane = 1/3) to give a white solid of Intermediate A (5.22 g, 10.7 mmol, yield 58%).

$^1$H NMR (400 MHz, $CDCl_3$, $\delta$) : 7.59 (dd, J = 7.6, 1.2 Hz, 2H), 7.29-7.24 (m, 2H), 7.17-7.12 (m, 2H), 7.09 (s, 2H), 6.93 (dd, J = 8.0, 1.6 Hz, 2H)
MS (ASAP): 488.20 (M+H$^+$). Calcd for. $C_{18}H_{10}Br_2Cl_2O_2$: 487.84

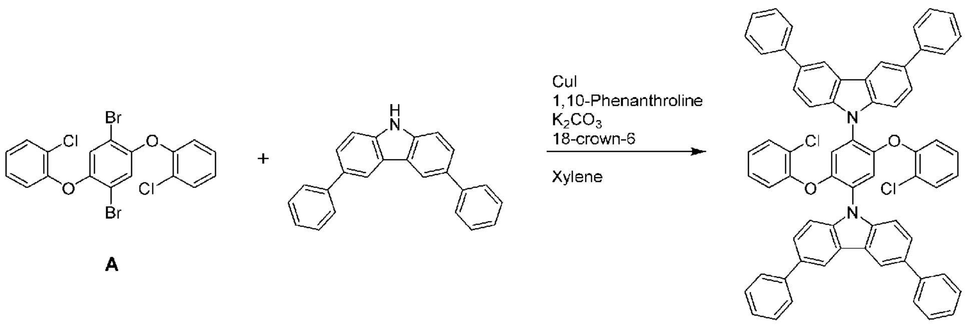


A

B

Intermediate B

Under a nitrogen stream, a xylene solution (30 mL) of Intermediate A (4.00 g, 8.18 mmol), 3,6-diphenylcarbazole (7.84 g, 24.5 mmol), copper iodide (0.598 g, 3.14 mmol), 1,10-phenanthroline (0.567 g, 3.14 mmol), potassium carbonate (6.78 g, 49.1 mmol) and 18-crown-6 (0.324 g, 1.23 mmol) was stirred at 160°C for 17 hours. The mixture was restored to

room temperature, filtered through Celite, and the solvent was evaporated away from the resultant filtrate. The residue was purified by silica gel column chromatography (toluene), and recrystallized from toluene and methanol to give a white solid of Intermediate B (4.14 g, 4.29 mmol, yield 52%).

$^1$H NMR (400 MHz, $CDCl_3$, δ) : 8.35 (d, J = 2.0 Hz, 4H), 7.77-7.72 (m, 12 H), 7.59 (d, J = 8.8 Hz, 4H), 7.52-7.47 (m, 8H), 7.39-7.34 (m, 4H), 7.28-7.24 (m, 4H), 7.10-7.05 (m, 2H), 7.00 (dd, J = 8.0, 1.6 Hz, 2H), 6.96-6.91 (m, 2H)
MS (ASAP):965.56 (M+H$^+$). Calcd for. $C_{66}H_{42}Cl_2N_2O_2$:964.26

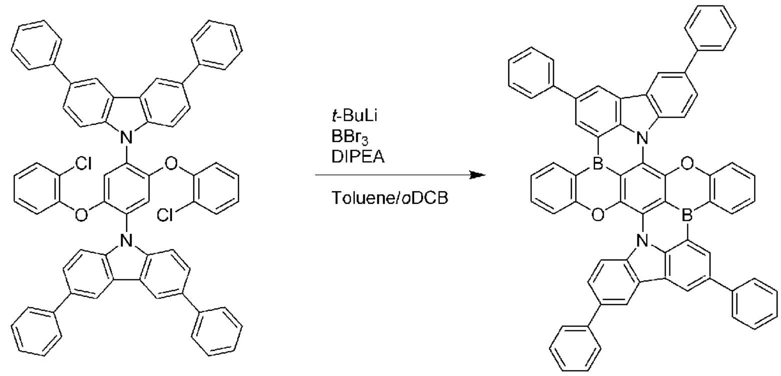


B 120

Compound 120

Under a nitrogen stream, t-BuLi (1.6 mol/L pentane solution, 9.7 mL, 15.5 mmol) was added to a toluene solution (200 mL) of Intermediate B (3.00 g, 3.11 mmol) at 0°C, and stirred at 50°C for 45 minutes. The reaction mixture was cooled to 0°C, boron tribromide (3.89 g, 15.5 mmol) was added, then stirred at room temperature for 30 minutes, and thereafter N,N-diisopropylethylamine (4.01 g, 31.1 mmol) and o-dichlorobenzene were added and stirred at 170°C for 20 hours. The mixture was restored to room temperature, filtered through Celite, and the solvent was evaporated away from the resultant filtrate. The residue was purified by silica gel column chromatography (toluene), and recrystallized from o-dichlorobenzene and acetonitrile to give a violet solid of Compound 120 (138 mg, 0.151 mmol, yield 5%).
MS (MALDI) : 913.23 (M+H$^+$). Calcd for. $C_{66}H_{38}B_2N_2O_2$: 912.31

(Synthesis Example 2) Synthesis of Compound 4

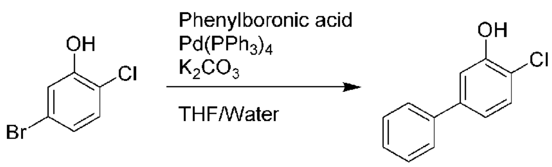


C

Intermediate C

Under a nitrogen stream, a tetrahydrofuran/distilled water solution (100 mL/50 mL) of 5-bromo-2-chlorophenol (10.4 g, 50.0 mmol), phenylboronic acid (6.40 g, 52.5 mmol), tetrakis(triphenylphosphine)palladium(0) (2.89 g, 2.50 mmol) and potassium carbonate (17.3 g, 125 mmol) was stirred at 80°C for 16 hours. The mixture was restored to room temperature, filtered through Celite, and the solvent was evaporated away from the resultant filtrate. The residue was purified by silica gel column chromatography (toluene/hexane = 9/1) to give pale yellowish oily Intermediate C (8.63 g, 42.2 mmol, yield 84%).

$^1$H NMR (400 MHz, $CDCl_3$, δ) : 7.57-7.53 (m, 2H), 7.467.40 (m, 2H), 7.38-7.33 (m, 2H), 7.26-7.25 (m, 1H), 7.10 (dd, J = 8.0, 2.0 Hz, 1H), 5.57 (s, 1H)
MS (ASAP) : 204.94 (M+H$^+$). Calcd for. $C_{12}H_9ClO$ : 204.03

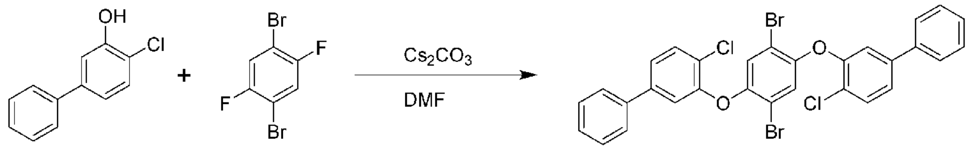


C

D

Intermediate D

Under a nitrogen stream, an N,N-dimethylformamide solution (100 mL) of Intermediate C (8.63 g, 42.2 mmol), 1,4-dibromo-2,5-difluorobenzene (5.21 g, 19.17 mmol), and cesium carbonate (25.0 g, 76.7 mmol) was stirred at 140°C for 17 hours. The mixture was restored to room temperature, water was added thereto to take a solid by filtration. The solid was purified by silica gel column chromatography (toluene), and recrystallized from toluene and methanol to give a white solid of Intermediate D (4.09 g, 6.37 mmol, yield 33%).

$^1$H NMR (400 MHz, $CDCl_3$, $\delta$) : 7.55 (d, J = 8.4 Hz), 7.53-7.49 (m, 4H), 7.46-7.41 (m, 4H), 7.40-7.35 (m, 4H), 7.15-7.14 (m, 4H)

MS (ASAP): 640.03 ($M^+$). Calcd for. $C_{30}H_{18}Br_2Cl_2O_2$: 639.90

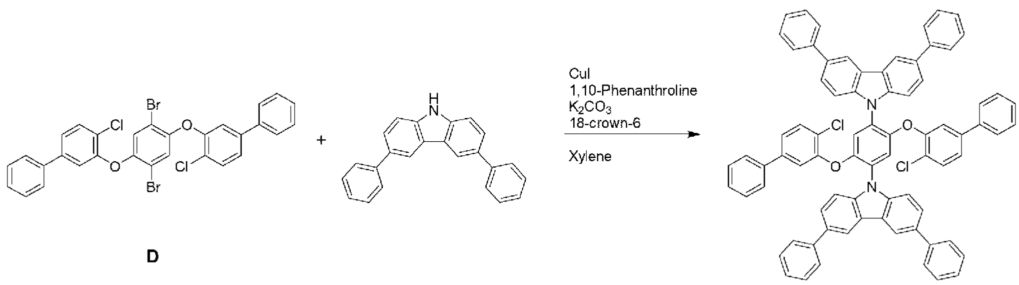


D

E

Intermediate E

Under a nitrogen stream, a xylene solution (80 mL) of Intermediate D (4.08 g, 6.37 mmol), 3,6-diphenylcarbazole (6.11 g, 19.1 mmol), copper iodide (1.21 g, 6.37 mmol), 1,10-phenanthroline (1.15 g, 6.37 mmol), potassium carbonate (5.28 g, 38.2 mmol) and 18-crown-6 (0.253 g, 0.956 mmol) was stirred at 160°C for 16 hours. The mixture was restored to room temperature, filtered through Celite, and the solvent was evaporated away from the resultant filtrate. The residue was purified by silica gel column chromatography (toluene), and recrystallized from toluene and methanol to give a white solid of Intermediate E (4.42 g, 3.96 mmol, yield 62%).

$^1$H NMR (400 MHz, $CDCl_3$, $\delta$) : 8.32 (d, J = 2.0 Hz, 4H), 7.73-7.67 (m, 12 H), 7.59 (d, J = 8.8 Hz, 4H), 7.52-7.47 (m, 8H), 7.39-7.27 (m, 18H), 7.12-7.08 (m, 4H)

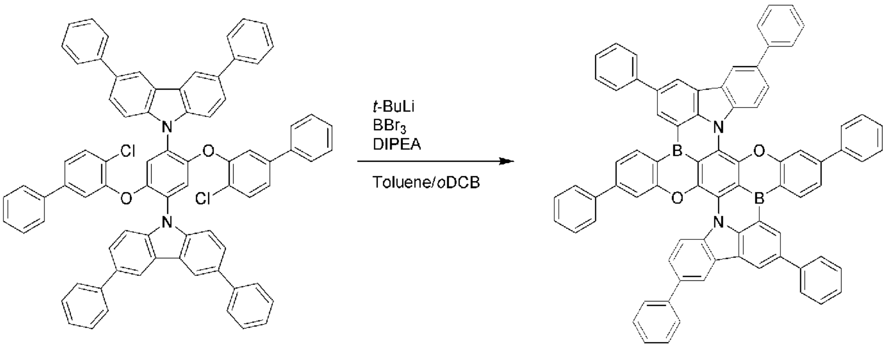


E

4

Compound 4

Under a nitrogen stream, t-BuLi (1.6 mol/L pentane solution, 5.6 mL, 8.95 mmol) was added to a toluene solution (200 mL) of Intermediate E (2.00 g, 1.79 mmol) at 0°C, and stirred at 50°C for 30 minutes. The reaction mixture was cooled to 0°C, boron tribromide (2.24 g, 8.95 mmol) was added, then stirred at room temperature for 30 minutes, and thereafter N,N-diisopropylethylamine (2.31 g, 17.9 mmol) and o-dichlorobenzene were added and stirred at 170°C for 20 hours. The mixture was restored to room temperature, and the precipitate was taken out by filtration. The solid was purified by silica gel column chromatography (o-dichlorobenzene), and recrystallized from o-dichlorobenzene and acetonitrile to give a violet solid of Compound 4 (40.0 mg, 0.0375 mmol, yield 2%).

(Synthesis Example 3) Synthesis of Compound 1979

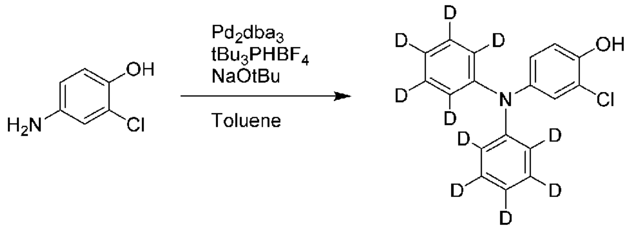


**F**

Intermediate F

Under a nitrogen stream, a toluene solution (450 mL) of 4-amino-2-chlorophenol (12.9 g, 90.0 mmol), bromobenzene-d5 (32.1 g, 198 mmol), tris(dibenzylideneacetone)dipalladium(0) (4.12 g, 4.50 mmol), tri-tert-butylphosphonium tetrafluoroborate (2.61 g, 9.00 mmol) and sodium tert-butoxide (43.2 g, 450 mmol) was stirred at 110°C for 15 hours. The mixture was restored to room temperature, water was added thereto, and the mixture was extracted three times with ethyl acetate. The organic layer was dried with magnesium sulfate, then filtered, and the solvent was evaporated away from the resultant filtrate. The residue was purified by silica gel column chromatography (dichloromethane/hexane = 1/1) to give a yellow solid of Intermediate F (20.1 g, 65.8 mmol, yield 73%).

$^1$H NMR (400 MHz, $CDCl_3$, $\delta$) : 7.10 (d, J = 2.0 Hz, 1H), 6.97 (dd, J= 8.8 Hz, 2.0 Hz, 1H), 6.93 (d, J = 8.8 Hz, 1H). MS (ASAP) : 306.19 (M+H$^+$). Calcd for. $C_{18}H_4D_{10}ClNO$ : 305.14

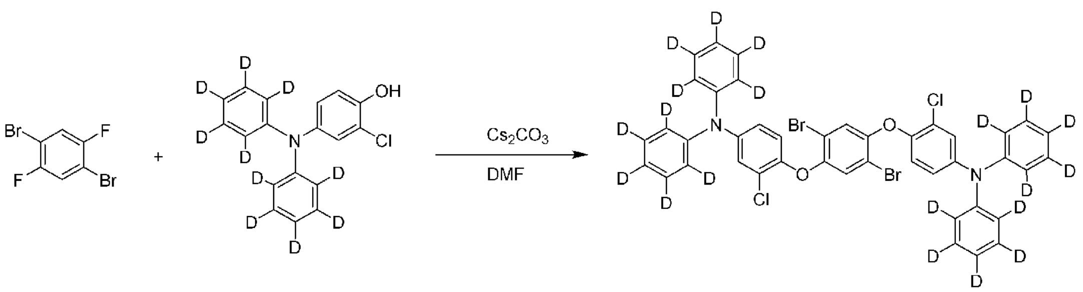


**F** **G**

Intermediate G

Under a nitrogen stream, an N,N-dimethylformamide solution (150 mL) of 1,4-dibromo-2,5-difluorobenzene (8.16 g, 30.0 mmol), Intermediate F (20.1 g, 65.8 mmol), and cesium carbonate (39.1 g, 120 mmol) was stirred at 160°C for 12 hours. The mixture was restored to room temperature, water was added thereto to take a solid by filtration. The solid was purified by silica gel column chromatography (dichloromethane/hexane = 1/3) to give a yellow solid of Intermediate G (8.44 g, 10.0 mmol, yield 33%).

$^1$H NMR (400 MHz, $CDCl_3$, $\delta$) : 7.17 (d, J = 2.8 Hz, 2H), 7.09 (s, 2H), 6.94 (dd, J = 8.8 Hz, 2.8 Hz, 2H), 6.83 (d, J = 8.8 Hz,

2H).
MS (ASAP) : 843.42 (M+H+). Calcd for. $C_{42}H_8D_{20}Br_2Cl_2N_2O_2$: 842.11

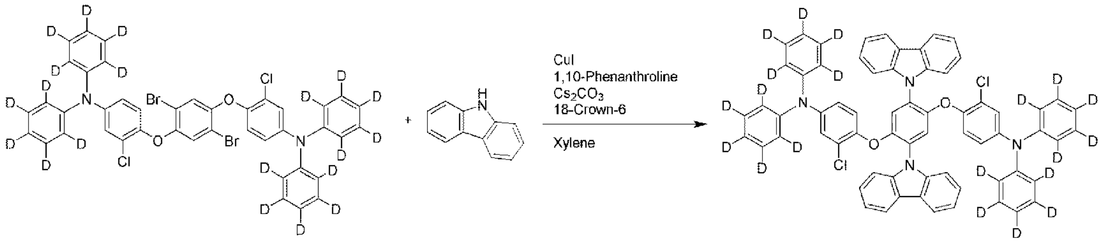


G H

Intermediate H

Under a nitrogen stream, a xylene solution (64 mL) of Intermediate G (7.89 g, 12.7 mmol), carbazole (4.67 g, 27.9 mmol), copper iodide (1.21 g, 6.35 mmol), 1,10-phenanthroline (1.14 g, 6.35 mmol), cesium carbonate (16.6 g, 50.8 mmol) and 18-crown-6 (0.671 g, 2.54 mmol) was stirred at 160°C for 42 hours. The mixture was restored to room temperature, water was added thereto, and the mixture was extracted three times with toluene. The organic layer was dried with magnesium sulfate, then filtered, and the solvent was evaporated away from the resultant filtrate. The residue was purified by silica gel column chromatography (dichloromethane/hexane = 1/3) to give a white solid of Intermediate H (2.06 g, 2.02 mmol, yield 16%).

$^1$H NMR (400 MHz, $CDCl_3$, δ) : 8.14 (d, J = 8.0 Hz, 4H), 7.50-7.44 (m, 8H), 7.35-7.31 (m, 4H), 7.30 (s, 2H), 8.50 (d, J = 2.8 Hz, 2H), 6.71 (d, J = 8.8 Hz, 2H), 6.65 (dd, J = 8.8 Hz, 2.8 Hz, 2H).
MS (ASAP):(M+H+). Calcd for. $C_{66}H_{24}D_{20}Cl_2N_4O_2$:1014.41

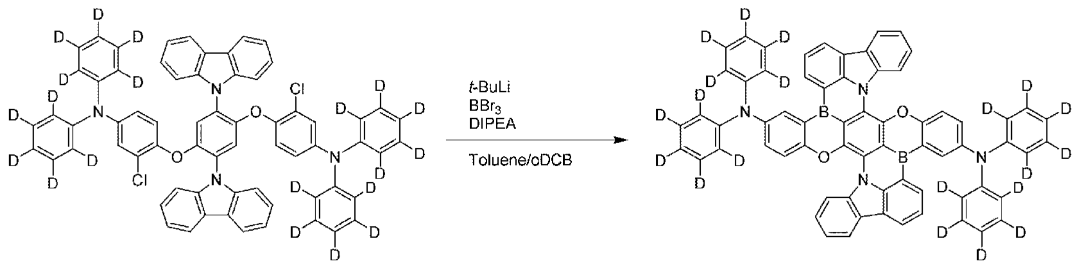


H 1979

Compound 1979

Under a nitrogen stream, tert-butyl lithium (1.6 mol/L pentane solution, 9.4 mL, 15.0 mmol) was added to a toluene solution (30 mL) of Intermediate H (3.01 g, 3.00 mmol) at 0°C, and stirred at 70°C for 30 minutes. The reaction mixture was cooled to 0°C, boron tribromide (3.76 g, 15.0 mmol) was added, then stirred at room temperature for 1 hour, and thereafter N,N-diisopropylethylamine (3.88 g, 30.0 mmol) and o-dichlorobenzene were added and stirred at 185°C for 14 hours. The mixture was restored to room temperature, filtered through Celite, and the solvent was evaporated away from the resultant filtrate. The residue was purified by silica gel column chromatography (toluene/hexane = 1/3), and recrystallized from dichloromethane and acetonitrile to give a violet solid of Compound 1979 (120 mg, 0.125 mmol, yield 4%). $^1$H NMR (400 MHz, $CDCl_3$, δ) : 8.57 (d, J = 2.8 Hz, 2H), 8.46-8.42 (m, 4H), 8.23 (d, J = 7.6 Hz, 2H), 7.96 (d, J = 8.4 Hz, 2H), 7.59-7.54 (m, 4H), 7.52-7.43 (m, 4H), 7.39 (d, J = 8.8 Hz, 2H).

(Synthesis Example 4) Synthesis of Compound 33499

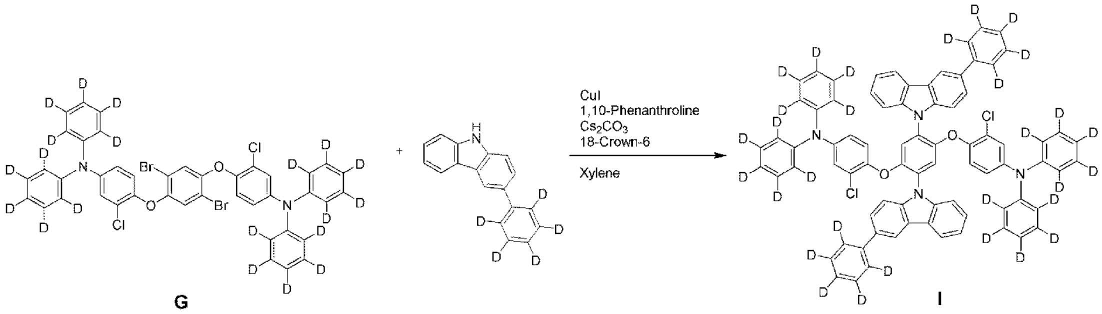


G  I

Intermediate I

Under a nitrogen stream, a xylene solution (90 mL) of Intermediate G (9.28 g, 11.0 mmol), 3-(phenyl-2,3,4,5,6-$d_5$)-9H-carbazole (6.01 g, 24.2 mmol), copper iodide (1.05 g, 5.50 mmol), 1,10-phenanthroline (0.991 g, 5.50 mmol), cesium carbonate (14.3 g, 44.0 mmol) and 18-crown-6 (0.581 g, 2.20 mmol) was stirred at 160°C for 36 hours. The mixture was restored to room temperature, water was added thereto, and the mixture was extracted three times with dichloromethane. The organic layer was dried with magnesium sulfate, then filtered, and the solvent was evaporated away from the resultant filtrate. The residue was purified by silica gel column chromatography (dichloromethane/hexane = 1/3) to give a white solid of Intermediate I (7.93 g, 6.73 mmol, yield 61%).

$^1$H NMR (400 MHz, $CDCl_3$, δ) : 8.75 (d, J = 2.0 Hz, 2H), 8.19 (d, J = 7.6 Hz, 2H), 7.74-7.71 (m, 2H), 7.57 (dd, J = 8.8 Hz, 3.6 Hz, 2H), 7.52-7.47 (m, 4H), 7.38-7.33 (m, 2H), 7.32 (s, 2H), 6.89 (d, J = 2.8 Hz, 2H), 6.77 (d, J = 8.8 Hz, 2H), 6.70 (dd, J = 8.8 Hz, 2.8 Hz, 2H).
MS (ASAP):1177.87 (M+H$^+$). Calcd for. $C_{78}H_{22}D_{30}Cl_2N_4O_2$:1176.54

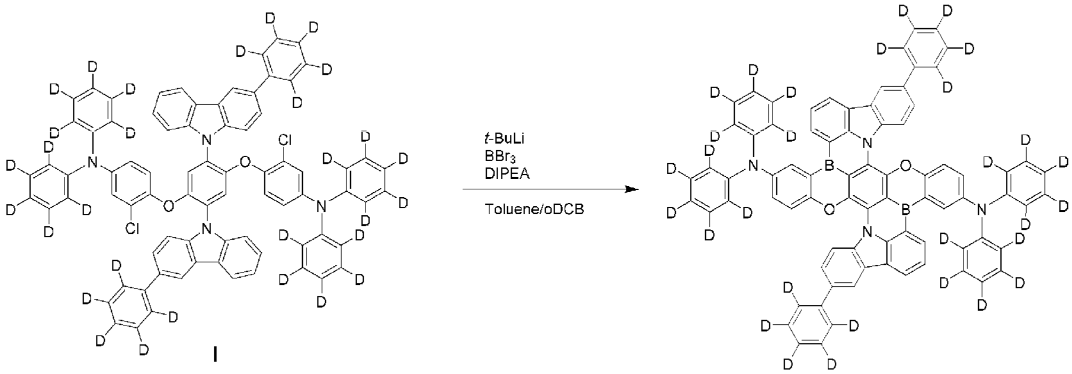


I  33499

Compound 33499

Under a nitrogen stream, tert-butyl lithium (1.6 mol/L pentane solution, 6.8 mL, 11.0 mmol) was added to a toluene solution (22 mL) of Intermediate I (2.59 g, 2.20 mmol) at -78°C, and stirred at 70°C for 30 minutes. The reaction mixture was cooled to -78°C, boron tribromide (2.76 g, 11.0 mmol) was added, then stirred at room temperature for 30 minutes, and thereafter N,N-diisopropylethylamine (2.84 g, 22.0 mmol) and o-dichlorobenzene were added and stirred at 185°C for 15 hours. The mixture was restored to room temperature, filtered through a silica gel pad, and the solvent was evaporated away from the resultant filtrate. The residue was purified by silica gel column chromatography (toluene/hexane = 3/7), and recrystallized from dichloromethane and acetonitrile to give a violet solid of Compound 33499 (289 mg, 0.257 mmol, yield 12%).

$^1$H NMR (400 MHz, $CDCl_3$, δ) : 8.6-8.4 (m, 4H), 8.39-8.30 (m, 2H), 8.19 (t, J = 8.0 Hz, 2H), 7.95-7.87 (m, 2H), 7.71 (dd, J = 8.8 Hz, 2.0 Hz, 2H), 7.52-7.38 (m, 4H), 7.34-7.28 (m, 2H).

(Synthesis Example 5) Synthesis of Compound 33179

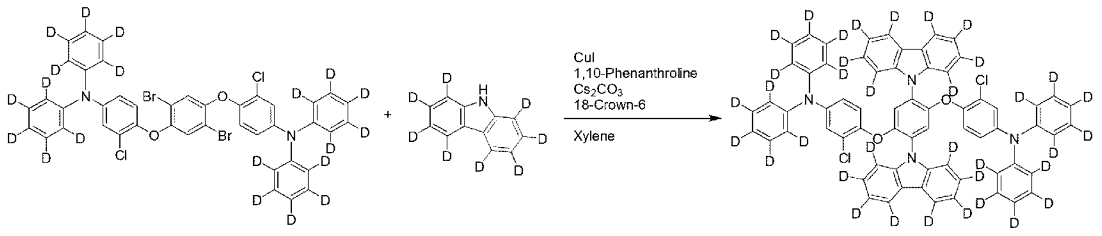


G J

Intermediate J

Under a nitrogen stream, a xylene solution (124 mL) of Intermediate G (5.25 g, 6.22 mmol), carbazole-1,2,3,4,5,6,7,8-d8 (2.40 g, 13.7 mmol), copper iodide (0.592 g, 3.11 mmol), 1,10-phenanthroline (0.561 g, 3.11 mmol), cesium carbonate (8.11 g, 24.9 mmol) and 18-crown-6 (0.329 g, 1.24 mmol) was stirred at 170°C for 96 hours. The mixture was restored to room temperature, water was added thereto, and the mixture was extracted three times with dichloromethane. The organic layer was dried with magnesium sulfate, then filtered, and the solvent was evaporated away from the resultant filtrate. The residue was purified by silica gel column chromatography (dichloromethane), and recrystallized from toluene to give a brown solid of Intermediate J (5.33 g, 5.17 mmol, yield 83%).

$^1$H NMR (400 MHz, $CDCl_3$, δ) : 7.31 (s, 2H), 6.85 (d, J = 2.4 Hz, 2H), 6.71 (d, J = 8.8 Hz, 2H), 6.65 (dd, J = 8.8 Hz, 2.4 Hz, 2H).

MS (ASAP):1031.79 (M+H$^+$). Calcd for. $C_{66}H_8D_{36}Cl_2N_4O_2$:1030.51

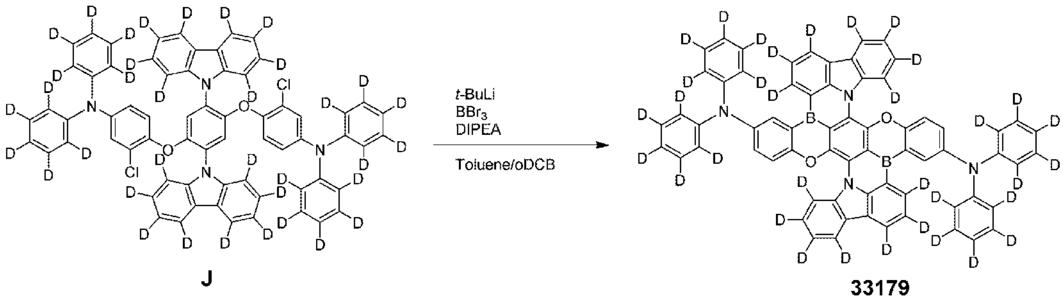


J 33179

Compound 33179

Under a nitrogen stream, tert-butyl lithium (1.6 mol/L pentane solution, 6.1 mL, 9.70 mmol) was added to a toluene solution (30 mL) of Intermediate J (2.00 g, 1.94 mmol) at 0°C, and stirred at 70°C for 30 minutes. The reaction mixture was cooled to 0°C, boron tribromide (1.52 g, 9.70 mmol) was added, then stirred for 1 hour at room temperature, and thereafter N,N-diisopropylethylamine (2.51 g, 19.4 mmol) and o-dichlorobenzene were added and stirred at 185°C for 14 hours. The mixture was restored to room temperature, filtered through Celite, and the solvent was evaporated away from the resultant filtrate. The residue was purified by silica gel column chromatography (toluene/hexane = 1/3), and recrystallized from dichloromethane and acetonitrile to give a violet solid of Compound 33179 (75.8 mg, 0.0776 mmol, yield 4%).

(Synthesis Example 6) Synthesis of Compound 1931

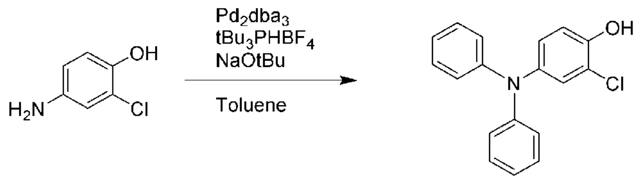


K

Intermediate K

Under a nitrogen stream, a toluene solution (580 mL) of 4-amino-2-chlorophenol (25.0 g, 174 mmol), bromobenzene (62.9 g, 401 mmol), tris(dibenzylideneacetone)dipalladium(0) (7.97 g, 8.71 mmol), tri-tert-butylphosphonium tetrafluoroborate (5.05 g, 17.4 mmol) and sodium tert-butoxide (58.6 g, 609 mmol) was stirred at 100°C for 15 hours. The mixture was restored to room temperature, water was added thereto, and the mixture was extracted three times with toluene. The organic layer was dried with magnesium sulfate, then filtered, and the solvent was evaporated away from the resultant filtrate. The residue was purified by silica gel column chromatography (toluene) to give a dark orange liquid of Intermediate K (51.2 g, 173 mmol, yield 99%).

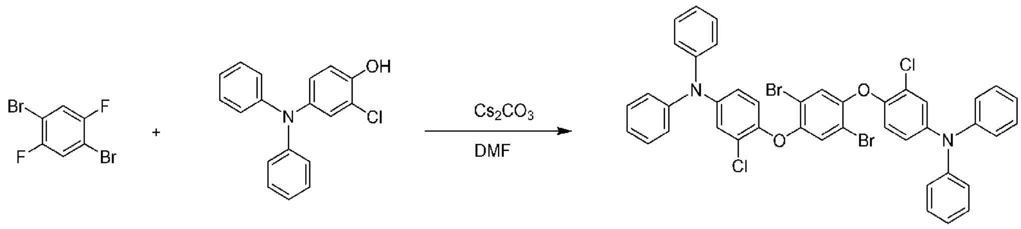


K L

Intermediate L

Under a nitrogen stream, an N,N-dimethylformamide solution (490 mL) of 1,4-dibromo-2,5-difluorobenzene (40.0 g, 147 mmol), Intermediate K (100 g, 338 mmol), and cesium carbonate (192 g, 588 mmol) was stirred at 160°C for 12 hours. The mixture was restored to room temperature, water was added thereto to take a solid by filtration. The solid was washed with hexane, methanol and acetone to give a yellow solid of Intermediate L (46.0 g, 55.9 mmol, yield 38%).

$^1$H NMR (400 MHz, $CDCl_3$, $\delta$) : 7.16 (d, J = 2.8 Hz, 2H), 7.13-7.03 (m, 22H), 6.94 (dd, J= 8.8 Hz, 2.8 Hz, 2H), 6.83 (d, J = 8.8 Hz, 2H).
MS (ASAP) : 823.22 (M+H$^+$). Calcd for. $C_{42}H_{28}Br_2Cl_2N_2O_2$: 821.99

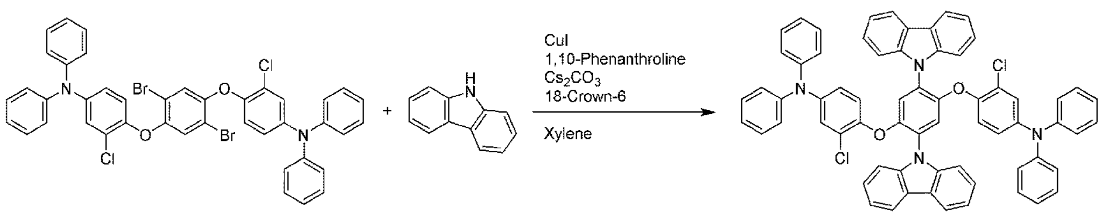


L

M

Intermediate M

Under a nitrogen stream, a xylene solution (533 mL) of Intermediate L (43.9 g, 53.3 mmol), carbazole (19.6 g, 117 mmol), copper iodide (5.07 g, 26.6 mmol), 1,10-phenanthroline (4.80 g, 26.6 mmol), cesium carbonate (69.4 g, 213 mmol) and 18-crown-6 (2.81 g, 10.6 mmol) was stirred at 170°C for 60 hours. The mixture was restored to room temperature, water was added thereto, and the mixture was extracted three times with toluene. The organic layer was dried with magnesium sulfate, then filtered, and the solvent was evaporated away from the resultant filtrate. The residue was purified by silica gel column chromatography (dichloromethane/hexane = 1/3), and recrystallized from toluene to give a brown solid of Intermediate M (12.4 g, 12.4 mmol, yield 23.3%).

$^1$H NMR (400 MHz, $CDCl_3$, $\delta$) : 8.14 (d, J = 8.0 Hz, 4H), 7.50-7.44 (m, 8H), 7.35-7.30 (m, 6H), 7.20-7.15 (m, 8H), 7.00-6.95 (m, 4H), 6.87-6.84 (m, 10H), 6.71 (d, J = 8.4 Hz, 2H), 6.65 (dd, J = 8.1 Hz, 2.8 Hz, 2H).
MS (ASAP):995.59 (M+H$^+$). Calcd for. $C_{66}H_{44}Cl_2N_4O_2$:994.28

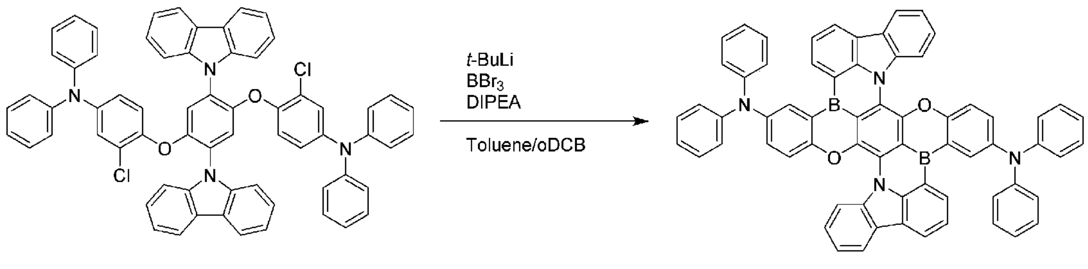


M 1931

Compound 1931

Under a nitrogen stream, tert-butyl lithium (1.6 mol/L pentane solution, 9.4 mL, 15.1 mmol) was added to a toluene solution (30 mL) of Intermediate M (3.00 g, 3.01 mmol) at -78°C, and stirred at 70°C for 30 minutes. The reaction mixture was cooled to -78°C, boron tribromide (3.77 g, 15.1 mmol) was added, then stirred for 1 hour at room temperature, and thereafter N,N-diisopropylethylamine (3.89 g, 30.1 mmol) and o-dichlorobenzene were added and stirred at 160°C for 14 hours. The mixture was restored to room temperature, filtered through Celite, and the solvent was evaporated away from the resultant filtrate. The residue was purified by silica gel column chromatography (toluene/hexane = 1/3), and recrystallized from dichloromethane and acetonitrile to give a violet solid of Compound 1931 (88.1 mg, 0.0934 mmol, yield 3%).

$^1$H NMR (400 MHz, $CDCl_3$, $\delta$) : 8.59-8.55 (m, 2H), 8.45-8.41 (m, 4H), 8.23 (d, J= 8.0 Hz, 2H), 7.95 (d, J = 8.0 Hz, 2H), 7.58-7.54 (m, 4H), 7.50-7.43 (m, 4H), 7.39-7.30 (m, 10H), 7.26-7.24 (m, 8H), 7.08 (t, J = 8.0 Hz, 4H).
MS (ASAP):943.55 ($M+H^+$). Calcd for. $C_{66}H_{44}B_2N_4O_2$:942.33

(Example 1) Preparation and Evaluation of Thin Film

Compound 120 and H1 were vapor-deposited from different vapor deposition sources on a quartz substrate by a vacuum deposition method under conditions of a vacuum degree of less than $1 \times 10^{-3}$ Pa to form a thin film having a content of Compound 120 of 0.5% by weight and a thickness of 100 nm. The photoluminescent quantum yield (PLQY) of the formed thin film was measured, and was a high value of 86%. The maximum emission wavelength was 612 nm, and the full-width at half-maximum was 38 nm.

A thin film was formed according to the same process but using Compound 4 in place of Compound 120, and the photoluminescent quantum yield (PLQY) thereof was measured and was a high value of 92%. The maximum emission wavelength was 615 nm, and the full-width at half-maximum was 39 nm.

(Example 2) Production and Evaluation of Organic Electroluminescent Device

On a glass substrate on which an anode made of indium-tin oxide (ITO) having a film thickness of 100 nm was formed, thin films were laminated by a vacuum deposition method at a vacuum degree of $1 \times 10^{-5}$ Pa. First, HAT-CN was formed to a thickness of 10 nm on the ITO, NPD was formed to a thickness of 30 nm on the HAT-CN, further TrisPCz was formed to a thickness of 10 nm thereon, and further H1 was formed to a thickness of 5 nm. Next, H1, T64 and Compound 120 were vapor co-deposited from different vapor deposition sources to form a light emitting layer with a thickness of 40 nm. The content of H1, T64 and Compound 120 was 64.5% by mass, 35.0% by mass, and 0.5% by mass, respectively. Next, after SF3-TRZ was formed to a thickness of 10 nm, Liq and SF3-TRZ were vapor co-deposited from different vapor deposition sources to form a layer with a thickness of 30 nm. The content of Liq and SF3-TRZ in this layer was 30% by mass and 70% by mass, respectively. Furthermore, Liq was formed to a thickness of 2 nm, and aluminum (Al) was vapor-deposited to a thickness of 100 nm to form a cathode, thereby producing an organic electroluminescent device.

When the produced organic electroluminescent device was energized, light emission was observed. Among the materials contained in the light emitting layer, the amount of light emission from Compound 120 was the largest. The S value of Compound 120 in the light emitting layer was measured, and was -0.4, which confirmed high orientation of Compound 120.

(Example 3) Production and Evaluation of Other Organic Electroluminescent Device

An organic electroluminescent device of Example 3 was produced according to the same process as in Example 2, except that T153 was used in place of T64 in forming the light emitting layer. The S value of Compound 120 in the light

emitting layer was measured, and was -0.4, which confirmed high orientation of Compound 120.

(Example 4) Production and Evaluation of Other Organic Electroluminescent Device

An organic electroluminescent device of Example 4 was produced according to the same process as in Example 3, except that Compound 4 was used in place of Compound 120 in forming the light emitting layer. The S value of Compound 4 in the light emitting layer was measured, and was -0.25, which confirmed high orientation of Compound 4.

Thin films and organic electroluminescent devices can be produced according to the same process as in Examples 1 o 3, but using the other compounds represented by the general formula (1) in place of Compound 120 and Compound 4.

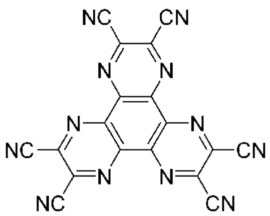

HAT-CN

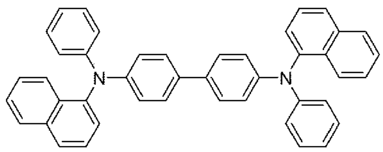

NPD

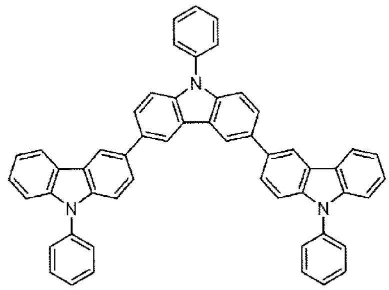

TrisPCz

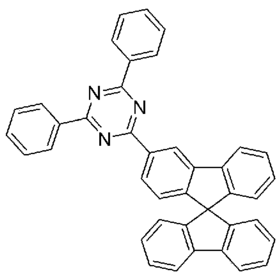

SF3-TRZ

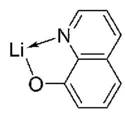

Liq

Industrial Applicability

The compound represented by the general formula (1) has good light emission characteristics. Consequently, by using the compound represented by the general formula (1), an excellent organic light emitting device can be provided. Accordingly, the industrial applicability of the present invention is great.

## Claims

**1.** A compound represented by the following general formula (1):

General Formula (1)

Genereal Formula (1)

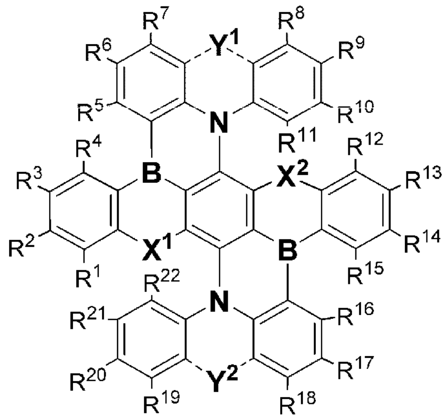

wherein $X^1$ and $X^2$ each independently represent O or S;

$Y^1$ and $Y^2$ each independently represent a single bond, O, S or $C(R^a)(R^b)$;
$R^1$ to $R^{22}$, $R^a$, and $R^b$ each independently represent a hydrogen atom, a deuterium atom or a substituent, but at least one of $R^1$ to $R^{22}$ is a substituent;
$R^1$ and $R^2$, $R^2$ and $R^3$, $R^3$ and $R^4$, $R^5$ and $R^6$, $R^6$ and $R^7$, $R^7$ and $Y^1$, $Y^1$ and $R^8$, $R^8$ and $R^9$, $R^9$ and $R^{10}$, $R^{10}$ and $R^{11}$, $R^{12}$ and $R^{13}$ , $R^{13}$ and $R^{14}$, $R^{14}$ and $R^{15}$, $R^{16}$ and $R^{17}$, $R^{17}$ and $R^{18}$, $R^{18}$ and $Y^2$, $Y^2$ and $R^{19}$, $R^{19}$ and $R^{20}$, $R^{20}$ and $R^{21}$, and $R^{21}$ and $R^{22}$ each can bond to each other to form a cyclic structure;
$R^{21}$ and $R^1$, $R^4$ and $R^5$, $R^{10}$ and $R^{12}$, and $R^{15}$ and $R^{16}$ each do not bond to each other to form a cyclic structure; and
$C-R^1$, $C-R^2$, $C-R^3$, $C-R^4$, $C-R^5$, $C-R^6$ , $C-R^7$, $C-R^8$, $C-R^9$ , $C-R^{10}$, $C-R^{11}$, $C-R^{12}$, $C-R^{13}$, $C-R^{14}$, $C-R^{15}$, $C-R^{16}$, $C-R^{17}$, $C-R^{18}$, $C-R^{19}$, $C-R^{20}$, $C-R^{21}$, and $C-R^{22}$ can be substituted with N.

2. The compound according to claim 1, wherein $R^1$ to $R^{22}$ each are a group selected from the group consisting of a hydrogen atom, a deuterium atom, an alkyl group and an aryl group or a group formed by combining at least two thereof, in which a part or all of the hydrogen atoms existing in the group can be substituted with deuterium atoms, or each are a substituted or unsubstituted diarylamino group, in which the two aryl groups constituting the diarylamino group can be linked to each other via a linking group.

3. The compound according to claim 1, wherein at least one of $R^1$ to $R^{22}$ is an aryl group optionally substituted with at least one selected from the group consisting of a deuterium atom, an alkyl group and an aryl group.

4. The compound according to claim 1, wherein $R^6$, $R^9$, $R^{17}$, and $R^{20}$ are substituents.

5. The compound according to claim 1, wherein, among $R^1$ to $R^{22}$, only 1 to 6 selected from the group consisting of $R^2$, $R^3$, $R^6$, $R^9$, $R^{13}$, $R^{14}$, $R^{17}$, and $R^{20}$ are substituents.

6. The compound according to claim 1, wherein the total carbon number of $R^1$ to $R^{22}$ is 10 to 60.

7. The compound according to claim 1, wherein the total number of the benzene rings of $R^1$ to $R^{22}$ is 2 to 6.

8. The compound according to claim 1, wherein $Y^1$ and $Y^2$ are single bonds.

9. The compound according to claim 1, wherein $X^1$ and $X^2$ are O.

10. The compound according to claim 1, which has a point-symmetric structure.

11. A light emitting material comprising the compound according to any one of claims 1 to 10.

12. A film comprising the compound according to any one of claims 1 to 10.

**13.** An organic semiconductor device comprising the compound according to any one of claims 1 to 10.

**14.** An organic light emitting device comprising the compound according to any one of claims 1 to 10.

**15.** The organic light emitting device according to claim 14, wherein the device has a layer containing the compound, and the layer also contains a host material.

**16.** The organic light emitting device according to claim 15, wherein the layer containing the compound further contains a delayed fluorescent material in addition to the compound and the host material, and the delayed fluorescent material has a lowest excited singlet energy lower than that of the host material and higher than that of the compound.

**17.** The organic light emitting device according to claim 14, wherein the device has a layer containing the compound, and the layer also contains a light emitting material having a structure different from that of the compound.

**18.** The organic light emitting device according to claim 14, wherein the amount of light emitted from the compound is the largest among the materials contained in the device.

**19.** The organic light emitting device according to claim 17, wherein the amount of light emitted from the light emitting material is larger than the amount of light emitted from the compound.

**20.** The organic light emitting device according to claim 14, which emits delayed fluorescence.

## INTERNATIONAL SEARCH REPORT

International application No. **PCT/JP2023/000230**

**A. CLASSIFICATION OF SUBJECT MATTER**

***C07F 5/02***(2006.01)i; ***C09K 11/06***(2006.01)i; ***H10K 50/00***(2023.01)i
FI: C07F5/02 A CSP; C09K11/06 660; H05B33/14 B

According to International Patent Classification (IPC) or to both national classification and IPC

**B. FIELDS SEARCHED**

Minimum documentation searched (classification system followed by classification symbols)

C07F5/02; C09K11/06; H10K50/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | CN 112645968 A (CHANGCHUN INSTITUTE OF APPLIED CHEMISTRY, CHINESE ACADEMY OF SCIENCES) 13 April 2021 (2021-04-13) claims, example 6, paragraphs [0644], [0647], [0651] | 1-8, 10-20 |
| A | | 9 |
| A | CN 113540371 A (TSINGHUA UNIVERSITY) 22 October 2021 (2021-10-22) claims, MR-118 | 1-20 |
| A | CN 112174992 A (TSINGHUA UNIVERSITY) 05 January 2021 (2021-01-05) paragraph [0049], formula 134 | 1-20 |
| A | JP 2018-43984 A (UNIV KWANSEI GAKUIN) 22 March 2018 (2018-03-22) claims, paragraph [0148], formula 1-2030 | 1-20 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 February 2023** | **20 March 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/000230**

| Patent document cited in search report | Publication date (day/month/year) | Patent family member(s) | Publication date (day/month/year) |
|---|---|---|---|
| CN 112645968 A | 13 April 2021 | (Family: none) | |
| CN 113540371 A | 22 October 2021 | (Family: none) | |
| CN 112174992 A | 05 January 2021 | WO 2022/068528 A1 | |
| JP 2018-43984 A | 22 March 2018 | US 2018/0069182 A1<br>claims, p. 211 formula (1-2030)<br>US 2020/0220083 A1<br>CN 107793441 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2015022974 A
- JP 2021103698 A
- JP 2021103699 A
- JP 2021103700 A
- JP 2021081332 A
- JP 2021103701 A
- JP 2021151805 A
- JP 2021188860 A
- WO 2013154064 A
- WO 2013011954 A
- WO 2013011955 A
- WO 2013081088 A
- JP 2013256490 A
- JP 2013116975 A
- WO 2013133359 A
- WO 2013161437 A
- JP 2014009352 A
- JP 2014009224 A
- JP 2017119663 A
- JP 2017119664 A
- JP 2017222623 A
- JP 2017226838 A
- JP 2018100411 A
- WO 2018047853 A
- JP 2013253121 A
- WO 2014034535 A
- WO 2014115743 A
- WO 2014122895 A
- WO 2014126200 A
- WO 2014136758 A
- WO 2014133121 A
- WO 2014136860 A
- WO 2014196585 A
- WO 2014189122 A
- WO 2014168101 A
- WO 2015008580 A
- WO 2014203840 A
- WO 2015002213 A
- WO 2015016200 A
- WO 2015019725 A
- WO 2015072470 A
- WO 2015108049 A
- WO 2015080182 A
- WO 2015072537 A
- WO 2015080183 A
- JP 2015129240 A
- WO 2015129714 A
- WO 2015129715 A
- WO 2015133501 A
- WO 2015136880 A
- WO 2015137244 A
- WO 2015137202 A
- WO 2015137136 A
- WO 2015146541 A
- WO 2015159541 A


### Non-patent literature cited in the description


- *Adv. Mater.*, 2016, vol. 28, 2777-2781
- *Angew. Chem. Int. Ed.*, 2018, vol. 57, 11316-11320
- **HANSCH, C.** *Chem. Rev.*, 1991, vol. 91